(19) Europäisches Patentamt
European Patent Office
Office européen des brevets

(11) EP 3 185 325 A1

(12) **EUROPEAN PATENT APPLICATION**

(43) Date of publication:
**28.06.2017 Bulletin 2017/26**

(51) Int Cl.:
***H01L 51/50*** *(2006.01)*

(21) Application number: **16191351.2**

(22) Date of filing: **29.09.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **22.12.2015 KR 20150184076**

(71) Applicant: **Samsung Display Co., Ltd.**
**Gyeonggi-Do (KR)**

(72) Inventors:
- **KIM, Seulong**
  **Gyeonggi-do, (KR)**
- **KIM, Younsun**
  **Gyeonggi-do, (KR)**
- **SHIN, Dongwoo**
  **Gyeonggi-do, (KR)**
- **LEE, Jungsub**
  **Gyeonggi-do, (KR)**
- **ITO, Naoyuki**
  **Gyeonggi-do, (KR)**
- **LIM, Jino**
  **Gyeonggi-do, (KR)**
- **JEONG, Hyein**
  **Gyeonggi-do, (KR)**

(74) Representative: **Leanse, Thomas Gordon Hamilton et al**
**Venner Shipley LLP**
**200 Aldersgate**
**GB-London EC1A 4HD (GB)**

(54) **ORGANIC LIGHT-EMITTING DEVICE**

(57) According to one or more embodiments, an organic light-emitting device comprises: a first electrode; a second electrode facing the first electrode; an emission layer between the first electrode and the second electrode; a hole transport region between the first electrode and the emission layer; and an electron transport region between the emission layer and the second electrode. The emission layer comprises a first compound represented by Formula 1, and at least one selected from the hole transport region and the electron transport region comprises a second compound represented by Formula 2A or 2B:

**Formula 1**

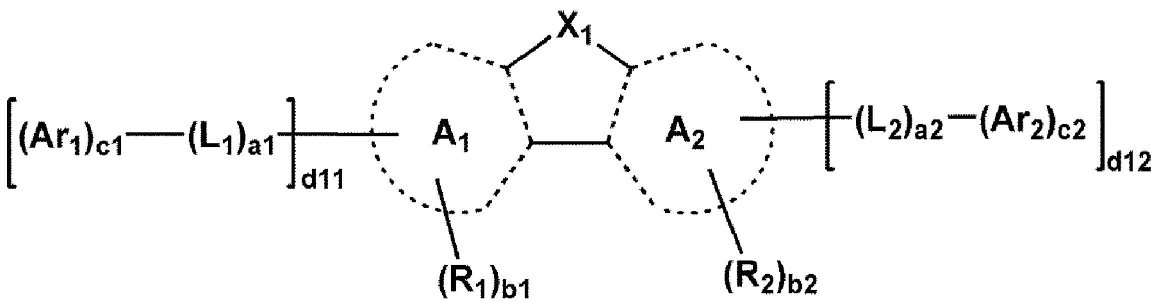

EP 3 185 325 A1

**Formula 2A**

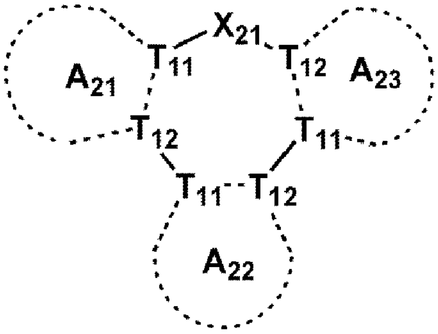

**Formula 2B**

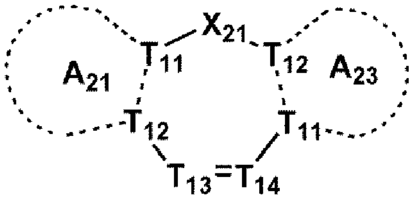

# FIG. 1

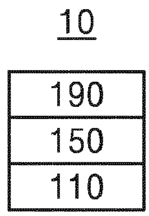

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and/or excellent brightness, driving voltage, and/or response speed characteristics, compared to other devices in the art.

An organic light-emitting device may comprise a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition from an excited state to a ground state, thereby generating light.

### SUMMARY OF THE INVENTION

The organic light-emitting device of the present invention has a low driving voltage and high efficiency.

Accordingly, the present invention provides an organic light-emitting device comprising:

a first electrode;
a second electrode facing the first electrode;
an emission layer between the first electrode and the second electrode;
a hole transport region between the first electrode and the emission layer; and
an electron transport region between the emission layer and the second electrode,
wherein the emission layer comprises a first compound,
at least one selected from the hole transport region and the electron transport region comprises a second compound,
the first compound is a compound of Formula 1 other than 4,4'-bis(N-carbazolyl)-1,1'-biphenyl (CBP) (i.e. Formula 1 is not CBP), and the second compound is represented by Formula 2A or 2B:

Formula 1

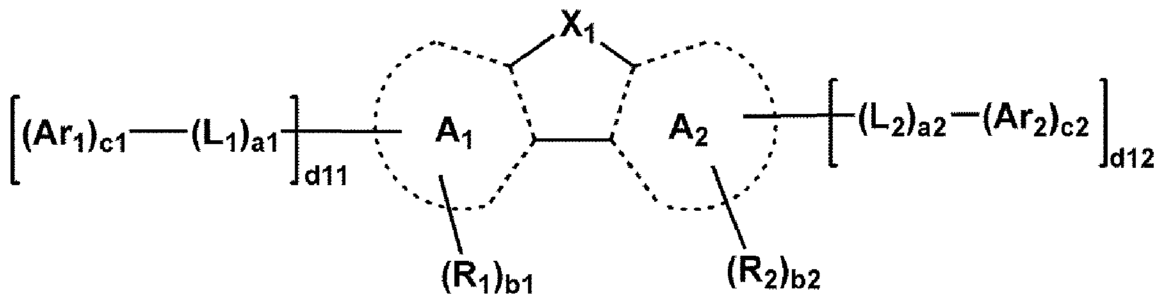

Formula 2A

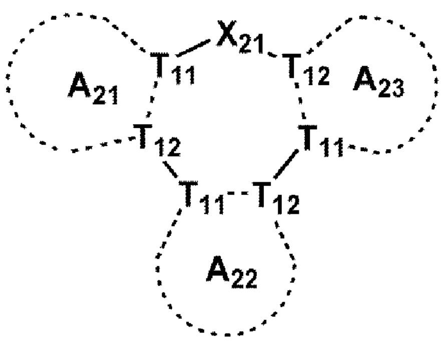

Formula 2B

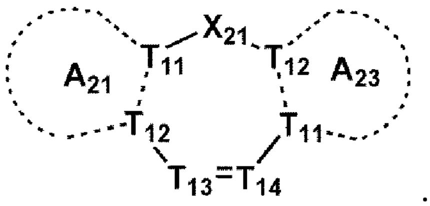

In Formulae 1, 2A, and 2B,

rings $A_1$ and $A_2$ are each independently selected from a $C_5$-$C_{60}$ carbocyclic group and a $C_1$-$C_{60}$ heterocyclic group,

rings $A_1$ and $A_2$ are each condensed with the 5-membered ring comprising X1 in Formula 1,

rings $A_{21}$, $A_{22}$, and $A_{23}$ are each independently a $C_5$-$C_{60}$ carbocyclic group or a $C_1$-$C_{60}$ heterocyclic group, each substituted with at least one *-[$(L_{22})_{a22}$-$(R_{22})_{b22}$], wherein * indicates a binding side to ring $A_{21}$, $A_{22}$, or $A_{23}$,

each $T_{11}$ is independently carbon or nitrogen,

each $T_{12}$ is independently carbon or nitrogen,

$T_{13}$ is N or C($R_{27}$), $T_{14}$ is N or C($R_{28}$), each bond between $T_{11}$ and $T_{12}$ represented by a dashed line in Formulae 2A and 2B is a single bond or a double bond, wherein the six atoms represented by the three $T_{11}$(s) and three $T_{12}$(s) in Formula 2A are not all nitrogen, and the six atoms represented by the two $T_{11}$(s), two $T_{12}$(s), $T_{13}$, and $T_{14}$ in Formula 2B are not all nitrogen. Any one of the three T11s in formula 2A may be different from each of the other two T11s, identical to each of the other two T11s, or identical to one of the other two T11s and different from one of the other two T11s. Any one of the three T12s in formula 2A may be different from each of the other two T12s, identical to each of the other two T12s,or identical to one of the other two T12s and different from one of the other two T12s. Any one of the two T11s in Formula 2B may be different from the other T11 or identical to the other T11. Any one of the two T12s in Formula 2B may be different from the other $T_{12}$ or identical to the other $T_{12}$.

Rings $A_{21}$, $A_{22}$, and $A_{23}$ are each be condensed (e.g., fused) with the central 7-membered ring in Formulae 2A and 2B (i.e. the 7-membered ring formed by the three T11s, three T12s and $X_{21}$ in formula 2A; and the 7-membered ring formed by the two T11s, two T12s,T13, T14 and X21 in formula 2B), such that they each share a $T_{11}$ and a $T_{12}$ with the central 7-membered ring.

$X_1$ is selected from N[$(L_3)_{a3}$-$(Ar_3)_{c3}$], Si($R_3$)($R_4$), O, S, and Se,

$X_{21}$ is selected from O, S, Se, C($R_{23}$)($R_{24}$), Si($R_{23}$)($R_{24}$), and N[$(L_{21})_{a21}$-$(R_{21})_{b21}$],

$L_1$ to $L_3$, $L_{21}$, and $L_{22}$ are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed C8-C60 polycyclic group, and a substituted or unsubstituted divalent non-aromatic condensed 8- to 60-membered heteropolycyclic group,

ai to a3, a2i, and a22 are each independently an integer selected from 0 to 5,

$Ar_1$ to $Ar_3$ are each independently selected from a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed C8-C60polycyclic group, a substituted or unsubstituted monovalent non-aromatic condensed 8- to 60-membered heteropolycyclic group, - Si($Q_1$)($Q_2$)($Q_3$), -N($Q_1$)($Q_2$), -B($Q_1$)($Q_2$), -C(=O)($Q_1$), -S(=O)$_2$($Q_1$), and -P(=O)($Q_1$)($Q_2$),

$c_1$ to $c_3$ are each independently be an integer selected from 1 to 3,

$R_1$ to $R_4$, $R_{21}$ to $R_{24}$, $R_{27}$, and $R_{28}$ are each independently selected from hydrogen, deuterium (-D), -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed C8-C60polycyclic group, a substituted or unsubstituted monovalent non-aromatic condensed 8- to 60-membered heteropolycyclic group, -Si($Q_4$)($Q_5$)($Q_6$),-N($Q_4$)($Q_5$), -B($Q_4$)($Q_5$), -C(=O)($Q_4$), -S(=O)$_2$($Q_4$), and -P(=O)($Q_4$)($Q_5$), b1 and b2 are each independently an integer selected from 1 to 6, and b21 and b22 are each independently an integer selected from 1 to 3,

d11 and d12 are each independently an integer selected from 0 to 4,

the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed C8-C60polycyclic group, the substituted divalent non-aromatic condensed 8- to 60-membered heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$

aryloxy group, the substituted $C_6$-$C_{60}$ arylthio group, the substituted $C_1$-$C_{60}$ heteroaryl group, the substituted monovalent non-aromatic condensed C8-C60polycyclic group, and the substituted monovalent non-aromatic condensed 8- to 60-membered heteropolycyclic group are each independently substituted with one or more substituents selected from the group consisting of:

deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, - I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60polycyclic group, a monovalent non-aromatic condensed 8- to 60-membered heteropolycyclic group, -Si($Q_{11}$)($Q_{12}$)($Q_{13}$), -N($Q_{11}$)($Q_{12}$),-B($Q_{11}$)($Q_{12}$), -C(=O)($Q_{11}$), -S(=O)$_2$($Q_{11}$), and -P(=O)($Q_{11}$)($Q_{12}$);
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60polycyclic group, a monovalent non-aromatic condensed 8- to 60-membered heteropolycyclic group, a biphenyl group, and a terphenyl group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$alkenyl group, a $C_2$-$C_{60}$alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60polycyclic group, a monovalent non-aromatic condensed 8- to 60-membered heteropolycyclic group, -Si($Q_{21}$)($Q_{22}$($Q_{23}$), -N($Q_{21}$)($Q_{22}$), -B($Q_{21}$)($Q_{22}$), -C(=O)($Q_{21}$), -S(=O)$_2$($Q_{21}$), and -P(=O)($Q_{21}$)($Q_{22}$); and
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and-P(=O)($Q_{31}$)($Q_{32}$),
wherein $Q_1$ to $Q_6$, $Q_{11}$ to $Q_{13}$, $Q_{21}$ to $Q_{23}$, and $Q_{31}$ to $Q_{33}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with a $C_1$-$C_{60}$ alkyl group, a $C_6$-$C_{60}$ aryl group substituted with a $C_6$-$C_{60}$ aryl group, a terphenyl group, a $C_1$-$C_{60}$ heteroaryl group, a $C_1$-$C_{60}$ heteroaryl group substituted with a $C_1$-$C_{60}$ alkyl group, a $C_1$-$C_{60}$ heteroaryl group substituted with a $C_6$-$C_{60}$ aryl group, a monovalent non-aromatic condensed C8-C60polycyclic group, and a monovalent non-aromatic condensed 8- to 60-membered heteropolycyclic group.

## BRIEF DESCRIPTION OF THE DRAWINGS

**FIGS.** 1 to 5 are schematic views of organic light-emitting devices, each according to various embodiments of the present disclosure.

## DETAILED DESCRIPTION

An organic light-emitting device according to the present invention comprises a first electrode, a second electrode facing the first electrode, an emission layer between the first electrode and the second electrode, a hole transport region between the first electrode and the emission layer, and an electron transport region between the emission layer and the second electrode, wherein the emission layer may comprise a first compound, and at least one selected from the hole transport region and the electron transport region may comprise a second compound.
The first compound is a compound represented by Formula 1 other than 4,4'-bis(N-carbazolyl)-1,1'-biphenyl (CBP), and the second compound is represented by Formula 2A or 2B:

**Formula 1**

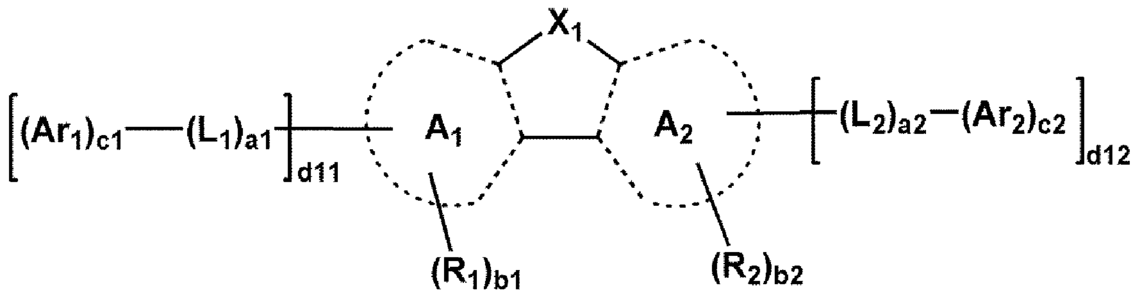

**Formula 2A**

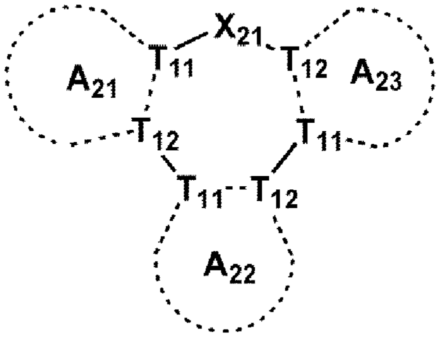

**Formula 2B**

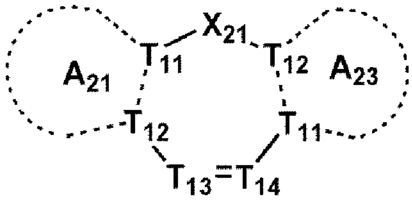

.

In Formula 1,
rings $A_1$ and $A_2$ are each independently selected from a $C_5$-$C_{60}$ carbocyclic group and a $C_1$-$C_{60}$ heterocyclic group.

Rings $A_1$ and $A_2$ in Formula 1 are each condensed with the 5-membered ring comprising $X_1$.

For example, rings $A_1$ and $A_2$ in Formula 1 may each independently be selected from a benzene group, a naphthalene group, an anthracene group, a phenanthrene group, an indene group, a fluorene group, a pyridine group, a pyrimidine group, a pyrazine group, a pyrrole group, a pyrazole group, an imidazole group, a quinoline group, a quinoxaline group, an isoquinoline group, a cinnoline group, a phthalazine group, a quinazoline group, a phenanthroline group, a phenanthridine group, a furan group, a thiophene group, an indole group, a benzofuran group, a benzothiophene group, a benzoxazole group, a benzothiazole group, a benzoimidazole group, a benzocarbazole group, a benzofluorene group, a benzonaphthofuran group, a benzonaphthothiophene group, a carbazole group, a dibenzofuran group, a dibenzothiophene group, a pyridoindole group, an indenopyridine group, a benzofuropyrimidine group, a benzofuropyridine group, an indenofluorene group, an indenoindole group, a benzoindole group, a naphthofuran group, a dipyridofuran group, a dipyridothiophene group, a pyrimidobenzofuran group, a pyridobenzofuran group, a pyrimidobenzothiophene group, a pyridobenzothiophene group, a group represented by Formula

" 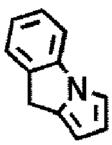 ",

a group represented by Formula

" 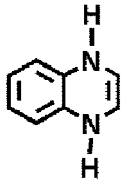 ",

a group represented by Formula

" 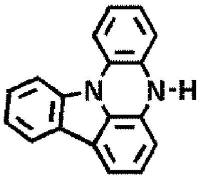 ",

and a group represented by Formula

" 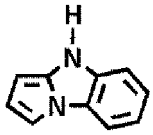 ".

Rings $A_{21}$, $A_{22}$, and $A_{23}$ in Formulae 2A and 2B are each independently a $C_5$-$C_{60}$ carbocyclic group or a $C_1$-$C_{60}$ heterocyclic group, each substituted with at least one $*-[(L_{22})_{a22}-(R_{22})_{b22}]$. $L_{22}$, a22, $R_{22}$, and b22 will be described in more detail below.

$T_{11}$ and $T_{12}$ in Formulae 2A and 2B are each independently carbon or nitrogen, $T_{13}$ is N or $C(R_{27})$, and $T_{14}$ is N or $C(R_{28})$. Each bond between $T_{11}$ and $T_{12}$ represented by a dashed line in formulae 2A and 2B is a single bond or a double bond, wherein the six atoms represented by the three $T_{11}$(s) and three $T_{12}$(s) in Formula 2A are not all nitrogen, and the six atoms represented by the two $T_{11}$(s), two $T_{12}$(s), $T_{13}$, and $T_{14}$ in Formula 2B are not all nitrogen, and rings $A_{21}$, $A_{22}$, and $A_{23}$ are each condensed (e.g., fussed) with the central 7-membered ring in Formulae 2A and 2B, such that they each share a $T_{11}$ and a $T_{12}$ with the central 7-membered ring.

$*-[(L_{22})_{a22}-(R_{22})_{b22}]$ substituted (e.g., as a substituent) in ring $A_{21}$, $*-[(L_{22})_{a22}-(R_{22})_{b22}]$ substituted (e.g., as a substitutent) in ring $A_{22}$, and $*-[(L_{22})_{a22}-(R_{22})_{b22}]$ substituted (e.g., as a substitutent) in ring $A_{23}$ may be identical to or different from one another.

In addition, when the number of $*-[(L_{22})_{a22}-(R_{22})_{b22}]$(s) substituted (e.g., as a substitutent) in ring $A_{21}$ is two or more, two or more $*-[(L_{22})_{a22}-(R_{22})_{b22}]$(s) may be identical to or different from each other, when the number of $*-[(L_{22})_{a22}-(R_{22})_{b22}]$(s) substituted (e.g., as a substitutent) in ring $A_{22}$ is two or more, two or more $*-[(L_{22})_{a22}-(R_{22})_{b22}]$(s) may be identical to or different from each other, and when the number of $*-[(L_{22})_{a22}-(R_{22})b_{22}]_{(}s)$ substituted (e.g., as a substitutent) in ring $A_{23}$ is two or more, two or more $*-[(L_{22})_{a22}-(R_{22})_{b22}]$(s) may be identical to or different from each other.

In various embodiments, rings $A_{21}$, $A_{22}$, and $A_{23}$ in Formulae 2A and 2B may each independently be selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and an naphthoindole group, each substituted with at least one *-[$(L_{22})_{a22}$-$(R_{22})_{b22}$].

In various embodiments, in the second compound represented by Formulae 2A and 2B, a case where rings $A_{21}$, $A_{22}$, and $A_{23}$ are all a benzene group substituted with at least one *-[$(L_{22})_{a22}$-$(R_{22})_{b22}$] maybe excluded.

In various embodiments, rings $A_{21}$, $A_{22}$, and $A_{23}$ in Formulae 2A and 2B may each independently be selected from groups represented by Formulae 2-1 to 2-36, each substituted with at least one *-[$(L_{22})_{a22}$-$(R_{22})_{b22}$]:

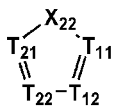
Formula 2-1

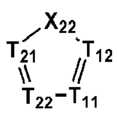
Formula 2-2

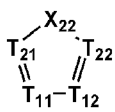
Formula 2-3

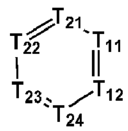
Formula 2-4

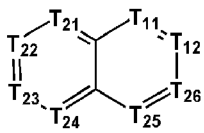
Formula 2-5

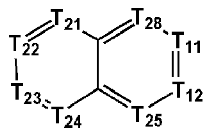
Formula 2-6

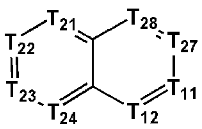
Formula 2-7

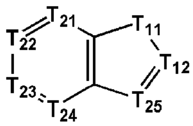
Formula 2-8

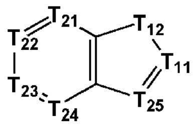
Formula 2-9

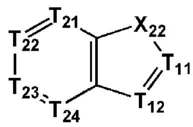
Formula 2-10

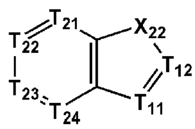
Formula 2-11

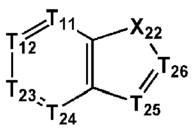
Formula 2-12

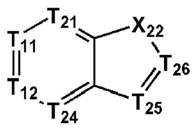
Formula 2-13

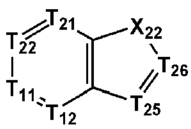
Formula 2-14

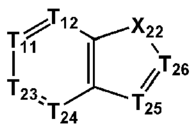
Formula 2-15

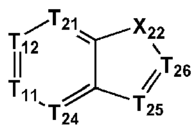
Formula 2-16

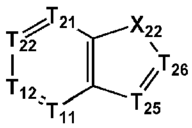
Formula 2-17

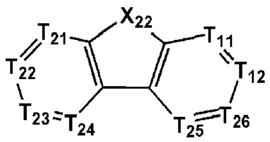
Formula 2-18

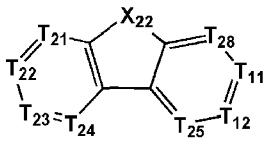
Formula 2-19

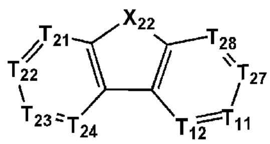
Formula 2-20

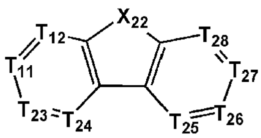
Formula 2-21

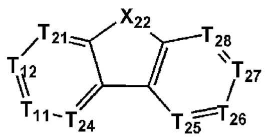
Formula 2-22

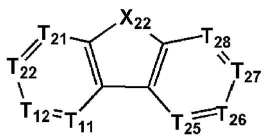
Formula 2-23

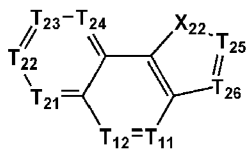
Formula 2-24

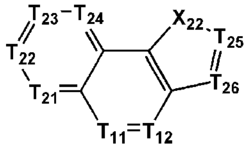
Formula 2-25

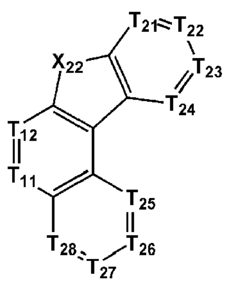
Formula 2-26

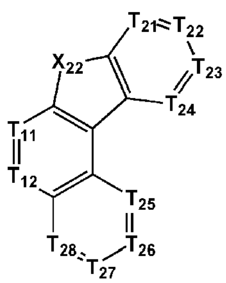
Formula 2-27

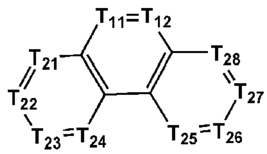
Formula 2-28

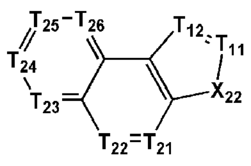

Formula 2-29

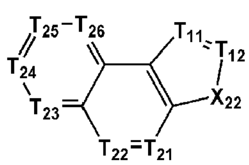

Formula 2-30

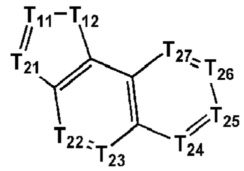

Formula 2-31

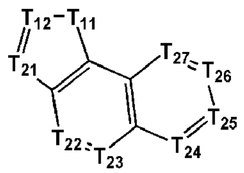

Formula 2-32

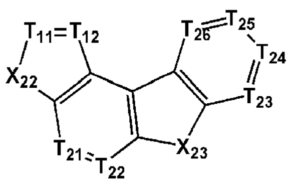

Formula 2-33

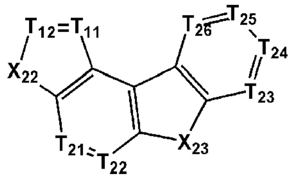

Formula 2-34

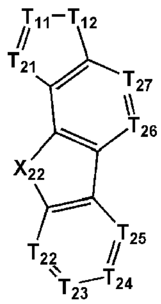

Formula 2-35

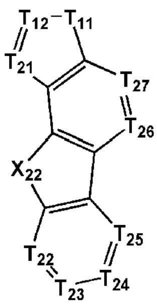

Formula 2-36

.

In Formulae 2-1 to 2-36,

$T_{11}$ and $T_{12}$ are the same as described above,
$X_{22}$ and $X_{23}$ may each independently be selected from O, S, Se, a moiety comprising C, a moiety comprising N, and a moiety comprising Si, and
$T_{21}$ to $T_{28}$ may each independently be selected from N and a moiety comprising C.

When both $X_{22}$ and $X_{23}$ are comprised in rings $A_{21}$ to $A_{23}$, $X_{22}$ and $X_{23}$ may be identical to or different from each other.

For example, in Formulae 2-1 to 2-36, $X_{22}$ and $X_{23}$ may each independently be O, S, Se, $C(R_{25})(R_{26})$, $N-[(L_{22})_{a22}-(R_{22})_{b22}]$, or $Si(R_{25})(R_{26})$, and $T_{21}$ to $T_{28}$ may each independently be N or $C-[(L_{22})_{a22}-(R_{22})_{b22}]$. $R_{25}$ and $R_{26}$ may each independently be selected from groups represented by $*-[(L_{22})_{a22}-(R_{22})_{b22})]$ as described herein.

In various embodiments, rings $A_{21}$, $A_{22}$, and $A_{23}$ in Formulae 2A and 2B may each independently be selected from groups represented by Formulae 2-101 to 2-229:

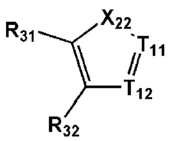

Formula 2-101

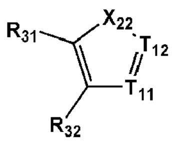

Formula 2-102

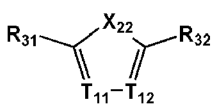

Formula 2-103

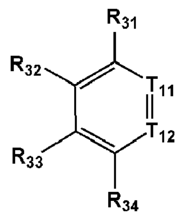

Formula 2-104

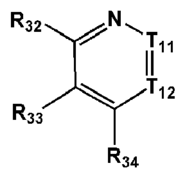

Formula 2-105

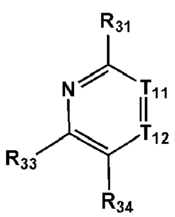

Formula 2-106

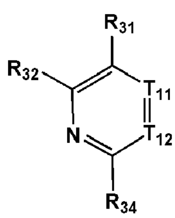

Formula 2-107

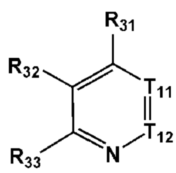

Formula 2-108

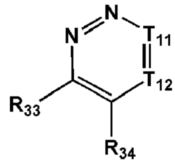

Formula 2-109

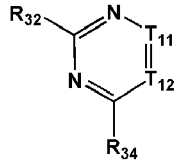

Formula 2-110

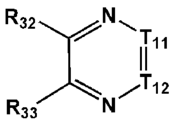

Formula 2-111

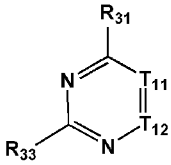

Formula 2-112

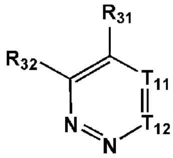

Formula 2-113

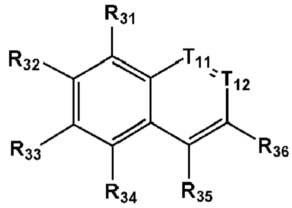

Formula 2-114

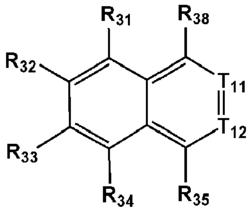

Formula 2-115

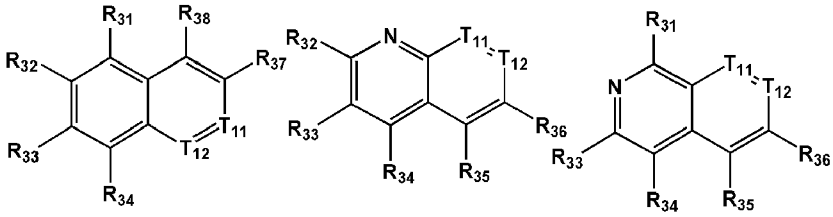

Formula 2-116

Formula 2-117

Formula 2-118

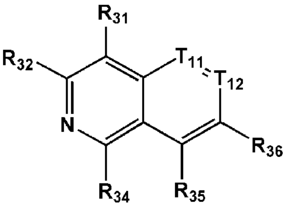

Formula 2-119

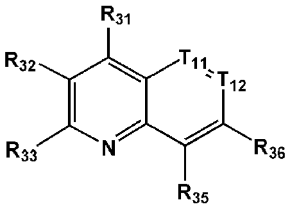

Formula 2-120

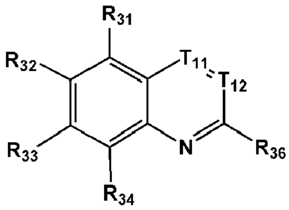

Formula 2-121

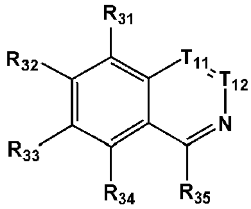

Formula 2-122

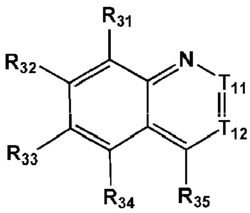

Formula 2-123

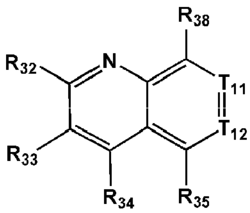

Formula 2-124

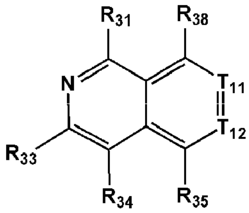

Formula 2-125

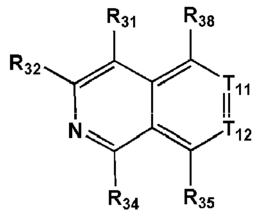

Formula 2-126

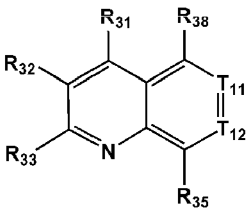

Formula 2-127

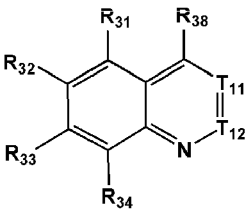

Formula 2-128

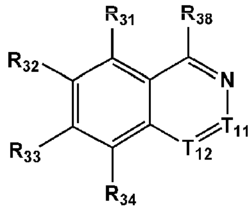

Formula 2-129

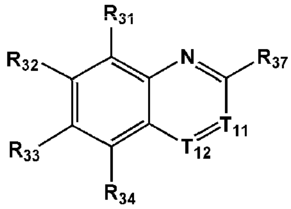

Formula 2-130

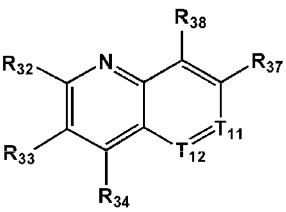

Formula 2-131

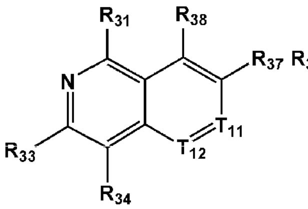

Formula 2-132

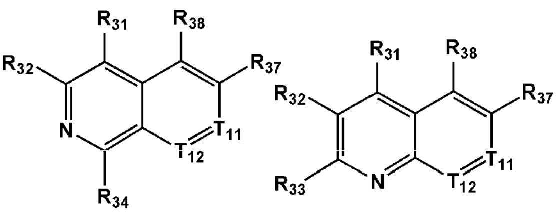

Formula 2-133

Formula 2-134

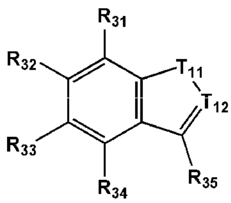
Formula 2-135

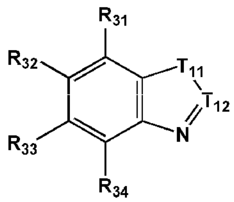
Formula 2-136

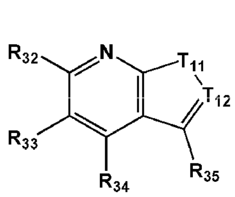
Formula 2-137

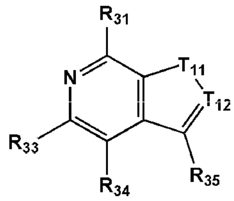
Formula 2-138

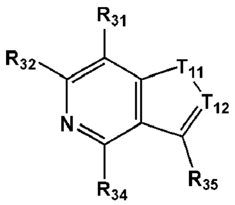
Formula 2-139

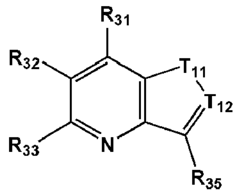
Formula 2-140

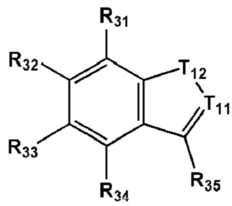
Formula 2-141

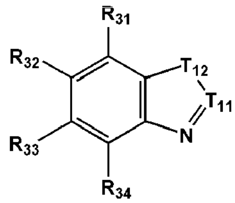
Formula 2-142

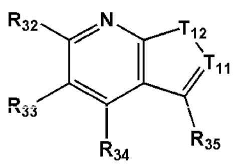
Formula 2-143

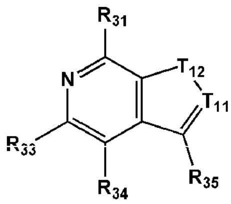
Formula 2-144

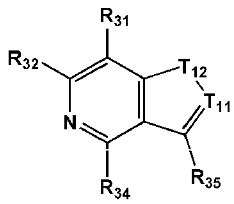
Formula 2-145

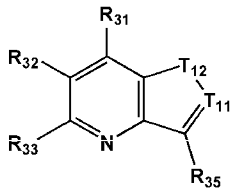
Formula 2-146

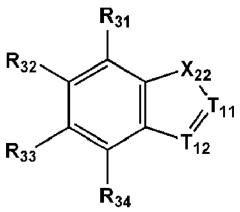
Formula 2-147

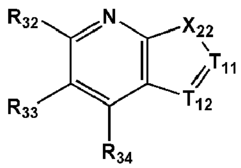
Formula 2-148

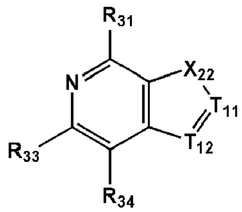
Formula 2-149

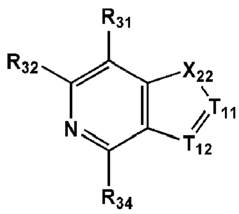
Formula 2-150

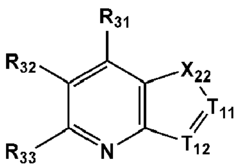
Formula 2-151

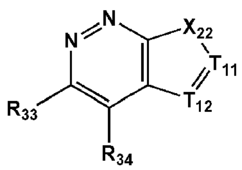
Formula 2-152

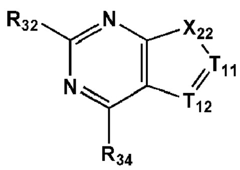
Formula 2-153

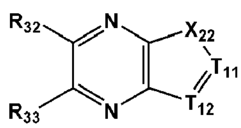
Formula 2-154

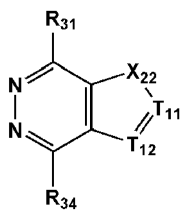
Formula 2-155

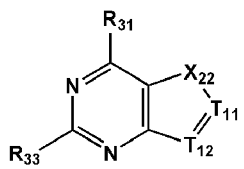
Formula 2-156

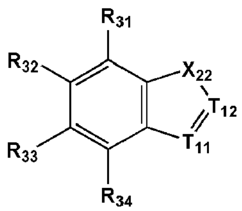
Formula 2-157

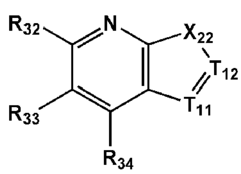
Formula 2-158

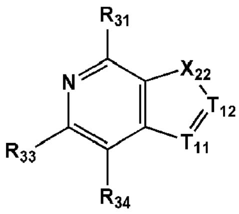
**Formula 2-159**

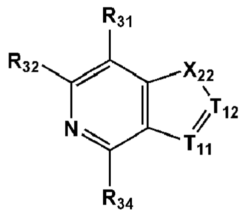
**Formula 2-160**

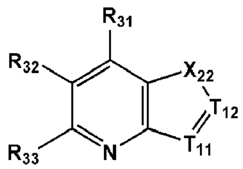
**Formula 2-161**

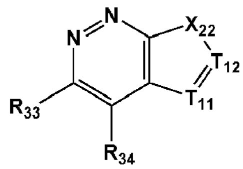
**Formula 2-162**

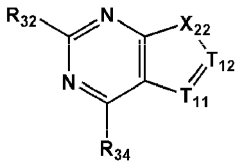
**Formula 2-163**

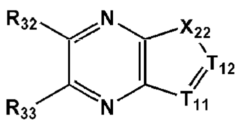
**Formula 2-164**

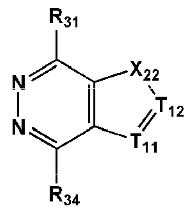
**Formula 2-165**

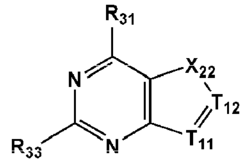
**Formula 2-166**

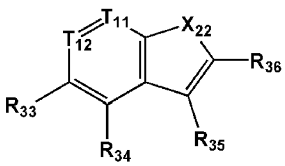
**Formula 2-167**

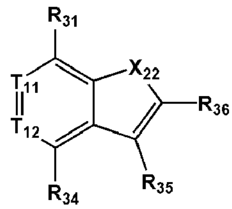
**Formula 2-168**

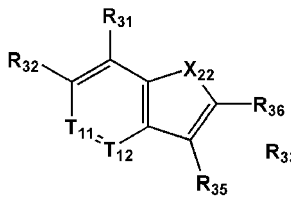
**Formula 2-169**

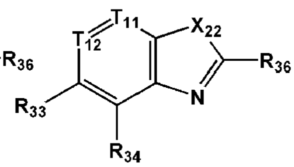
**Formula 2-170**

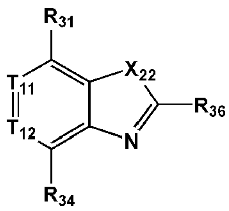
**Formula 2-171**

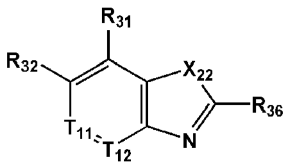
**Formula 2-172**

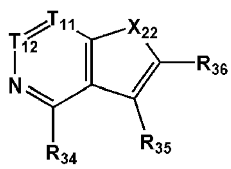
**Formula 2-173**

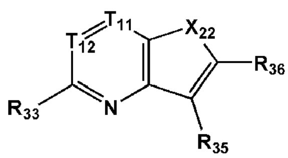
**Formula 2-174**

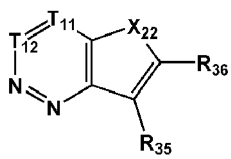
**Formula 2-175**

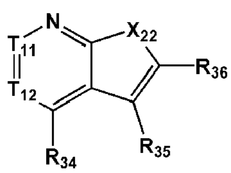
**Formula 2-176**

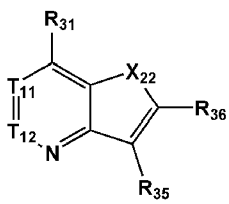
**Formula 2-177**

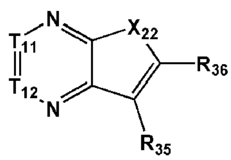
**Formula 2-178**

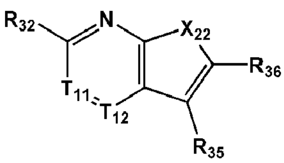
**Formula 2-179**

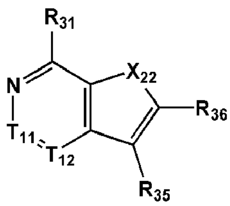
**Formula 2-180**

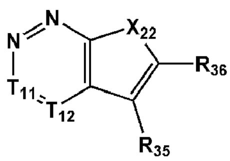
**Formula 2-181**

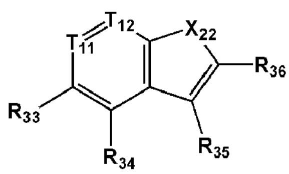
**Formula 2-182**

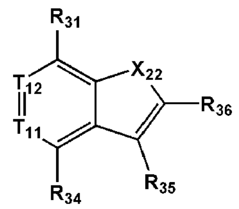

Formula 2-183

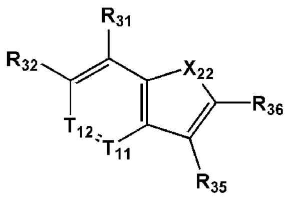

Formula 2-184

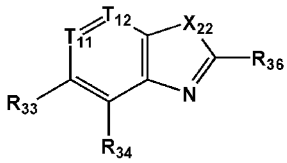

Formula 2-185

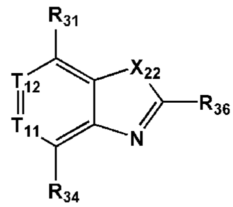

Formula 2-186

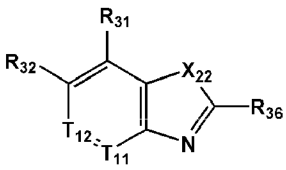

Formula 2-187

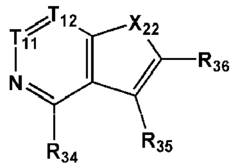

Formula 2-188

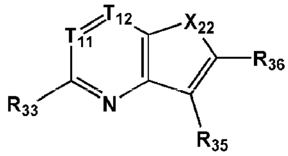

Formula 2-189

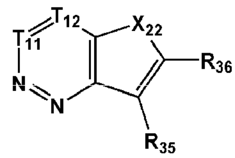

Formula 2-190

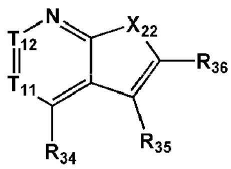

Formula 2-191

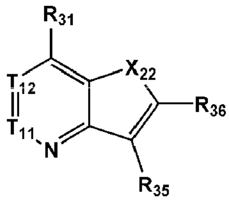

Formula 2-192

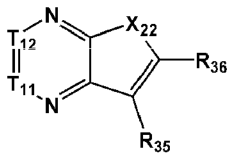

Formula 2-193

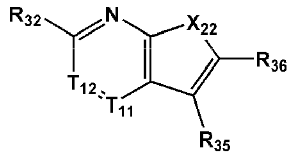

Formula 2-194

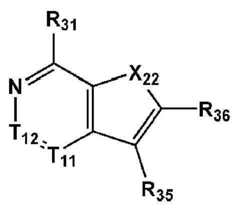

Formula 2-195

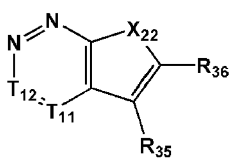

Formula 2-196

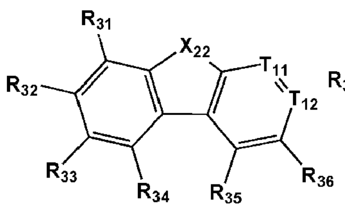

Formula 2-197

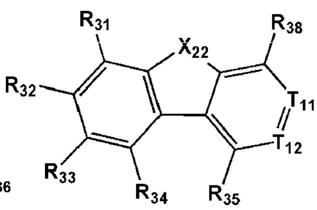

Formula 2-198

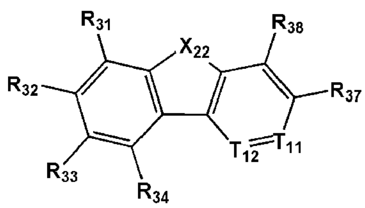

Formula 2-199

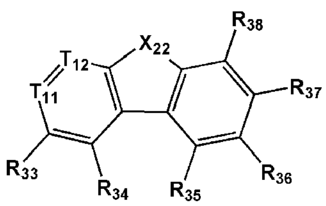

Formula 2-200

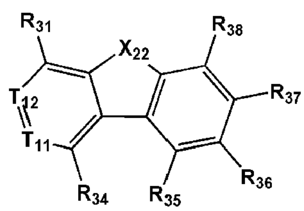

Formula 2-201

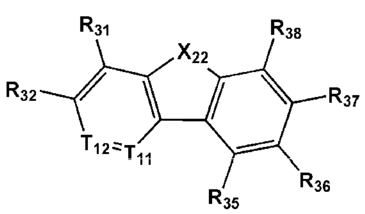

Formula 2-202

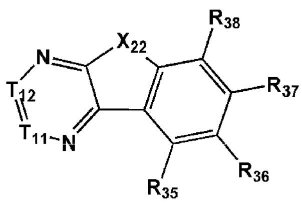

Formula 2-203

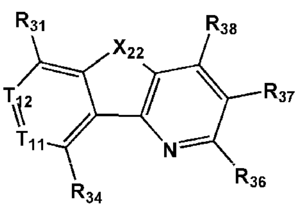

Formula 2-204

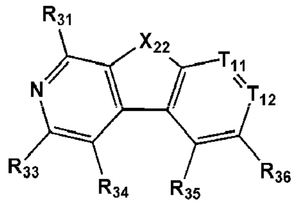

Formula 2-205

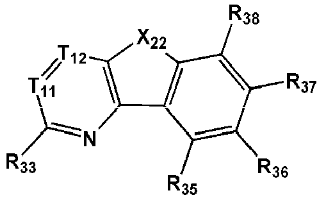

Formula 2-206

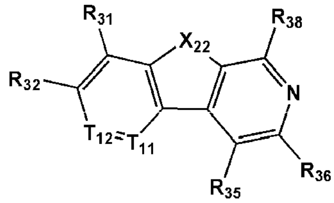

Formula 2-207

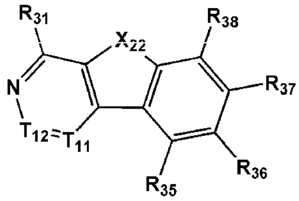

Formula 2-208

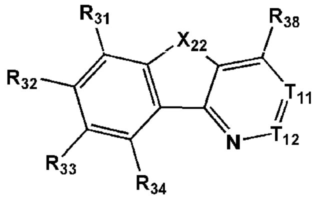

Formula 2-209

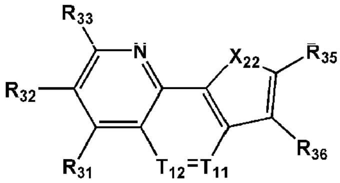

Formula 2-210

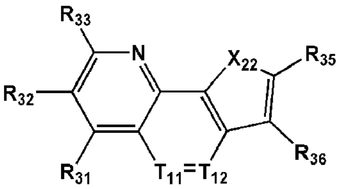

Formula 2-211

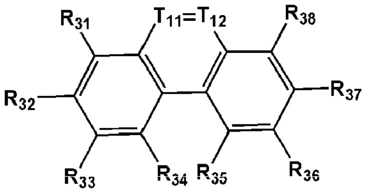

Formula 2-212

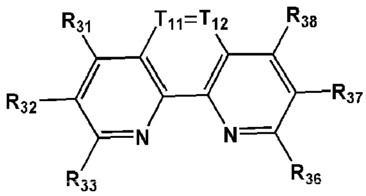

Formula 2-213

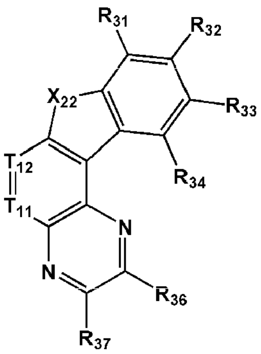

Formula 2-214

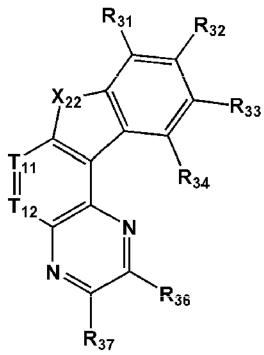

Formula 2-215

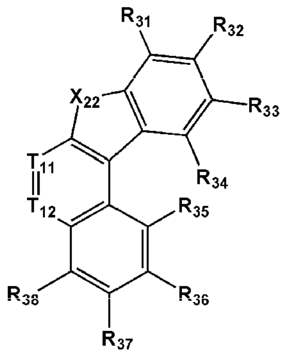

Formula 2-216

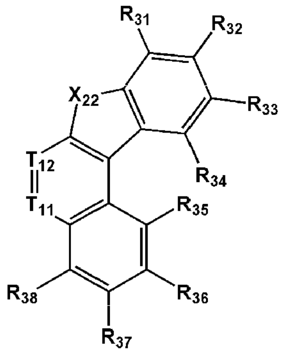

Formula 2-217

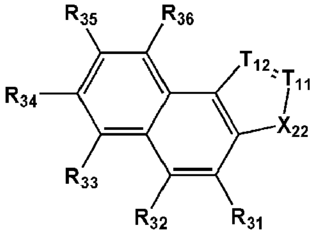

Formula 2-218

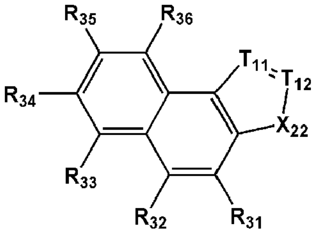

Formula 2-219

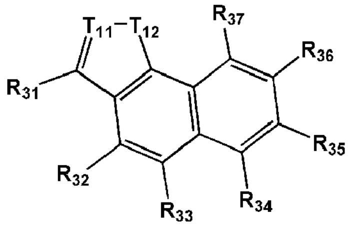

Formula 2-220

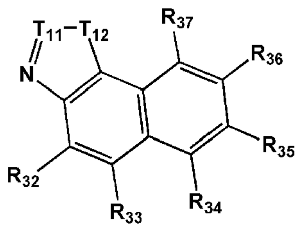

Formula 2-221

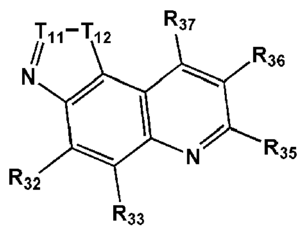

Formula 2-222

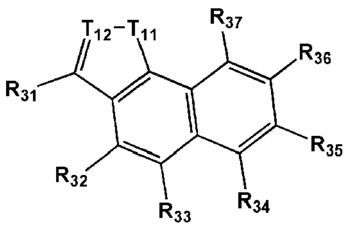

Formula 2-223

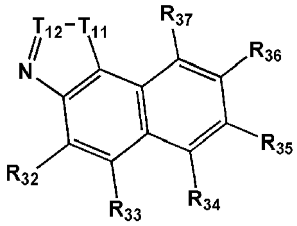

Formula 2-224

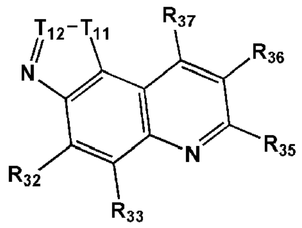

Formula 2-225

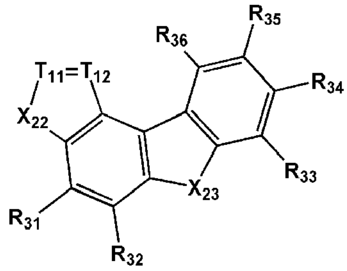

Formula 2-226

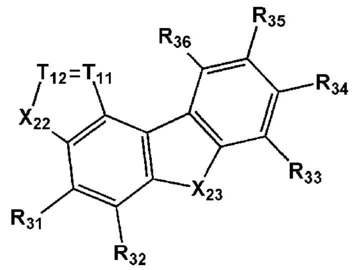

Formula 2-227

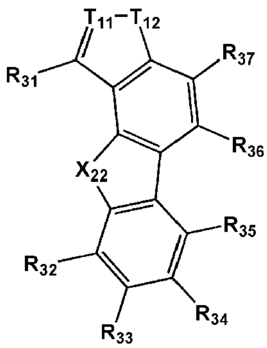

Formula 2-228

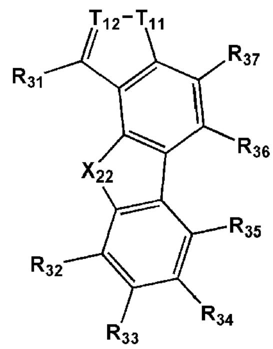

Formula 2-229

In Formulae 2-101 to 2-229,

$T_{11}$ and $T_{12}$ are the same as described above,
$X_{22}$ and $X_{23}$ are the same as described above, and
$R_{31}$ to $R_{38}$ may each independently be selected from substituents represented by $*\text{-}[(L_{22})_{a22}\text{-}(R_{22})_{b22}]$ as described herein.

In Formulae 2-101 to 2-229, when the number of $*\text{-}[(L_{22})_{a22}\text{-}(R_{22})_{b22}]$(s) is two or more, two or more $*\text{-}[(L_{22})_{a22}\text{-}(R_{22})_{b22}]$(s) (e.g., in the respective Formula) may be identical to or different from each other.

In some embodiments, when the number of $*\text{-}[(L_{22})_{a22}\text{-}(R_{22})_{b22}]$(s) in $R_{31}$ to $R_{38}$ is 2 or more, no more than 2 $*\text{-}[(L_{22})_{a22}\text{-}(R_{22})_{b22}]$(s) is a cyclic group or contains a cyclic group. In some embodiments, when the number of $*\text{-}[(L_{22})_{a22}\text{-}(R_{22})_{b22}]$(s) in $R_{31}$ to $R_{38}$ is 2 or more, no more than 1 $*\text{-}[(L_{22})_{a22}\text{-}(R_{22})_{b22}]$ is a cyclic group or contains a cyclic group. In some embodiments, when the number of $*\text{-}[(L_{22})_{a22}\text{-}(R_{22})_{b22}]$(s) in $R_{31}$ to $R_{38}$ is 2 or more, no more than 2 $*\text{-}[(L_{22})_{a22}\text{-}(R_{22})_{b22}]$(s) is other than hydrogen. In some embodiments, when the number of $*\text{-}[(L_{22})_{a22}\text{-}(R_{22})_{b22}]$(s) in $R_{31}$ to $R_{38}$ is 2 or more, no more than 1 $*\text{-}[(L_{22})_{a22}\text{-}(R_{22})_{b22}]$ is other than hydrogen.

In some embodiments, in Formulae 2A to 2B, a case where rings $A_{21}$, $A_{22}$, and $A_{23}$ are all represented by Formula 2-104 may be excluded.

In various embodiments, the second compound represented by Formula 2A or 2B may be represented by one selected from Formulae 2-201A to 2-269A, and rings $A_{21}$, $A_{22}$, and $A_{23}$ in Formulae 2-201A to 2-269A may each be selected from the Formulae shown in Table 1.

**Table 1**

| Formula No. | Formula No. for ring $A_{21}$ | Formula No. for ring $A_{22}$ | Formula No. for ring $A_{23}$ |
|---|---|---|---|
| 2-201A | 2-2 | 2-4 | 2-4 |
| 2-202A | 2-4 | 2-4 | 2-1 |
| 2-203A | 2-4 | 2-4 | 2-2 |
| 2-204A | 2-4 | 2-4 | 2-3 |
| 2-205A | 2-4 | 2-1 | 2-4 |
| 2-206A | 2-4 | 2-2 | 2-4 |
| 2-207A | 2-4 | 2-4 | 2-10 |
| 2-208A | 2-11 | 2-4 | 2-4 |
| 2-209A | 2-4 | 2-4 | 2-11 |
| 2-210A | 2-4 | 2-10 | 2-4 |
| 2-211A | 2-4 | 2-4 | 2-8 |
| 2-212A | 2-4 | 2-9 | 2-4 |
| 2-213A | 2-4 | 2-4 | 2-14 |
| 2-214A | 2-17 | 2-4 | 2-4 |
| 2-215A | 2-4 | 2-4 | 2-15 |
| 2-216A | 2-13 | 2-4 | 2-4 |
| 2-217A | 2-4 | 2-4 | 2-16 |
| 2-218A | 2-4 | 2-4 | 2-13 |
| 2-219A | 2-16 | 2-4 | 2-4 |
| 2-220A | 2-4 | 2-4 | 2-12 |
| 2-221A | 2-4 | 2-4 | 2-17 |
| 2-222A | 2-4 | 2-16 | 2-4 |
| 2-223A | 2-4 | 2-15 | 2-4 |
| 2-224A | 2-4 | 2-14 | 2-4 |
| 2-225A | 2-4 | 2-17 | 2-4 |
| 2-226A | 2-19 | 2-4 | 2-4 |
| 2-227A | 2-22 | 2-4 | 2-4 |
| 2-228A | 2-18 | 2-4 | 2-4 |
| 2-229A | 2-23 | 2-4 | 2-4 |
| 2-230A | 2-21 | 2-4 | 2-4 |
| 2-231A | 2-20 | 2-4 | 2-4 |
| 2-232A | 2-4 | 2-23 | 2-4 |
| 2-233A | 2-4 | 2-18 | 2-4 |
| 2-234A | 2-4 | 2-21 | 2-4 |
| 2-235A | 2-4 | 2-19 | 2-4 |
| 2-236A | 2-5 | 2-2 | 2-4 |
| 2-237A | 2-5 | 2-1 | 2-4 |

(continued)

| Formula No. | Formula No. for ring $A_{21}$ | Formula No. for ring $A_{22}$ | Formula No. for ring $A_{23}$ |
|---|---|---|---|
| 2-238A | 2-2 | 2-2 | 2-4 |
| 2-239A | 2-4 | 2-23 | 2-1 |
| 2-240A | 2-6 | 2-10 | 2-4 |
| 2-241A | 2-4 | 2-4 | 2-29 |
| 2-242A | 2-7 | 2-4 | 2-10 |
| 2-243A | 2-11 | 2-4 | 2-10 |
| 2-244A | 2-4 | 2-10 | 2-6 |
| 2-245A | 2-11 | 2-11 | 2-4 |
| 2-246A | 2-11 | 2-11 | 2-5 |
| 2-247A | 2-11 | 2-11 | 2-10 |
| 2-248A | 2-7 | 2-9 | 2-4 |
| 2-249A | 2-4 | 2-4 | 2-25 |
| 2-250A | 2-11 | 2-15 | 2-4 |
| 2-251A | 2-18 | 2-28 | 2-4 |
| 2-252A | 2-23 | 2-10 | 2-4 |
| 2-253A | 2-4 | 2-27 | 2-4 |
| 2-254A | 2-6 | 2-18 | 2-4 |
| 2-255A | 2-4 | 2-23 | 2-5 |
| 2-256A | 2-23 | 2-4 | 2-14 |
| 2-257A | 2-17 | 2-4 | 2-14 |
| 2-258A | 2-14 | 2-4 | 2-12 |
| 2-259A | 2-17 | 2-4 | 2-12 |
| 2-260A | 2-14 | 2-16 | 2-2 |
| 2-261A | 2-17 | 2-5 | 2-14 |
| 2-262A | 2-17 | 2-13 | 2-17 |
| 2-263A | 2-17 | 2-14 | 2-12 |
| 2-264A | 2-17 | 2-12 | 2-12 |
| 2-265A | 2-5 | 2-1 | 2-18 |
| 2-266A | 2-4 | 2-29 | 2-4 |
| 2-267A | 2-4 | 2-31 | 2-4 |
| 2-268A | 2-4 | 2-33 | 2-4 |
| 2-269A | 2-4 | 2-35 | 2-4 |

In various embodiments, the second compound represented by Formula 2A or 2B may be represented by one selected from Formulae 2-201B to 2-215B, and rings $A_{21}$ and $A_{23}$ in Formulae 2-201B to 2-215B (e.g., each representing a compound represented by Formula 2B) may each be selected from the Formulae shown in Table 2.

**Table 2**

| Formula No. | Formula No. for ring $A_{21}$ | Formula No. for ring $A_{22}$ | Formula No. for ring $A_{23}$ |
|---|---|---|---|
| 2-201B | 2-4 | - | 2-19 |
| 2-202B | 2-4 | - | 2-22 |
| 2-203B | 2-4 | - | 2-18 |
| 2-204B | 2-4 | - | 2-23 |
| 2-205B | 2-4 | - | 2-21 |
| 2-206B | 2-4 | - | 2-20 |
| 2-207B | 2-5 | - | 2-23 |
| 2-208B | 2-7 | - | 2-23 |
| 2-209B | 2-4 | - | 2-26 |
| 2-210B | 2-7 | - | 2-22 |
| 2-211B | 2-13 | - | 2-16 |
| 2-212B | 2-5 | - | 2-19 |
| 2-213B | 2-7 | - | 2-20 |
| 2-214B | 2-19 | - | 2-18 |
| 2-215B | 2-18 | - | 2-18 |

In various embodiments, the second compound represented by Formula 2A or 2B may be represented by one selected from Formulae 2-301A to 2-421A, and rings $A_{21}$, $A_{22}$, and $A_{23}$ in Formulae 2-301A to 2-419A and 2-421A to 2-431A may each be selected from the Formulae shown in Table 3.

**Table 3**

| Formula No. | Formula No. for ring $A_{21}$ | Formula No. for ring $A_{22}$ | Formula No. for ring $A_{23}$ |
|---|---|---|---|
| 2-301A | 2-104 | 2-147 | 2-104 |
| 2-302A | 2-102 | 2-104 | 2-104 |
| 2-303A | 2-104 | 2-104 | 2-101 |
| 2-304A | 2-104 | 2-104 | 2-102 |
| 2-305A | 2-104 | 2-104 | 2-103 |
| 2-306A | 2-104 | 2-101 | 2-104 |
| 2-307A | 2-104 | 2-102 | 2-104 |
| 2-308A | 2-104 | 2-104 | 2-147 |
| 2-309A | 2-157 | 2-104 | 2-104 |
| 2-310A | 2-104 | 2-104 | 2-157 |
| 2-311A | 2-104 | 2-147 | 2-107 |
| 2-312A | 2-104 | 2-149 | 2-104 |
| 2-313A | 2-104 | 2-156 | 2-104 |
| 2-314A | 2-107 | 2-147 | 2-106 |
| 2-315A | 2-104 | 2-151 | 2-104 |
| 2-316A | 2-104 | 2-147 | 2-106 |
| 2-317A | 2-104 | 2-148 | 2-104 |
| 2-318A | 2-104 | 2-150 | 2-104 |

(continued)

| Formula No. | Formula No. for ring $A_{21}$ | Formula No. for ring $A_{22}$ | Formula No. for ring $A_{23}$ |
|---|---|---|---|
| 2-319A | 2-106 | 2-147 | 2-104 |
| 2-320A | 2-104 | 2-106 | 2-147 |
| 2-321A | 2-157 | 2-107 | 2-104 |
| 2-322A | 2-106 | 2-104 | 2-147 |
| 2-323A | 2-104 | 2-107 | 2-147 |
| 2-324A | 2-107 | 2-104 | 2-147 |
| 2-325A | 2-104 | 2-104 | 2-160 |
| 2-326A | 2-104 | 2-111 | 2-157 |
| 2-327A | 2-108 | 2-104 | 2-158 |
| 2-328A | 2-111 | 2-104 | 2-157 |
| 2-329A | 2-107 | 2-147 | 2-104 |
| 2-330A | 2-104 | 2-104 | 2-135 |
| 2-331A | 2-104 | 2-141 | 2-104 |
| 2-332A | 2-104 | 2-142 | 2-104 |
| 2-333A | 2-107 | 2-104 | 2-135 |
| 2-334A | 2-104 | 2-111 | 2-135 |
| 2-335A | 2-104 | 2-143 | 2-104 |
| 2-336A | 2-106 | 2-142 | 2-104 |
| 2-337A | 2-107 | 2-142 | 2-106 |
| 2-338A | 2-104 | 2-104 | 2-169 |
| 2-339A | 2-184 | 2-104 | 2-104 |
| 2-340A | 2-104 | 2-104 | 2-182 |
| 2-341A | 2-168 | 2-104 | 2-104 |
| 2-342A | 2-104 | 2-104 | 2-183 |
| 2-343A | 2-104 | 2-104 | 2-168 |
| 2-344A | 2-183 | 2-104 | 2-104 |
| 2-345A | 2-104 | 2-104 | 2-167 |
| 2-346A | 2-104 | 2-104 | 2-184 |
| 2-347A | 2-104 | 2-183 | 2-104 |
| 2-348A | 2-104 | 2-182 | 2-104 |
| 2-349A | 2-104 | 2-169 | 2-104 |
| 2-350A | 2-104 | 2-184 | 2-104 |
| 2-351A | 2-107 | 2-104 | 2-179 |
| 2-352A | 2-111 | 2-104 | 2-169 |
| 2-353A | 2-104 | 2-111 | 2-182 |
| 2-354A | 2-106 | 2-104 | 2-185 |
| 2-355A | 2-171 | 2-104 | 2-104 |
| 2-356A | 2-104 | 2-104 | 2-115 |

(continued)

| Formula No. | Formula No. for ring $A_{21}$ | Formula No. for ring $A_{22}$ | Formula No. for ring $A_{23}$ |
|---|---|---|---|
| 2-357A | 2-104 | 2-104 | 2-178 |
| 2-358A | 2-104 | 2-106 | 2-167 |
| 2-359A | 2-108 | 2-105 | 2-167 |
| 2-360A | 2-105 | 2-104 | 2-167 |
| 2-361A | 2-112 | 2-104 | 2-184 |
| 2-362A | 2-104 | 2-192 | 2-104 |
| 2-363A | 2-107 | 2-182 | 2-106 |
| 2-364A | 2-104 | 2-169 | 2-105 |
| 2-365A | 2-105 | 2-184 | 2-104 |
| 2-366A | 2-105 | 2-169 | 2-105 |
| 2-367A | 2-198 | 2-104 | 2-104 |
| 2-368A | 2-201 | 2-104 | 2-104 |
| 2-369A | 2-197 | 2-104 | 2-104 |
| 2-370A | 2-202 | 2-104 | 2-104 |
| 2-371A | 2-200 | 2-104 | 2-104 |
| 2-372A | 2-199 | 2-104 | 2-104 |
| 2-373A | 2-104 | 2-202 | 2-104 |
| 2-374A | 2-104 | 2-197 | 2-104 |
| 2-375A | 2-104 | 2-200 | 2-104 |
| 2-376A | 2-104 | 2-198 | 2-104 |
| 2-377A | 2-209 | 2-104 | 2-104 |
| 2-378A | 2-207 | 2-104 | 2-104 |
| 2-379A | 2-200 | 2-106 | 2-104 |
| 2-380A | 2-104 | 2-208 | 2-104 |
| 2-381A | 2-105 | 2-198 | 2-108 |
| 2-382A | 2-202 | 2-102 | 2-104 |
| 2-383A | 2-202 | 2-101 | 2-106 |
| 2-384A | 2-102 | 2-102 | 2-107 |
| 2-385A | 2-104 | 2-202 | 2-101 |
| 2-386A | 2-123 | 2-147 | 2-104 |
| 2-387A | 2-104 | 2-104 | 2-218 |
| 2-388A | 2-116 | 2-104 | 2-147 |
| 2-389A | 2-157 | 2-104 | 2-147 |
| 2-390A | 2-107 | 2-147 | 2-115 |
| 2-391A | 2-157 | 2-157 | 2-104 |
| 2-392A | 2-157 | 2-157 | 2-114 |
| 2-393A | 2-157 | 2-157 | 2-147 |
| 2-394A | 2-116 | 2-147 | 2-104 |

(continued)

| Formula No. | Formula No. for ring $A_{21}$ | Formula No. for ring $A_{22}$ | Formula No. for ring $A_{23}$ |
|---|---|---|---|
| 2-395A | 2-104 | 2-104 | 2-210 |
| 2-396A | 2-157 | 2-182 | 2-104 |
| 2-397A | 2-197 | 2-213 | 2-104 |
| 2-398A | 2-202 | 2-167 | 2-104 |
| 2-399A | 2-104 | 2-216 | 2-104 |
| 2-400A | 2-124 | 2-197 | 2-104 |
| 2-401A | 2-104 | 2-202 | 2-114 |
| 2-402A | 2-168 | 2-104 | 2-169 |
| 2-403A | 2-184 | 2-104 | 2-169 |
| 2-404A | 2-169 | 2-104 | 2-167 |
| 2-405A | 2-184 | 2-106 | 2-167 |
| 2-406A | 2-169 | 2-183 | 2-102 |
| 2-407A | 2-184 | 2-114 | 2-169 |
| 2-408A | 2-184 | 2-168 | 2-184 |
| 2-409A | 2-184 | 2-104 | 2-167 |
| 2-410A | 2-184 | 2-167 | 2-167 |
| 2-411A | 2-114 | 2-101 | 2-197 |
| 2-412A | 2-104 | 2-149 | 2-104 |
| 2-413A | 2-106 | 2-104 | 2-147 |
| 2-414A | 2-104 | 2-104 | 2-168 |
| 2-415A | 2-200 | 2-106 | 2-104 |
| 2-416A | 2-104 | 2-104 | 2-183 |
| 2-417A | 2-104 | 2-104 | 2-101 |
| 2-418A | 2-105 | 2-169 | 2-105 |
| 2-419A | 2-104 | 2-147 | 2-107 |
| 2-421A | 2-104 | 2-218 | 2-104 |
| 2-422A | 2-104 | 2-226 | 2-104 |
| 2-423A | 2-104 | 2-222 | 2-104 |
| 2-424A | 2-104 | 2-228 | 2-104 |
| 2-425A | 2-104 | 2-151 | 2-104 |
| 2-426A | 2-106 | 2-147 | 2-107 |
| 2-427A | 2-104 | 2-147 | 2-106 |
| 2-428A | 2-107 | 2-150 | 2-104 |
| 2-429A | 2-104 | 2-143 | 2-104 |
| 2-430A | 2-107 | 2-142 | 2-106 |
| 2-431A | 2-104 | 2-142 | 2-104 |

In various embodiments, the second compound represented by Formula 2A or 2B may be represented by one

selected from Formulae 2-301B to 2-320B, and rings $A_{21}$ and $A_{23}$ in Formulae 2-301B to 2-320B (e.g., each representing a compound represented by Formula 2B) may each be selected from the Formulae shown in Table 4.

Table 4

| Formula No. | Formula No. for ring $A_{21}$ | Formula No. for ring $A_{22}$ | Formula No. for ring $A_{23}$ |
|---|---|---|---|
| 2-301B | 2-104 | - | 2-198 |
| 2-302B | 2-104 | - | 2-201 |
| 2-303B | 2-104 | - | 2-197 |
| 2-304B | 2-104 | - | 2-202 |
| 2-305B | 2-104 | - | 2-200 |
| 2-306B | 2-104 | - | 2-199 |
| 2-307B | 2-104 | - | 2-203 |
| 2-308B | 2-104 | - | 2-204 |
| 2-309B | 2-106 | - | 2-205 |
| 2-310B | 2-104 | - | 2-206 |
| 2-311B | 2-112 | - | 2-199 |
| 2-312B | 2-114 | - | 2-202 |
| 2-313B | 2-116 | - | 2-202 |
| 2-314B | 2-104 | - | 2-214 |
| 2-315B | 2-130 | - | 2-201 |
| 2-316B | 2-168 | - | 2-183 |
| 2-317B | 2-114 | - | 2-198 |
| 2-318B | 2-116 | - | 2-199 |
| 2-319B | 2-198 | - | 2-197 |
| 2-320B | 2-197 | - | 2-197 |

$X_1$ in Formula 1 is selected from $N[(L_3)_{a3}-(Ar_3)_{c3}]$, $Si(R_3)(R_4)$, O, S, and Se. For example, $X_1$ in Formula 1 may be selected from $N[(L_3)_{a3}-(Ar_3)c_3]$, O, and S.

$X_{21}$ in Formulae 2A and 2B is selected from O, S, Se, $C(R_{23})(R_{24})$, $Si(R_{23})(R_{24})$, and $N-[(L_{21})_{a21}(R_{21})_{b21}]$.

In various embodiments, $X_{21}$ in Formulae 2A and 2B may be $N[(L_{21})_{a21}(R_{21})_{b21}]$.

In various embodiments, $X_{21}$ in Formulae 2A and 2B may be O, S, Se, $C(R_{23})(R_{24})$, or $Si(R_{23})(R_{24})$, and at least one selected from $A_{21}$, $A_{22}$, and $A_{23}$ in Formula 2A and at least one selected from rings $A_{21}$ and $A_{23}$ in Formula 2B may each independently be selected from groups represented by Formulae 2-1 to 2-3, 2-10 to 2-27, and 2-33 to 2-36, and $X_{22}$ or $X_{23}$ in Formulae 2-1 to 2-3, 2-10 to 2-27, and 2-33 to 2-36 may be $N-[(L_{22})_{a22}-(R_{22})_{b22}]$.

In various embodiments, $X_{21}$ in Formulae 2A and 2B may be O, S, Se, $C(R_{23})(R_{24})$, or $Si(R_{23})(R_{24})$, and at least one selected from rings $A_{21}$, $A_{22}$, and $A_{23}$ in Formula 2A and at least one selected from rings $A_{21}$ and $A_{23}$ in Formula 2B may each independently be selected from groups represented by Formulae 2-101 to 2-103, 2-147 to 2-211, 2-214 to 2-219, and 2-226 to 2-229, and $X_{22}$ or $X_{23}$ in Formulae 2-101 to 2-103, 2-147 to 2-211, 2-214 to 2-219, and 2-226 to 2-229 may be $N-[(L_{22})_{a22}-(R_{22})_{b22}]$, but embodiments of the present disclosure are not limited thereto.

$X_{21}$ in Formulae 2A and 2B is O, S, Se, $C(R_{23})(R_{24})$, $Si(R_{23})(R_{24})$, or $N-[(L_{21})_{a21}--(R_{21})_{b21}]$, and $X_{22}$ and $X_{23}$ is each independently O, S, Se, $C(R_{25})(R_{26})$, $Si(R_{25})(R_{26})$, or $N-[(L_{22})_{a22}-(R_{22})_{b22}]$. $L_{21}$, $L_{22}$, a21, a22, $R_{21}$ to $R_{26}$, b21, and b22 are the same as described below.

$L_1$ to $L_3$, $L_{21}$, and $L_{22}$ in Formulae 1, 2A, and 2B are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed C8-C60polycyclic group, and a substituted or unsubstituted divalent non-aromatic condensed 8- to 60-membered heteropolycyclic group.

In some embodiments, $L_1$ to $L_3$, $L_{21}$, and $L_{22}$ in Formulae 1, 2A, and 2B may each independently be selected from the group consisting of:

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a $C_1C_{20}$ alkyl group, a $C_1$-$C_{20}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed C8-C60polycyclic group, a monovalent non-aromatic condensed 8- to 60-membered heteropolycyclic group, a biphenyl group, a terphenyl group, $-Si(Q_{31})(Q_{32})(Q_{33})$, $-N(Q_{31})(Q_{32})$, $-B(Q_{31})(Q_{32})$,$-C(=O)(Q_{31})$, $-S(=O)_2(Q_{31})$, and $-P(=O)(Q_{31})(Q_{32})$,

wherein $Q_{31}$ to $Q_{33}$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and

a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group, but embodiments of the present disclosure are not limited thereto.

In various embodiments, $L_1$ to $L_3$, $L_{21}$, and $L_{22}$ in Formulae 1, 2A, and 2B may each independently be selected from groups represented by Formulae 3-1 to 3-99, but embodiments of the present disclosure are not limited thereto:

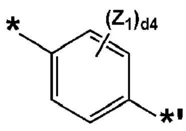
Formula 3-1

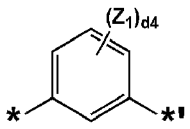
Formula 3-2

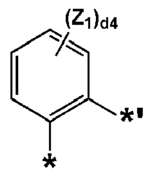
Formula 3-3

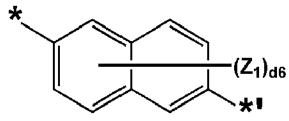
Formula 3-4

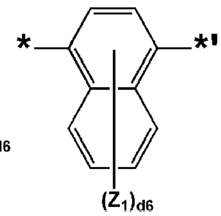
Formula 3-5

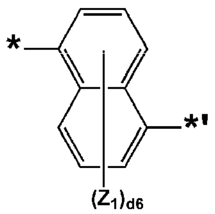
Formula 3-6

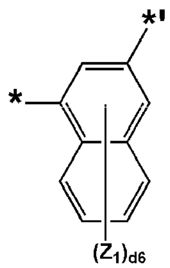
Formula 3-7

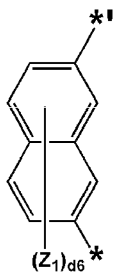
Formula 3-8

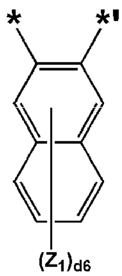
Formula 3-9

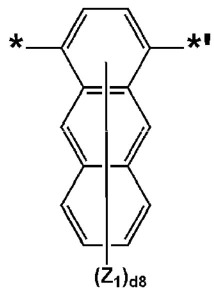
Formula 3-10

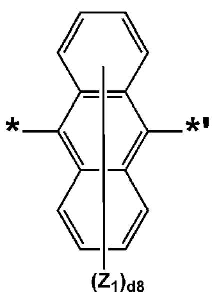
Formula 3-11

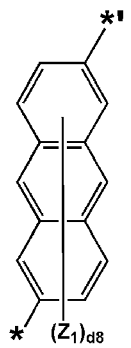
Formula 3-12

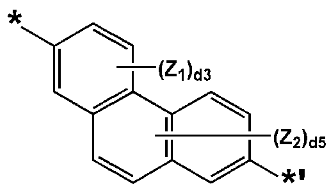
Formula 3-13

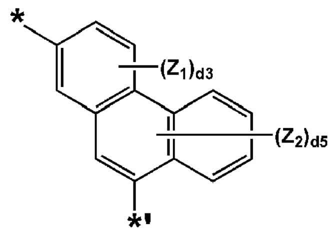
Formula 3-14

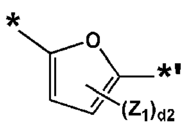
Formula 3-15

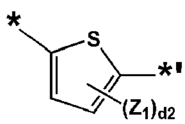
Formula 3-16

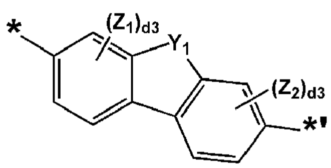
Formula 3-17

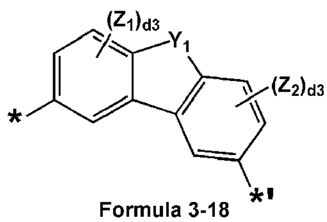
Formula 3-18

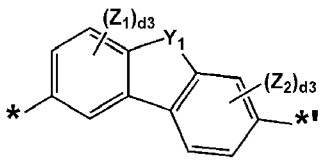
Formula 3-19

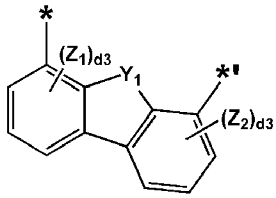
Formula 3-20

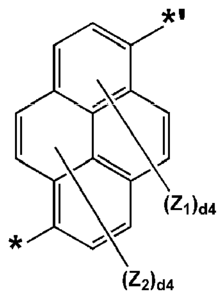
Formula 3-21

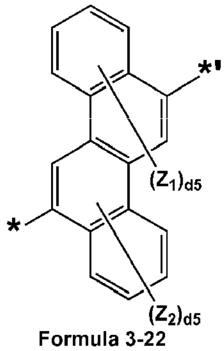
Formula 3-22

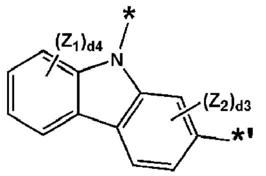
Formula 3-23

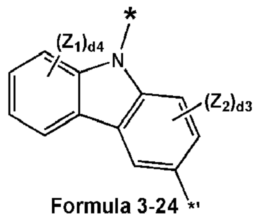
Formula 3-24

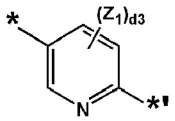
Formula 3-25

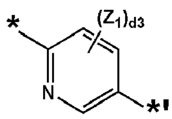
Formula 3-26

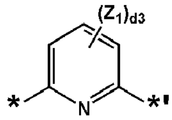
Formula 3-27

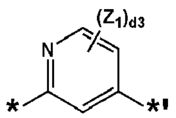
Formula 3-28

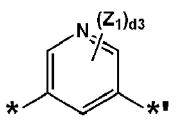
Formula 3-29

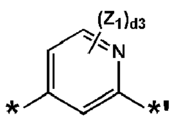
Formula 3-30

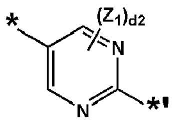
Formula 3-31

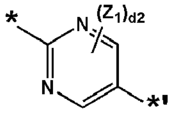
Formula 3-32

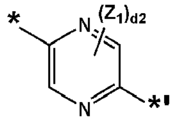
Formula 3-33

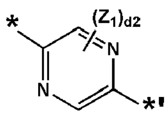
Formula 3-34

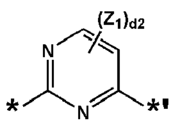
Formula 3-35

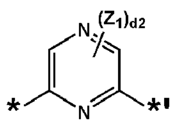
Formula 3-36

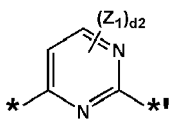
Formula 3-37

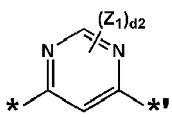
Formula 3-38

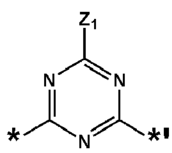
Formula 3-39

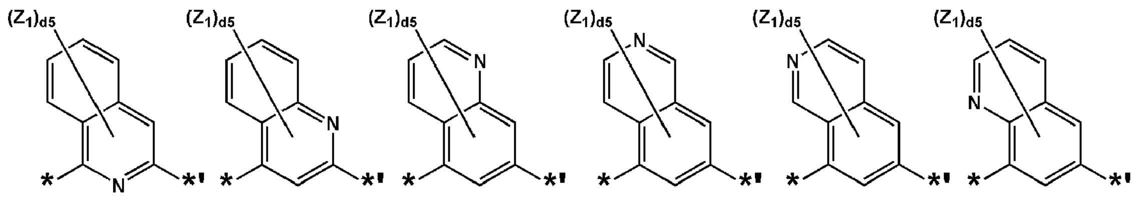
Formula 3-40 Formula 3-41 Formula 3-42 Formula 3-43 Formula 3-44 Formula 3-45

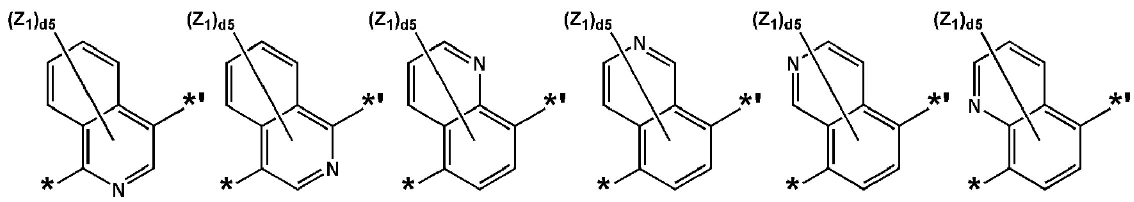
Formula 3-46 Formula 3-47 Formula 3-48 Formula 3-49 Formula 3-50 Formula 3-51

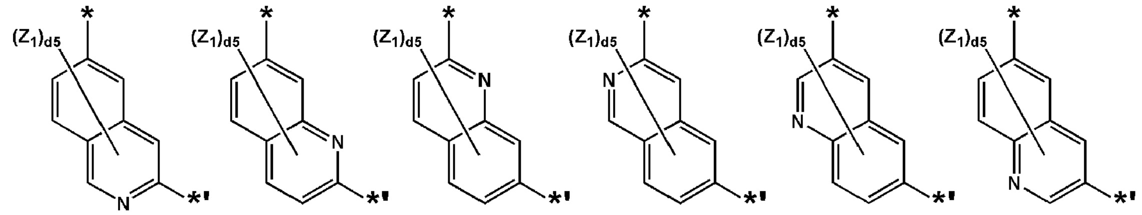

Formula 3-52 Formula 3-53 Formula 3-54 Formula 3-55 Formula 3-56 Formula 3-57

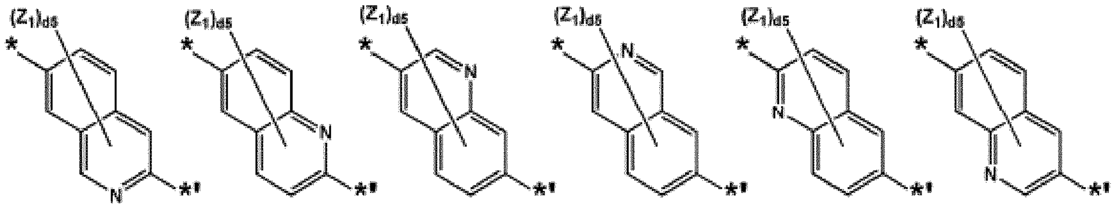

Formula 3-58 Formula 3-59 Formula 3-60 Formula 3-61 Formula 3-62 Formula 3-63

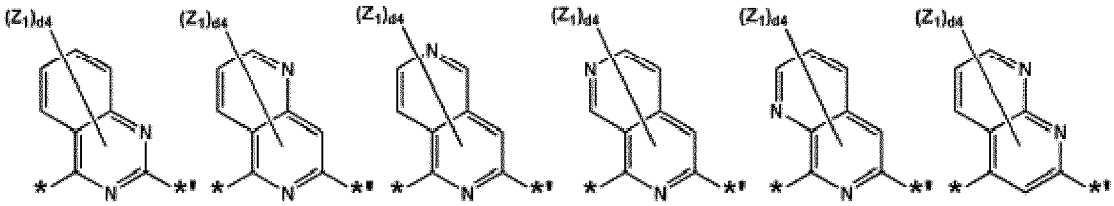

Formula 3-64 Formula 3-65 Formula 3-66 Formula 3-67 Formula 3-68 Formula 3-69

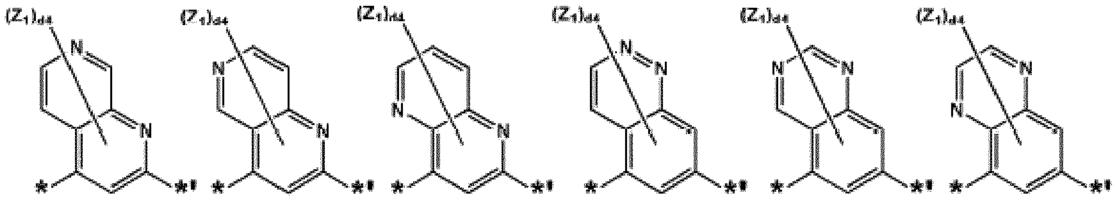

Formula 3-70 Formula 3-71 Formula 3-72 Formula 3-73 Formula 3-74 Formula 3-75

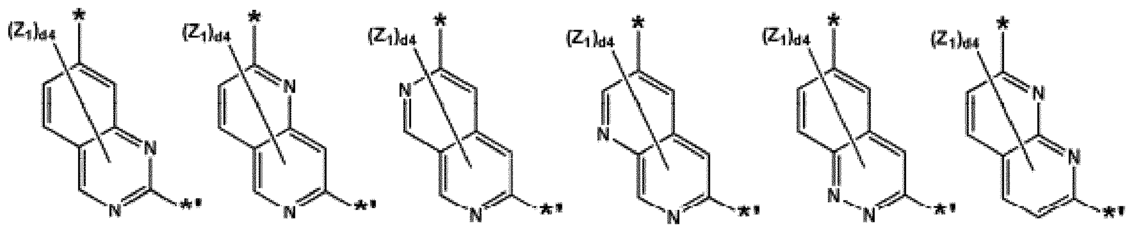

Formula 3-76 Formula 3-77 Formula 3-78 Formula 3-79 Formula 3-80 Formula 3-81

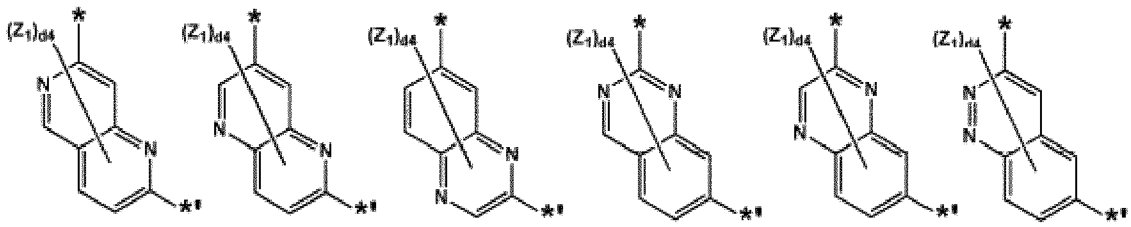

Formula 3-82 Formula 3-83 Formula 3-84 Formula 3-85 Formula 3-86 Formula 3-87

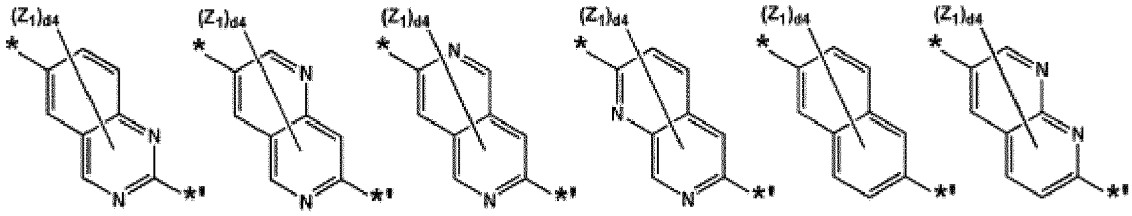

Formula 3-88 Formula 3-89 Formula 3-90 Formula 3-91 Formula 3-92 Formula 3-93

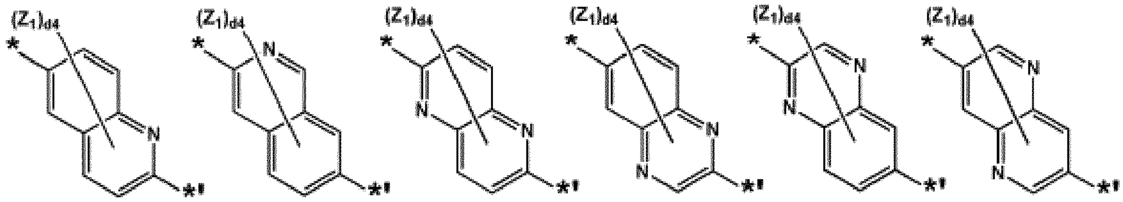

Formula 3-94 Formula 3-95 Formula 3-96 Formula 3-97 Formula 3-98 Formula 3-99

.

In Formula 3-1 to 3-99, $Y_1$ may be O, S, $C(Z_3)(Z_4)$, $N(Z_5)$, or $Si(Z_6)(Z_7)$,

$Z_1$ to $Z_7$ may each independently be selected from hydrogen, deuterium, -F, -Cl,-Br, -I, a hydroxyl group, a cyano group, a nitro group, an amidino group, a hydrazino group, a hydrazono group, a $C_1C_{20}$ alkyl group, a $C_1C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group,$-Si(Q_{31})(Q_{32})(Q_{33})$, $-N(Q_{31})(Q_{32})$O $-B(Q_{31})(Q_{32})$, $-C(=O)(Q_{31})$, $-S(=O)_2(Q_{31})$, and$-P(=O)(Q_{31})(Q_{32})$,

wherein $Q_{31}$ to $Q_{33}$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and

a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group,

$d_2$ may be an integer selected from 0 to 2,

$d_3$ may be an integer selected from 0 to 3,

$d_4$ may be an integer selected from 0 to 4,

$d_5$ may be an integer selected from 0 to 5,

d6 may be an integer selected from 0 to 6,

d8 may be an integer selected from 0 to 8, and

* and *' each indicate a binding site to a neighboring atom.

In Formulae 1, 2A, and 2B, a1, a2, $a_3$, a21, and a22 indicate the number of $L_1$(s), the number of $L_2$(s), the number of $L_3$(s), the number of $L_{21}$(s), and the number of $L_{22}$(s), respectively. In Formulae 1, 2A, and 2B, a1 to $a_3$, a2i,

and a22 may each independently be an integer selected from 0 to 5. When a1 is two or more, two or more $L_1$(s) may be identical to or different from each other. When a2 is two or more, two or more $L_2$(s) may be identical to or different from each other. When $a_3$ is two or more, two or more $L_3$(s) may be identical to or different from each other. When a2i is two or more, two or more $L_{21}$(s) may be identical to or different from each other. When a22 is two or more, two or more $L_{22}$(s) may be identical to or different from each other. When ai is zero, *-$(L_i)_{a1}$-*' may be a single bond. When a2 is zero, *-$(L_2)_{a2}$-*' may be a single bond. When $a_3$ is zero, *-$(L_3)_{a3}$-*' may be a single bond. When a21 is zero, *-$(L_{21})_{a21}$-*' may be a single bond. When a22 is zero, *-$(L_{22})_{a22}$-*' may be a single bond. In any single incidence of a group *-[$(L_1)_{a1}$-$(Ar_1)$c$_1$], in some embodiments, when a1 is zero, c1 is 1. In any single incidence of a group *-[$(L_2)_{a2}$-$(Ar_2)_{c2}$], in some embodiments, when a2 is zero, c2 is 1. In any single incidence of a group *-$(L_3)_{a3}$-$(Ar_3)_{c3}$, in some embodiments, when $a_3$ is zero, $c_3$ is 1. In any single incidence of a group *-[$(L_{21})_{a21}$-$(R_{21})_{b21}$], in some embodiments, when a2i is zero, $b_{21}$ is 1. In any single incidence of a group *-[$(L_{22})_{a22}$-$(R_{22})_{b22}$],in some embodiments, when a22 is zero, $b_{22}$ is 1.

In various embodiments, ai to $a_3$, a2i, and a22 in Formulae 1 and 2 may each independently be an integer selected from 0 to 3, but embodiments of the present disclosure are not limited thereto.

$Ar_1$ to $Ar_3$ in Formula 1 are each independently selected from a substituted or unsubstituted $C_1$-$C_{60}$ alkyl group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed $C_8$-$C_{60}$ polycyclic group, a substituted or unsubstituted monovalent non-aromatic condensed 8- to 6o-membered heteropolycyclic group, -Si($Q_1$)($Q_2$)($Q_3$), -N($Q_1$)($Q_2$), -B($Q_1$)($Q_2$), -C(=O)($Q_1$),-S(=O)$_2$($Q_1$), and -P(=O)($Q_1$)($Q_2$).

In some embodiments, in Formula 1, $Ar_1$ to $Ar_3$ may each independently be selected from the group consisting of:

a group represented by any of Formulae 1-1 and 1-2, a $C_1$-$C_{20}$ alkyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si($Q_1$)($Q_2$)($Q_3$), -N($Q_1$)($Q_2$),-B($Q_1$)($Q_2$), -C(=O)($Q_1$), -S(=O)$_2$($Q_1$), and -P(=O)($Q_1$)($Q_2$); and

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium,-F, -Cl, -Br, -I, a hydroxyl group, a cyano group, a nitro group, an amidino group, a hydrazino group, a hydrazono group, a $C_1$-$C_{10}$ alkyl group, a $C_1$-$C_{10}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl

group, a $C_6$-$C_{60}$ aryl group, a $C_1$-$C_{60}$ heteroaryl group, a monovalent non-aromatic condensed $C_8$-$C_{60}$ polycyclic group, a monovalent non-aromatic condensed 8- to 60-membered heteropolycyclic group, a biphenyl group, a terphenyl group, -Si($Q_{31}$)($Q_{32}$)($Q_{33}$), -N($Q_{31}$)($Q_{32}$), -B($Q_{31}$)($Q_{32}$), -C(=O)($Q_{31}$),-S(=O)$_2$($Q_{31}$), and -P(=O)($Q_{3,}$)($Q_{32}$), and

In some embodiments, $R_1$ to $R_4$, $R_{21}$ to $R_{24}$, $R_{27}$, and $R_{28}$ may each independently be selected from the group conssiting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si($Q_4$)($Q_5$)($Q_6$), -N($Q_4$)($Q_5$), -B($Q_4$)($Q_5$), -C(=O)($Q_4$), - S(=O)$_2$($Q_4$), and -P(=O)($Q_4$)($Q_5$); and

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium,-F, -Cl, -Br, -I, a hydroxyl group, a cyano group, a nitro group, an amidino group, a hydrazino group, a hydrazono group, a $C_1$-$C_{10}$ alkyl group, a $C_1$-$C_{10}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed $C_8$-$C_{60}$ polycyclic group, a monovalent non-aromatic condensed 8- to 6o-membered heteropolycyclic group, a biphenyl group, a terphenyl group, -Si($Q_{31}$)($Q_{32}$)($Q_{33}$), -N($Q_{31}$)($Q_{32}$), -B($Q_{31}$)($Q_{32}$), -C(=O)($Q_{31}$),-S(=O)$_2$($Q_{31}$), and -P(=O)($Q_{31}$)($Q_{32}$), wherein $Q_1$to $Q_6$ and $Q_{31}$ to $Q_{33}$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and

a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group:

**Formula 1-1** **Formula 1-2**

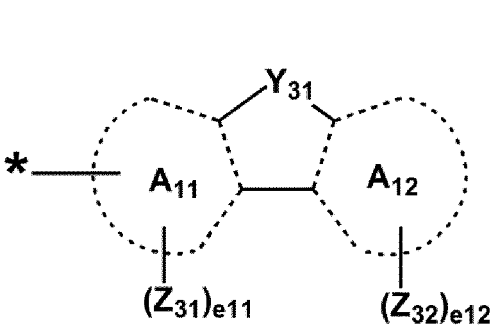

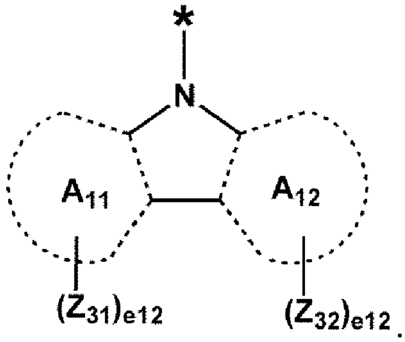

In Formulae 1-1 and 1-2,

$A_{11}$ and $A_{12}$ may each independently be selected from a cyclohexene group, a benzene group, a naphthalene group, a phenanthrene group, an anthracene group, a triphenylene group, a pyrene group, a carbazole group, a fluorene group, a spiro-bifluorene group, a pyridine group, a pyrazine group, a pyrimidine group, a pyridazine group, a quinoline group, an isoquinoline group, a quinoxaline group, a quinazoline group, a triazine group, an indene group, a benzofuran group, a benzothiophene group, a dibenzofuran group, and a dibenzothiophene group,
$Y_{31}$ may be selected from $N[(L_{11})a_{11}-(Z_{33})_{e13}]$, $C(Z_{34})(Z_{35})$, $Si(Z_{34})(Z_{35})$, O, S, and Se,
$L_{11}$ may be the same as described above in connection with $L_1$ in Formula 1,
a11 may be the same as described above in connection with a1,
$Z_{31}$ to $Z_{35}$ may each independently be selected from the group consisting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a quinolinyl group, an isoquinolinyl group, a benzoquinolinyl group, a quinoxalinyl group, a quinazolinyl group, a benzoimidazolyl group, an isobenzothiazolyl group, a benzoxazolyl group, an isobenzoxazolyl group, an oxadiazolyl group, and a triazinyl group; and

$$-Si(Q_{31})(Q_{32})(Q_{33}),$$

e11 and e12 may each independently be an integer selected from 1 to 10,
e13 may be an integer selected from 1 to 3,
$Q_{31}$ to $Q_{33}$ are the same as described above, and
* indicates a binding site to a neighboring atom.

For example, rings $A_{11}$ and $A_{12}$ in Formulae 1-1 and 1-2 may each independently be selected from a benzene group, a naphthalene group, and a pyridine group.
$X_1$ may be $N[(L_3)_{a3}-(Ar_3)c_3]$, and at least one selected from $A_{r1}$ to $A_{r3}$ may be a group represented by Formula 1-1 or 1-2.
In various embodiments, in Formula 1, $X_1$ may be O, S, or Se, and at least one selected from $Ar_1$ and $Ar_2$ may be a group represented by Formula 1-1 or 1-2.
In various embodiments, $Ar_1$ to $Ar_3$ in Formula 1 may each independently be selected from groups represented by Formulae 1-1 and 1-2, a $C_1$-$C_{20}$ alkyl group, groups represented by Formulae 5-1 to 5-45 and 6-1 to 6-124, and $-Si(Q_1)(Q_2)(Q_3)$:

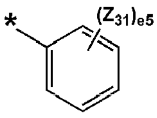

Formula 5-1

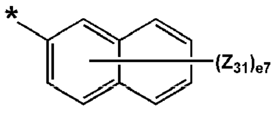

Formula 5-2

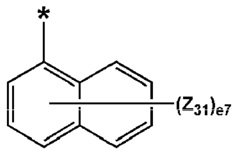

Formula 5-3

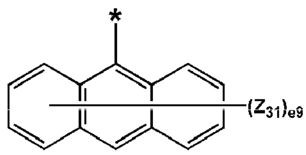

Formula 5-4

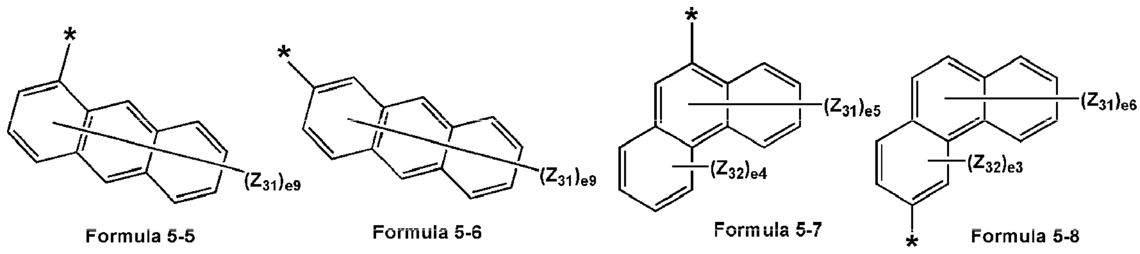

Formula 5-5

Formula 5-6

Formula 5-7

Formula 5-8

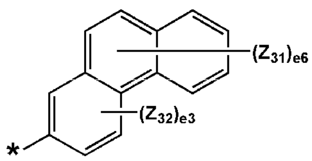

Formula 5-9

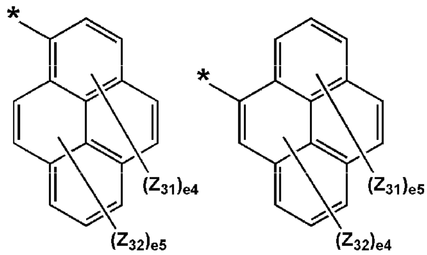

Formula 5-10

Formula 5-11

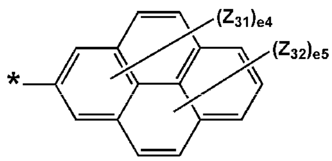

Formula 5-12

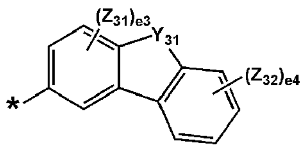

Formula 5-13

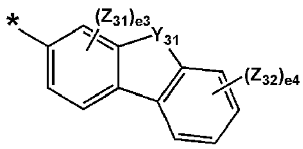

Formula 5-14

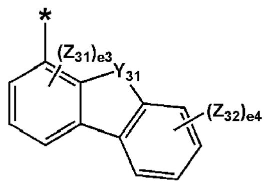

Formula 5-15

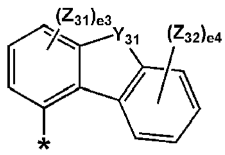

Formula 5-16

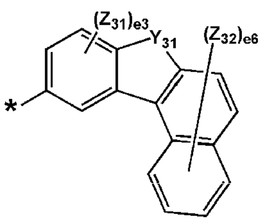

Formula 5-17

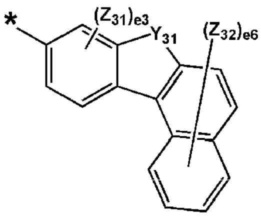

Formula 5-18

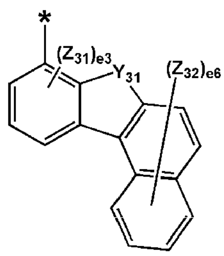

Formula 5-19

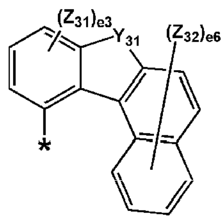

Formula 5-20

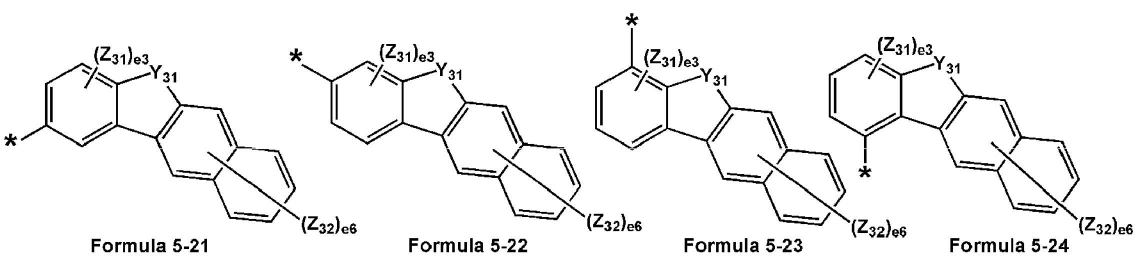

Formula 5-21

Formula 5-22

Formula 5-23

Formula 5-24

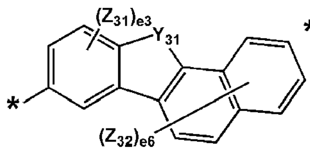

Formula 5-25

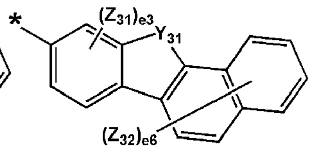

Formula 5-26

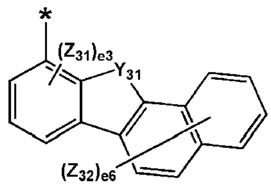

Formula 5-27

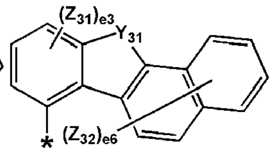

Formula 5-28

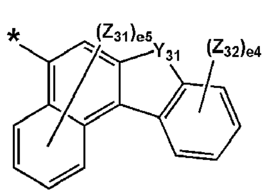

Formula 5-29

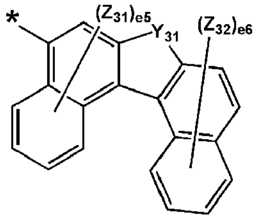

Formula 5-30

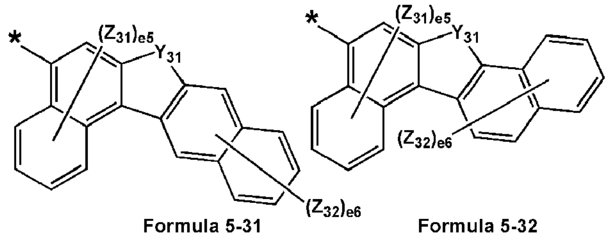

Formula 5-31

Formula 5-32

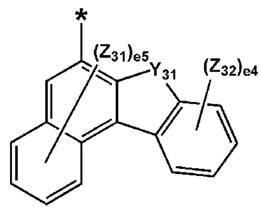

Formula 5-33

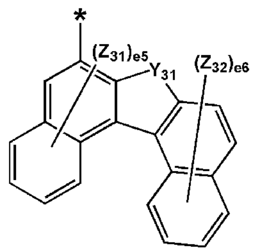

Formula 5-34

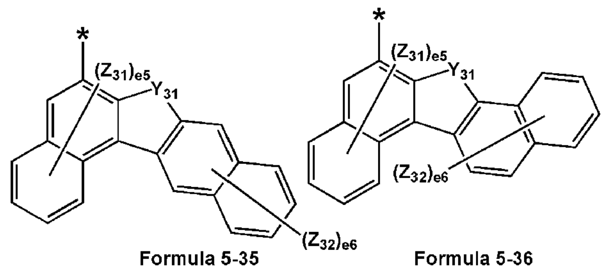

Formula 5-35

Formula 5-36

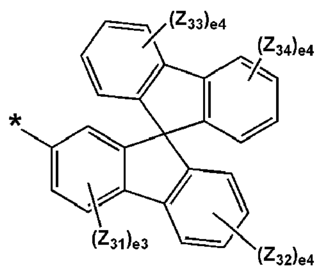

Formula 5-37

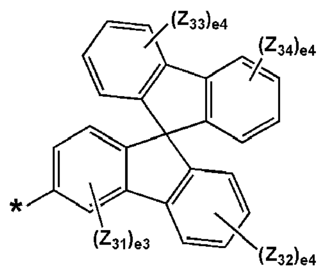

Formula 5-38

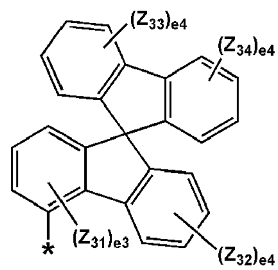

Formula 5-39

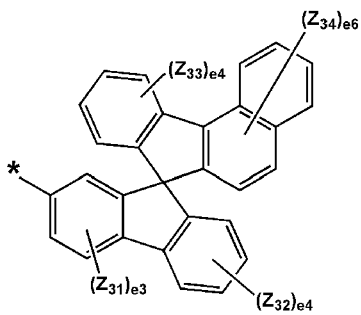

Formula 5-40

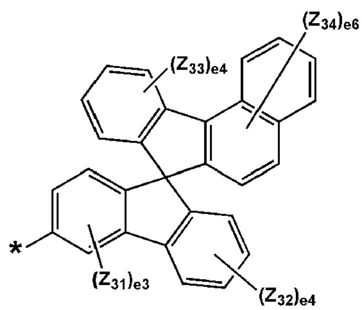

Formula 5-41

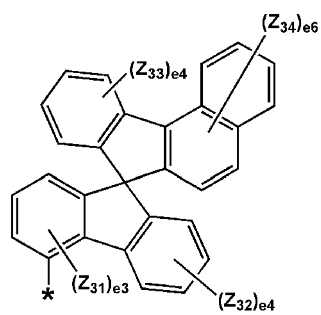

Formula 5-42

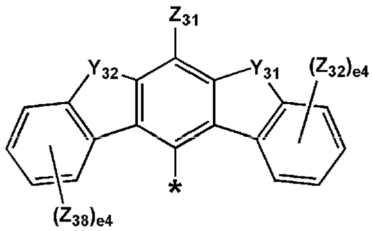

Formula 5-43

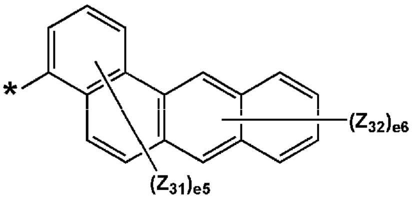

Formula 5-44

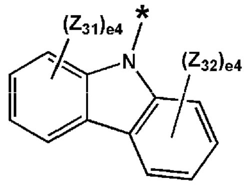

Formula 5-45

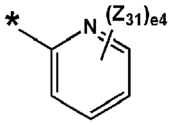

Formula 6-1

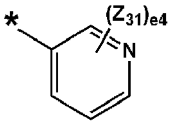

Formula 6-2

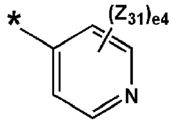

Formula 6-3

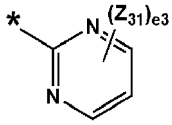

Formula 6-4

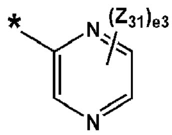

Formula 6-5

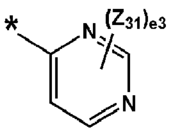

Formula 6-6

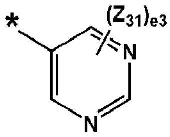

Formula 6-7

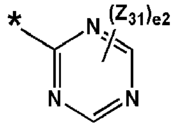

Formula 6-8

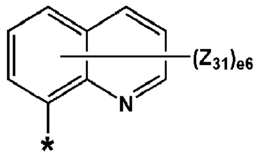

Formula 6-9

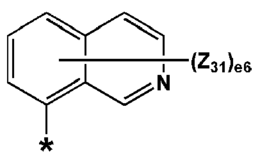

Formula 6-10

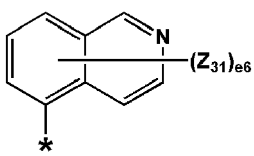

Formula 6-11

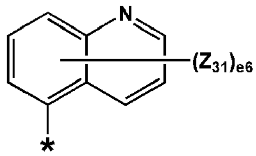

Formula 6-12

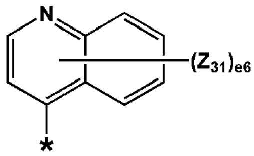

Formula 6-13

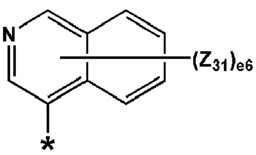

Formula6-14

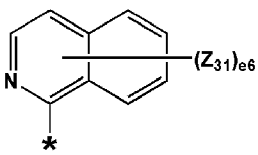

Formula 6-15

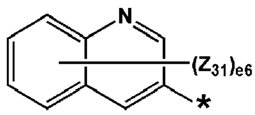

Formula 6-16

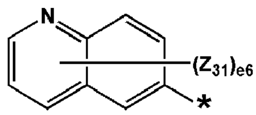

Formula 6-17

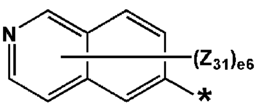

Formula 6-18

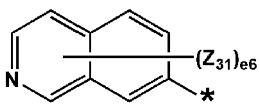

Formula 6-19

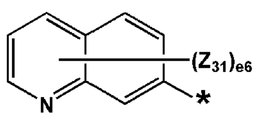

Formula 6-20

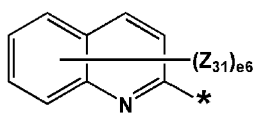

Formula 6-21

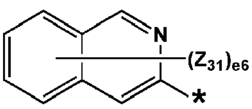

Formula 6-22

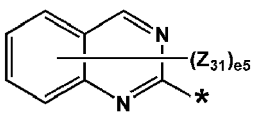

Formula 6-23

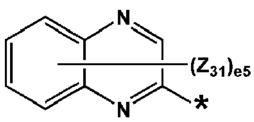

Formula 6-24

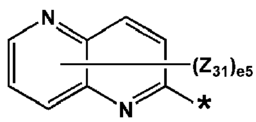

Formula 6-25

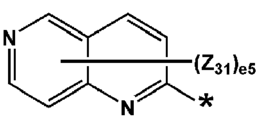

Formula 6-26

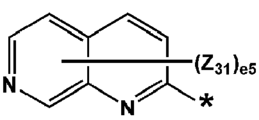

Formula 6-27

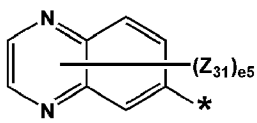

Formula 6-28

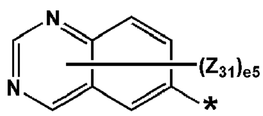

Formula 6-29

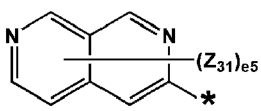
Formula 6-30

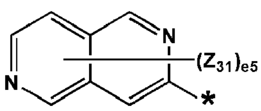
Formula 6-31

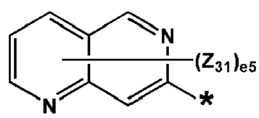
Formula 6-32

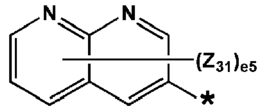
Formula 6-33

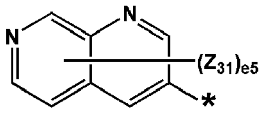
Formula 6-34

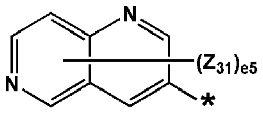
Formula 6-35

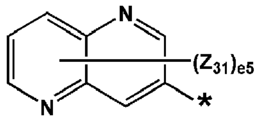
Formula 6-36

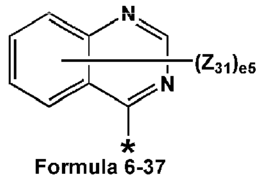
Formula 6-37

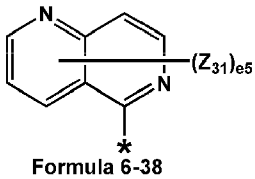
Formula 6-38

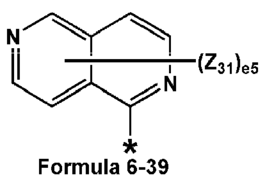
Formula 6-39

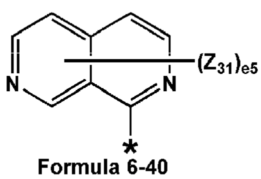
Formula 6-40

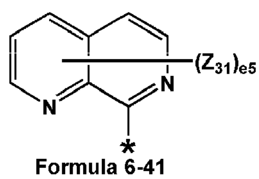
Formula 6-41

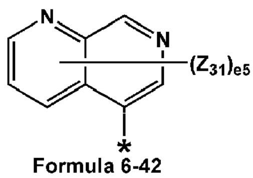
Formula 6-42

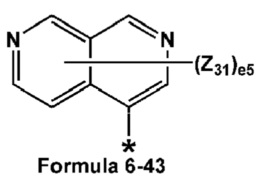
Formula 6-43

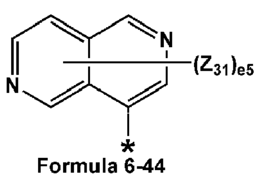
Formula 6-44

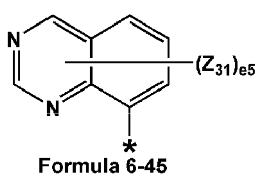
Formula 6-45

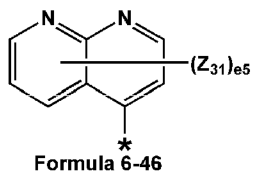
Formula 6-46

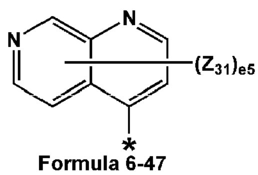
Formula 6-47

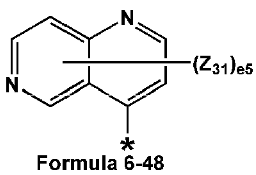
Formula 6-48

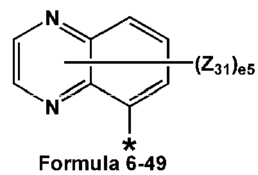
Formula 6-49

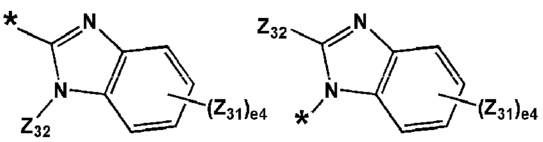
Formula 6-50

Formula 6-51

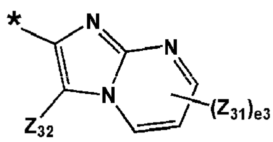
Formula 6-52

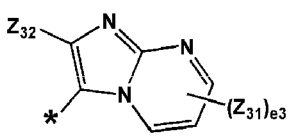
Formula 6-53

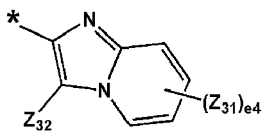
Formula 6-54

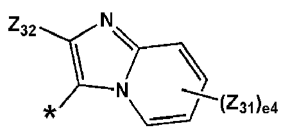
Formula 6-55

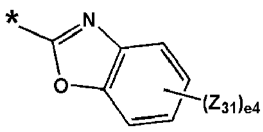
Formula 6-56

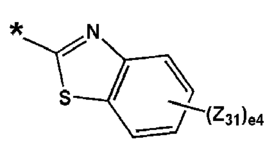
Formula 6-57

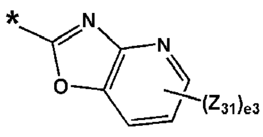
Formula 6-58

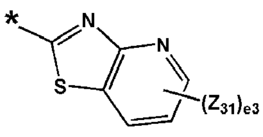
Formula 6-59

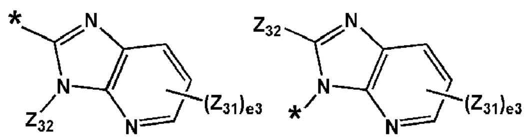
Formula 6-60

Formula 6-61

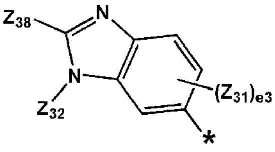
Formula 6-62

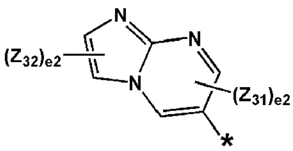
Formula 6-63

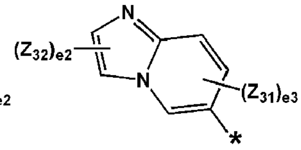
Formula 6-64

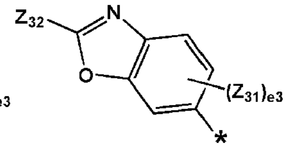
Formula 6-65

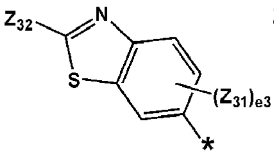
Formula 6-66

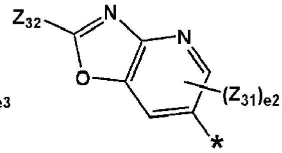
Formula 6-67

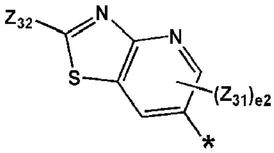
Formula 6-68

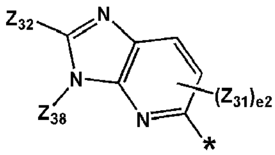
Formula 6-69

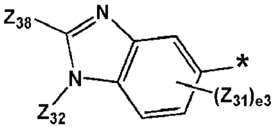
Formula 6-70

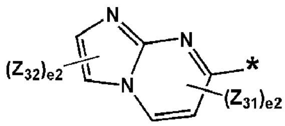
Formula 6-71

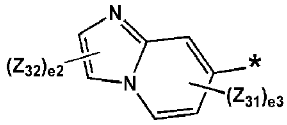
Formula 6-72

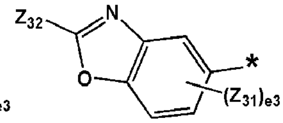
Formula 6-73

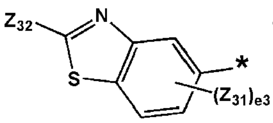
Formula 6-74

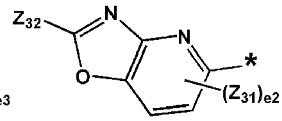
Formula 6-75

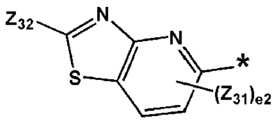
Formula 6-76

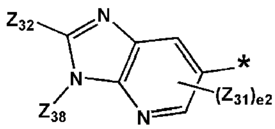
Formula 6-77

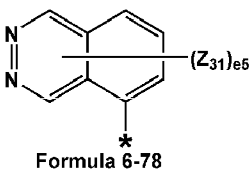
Formula 6-78

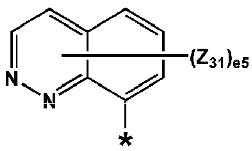
Formula 6-79

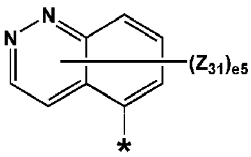
Formula 6-80

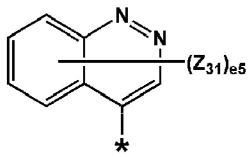
Formula 6-81

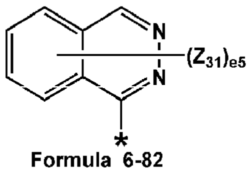
Formula 6-82

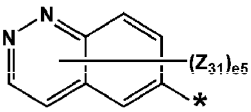
Formula 6-83

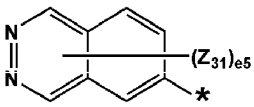
Formula 6-84

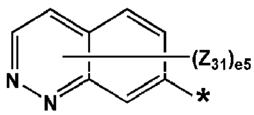
Formula 6-85

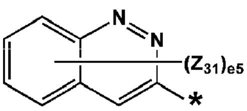
Formula 6-86

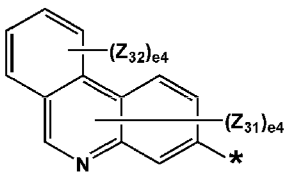
Formula 6-87

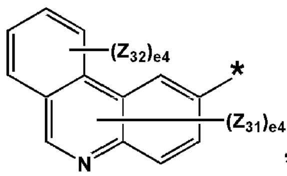
Formula 6-88

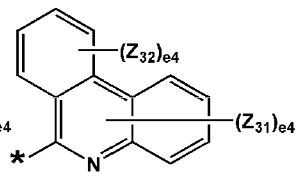
Formula 6-89

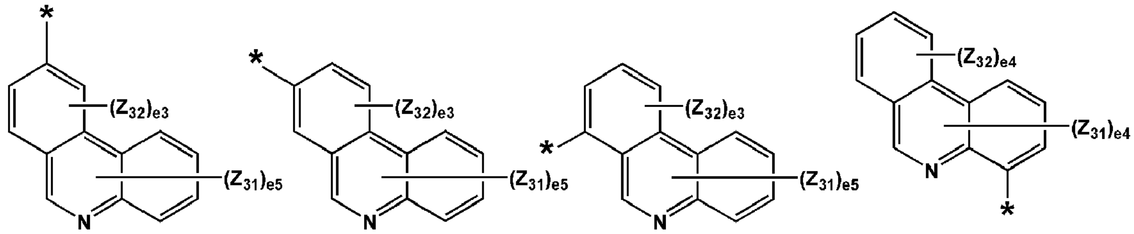

Formula 6-90 Formula 6-91 Formula 6-92 Formula 6-93

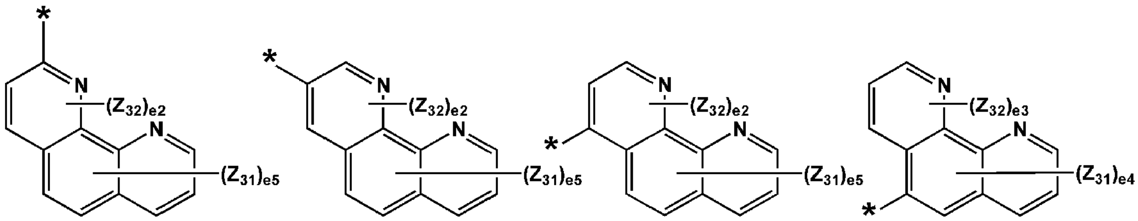

Formula 6-94 Formula 6-95 Formula 6-96 Formula 6-97

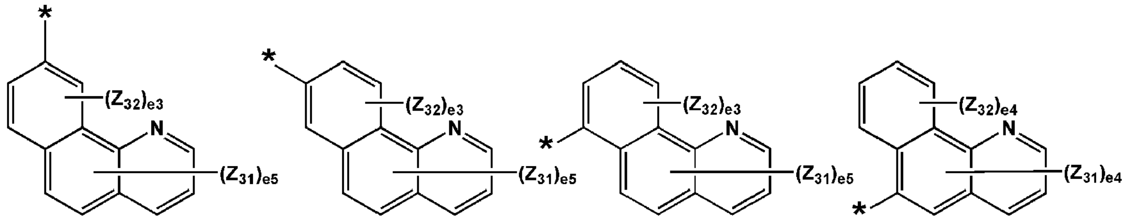

Formula 6-98 Formula 6-99 Formula 6-100 Formula 6-101

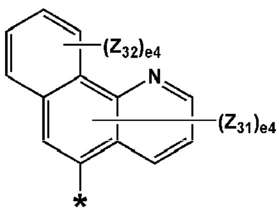

Formula 6-102

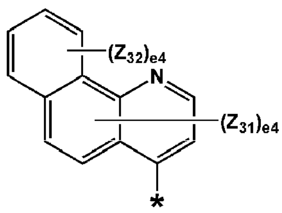

Formula 6-103

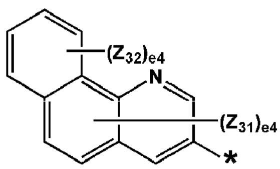

Formula 6-104

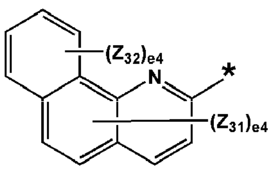

Formula 6-105

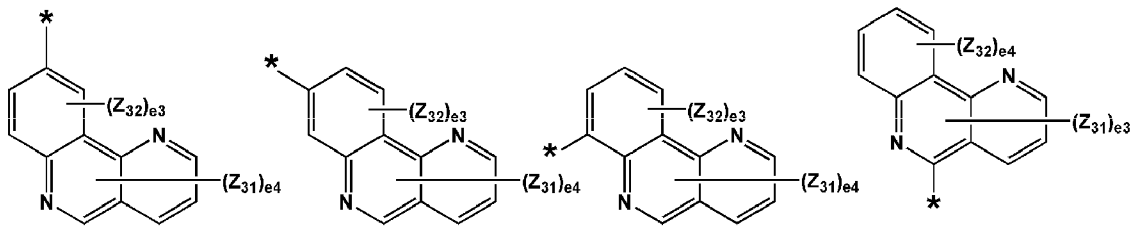

Formula 6-106 Formula 6-107 Formula 6-108 Formula 6-109

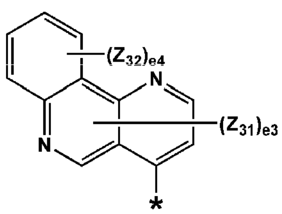

Formula 6-110

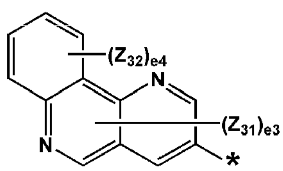

Formula 6-111

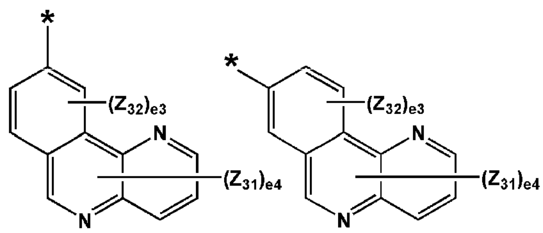

Formula 6-112 Formula 6-113

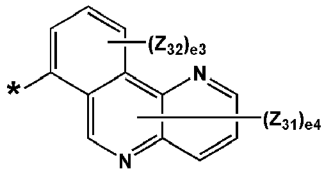

Formula 6-114

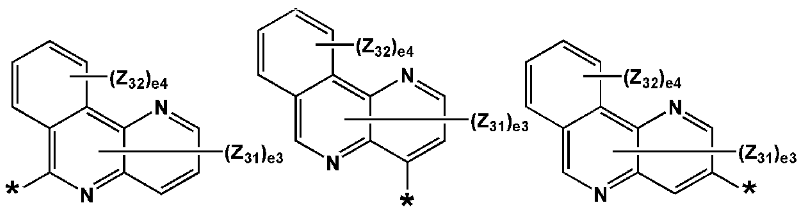

Formula 6-115 Formula 6-116 Formula 6-117

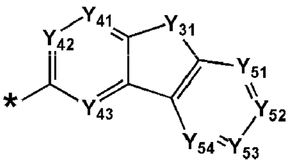

Formula 6-118

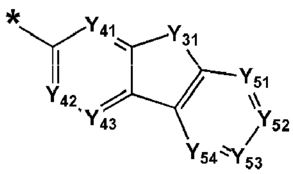

Formula 6-119

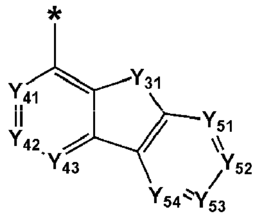

Formula 6-120

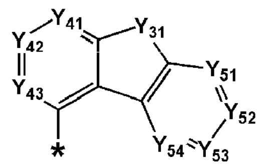

Formula 6-121

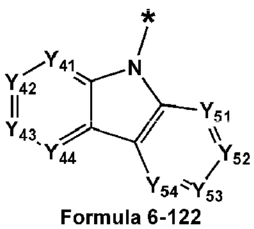

Formula 6-122

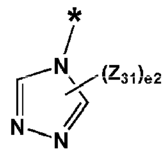

Formula 6-123

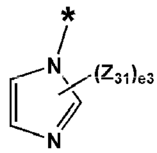

Formula 6-124

In Formulae 5-1 to 5-45 and 6-1 to 6-124,

$Y_{31}$ and $Y_{32}$ may each independently be O, S, $C(Z_{33})(Z_{34})$, $N(Z_{35})$, or $Si(Z_{36})(Z_{37})$,

$Y_{41}$ may be N or $C(Z_{41})$, $Y_{42}$ may be N or $C(Z_{42})$, $Y_{43}$ may be N or $C(Z_{43})$, $Y_{44}$ may be N or $C(Z_{44})$, $Y_{51}$ may be N or $C(Z_{51})$, $Y_{52}$ may be N or $C(Z_{52})$, $Y_{53}$ may be N or $C(Z_{53})$, $Y_{54}$ may be N or $C(Z_{54})$, at least one selected from $Y_{41}$ to $Y_{43}$ and $Y_{51}$ to $Y_{54}$ in Formulae 6-118 to 6-121 may be N, and at least one selected from $Y_{41}$ to $Y_{44}$ and $Y_{51}$ to $Y_{54}$ in Formula 6-122 may be N,

$Z_{31}$ to $Z_{38}$, $Z_{41}$ to $Z_{44}$, and $Z_{51}$ to $Z_{54}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and $-Si(Q_{31})(Q_{32})(Q_{33})$,

wherein $Q_1$ to $Q_3$ and $Q_{31}$ to $Q_{33}$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and

a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group,e2 may be an integer selected from 0 to 2,

$e_3$ may be an integer selected from 0 to 3,

$e_4$ may be an integer selected from 0 to 4,

$e_5$ may be an integer selected from 0 to 5,

e6 may be an integer selected from 0 to 6,

$e_7$ may be an integer selected from 0 to 7,

$e_9$ may be an integer selected from 0 to 9, and

* indicates a binding site to a neighboring atom.

In various embodiments, $Ar_1$ to $Ar_3$ in Formula 1 may each independently be selected from -Si($Q_1$)($Q_2$)($Q_3$) and a group represented by any of Formulae 9-1 to 9-100 and 10-1 to 10-121, but embodiments of the present disclosure are not limited thereto:

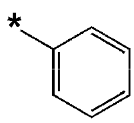
Formula 9-1

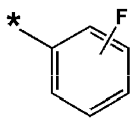
Formula 9-2

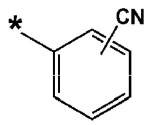
Formula 9-3

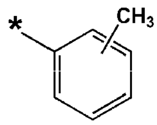
Formula 9-4

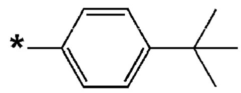
Formula 9-5

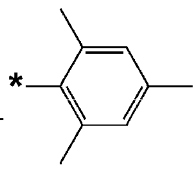
Formula 9-6

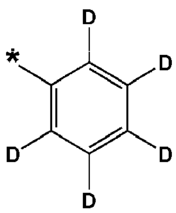
Formula 9-7

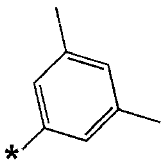
Formula 9-8

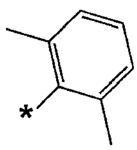
Formula 9-9

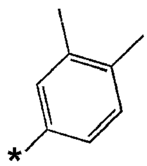
Formula 9-10

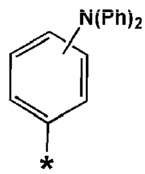
Formula 9-11

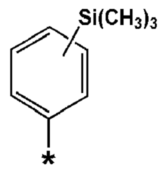
Formula 9-12

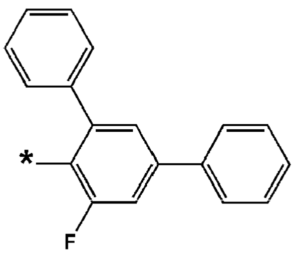
Formula 9-13

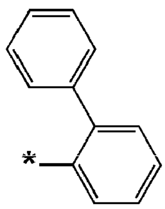
Formula 9-14

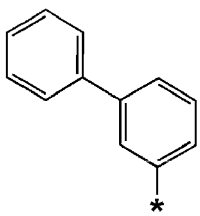
Formula 9-15

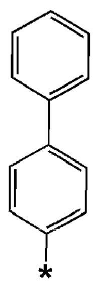
Formula 9-16

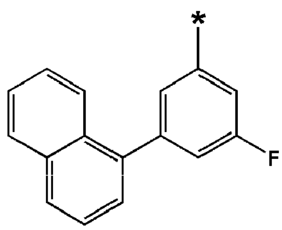
Formula 9-17

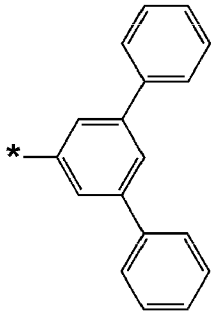 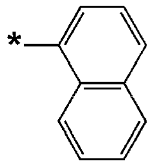 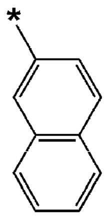 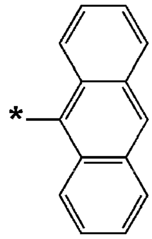 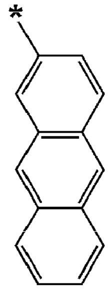 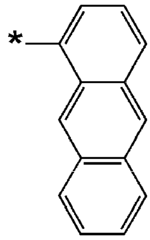

Formula 9-18 Formula 9-19 Formula 9-20 Formula 9-21 Formula 9-22 Formula 9-23

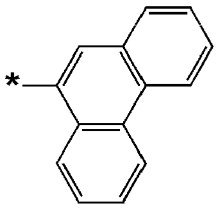 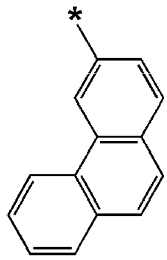 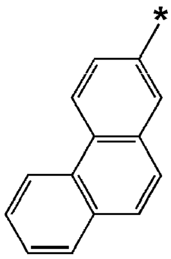 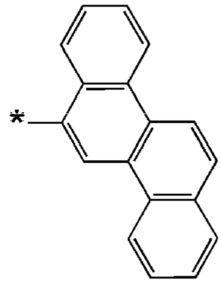 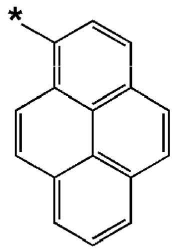

Formula 9-24 Formula 9-25 Formula 9-26 Formula 9-27 Formula 9-28

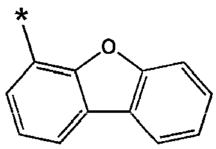 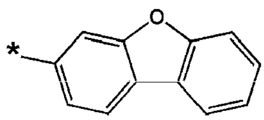 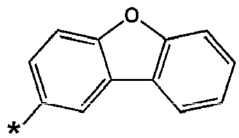 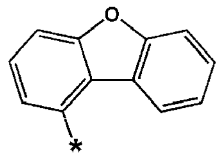

Formula 9-29 Formula 9-30 Formula 9-31 Formula 9-32

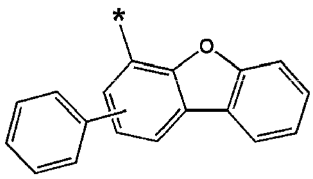 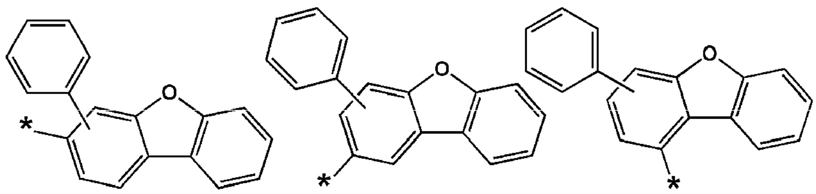

Formula 9-33 Formula 9-34 Formula 9-35 Formula 9-36

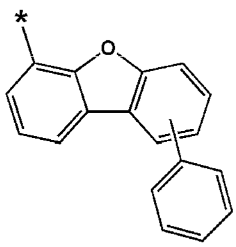 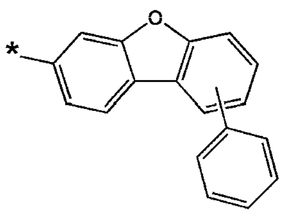 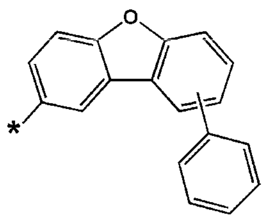 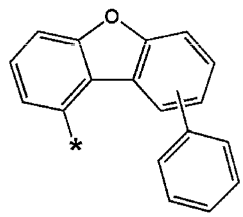

Formula 9-37 Formula 9-38 Formula 9-39 Formula 9-40

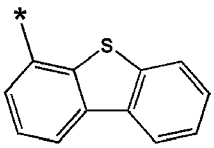
Formula 9-41

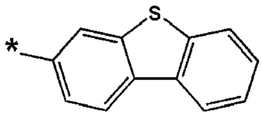
Formula 9-42

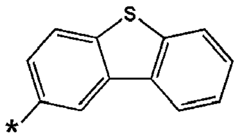
Formula 9-43

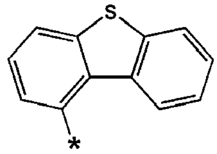
Formula 9-44

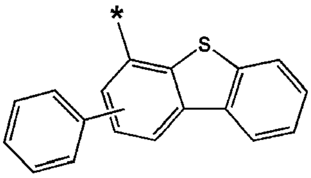
Formula 9-45

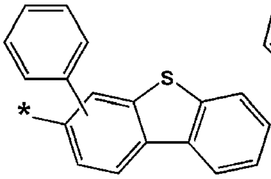
Formula 9-46

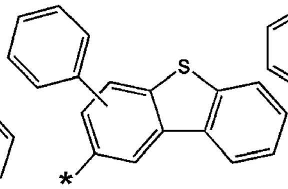
Formula 9-47

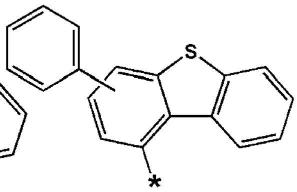
Formula 9-48

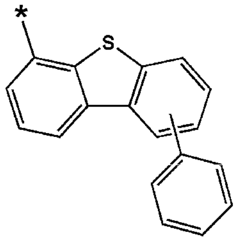
Formula 9-49

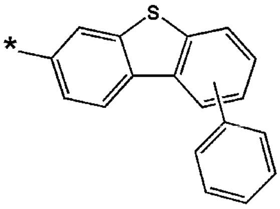
Formula 9-50

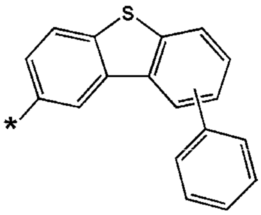
Formula 9-51

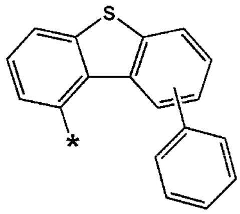
Formula 9-52

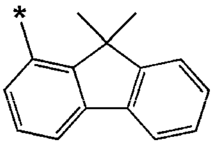
Formula 9-53

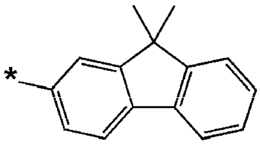
Formula 9-54

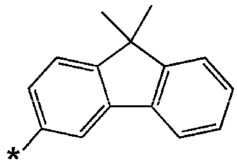
Formula 9-55

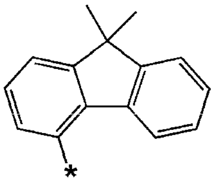
Formula 9-56

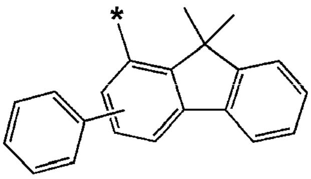
Formula 9-57

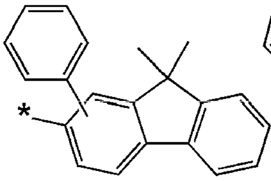
Formula 9-58

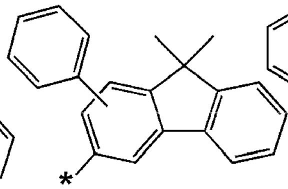
Formula 9-59

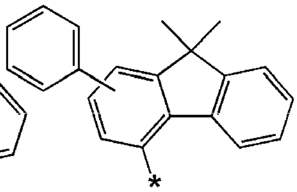
Formula 9-60

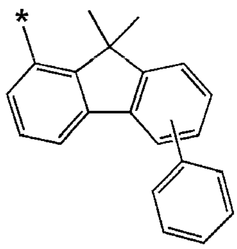
Formula 9-61

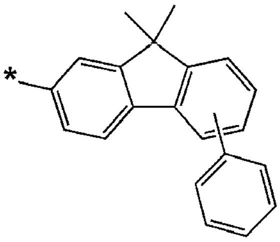
Formula 9-62

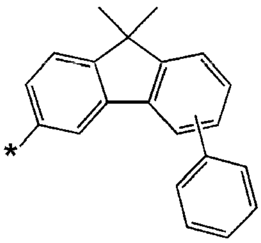
Formula 9-63

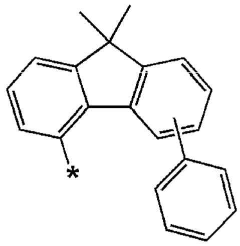
Formula 9-64

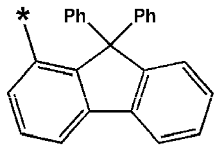

Formula 9-65

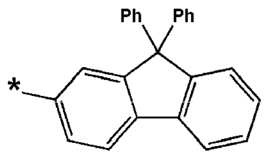

Formula 9-66

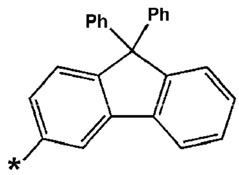

Formula 9-67

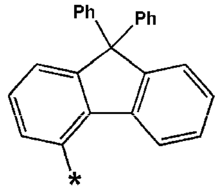

Formula 9-68

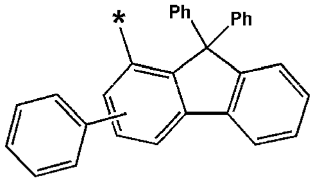

Formula 9-69

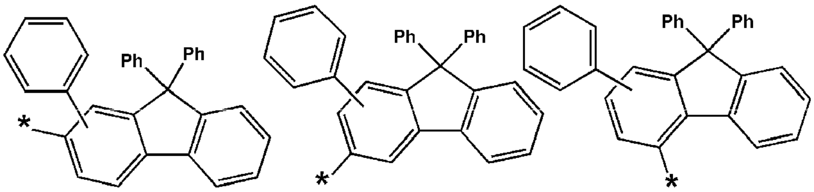

Formula 9-70

Formula 9-71

Formula 9-72

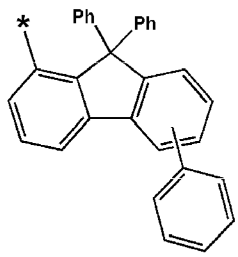

Formula 9-73

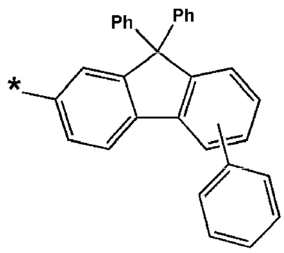

Formula 9-74

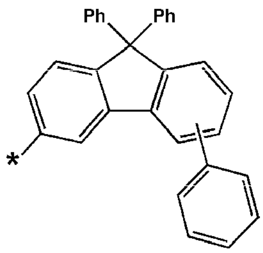

Formula 9-75

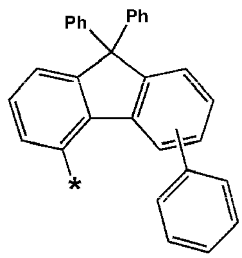

Formula 9-76

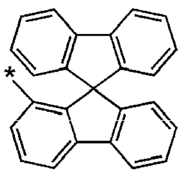

Formula 9-77

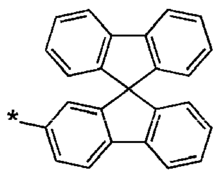

Formula 9-78

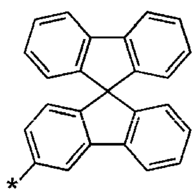

Formula 9-79

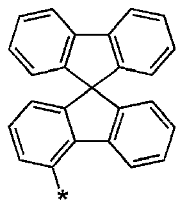

Formula 9-80

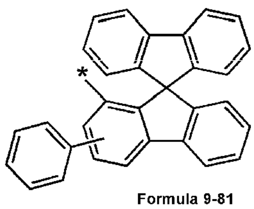

Formula 9-81

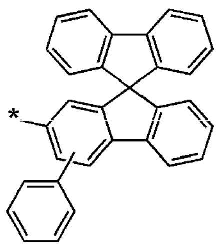

Formula 9-82

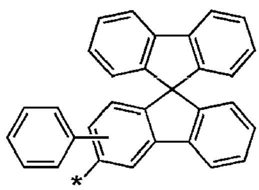

Formula 9-83

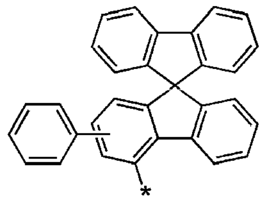

Formula 9-84

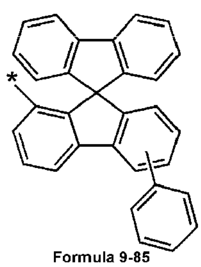

Formula 9-85

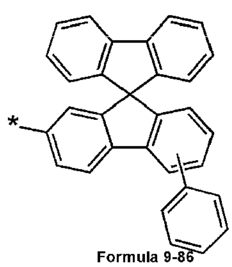

Formula 9-86

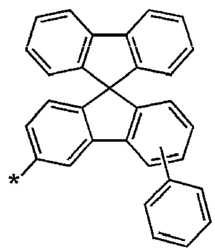

Formula 9-87

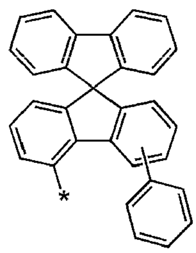

Formula 9-88

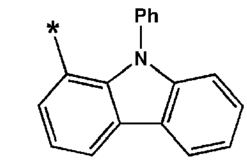
Formula 9-89

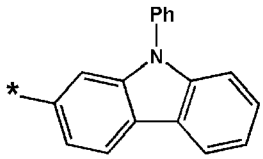
Formula 9-90

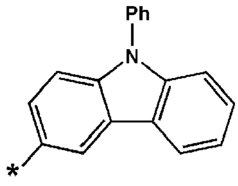
Formula 9-91

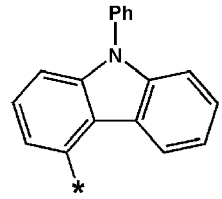
Formula 9-92

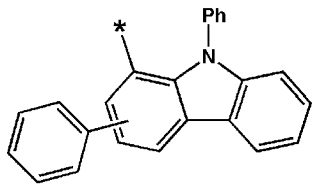
Formula 9-93

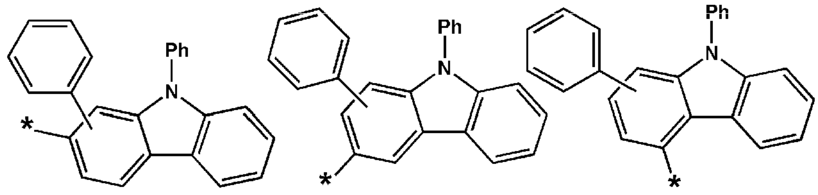
Formula 9-94 Formula 9-95 Formula 9-96

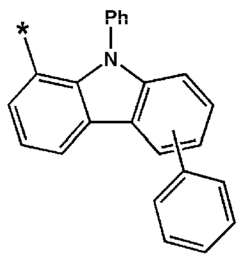
Formula 9-97

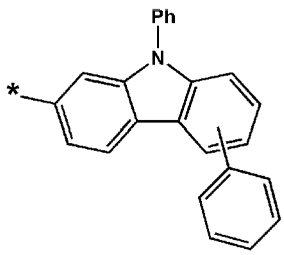
Formula 9-98

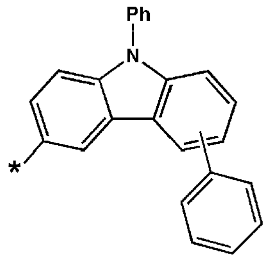
Formula 9-99

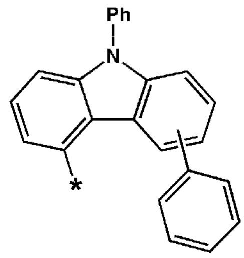
Formula 9-100

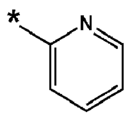
Formula 10-1

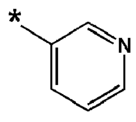
Formula 10-2

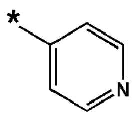
Formula 10-3

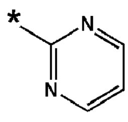
Formula 10-4

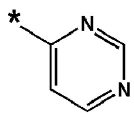
Formula 10-5

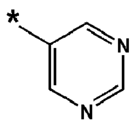
Formula 10-6

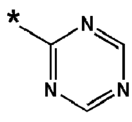
Formula 10-7

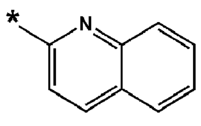
Formula 10-8

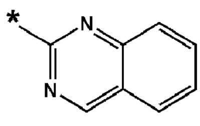
Formula 10-9

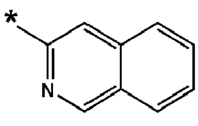
Formula 10-10

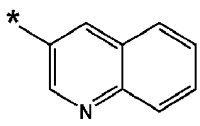
Formula 10-11

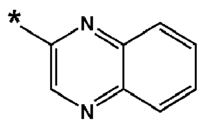
Formula 10-12

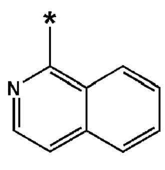
Formula 10-13

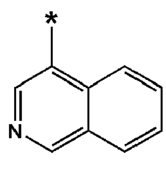
Formula 10-14

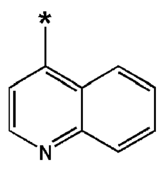
Formula 10-15

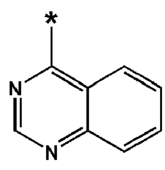
Formula 10-16

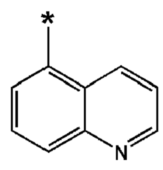
Formula 10-17

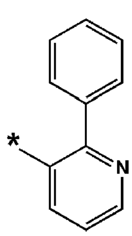
Formula 10-18

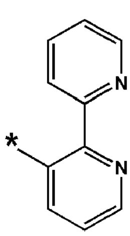
Formula 10-19

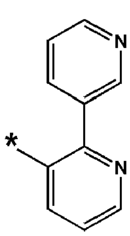
Formula 10-20

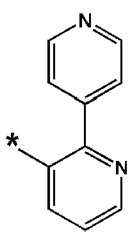
Formula 10-21

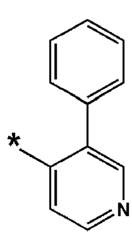
Formula 10-22

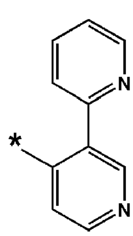
Formula 10-23

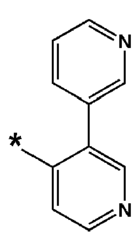
Formula 10-24

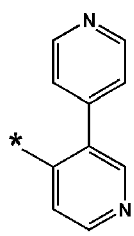
Formula 10-25

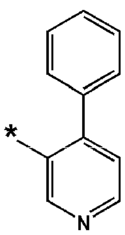
Formula 10-26
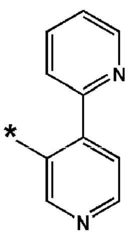
Formula 10-27
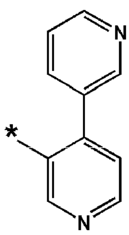
Formula 10-28
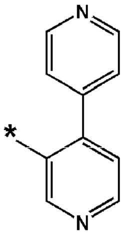
Formula 10-29
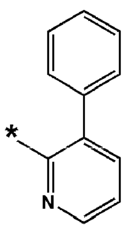
Formula 10-30
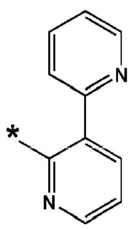
Formula 10-31
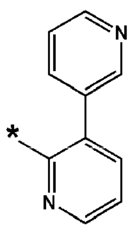
Formula 10-32
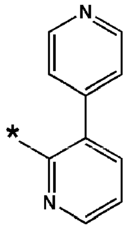
Formula 10-33

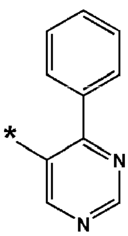
Formula 10-34
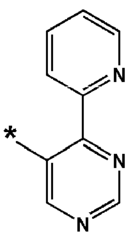
Formula 10-35
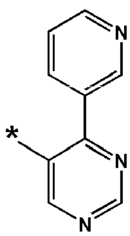
Formula 10-36
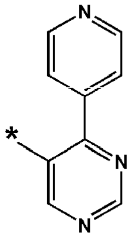
Formula 10-37
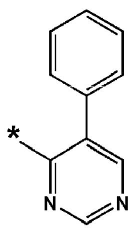
Formula 10-38
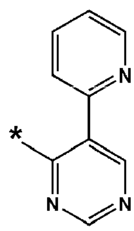
Formula 10-39
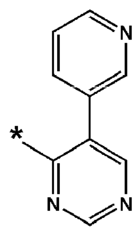
Formula 10-40
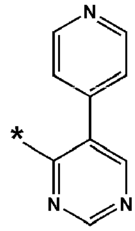
Formula 10-41

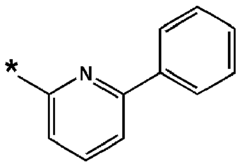
Formula 10-42
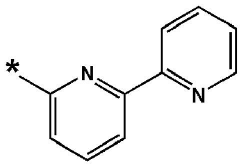
Formula 10-43
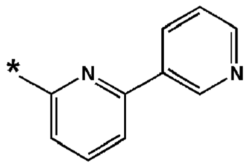
Formula 10-44
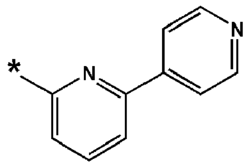
Formula 10-45

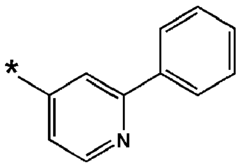
Formula 10-46
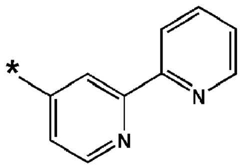
Formula 10-47
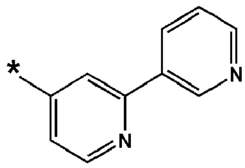
Formula 10-48
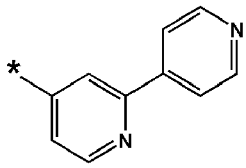
Formula 10-49

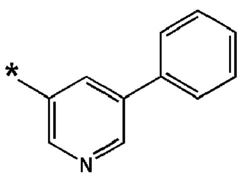
Formula 10-50
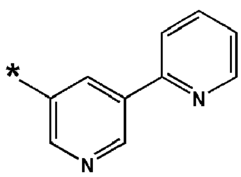
Formula 10-51
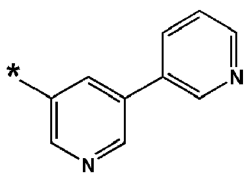
Formula 10-52
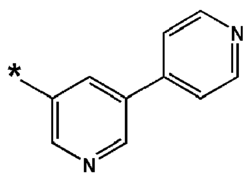
Formula 10-53

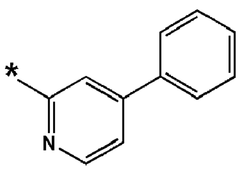
Formula 10-54
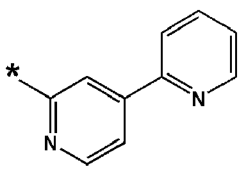
Formula 10-55
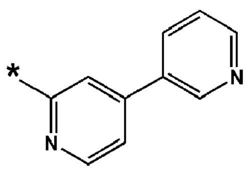
Formula 10-56
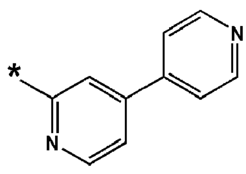
Formula 10-57

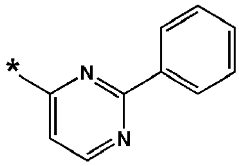
Formula 10-58

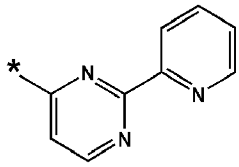
Formula 10-59

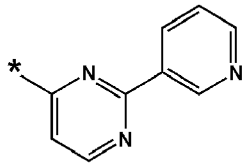
Formula 10-60

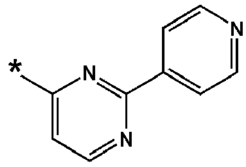
Formula 10-61

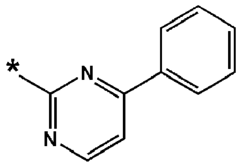
Formula 10-62

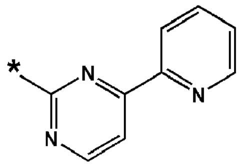
Formula 10-63

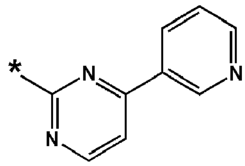
Formula 10-64

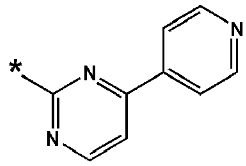
Formula 10-65

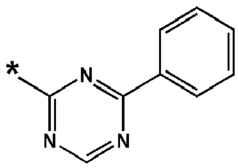
Formula 10-66

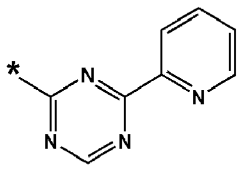
Formula 10-67

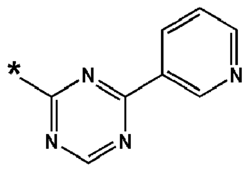
Formula 10-68

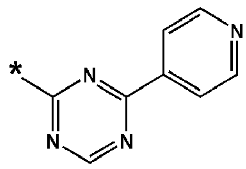
Formula 10-69

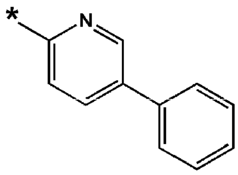
Formula 10-70

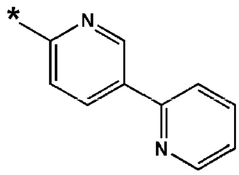
Formula 10-71

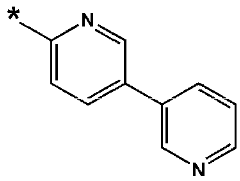
Formula 10-72

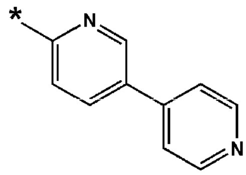
Formula 10-73

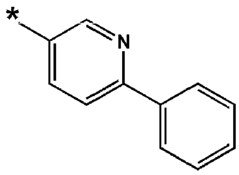
Formula 10-74

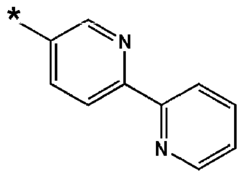
Formula 10-75

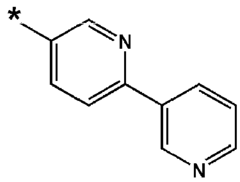
Formula 10-76

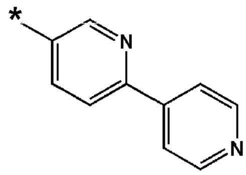
Formula 10-77

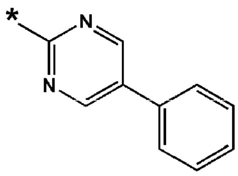
Formula 10-78

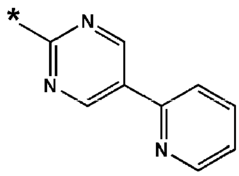
Formula 10-79

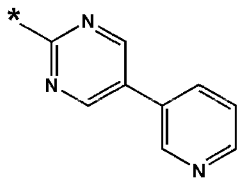
Formula 10-80

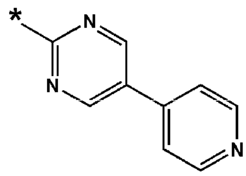
Formula 10-81

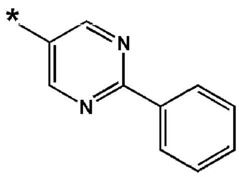
Formula 10-82

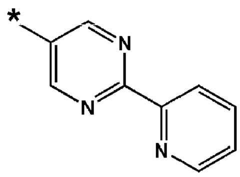
Formula 10-83

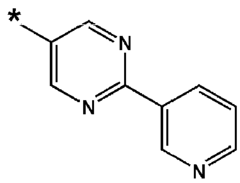
Formula 10-84

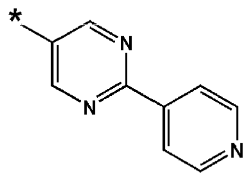
Formula 10-85

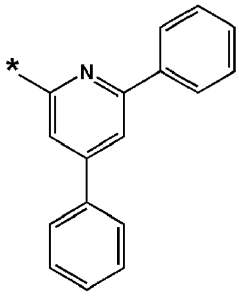
Formula 10-86

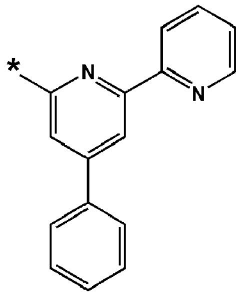
Formula 10-87

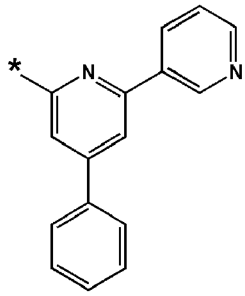
Formula 10-88

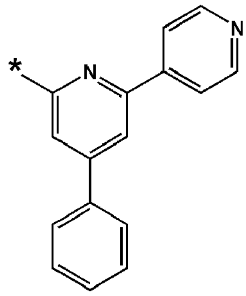
Formula 10-89

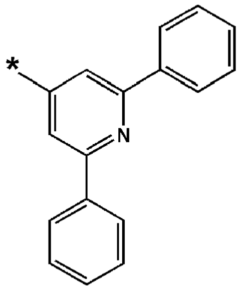
Formula 10-90

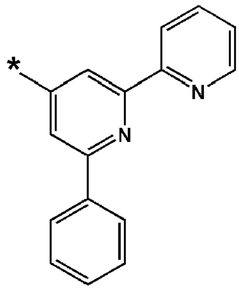
Formula 10-91

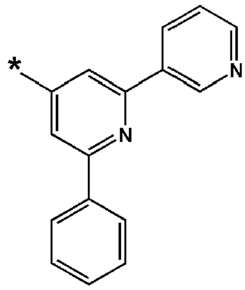
Formula 10-92

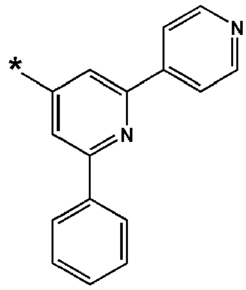
Formula 10-93

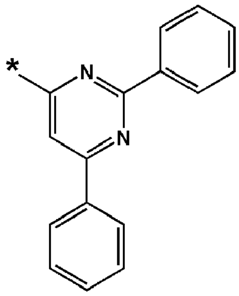
Formula 10-94

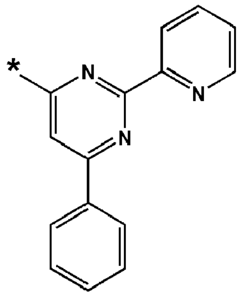
Formula 10-95

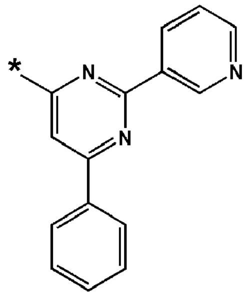
Formula 10-96

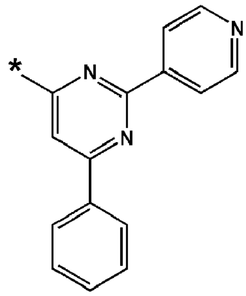
Formula 10-97

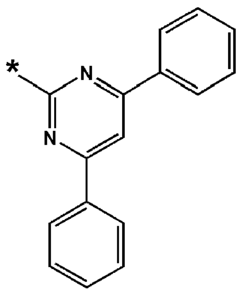
Formula 10-98

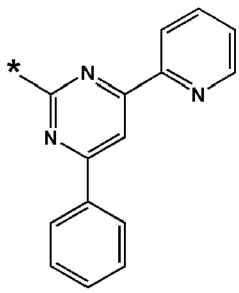
Formula 10-99

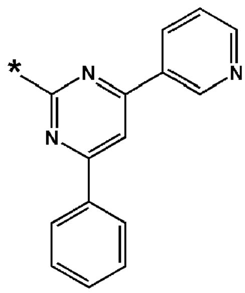
Formula 10-100

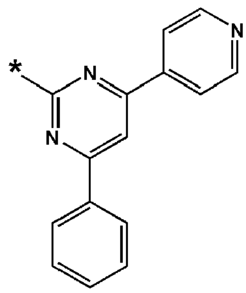
Formula 10-101

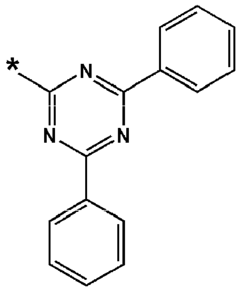
Formula 10-102

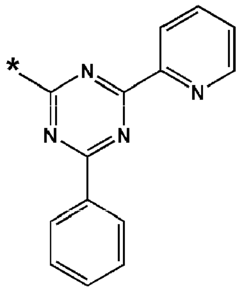
Formula 10-103

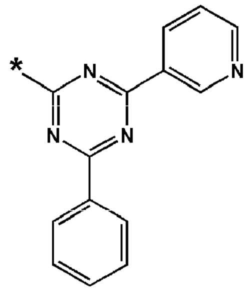
Formula 10-104

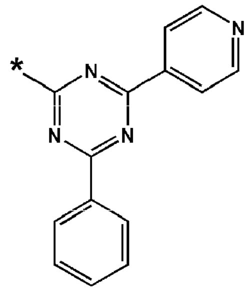
Formula 10-105

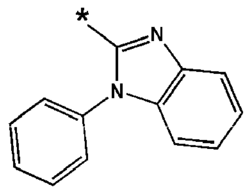
Formula 10-106

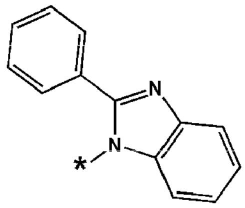
Formula 10-107

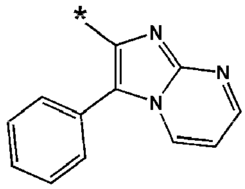
Formula 10-108

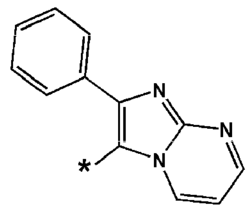
Formula 10-109

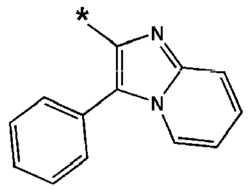
Formula 10-110

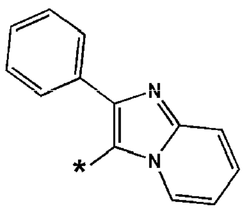
Formula 10-111

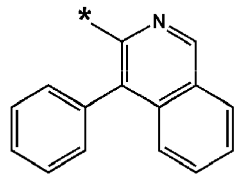
Formula 10-112

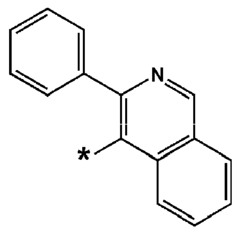
Formula 10-113

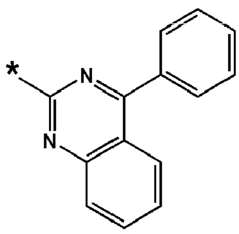
Formula 10-114

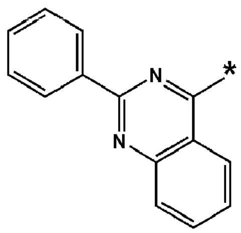
Formula 10-115

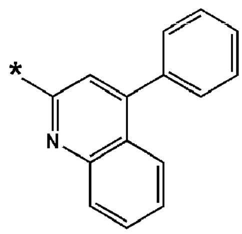
Formula 10-116

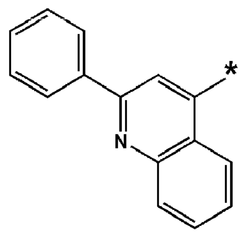
Formula 10-117

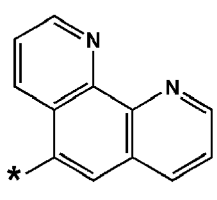
Formula 10-118

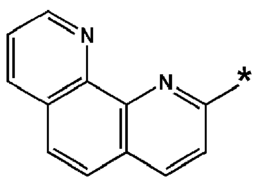
Formula 10-119

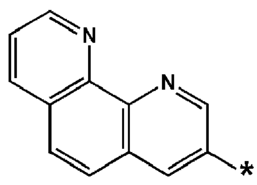
Formula 10-120

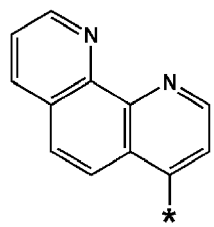
Formula 10-121

In Formulae 9-1 to 9-100 and 10-1 to 10-121, Ph may refer to a phenyl group, * indicates a binding site to a neighboring atom, and $Q_1$to $Q_3$ are the same as described above.

In Formula 1, c1 indicates the number of $Ar_1$(s), c2 indicates the number of $Ar_2$(s), and $c_3$ indicates the number of $Ar_3$(s). c1 to $c_3$ are each independently an integer selected from 1 to 3. When c1 is two or more, two or more $Ar_1$(s)

may be identical to or different from each other, when c2 is two or more, two or more $Ar_2$(s) may be identical to or different from each other, and when $c_3$ is two or more, two or more $Ar_3$(s) may be identical to or different from each other.

For example, c1 to $c_3$ in Formula 1 may each independently be 1 or 2.

$R_1$ to $R_4$, $R_{21}$ to $R_{24}$, $R_{27}$, and $R_{28}$ in Formulae 1, 2A, and 2B are each independently selected from hydrogen, deuterium (-D), -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed $C_8$-$C_{60}$ polycyclic group, a substituted or unsubstituted monovalent non-aromatic condensed 8- to 60-membered heteropolycyclic group, -Si($Q_4$)($Q_5$)($Q_6$), -N($Q_4$)($Q_5$), -B($Q_4$)($Q_5$), -C(=O)($Q_4$),-S(=O)$_2$($Q_4$), and -P(=O)($Q_4$)($Q_5$).

For example, $R_1$ to $R_4$ in Formula 1 may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a phenanthrenyl group, an anthracenyl group, a fluorenyl group, a dimethyl-fluorenyl group, a diphenyl-fluorenyl group, and -Si($Q_4$)($Q_5$)($Q_6$), wherein $Q_4$ to $Q_6$ are the same as described above.

$R_{21}$ to $R_{24}$, $R_{27}$, and $R_{28}$ in Formulae 2A and 2B may each independently be selected from the group consisting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;

a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a picenyl group, a perylenyl group, a pentaphenyl group, a hexacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si($Q_4$)($Q_5$)($Q_6$), -N($Q_4$)(Qs),-B($Q_4$)($Q_5$), -C(=O)($Q_4$), -S(=O)$_2$($Q_4$), and -P(=O)($Q_4$)($Q_5$); and

a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium, - F, -Cl, -Br, -I, a hydroxyl group, a cyano group, a nitro group, an amidino group, a hydrazino group, a hydrazono group, a $C_1$-$C_{10}$ alkyl group, a $C_1$-$C_{10}$ alkoxy group, a $C_3$-$C_{20}$ cycloalkyl group, a $C_6$-$C_{20}$ aryl group, a $C_3$-$C_{20}$ heteroaryl group, -Si($Q_{31}$)($Q_{32}$)($Q_{33}$),-N($Q_{31}$)($Q_{32}$), -B($Q_{31}$)($Q_{32}$), -C(=O)($Q_{31}$), -S(=O)$_2$($Q_{31}$), and -P(=O)($Q_{31}$)($Q_{32}$),

wherein $Q_4$ to $Q_6$ and $Q_{31}$ to $Q_{33}$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group.

In various embodiments, in Formulae 1, 2A, and 2B,

$R_1$ to $R_4$, $R_{21}$ to $R_{24}$, $R_{27}$, and $R_{28}$ may each independently be selected from the group consisting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;
groups represented by Formulae 5-1 to 5-45 and 6-1 to 6-124; and -Si($Q_4$)($Q_5$)($Q_6$), -N($Q_4$)($Q_5$), -B($Q_4$)($Q_5$), -C(=O)($Q_4$), -S(=O)$_2$($Q_4$), and-P(=O)($Q_4$)($Q_5$),
wherein $Q_4$ to $Q_6$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group.

In various embodiments, in Formulae 1, 2A, and 2B,
$R_1$ to $R_4$, $R_{21}$ to $R_{24}$, $R_{27}$, and $R_{28}$ may each independently be selected from the group consisting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;
groups represented by Formulae 9-1 to 9-100 and 10-1 to 10-121; and
-Si($Q_4$)($Q_5$)($Q_6$), -N($Q_4$)($Q_5$), -B($Q_4$)($Q_5$), -C(=O)($Q_4$), -S(=O)$_2$($Q_4$), and-P(=O)($Q_4$)($Q_5$),
wherein $Q_4$ to $Q_6$ may each independently be selected from the group consisting of:

a $C_1$-$C_{10}$ alkyl group, a $C_1$-$C_{10}$ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a $C_1$-$C_{10}$ alkyl group, a $C_1$-$C_{10}$ alkoxy group, and a phenyl group.

In Formulae 1 and 2, b1, b2, b21, and b22 indicate the number of $R_1$(s), the number of $R_2$(s), the number of $R_{21}$(s), and the number of $R_{22}$(s), respectively. b1 and b2 are each independently an integer selected from 1 to 6, and b21 and b22 are each independently an integer selected from 1 to 3. When b1 is two or more, two or more $R_1$(s) may be identical to or different from each other. When b2 is two or more, two or more $R_2$(s) may be identical to or different from each other. When b21 is two or more, two or more $R_{21}$(s) may be identical to or different from each other. When b22 is two or more, two or more $R_{22}$(s) may be identical to or different from each other.
For example, b1 and b2 may each independently be an integer selected from 1 to 4, and b21 to b22 may each independently be 1 or 2.
In Formula 1, d11 and d12 indicate the number of*-[($L_1$)$_{a1}$-($Ar_1$)$_{c1}$](s) and the number of *-[($L_2$)$_{a2}$-($Ar_2$)$_{c2}$](s) respectively. d11 and d12 are each independently an integer selected from 0 to 4.
When d11 is two or more, two or more *-[($L_1$)$_{a1}$-($Ar_1$)$_{c1}$](s) may be identical to or different from each other, and when d12 is two or more, two or more *-[($L_2$)$_{a2}$-($Ar_2$)$_{c2}$](s) may be identical to or different from each other.
For example, d11 and d12 in Formula 1 may each independently be an integer selected from 0, 1, and 2, but embodiments of the present disclosure are not limited thereto.
In various embodiments, the first compound may be represented by one selected from Formulae 1A to 1F:

Formula 1A

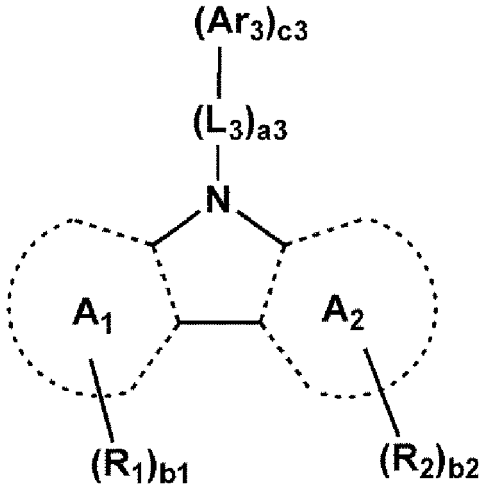

Formula 1B

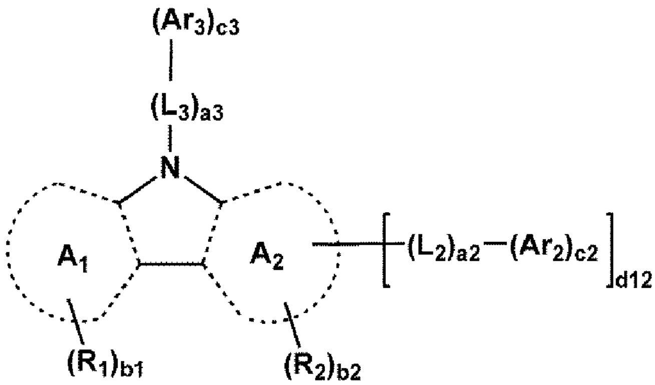

Formula 1C

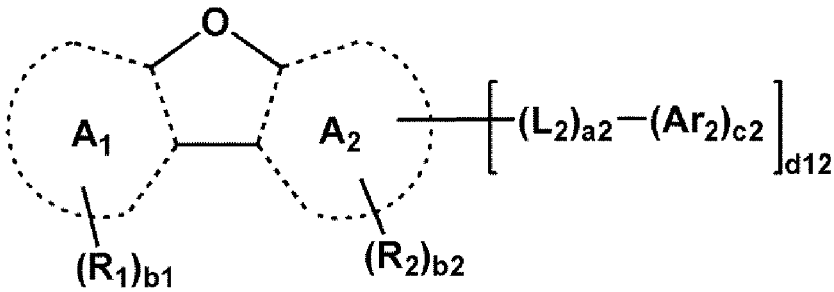

Formula 1D

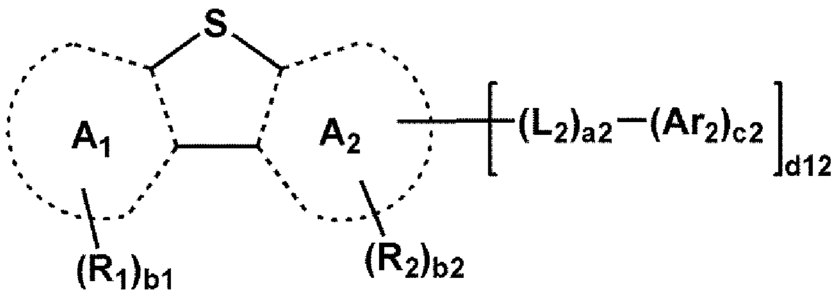

Formula 1E

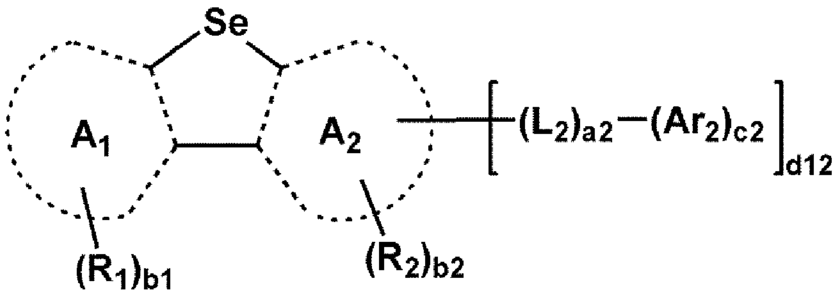

Formula 1F

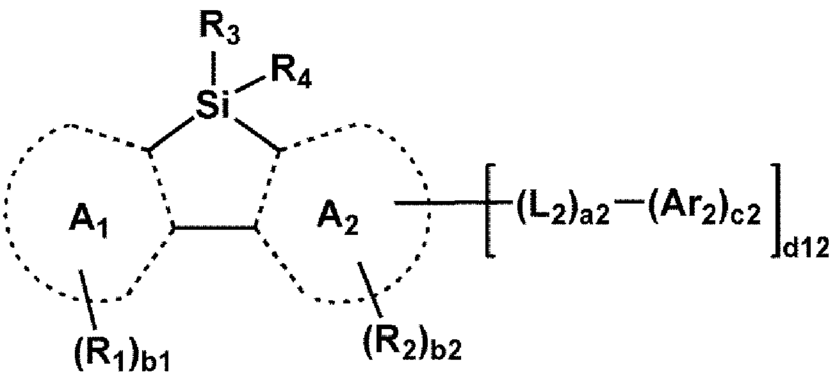

In Formulae 1A to 1F,

ring $A_1$, ring $A_2$, $L_2$, $L_3$, a2, a3, $Ar_2$, $Ar_3$, $c_2$, $c_3$, $R_1$ to $R_4$, $b_1$, b2, and d12 are the same as respectively described above.

For example, in Formulae 1A to 1F,
ring $A_1$ may be selected from a benzene group, a naphthalene group, a pyridine group, and a pyrimidine group,
ring $A_2$ may be selected from a benzene group, a naphthalene group, a phenanthrene group, an anthracene group, a phenanthroline group, an indenopyridine group, a benzofuropyrimidine group, a benzofuropyridine group, an indenofluorene group, an indenoindole group, a benzoindole group, a naphthofuran group, a benzonaphthofuran group, a pyridobenzothiophene group, a benzonaphthothiophene group, a benzocarbazole group, a quinoline group, a quinoxaline group, a pyridine group, a pyrimidine group, an indole group, a carbazole, a fluorene, a benzofluorene, a benzofuran, a benzoxazole, an indene, a dibenzofuran, a dibenzothiophene, a pyridoindole, a group represented by Formula

" 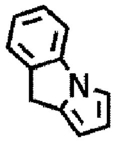 ",

a group represented by Formula

" 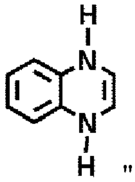 ",

a group represented by Formula

" 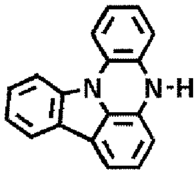 ",

and a group represented by Formula

" 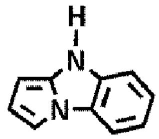 ",

and

$R_1$ and $R_2$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a $C_6$-$C_{30}$ aryl group, a $C_1$-$C_{30}$ heteroaryl group, -Si($Q_4$)($Q_5$)($Q_6$), -N($Q_4$)($Q_5$), -B($Q_4$)($Q_5$),-C(=O)($Q_4$), -S(=O)$_2$($Q_4$), and -P(=O)($Q_4$)($Q_5$).

In various embodiments, the first compound may be selected from Compounds 1-1 to 1-194:

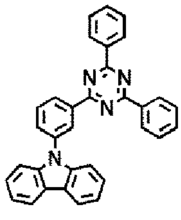
1-1

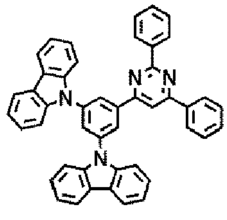
1-2

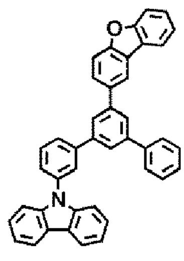
1-3

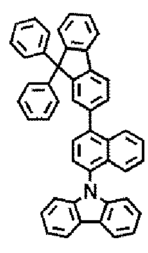
1-4

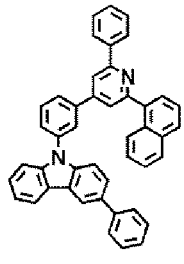
1-5

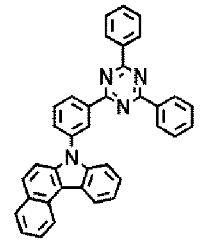

1-6

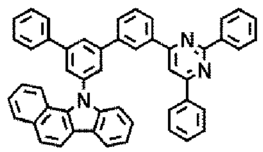

1-7

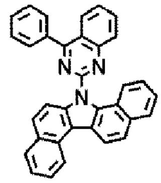

1-8

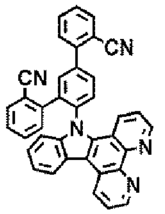

1-9

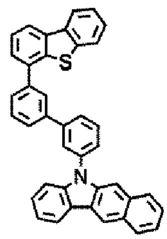

1-10

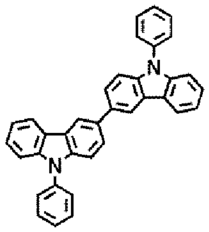

1-11

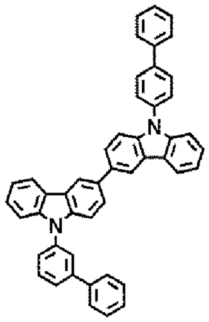

1-12

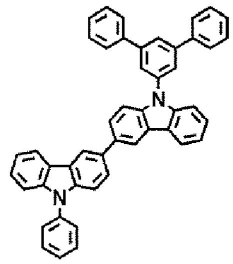

1-13

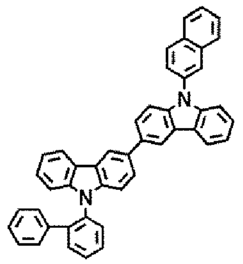

1-14

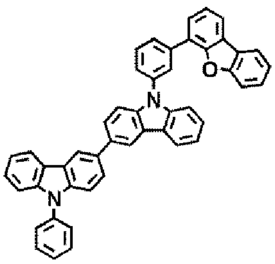

1-15

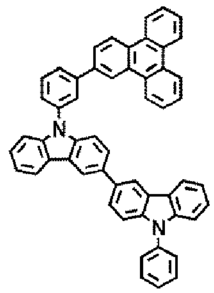

1-16

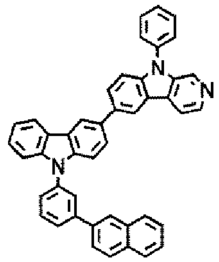

1-17

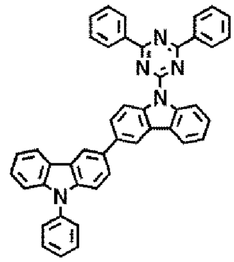

1-18

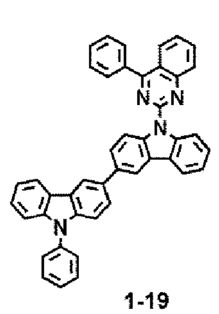

1-19

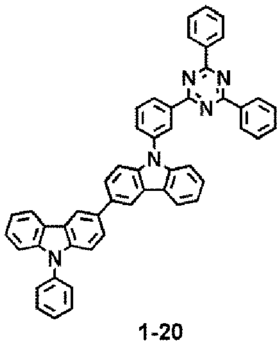

1-20

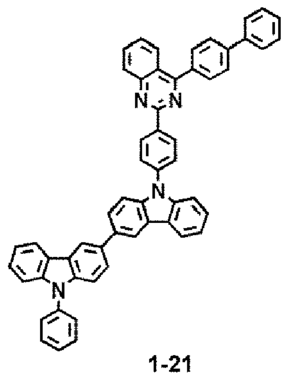

1-21

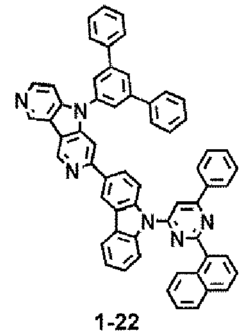

1-22

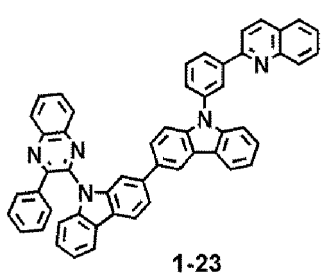

1-23

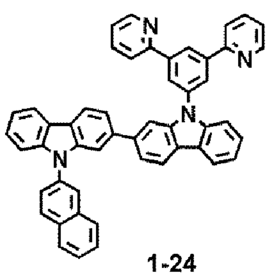

1-24

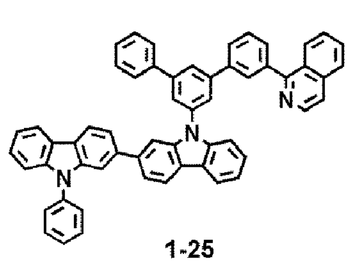

1-25

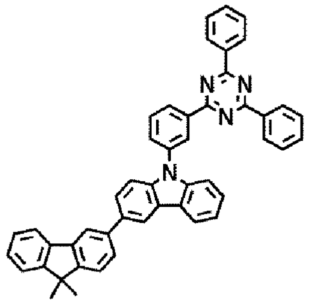
1-26

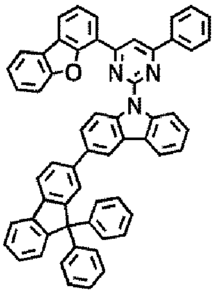
1-27

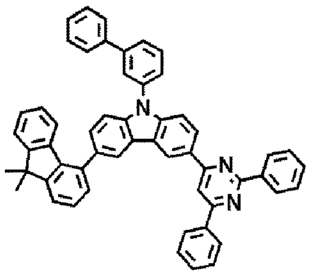
1-28

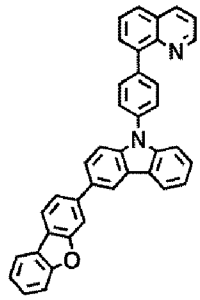
1-29

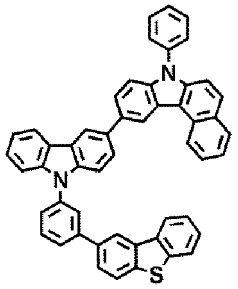
1-30

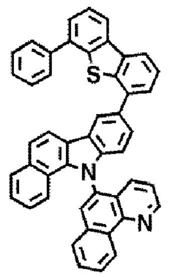
1-31

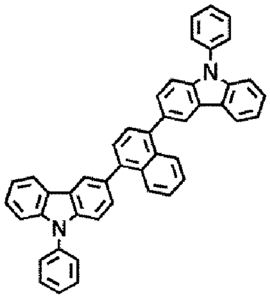
1-32

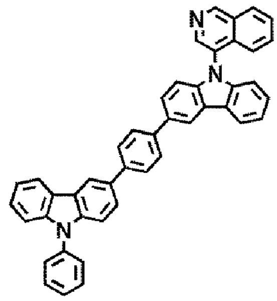
1-33

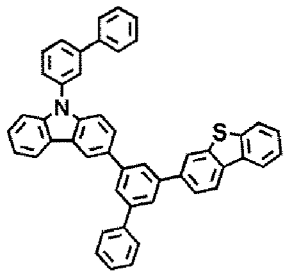
1-34

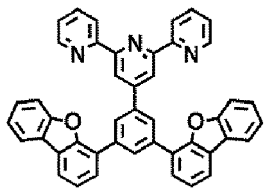
1-35

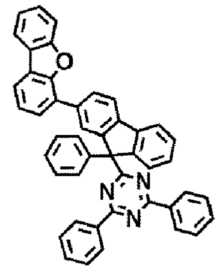
1-36

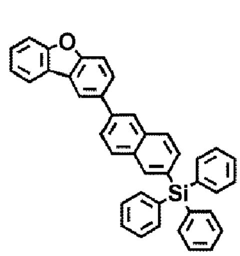
1-37

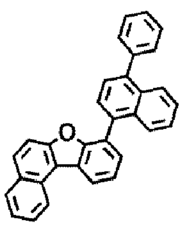
1-38

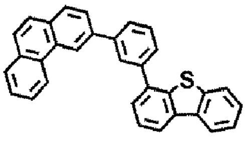
1-39

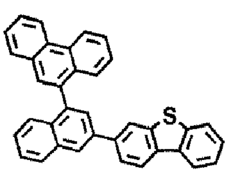
1-40

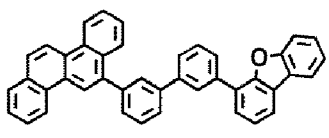
1-41

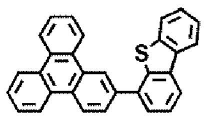
1-42

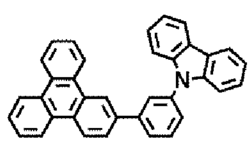
1-43

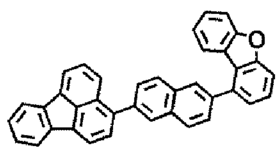
1-44

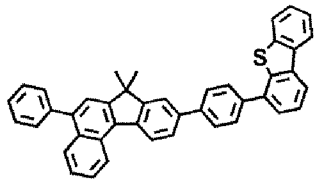
1-45

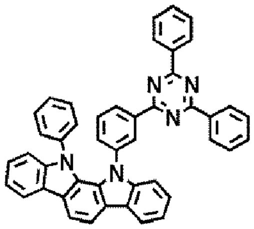
1-46

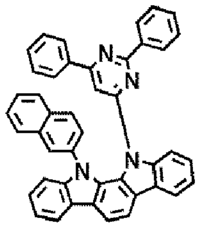
1-47

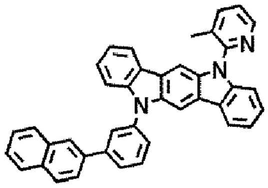
1-48

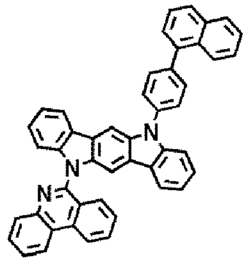
1-49

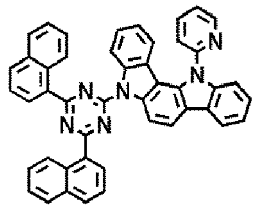
1-50

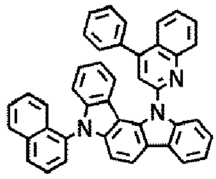
1-51

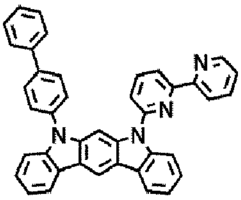
1-52

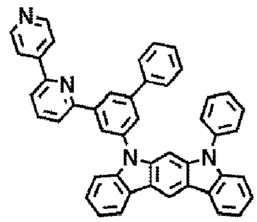
1-53

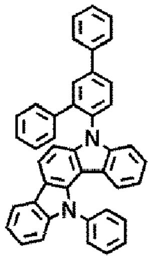
1-54

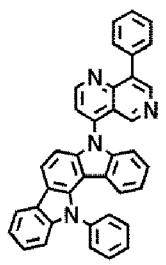
1-55

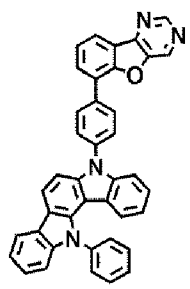
1-56

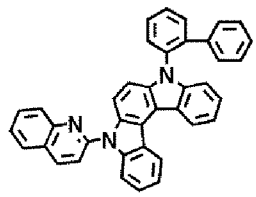
1-57

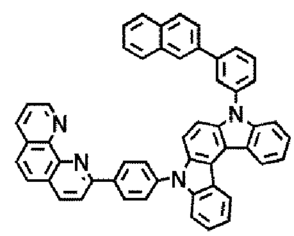
1-58

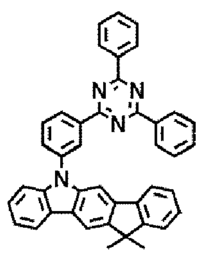
1-59

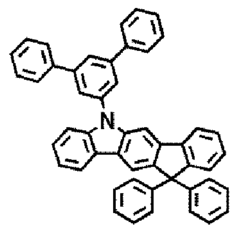
1-60

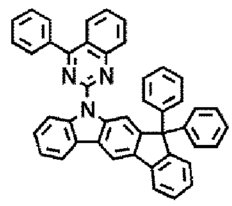
1-61

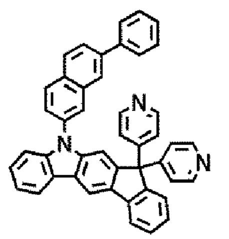
1-62

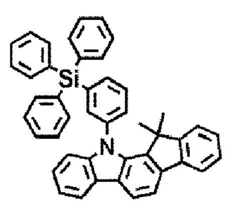
1-63

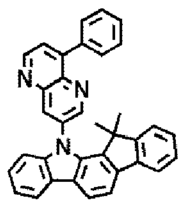
1-64

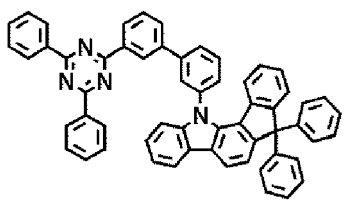
1-65

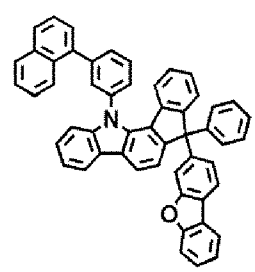
1-66

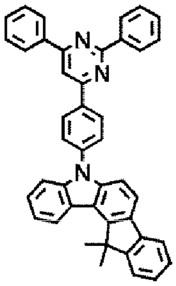
1-67

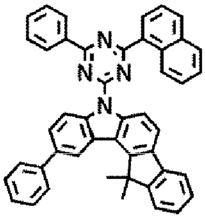
1-68

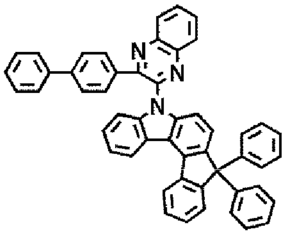
1-69

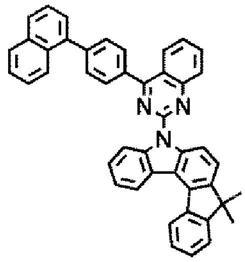
1-70

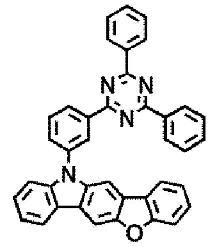
1-71

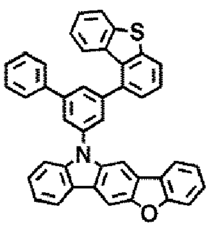
1-72

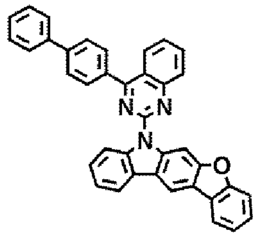
1-73

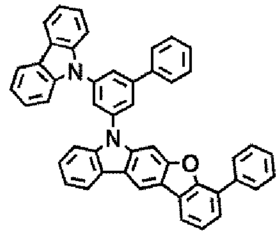
1-74

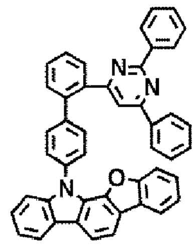
1-75

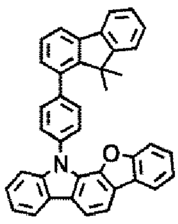
1-76

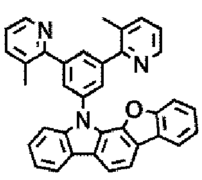
1-77

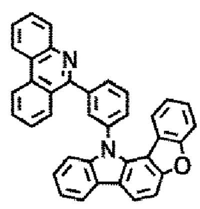
1-78

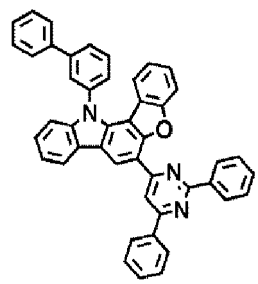
1-79

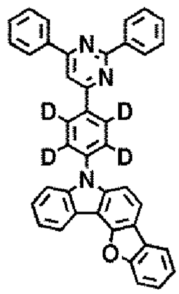
1-80

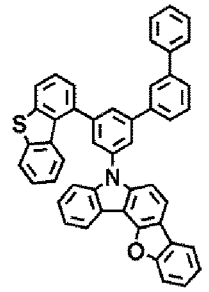
1-81

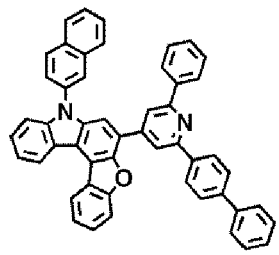
1-82

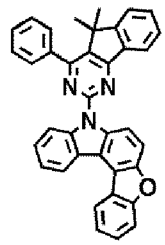
1-83

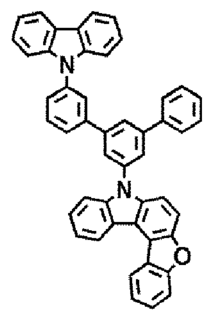
1-84

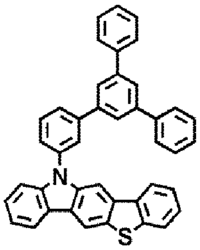
1-85

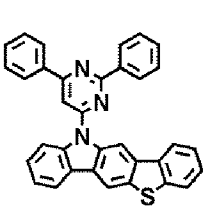
1-86

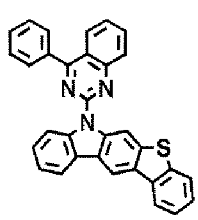
1-87

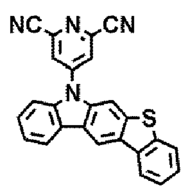
1-88

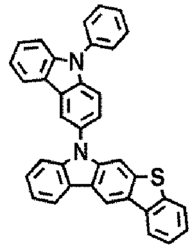
1-89

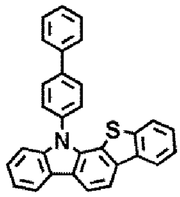
1-90

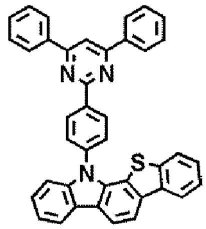
1-91

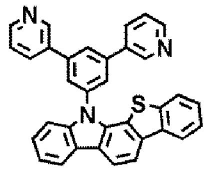
1-92

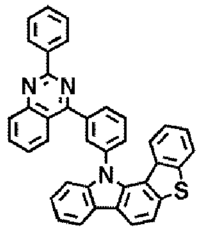
1-93

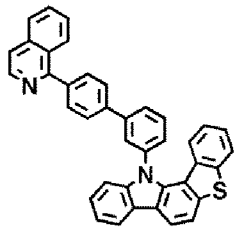
1-94

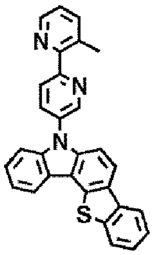
1-95

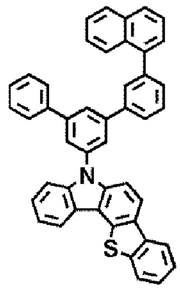
1-96

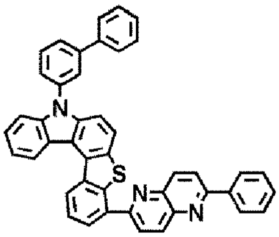
1-97

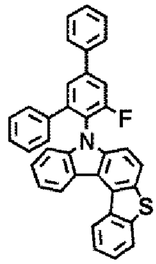
1-98

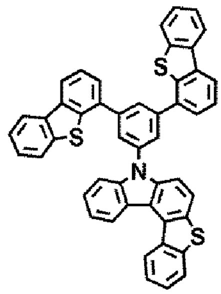
1-99

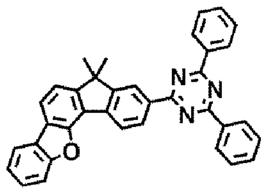
1-100

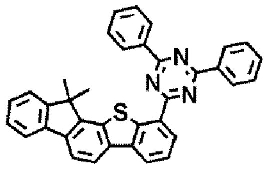
1-101

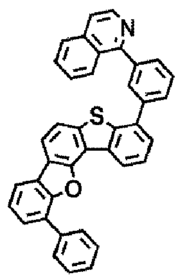
1-102

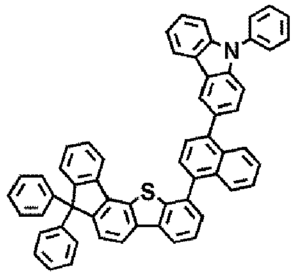
1-103

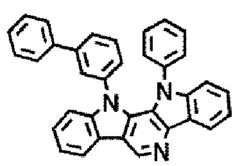
1-104

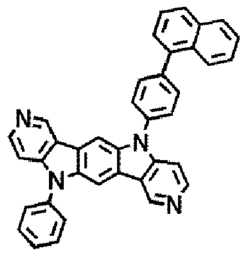
1-105

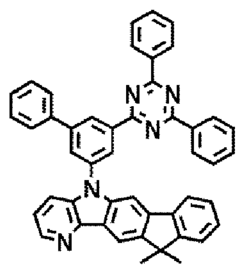
1-106

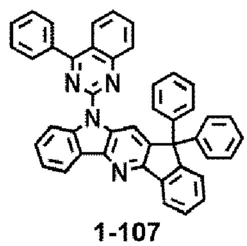
1-107

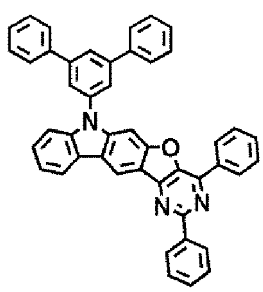
1-108

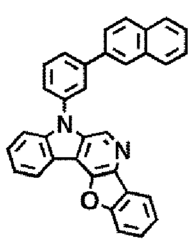
1-109

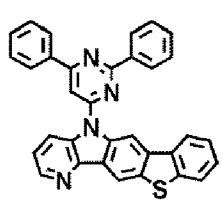
1-110

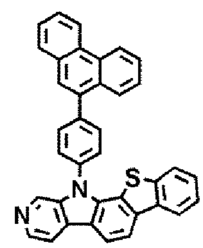
1-111

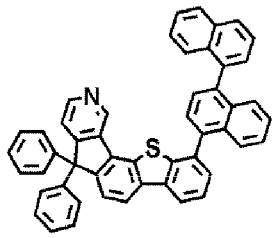
1-112

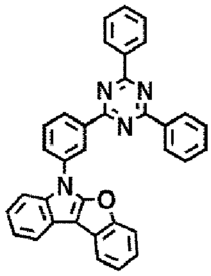
1-113

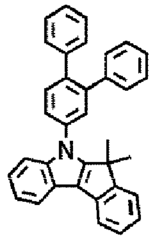
1-114

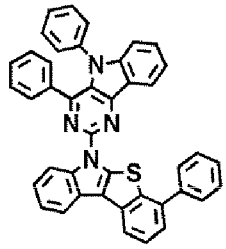
1-115

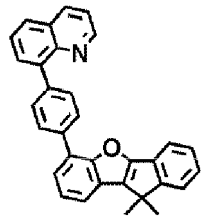
1-116

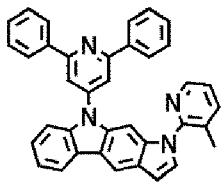
1-117

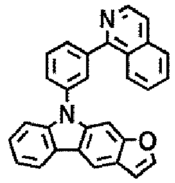
1-118

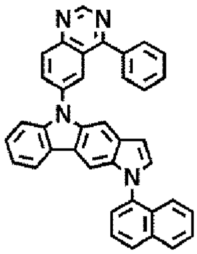
1-119

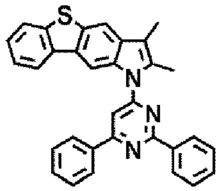
1-120

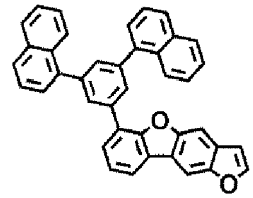
1-121

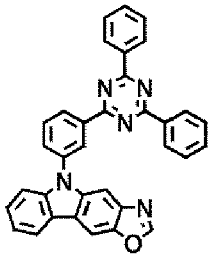
1-122

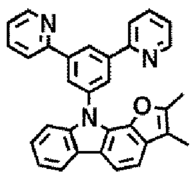
1-123

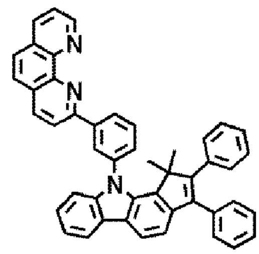
1-124

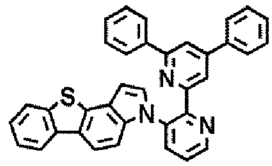
1-125

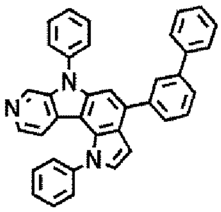
1-126

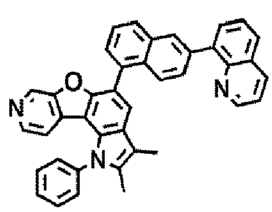
1-127

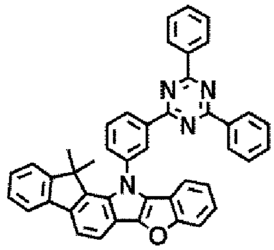
1-128

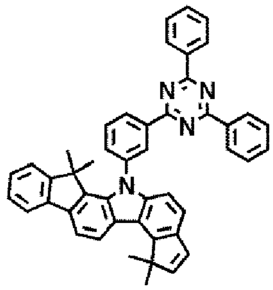
1-129

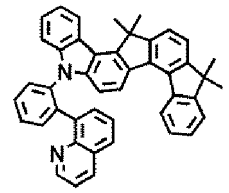
1-130

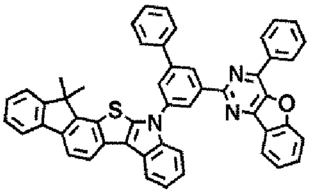
1-131

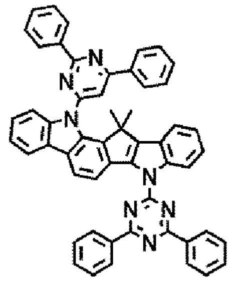
1-132

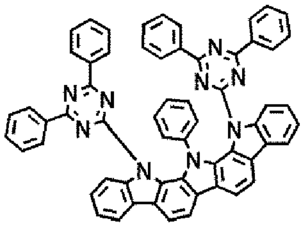
1-133

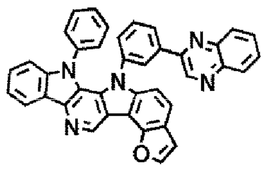
1-134

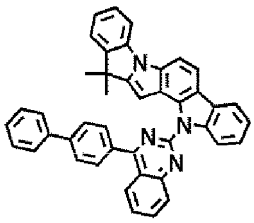
1-135

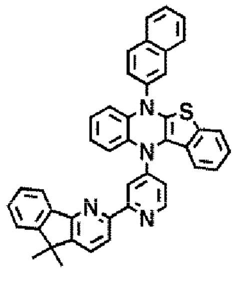
1-136

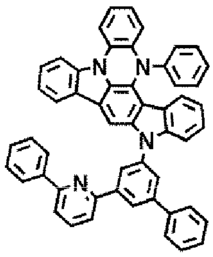
1-137

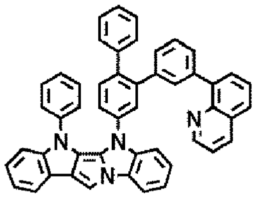
1-138

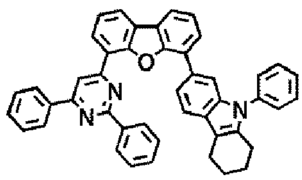
1-139

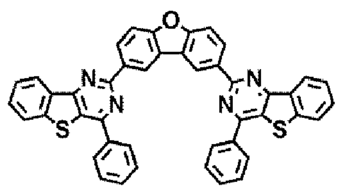
1-140

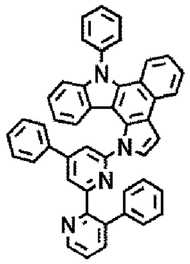
1-141

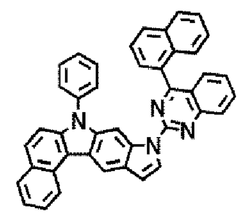
1-142

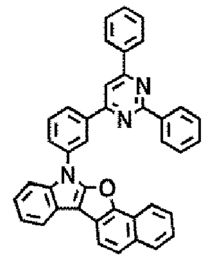
1-143

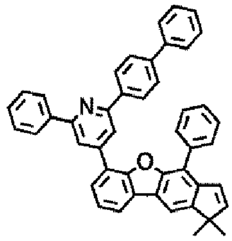
1-144

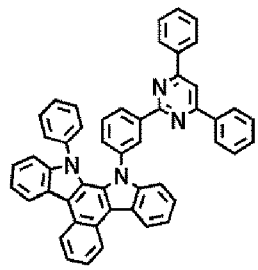
1-145

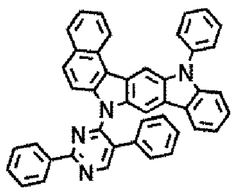
1-146

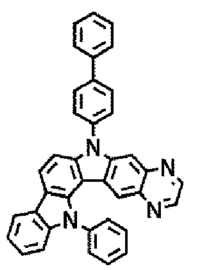
1-147

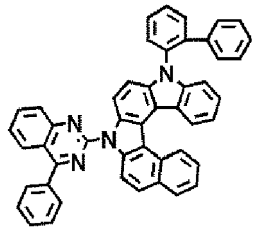
1-148

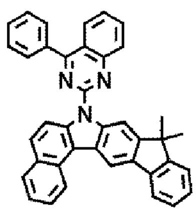
1-149

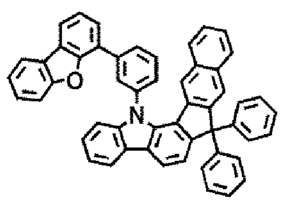
1-150

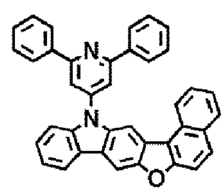
1-151

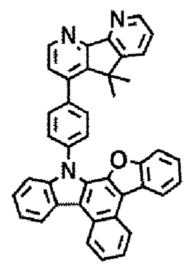
1-152

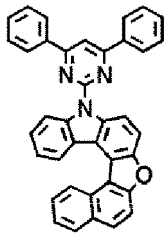

1-153

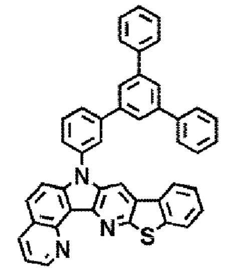

1-154

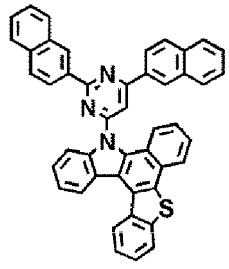

1-155

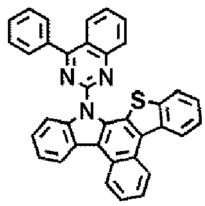

1-156

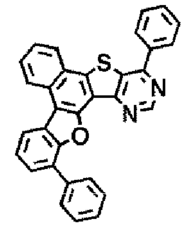

1-157

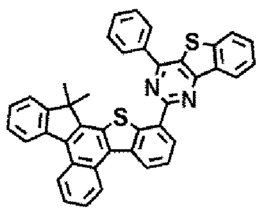

1-158

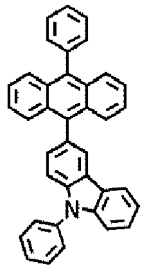

1-159

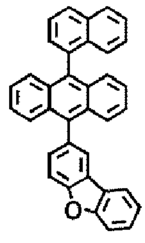

1-160

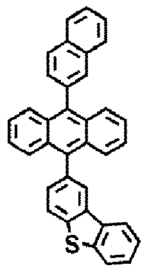

1-161

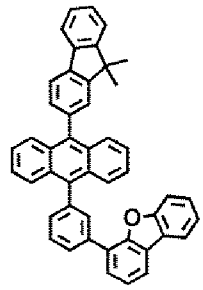

1-162

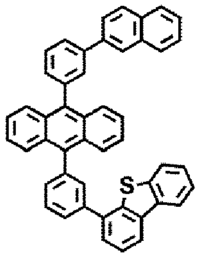

1-163

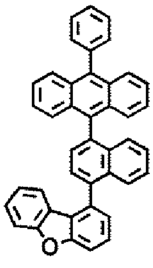

1-164

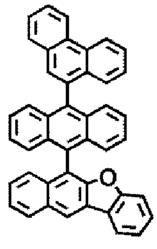

1-165

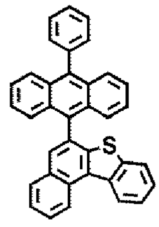

1-166

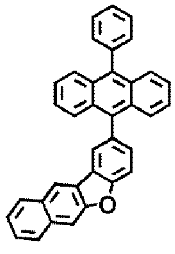

1-167

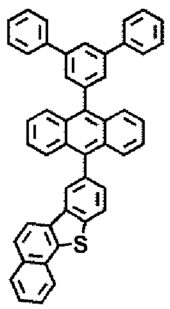

1-168

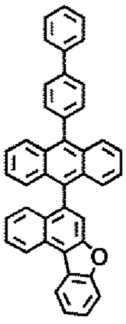

1-169

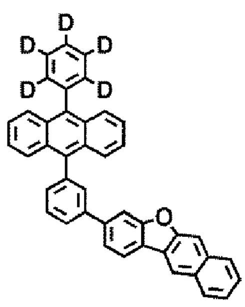

1-170

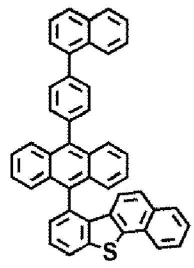

1-171

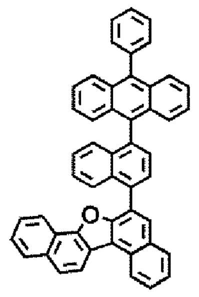

1-172

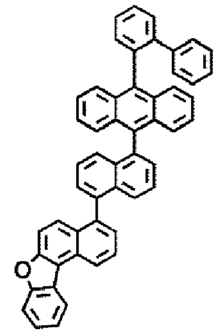
1-173

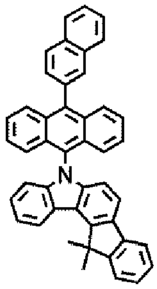
1-174

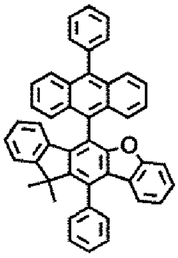
1-175

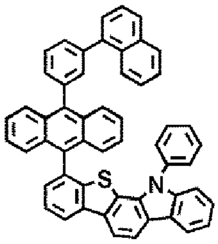
1-176

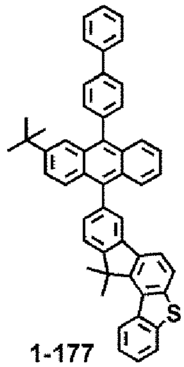
1-177

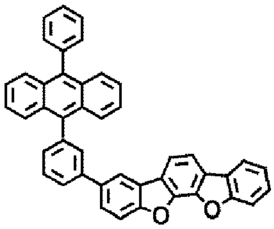
1-178

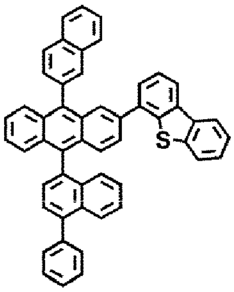
1-179

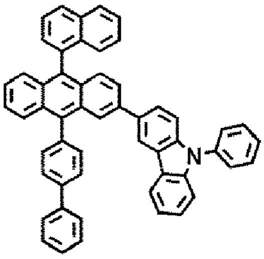
1-180

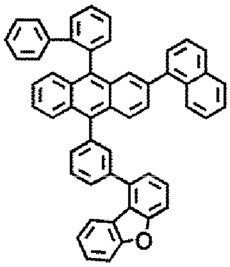
1-181

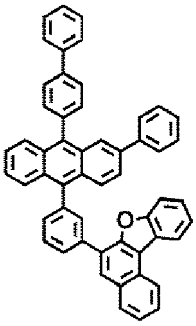
1-182

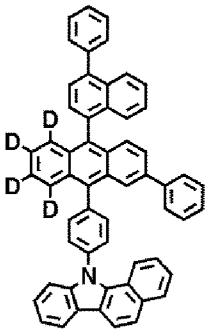
1-183

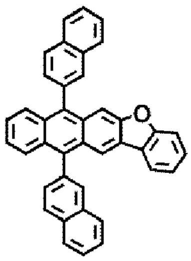
1-184

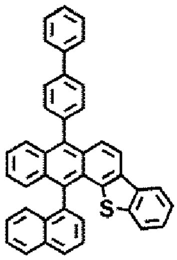
1-185

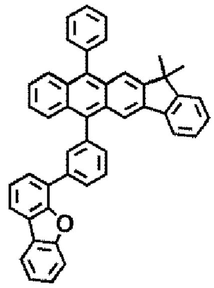
1-186

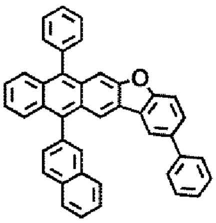
1-187

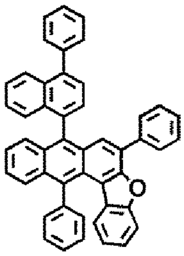
1-188

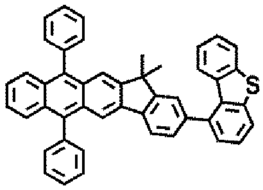
1-189

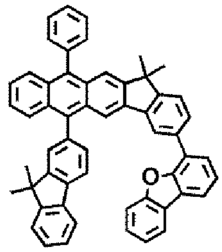
1-190

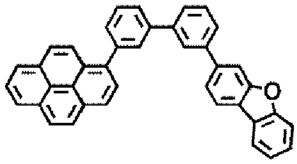
1-191

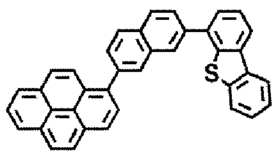
1-192

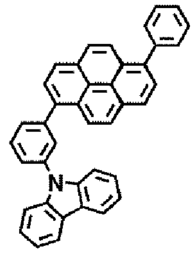
1-193

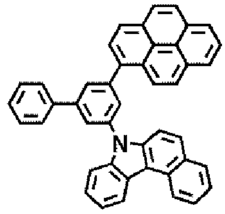
1-194

.

In various embodiments, the second compound may be selected from Compounds 2-1a to 2-172a and 2-1 to 2-262, but embodiments of the present disclosure are not limited thereto:

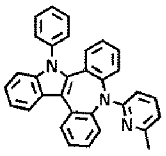
2-1a

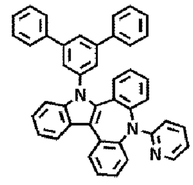
2-2a

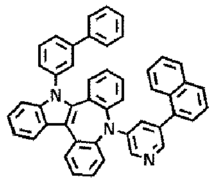
2-3a

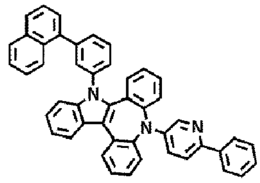
2-4a

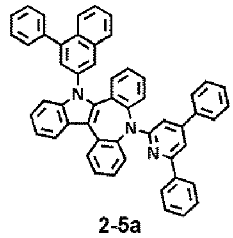
2-5a

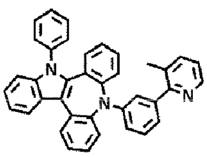
2-6a

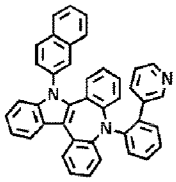
2-7a

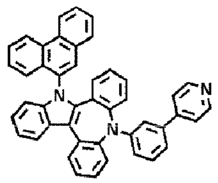
2-8a

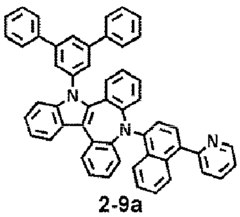
2-9a

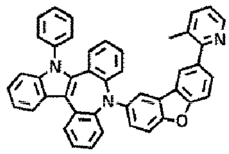
2-10a

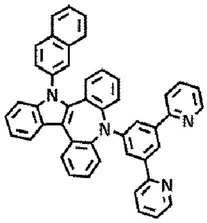
2-11a

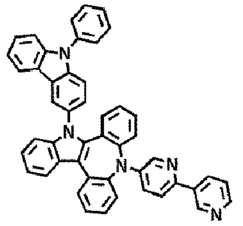
2-12a

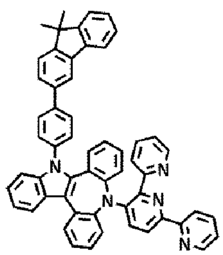
2-13a

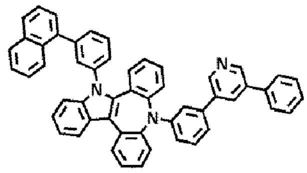
2-14a

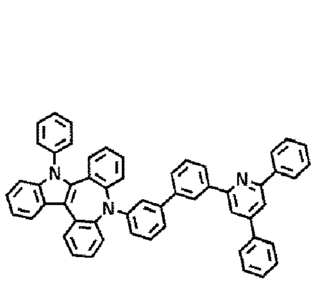
2-15a

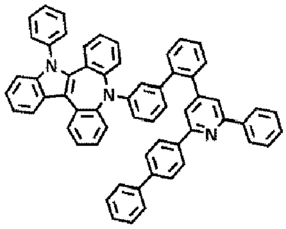
2-16a

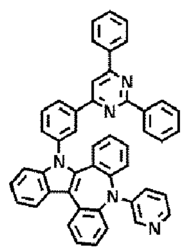
2-17a

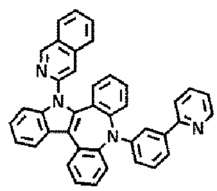
2-18a

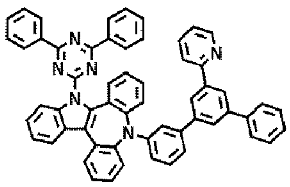
2-19a

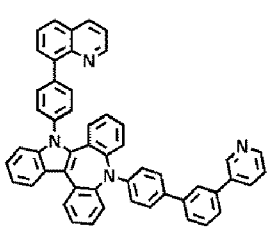
2-20a

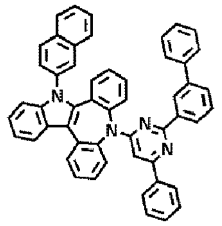
2-21a

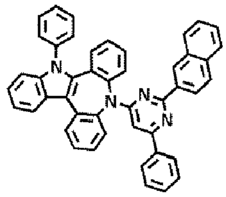
2-22a

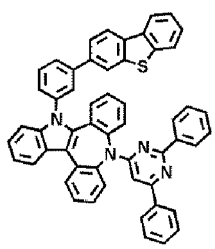
2-23a

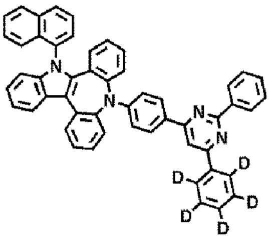
2-24a

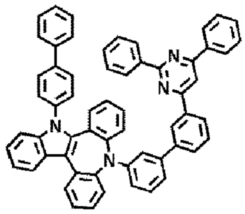
2-25a

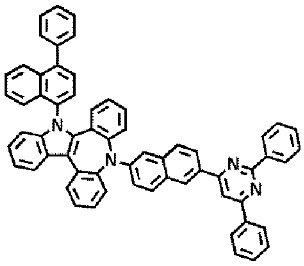
2-26a

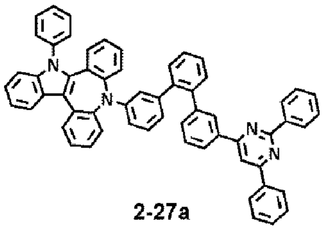
2-27a

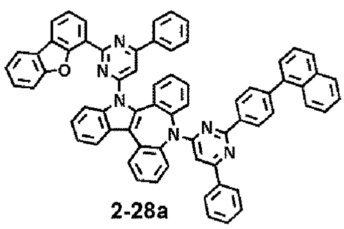
2-28a

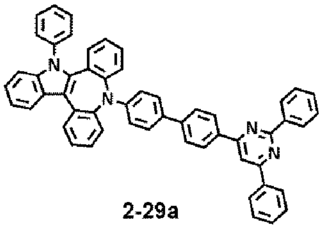
2-29a

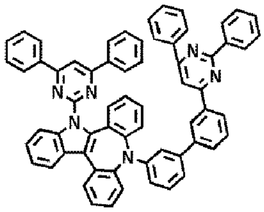
2-30a

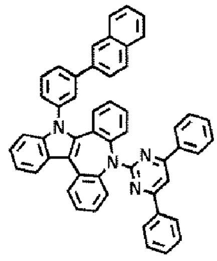
2-31a

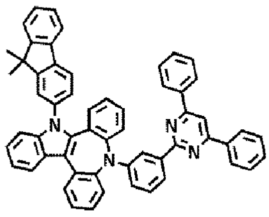
2-32a

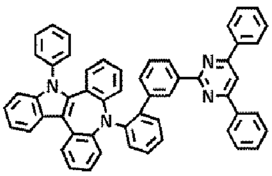
2-33a

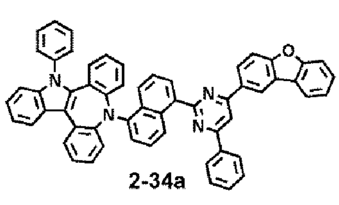
2-34a

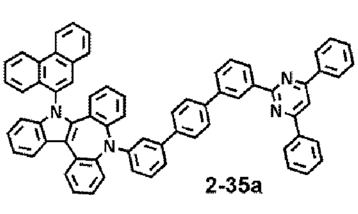
2-35a

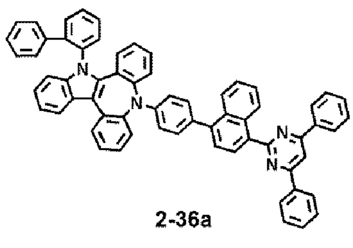
2-36a

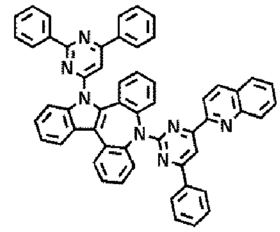
2-37a

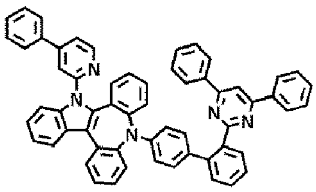
2-38a

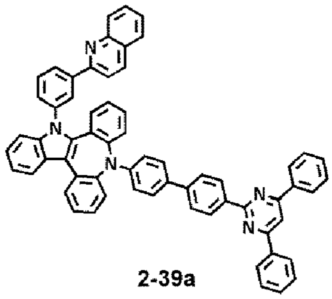
2-39a

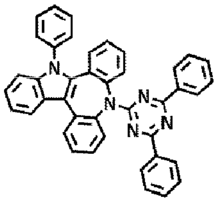
2-40a

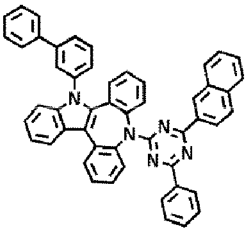
2-41a

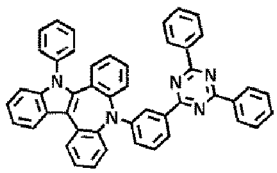
2-42a

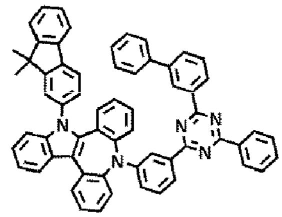
2-43a

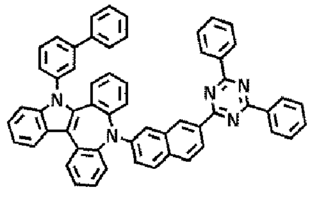
2-44a

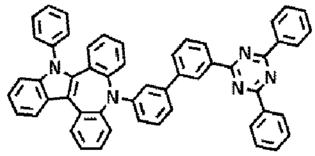
2-45a

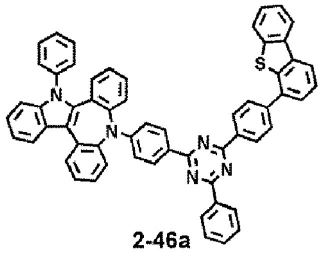
2-46a

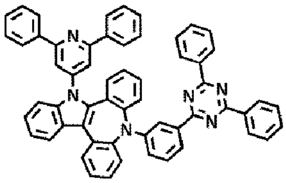
2-47a

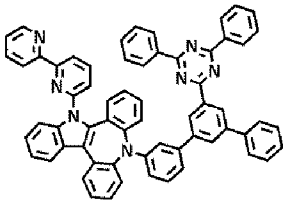
2-48a

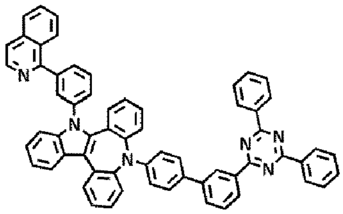
2-49a

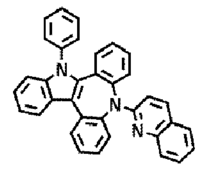
2-50a

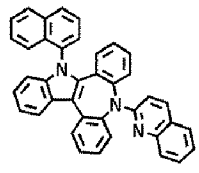
2-51a

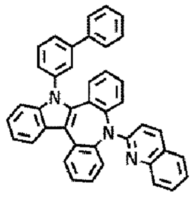
2-52a

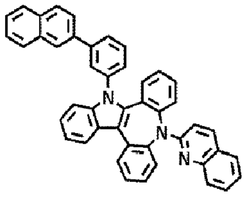
2-53a

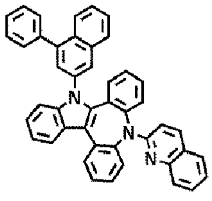
2-54a

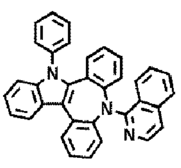
2-55a

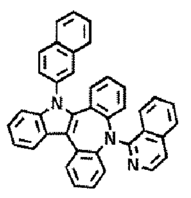
2-56a

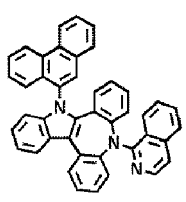
2-57a

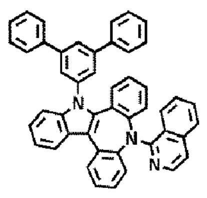
2-58a

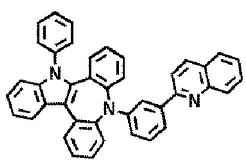
2-59a

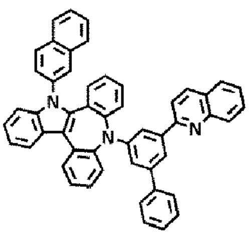
2-60a

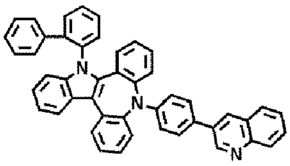
2-61a

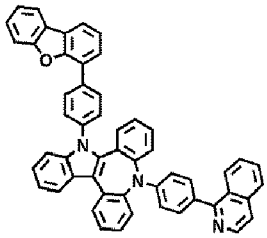
2-62a

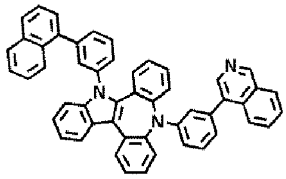
2-63a

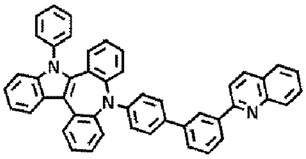
2-64a

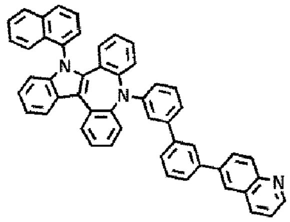
2-65a

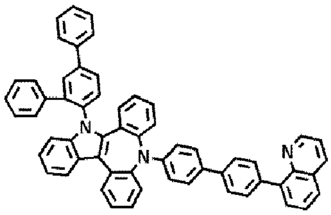
2-66a

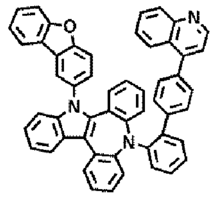
2-67a

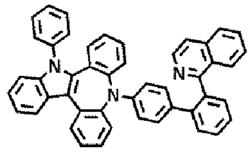
2-68a

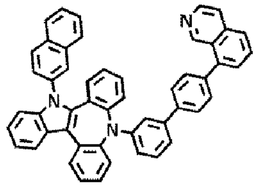
2-69a

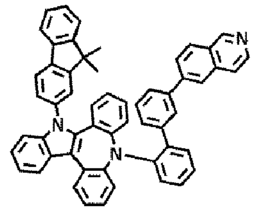
2-70a

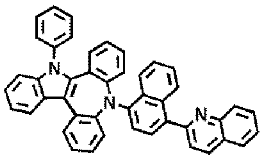
2-71a

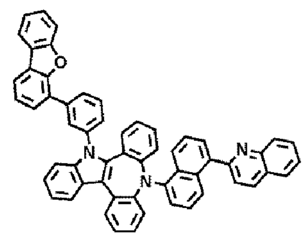
2-72a

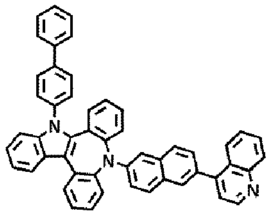
2-73a

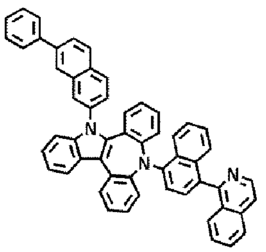
2-74a

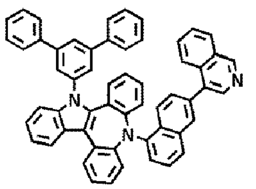
2-75a

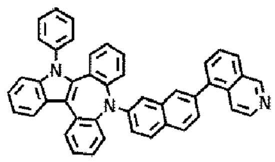
2-76a

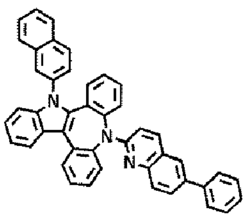
2-77a

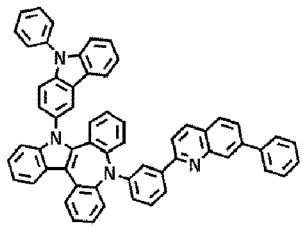
2-78a

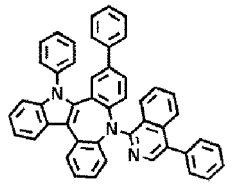
2-79a

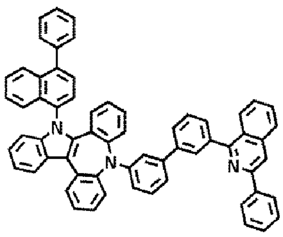

2-80a

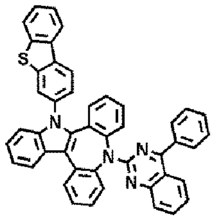

2-81a

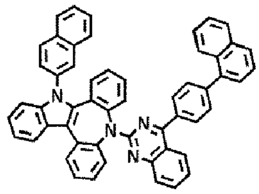

2-82a

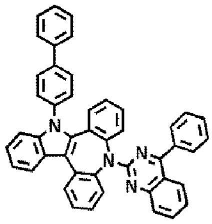

2-83a

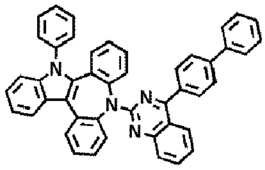

2-84a

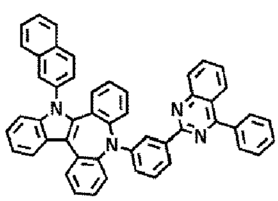

2-85a

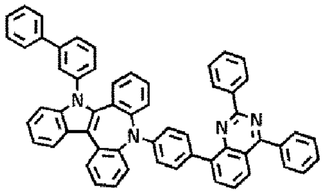

2-86a

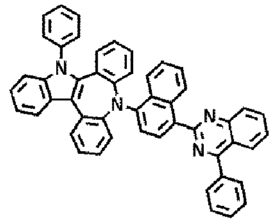

2-87a

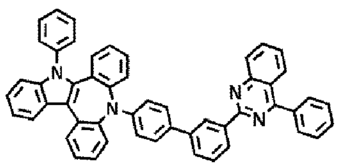

2-88a

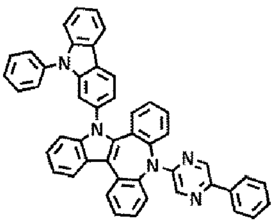

2-89a

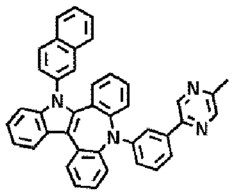

2-90a

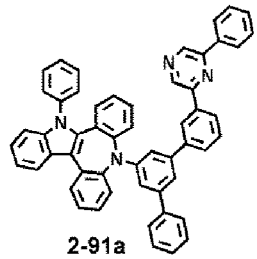

2-91a

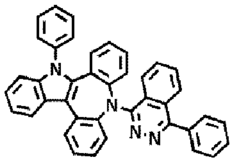

2-92a

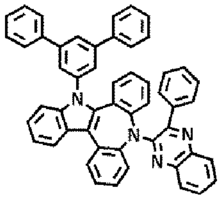

2-93a

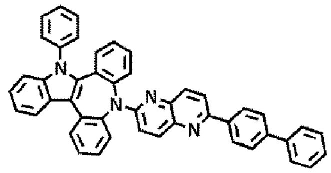

2-94a

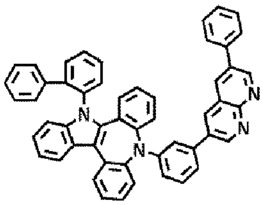

2-95a

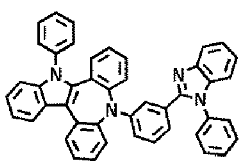

2-96a

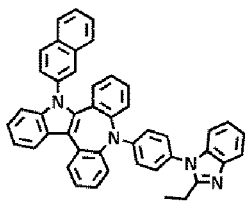

2-97a

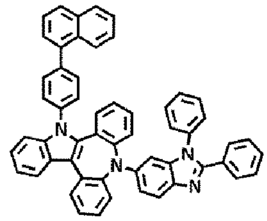

2-98a

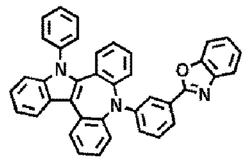

2-99a

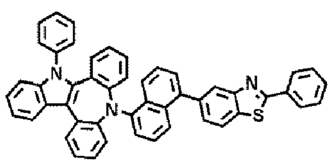

2-100a

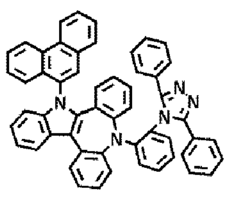

2-101a

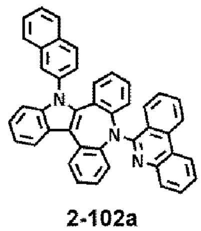

2-102a

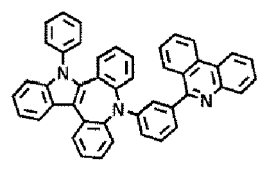

2-103a

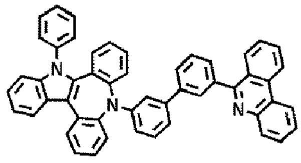
2-104a

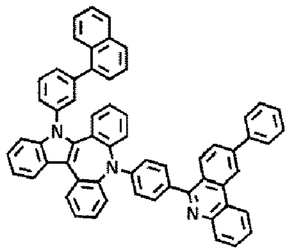
2-105a

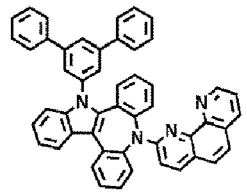
2-106a

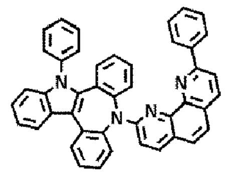
2-107a

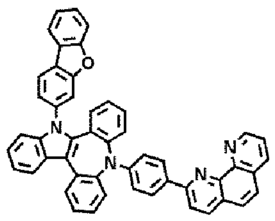
2-108a

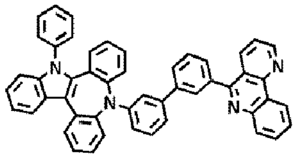
2-109a

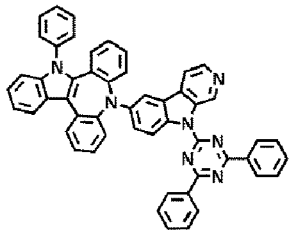
2-110a

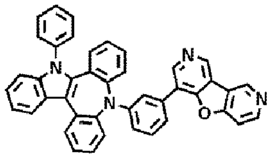
2-111a

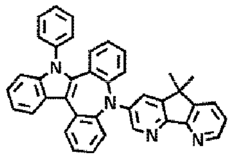
2-112a

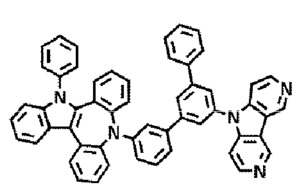
2-113a

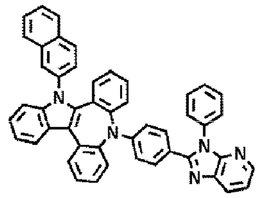
2-114a

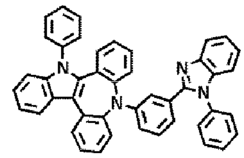
2-115a

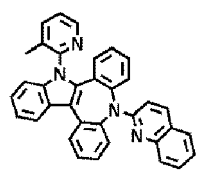
2-116a

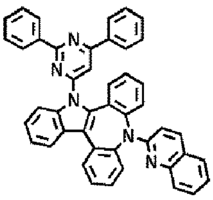
2-117a

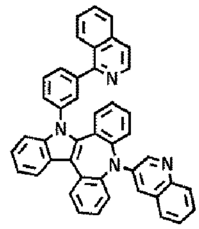
2-118a

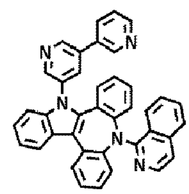
2-119a

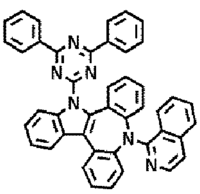
2-120a

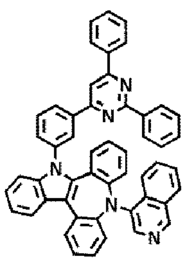
2-121a

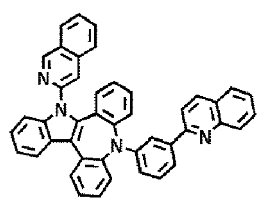
2-122a

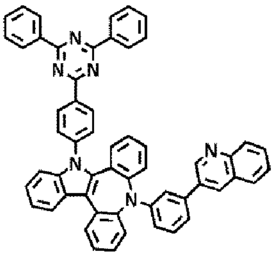
2-123a

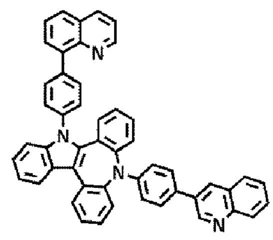
2-124a

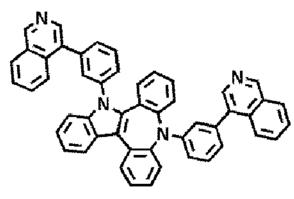

2-125a

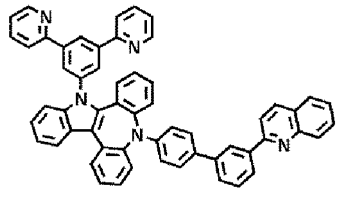

2-126a

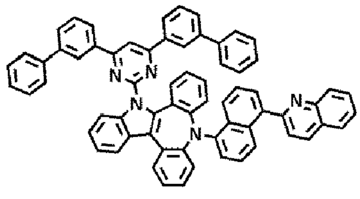

2-127a

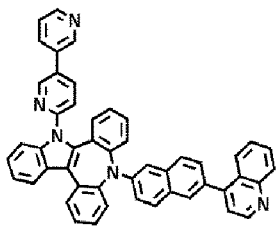

2-128a

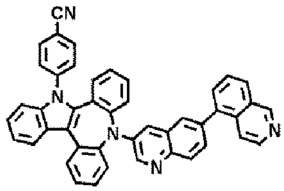

2-129a

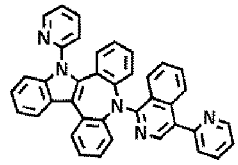

2-130a

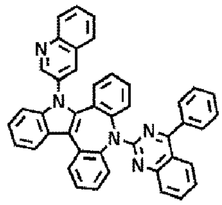

2-131a

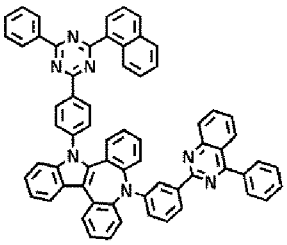

2-132a

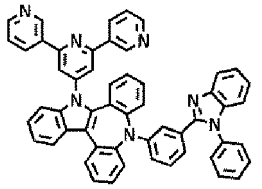

2-133a

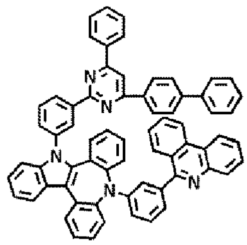

2-134a

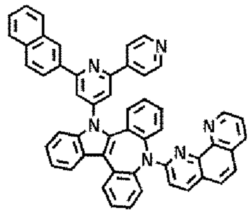

2-135a

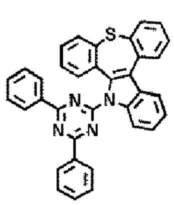

2-136a

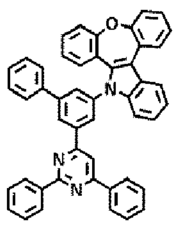

2-137a

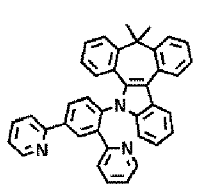

2-138a

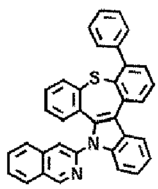

2-139a

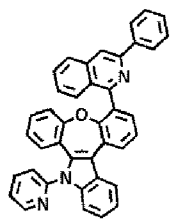

2-140a

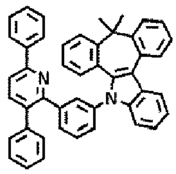

2-141a

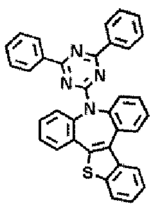

2-142a

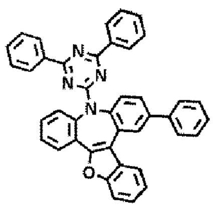

2-143a

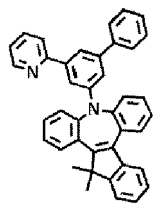

2-144a

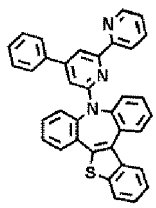

2-145a

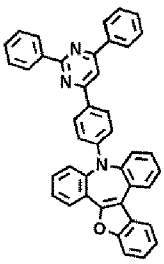

2-146a

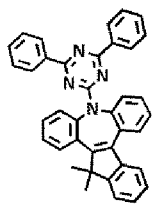

2-147a

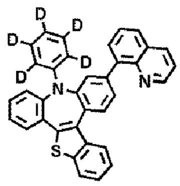
2-148a
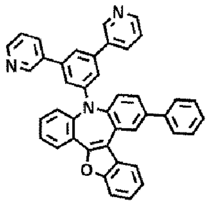
2-149a
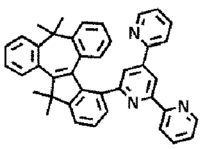
2-150a
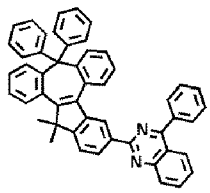
2-151a
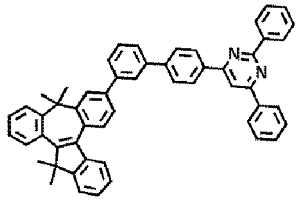
2-152a

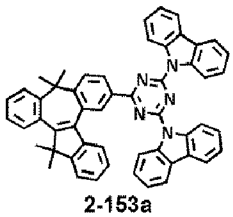
2-153a
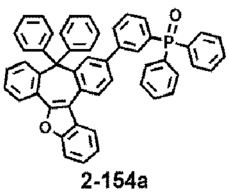
2-154a
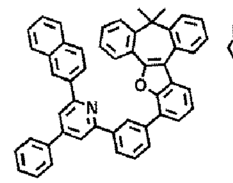
2-155a
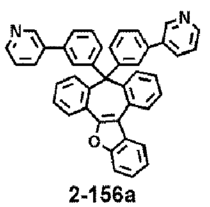
2-156a
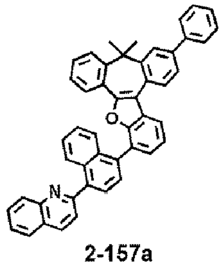
2-157a

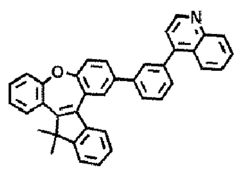
2-158a
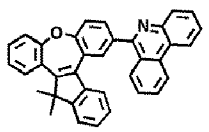
2-159a
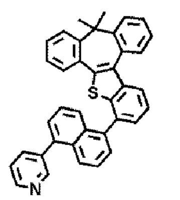
2-160a
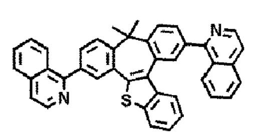
2-161a
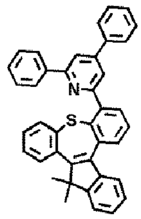
2-162a

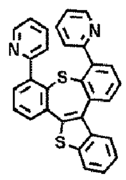
2-163a
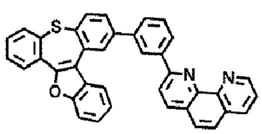
2-164a
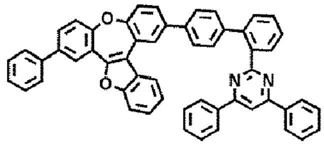
2-165a
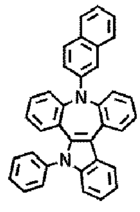
2-166a
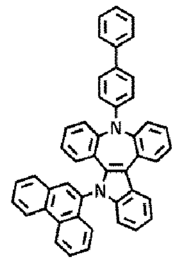
2-167a

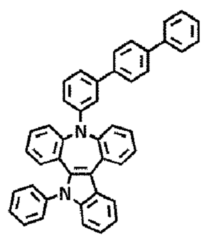
2-168a
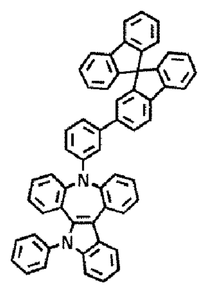
2-169a
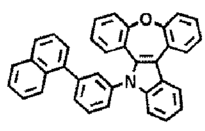
2-170a
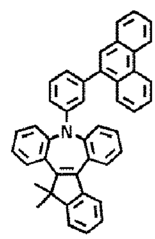
2-171a
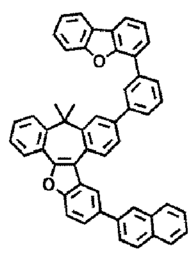
2-172a

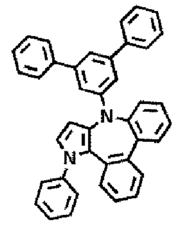
2-1

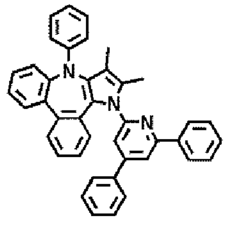
2-2

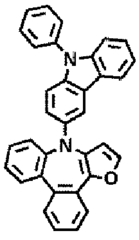
2-3

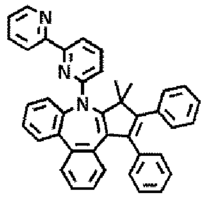
2-4

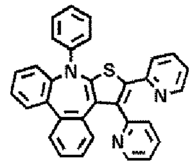
2-5

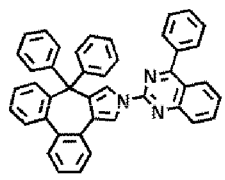
2-6

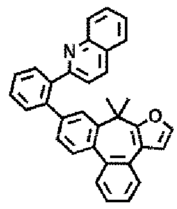
2-7

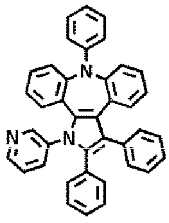
2-8

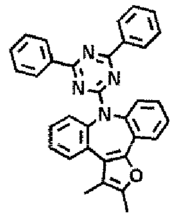
2-9

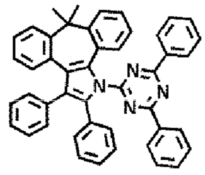
2-10

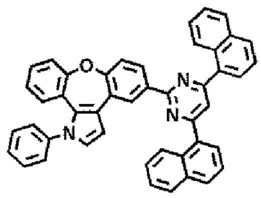
2-11

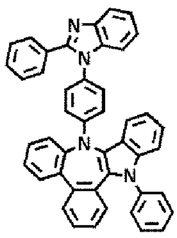
2-12

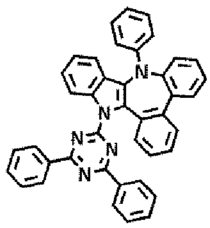
2-13

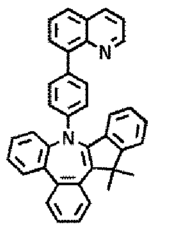
2-14

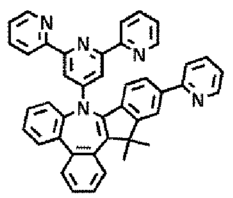
2-15

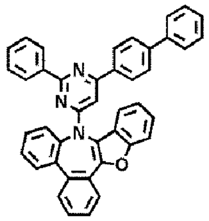
2-16

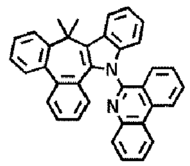
2-17

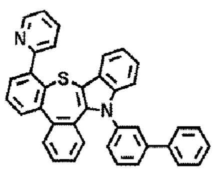
2-18

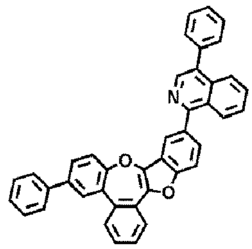
2-19

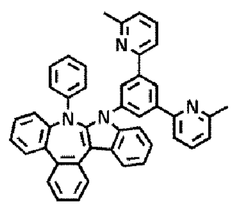
2-20

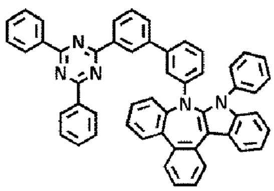
2-21

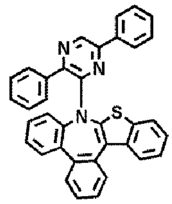
2-22

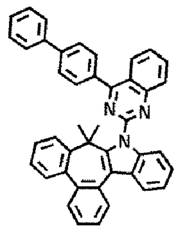
2-23

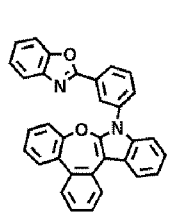
2-24

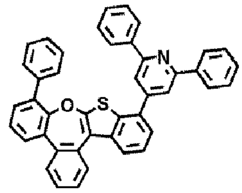
2-25

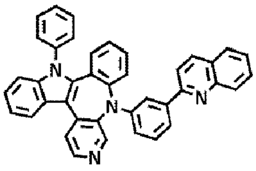
2-26

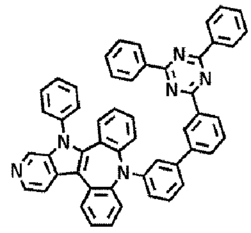
2-27

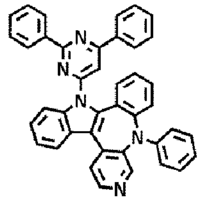
2-28

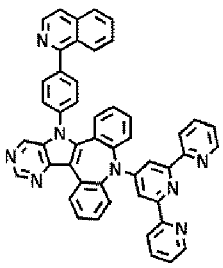
2-29

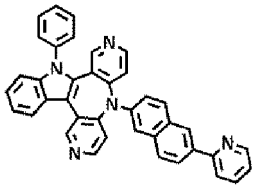
2-30

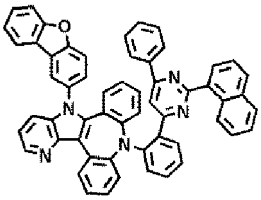
2-31

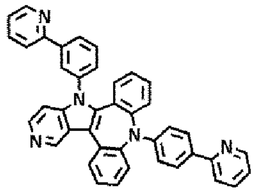
2-32

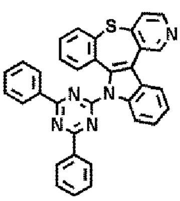
2-33

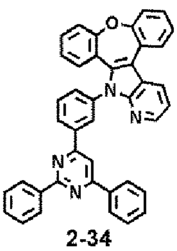
2-34

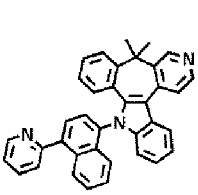
2-35

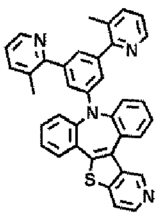
2-36

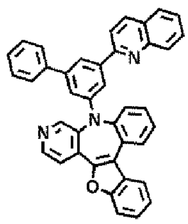
2-37

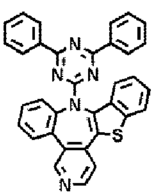
2-38

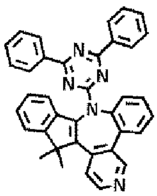
2-39

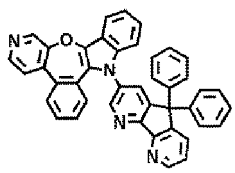
2-40

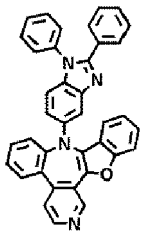
2-41

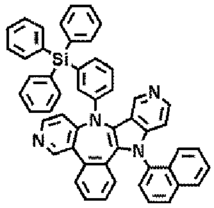
2-42

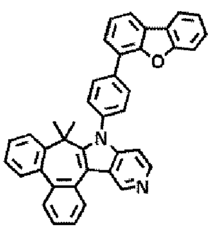
2-43

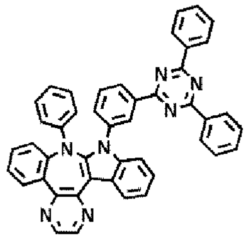
2-44

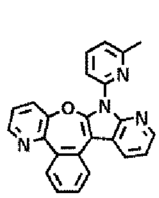
2-45

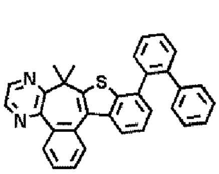
2-46

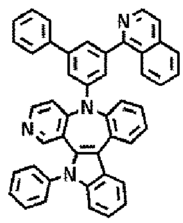
2-47

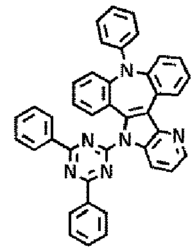
2-48

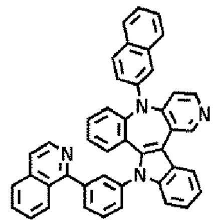
2-49

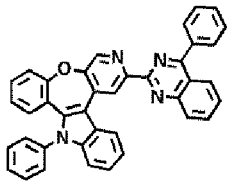
2-50

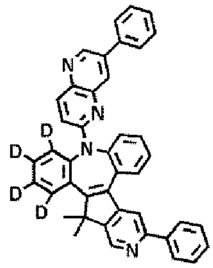
2-51

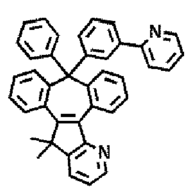
2-52

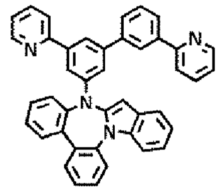
2-53

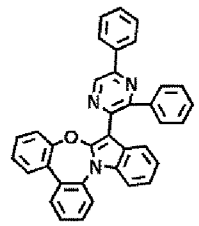
2-54

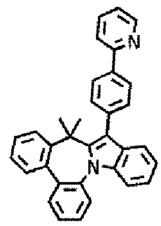
2-55

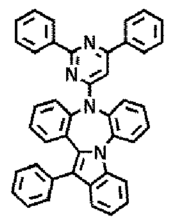
2-56

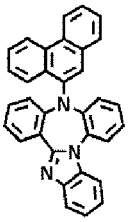
2-57

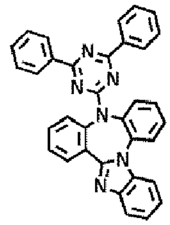
2-58

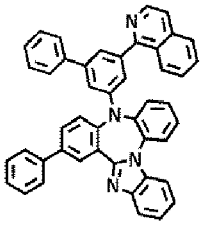
2-59

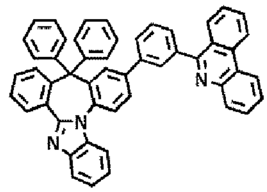
2-60

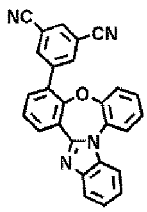
2-61

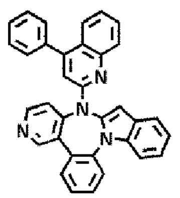
2-62

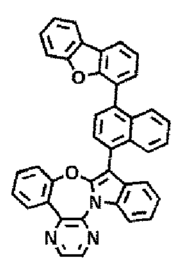
2-63

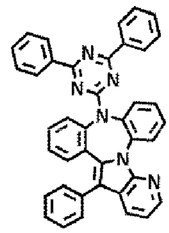
2-64

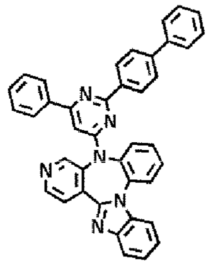
2-65

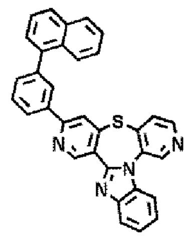
2-66

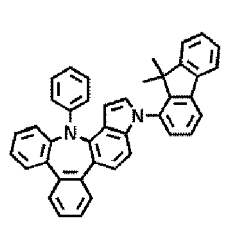
2-67

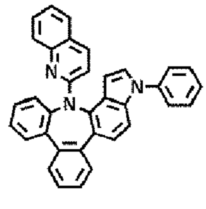
2-68

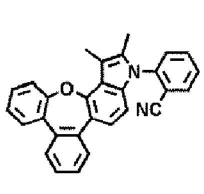
2-69

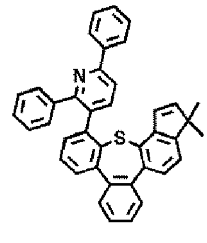
2-70

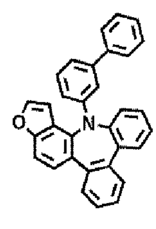
2-71

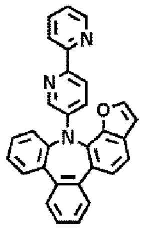
2-72

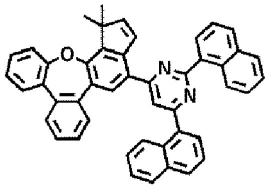
2-73

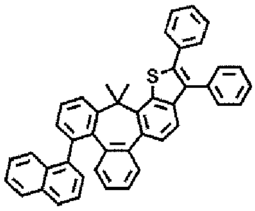
2-74

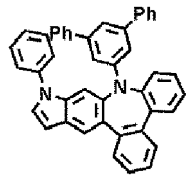
2-75

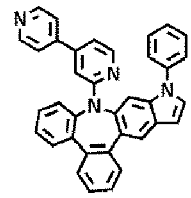
2-76

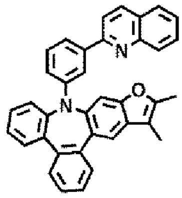
2-77

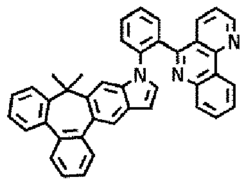
2-78

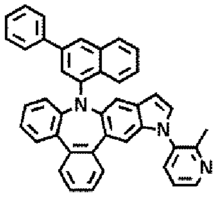
2-79

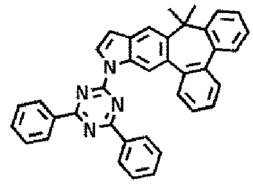
2-80

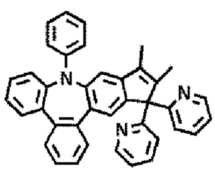
2-81

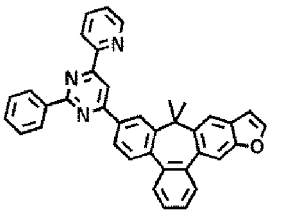
2-82

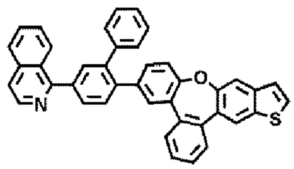
2-83

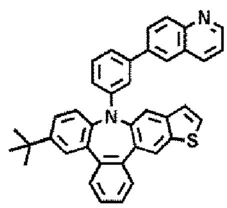
2-84

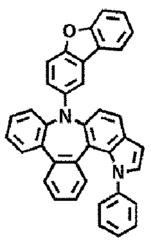
2-85

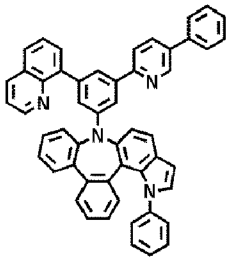
2-86

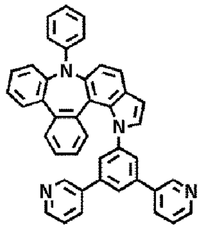
2-87

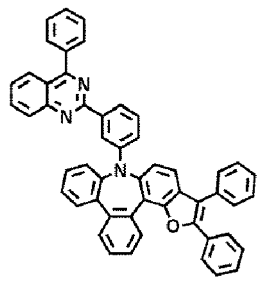
2-88

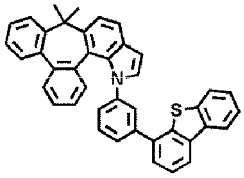
2-89

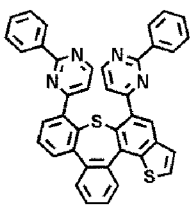
2-90

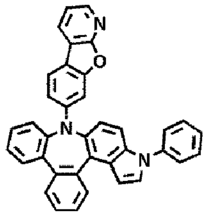
2-91

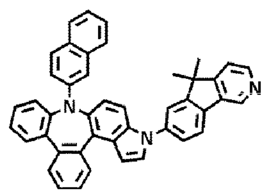
2-92

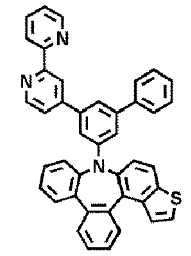
2-93

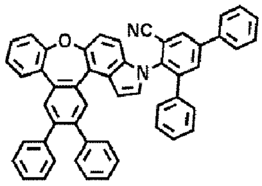
2-94

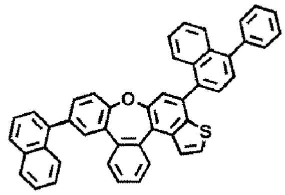
2-95

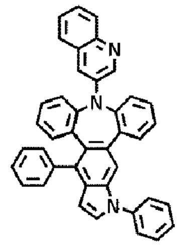
2-96

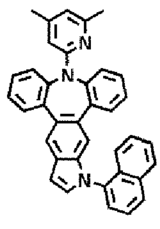
2-97

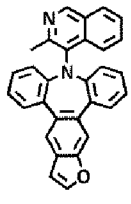
2-98

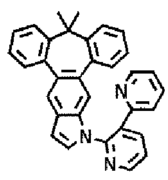
2-99

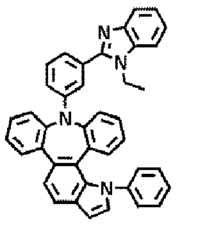
2-100

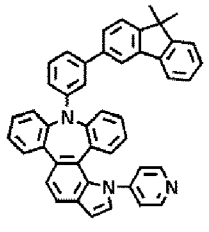
2-101

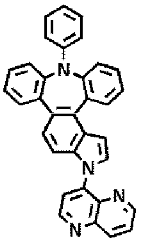
2-102

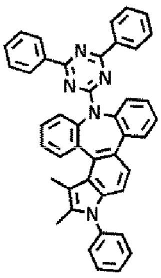
2-103

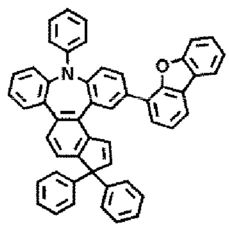
2-104

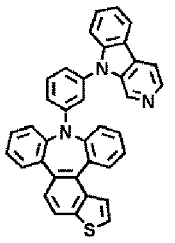
2-105

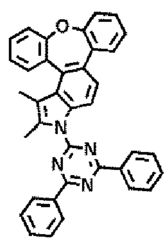
2-106

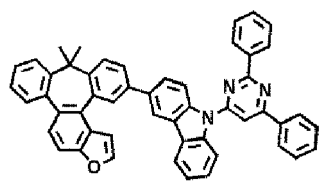
2-107

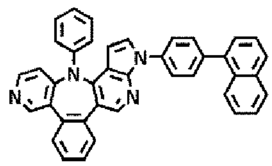
2-108

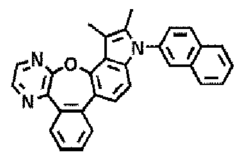
2-109

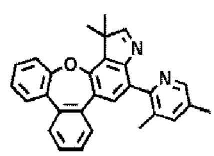
2-110

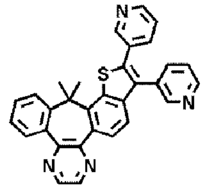
2-111

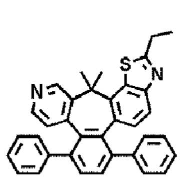
2-112

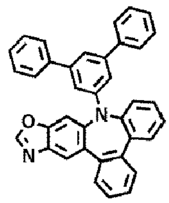
2-113

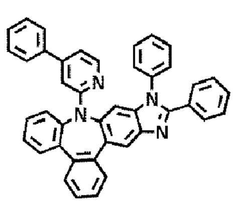
2-114

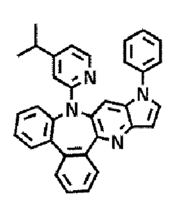
2-115

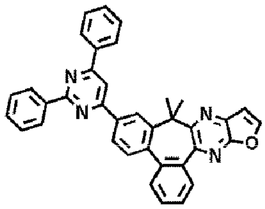
2-116

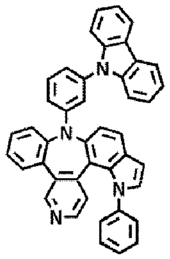
2-117

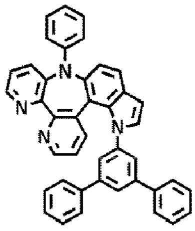
2-118

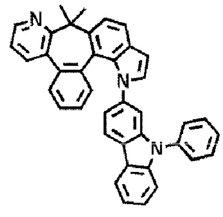
2-119

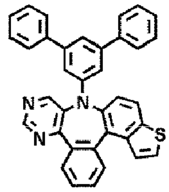
2-120

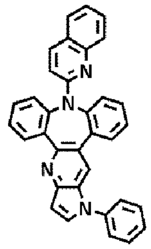
2-121

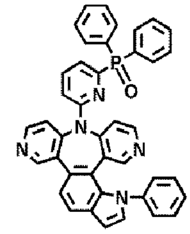
2-122

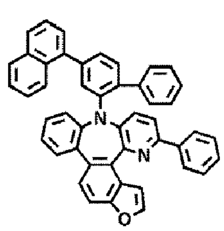
2-123

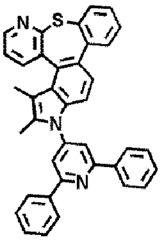
2-124

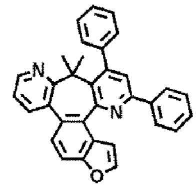
2-125

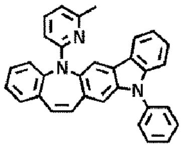
2-126

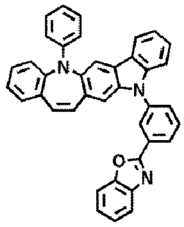
2-127

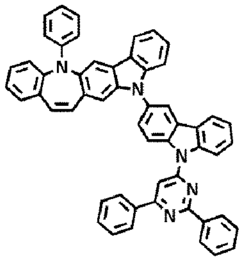
2-128

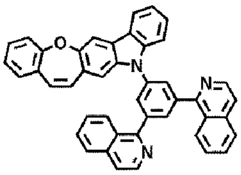
2-129

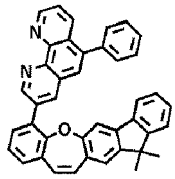
2-130

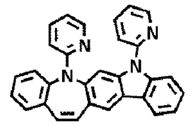
2-131

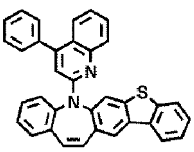
2-132

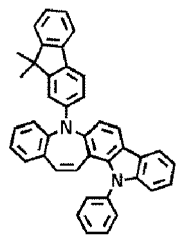
2-133

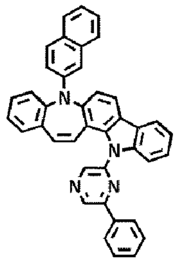
2-134

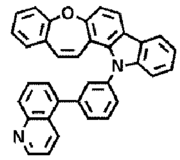
2-135

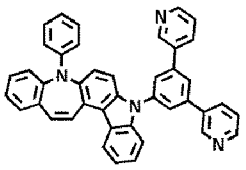
2-136

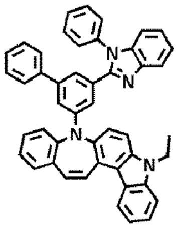
2-137

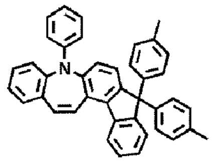
2-138

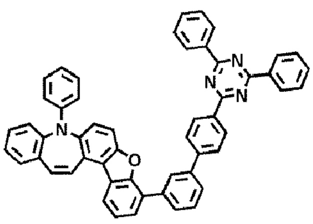
2-139

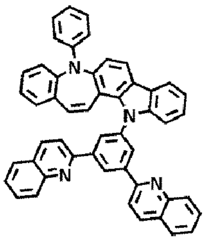
2-140

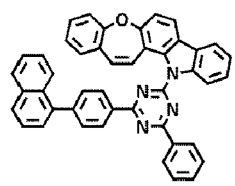
2-141

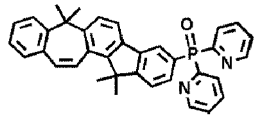
2-142

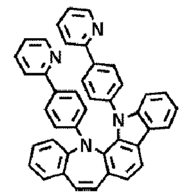
2-143

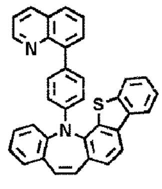
2-144

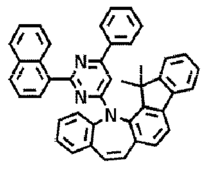
2-145

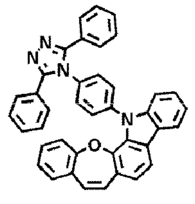
2-146

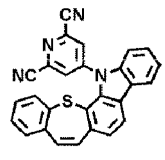
2-147

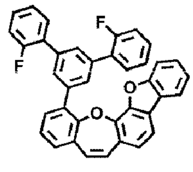
2-148

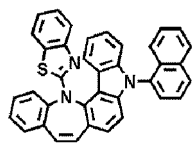
2-149

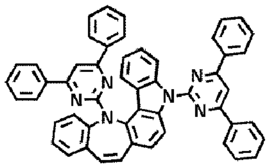
2-150

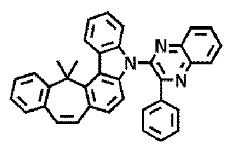
2-151

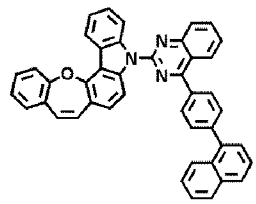
2-152

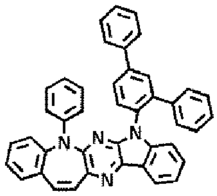
2-153

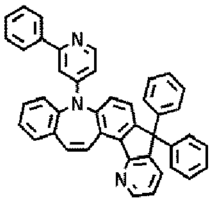
2-154

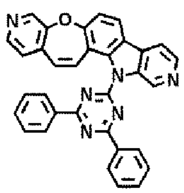
2-155

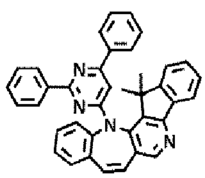
2-156

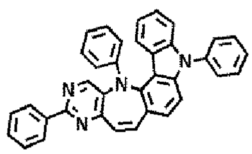
2-157

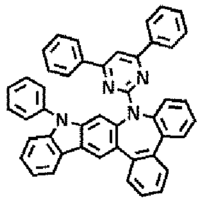
2-158

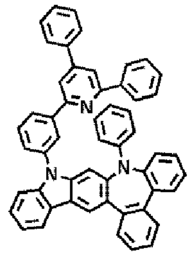
2-159

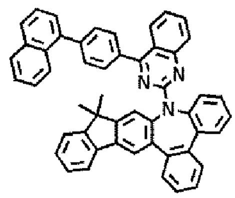
2-160

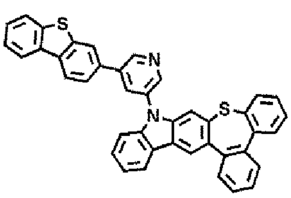
2-161

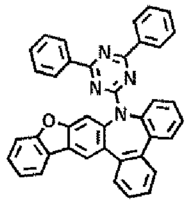
2-162

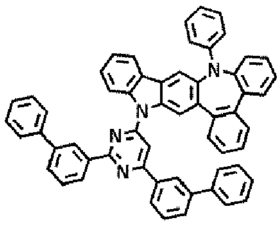
2-163

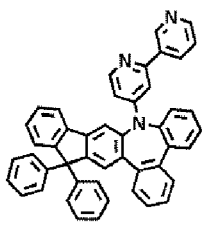
2-164

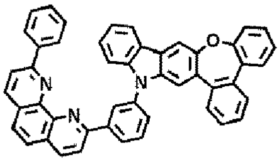
2-165

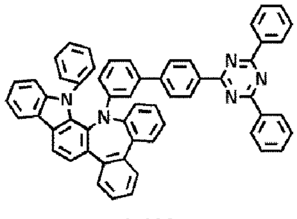
2-166

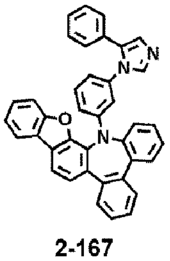
2-167

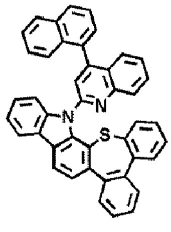
2-168

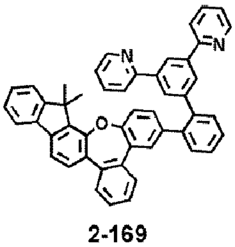
2-169

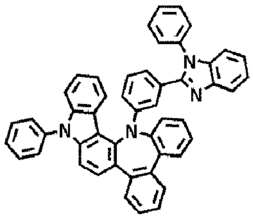
2-170

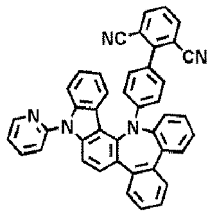
2-171

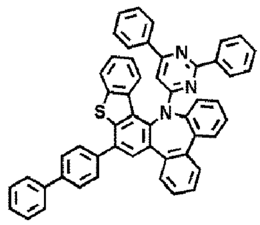
2-172

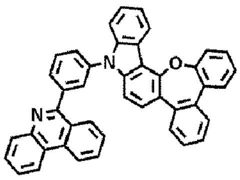
2-173

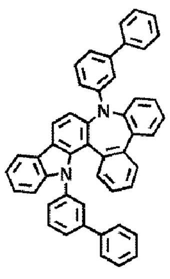
2-174

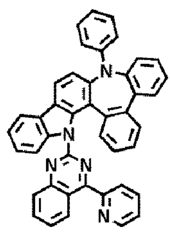
2-175

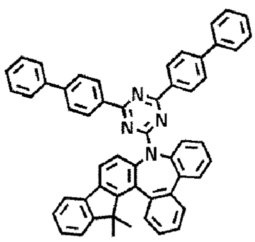
2-176

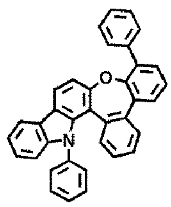
2-177

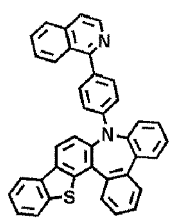
2-178

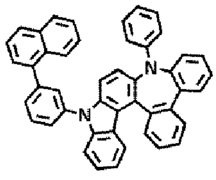
2-179

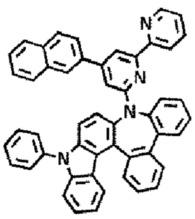
2-180

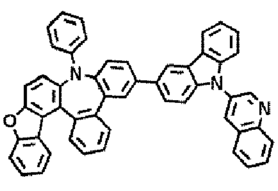
2-181

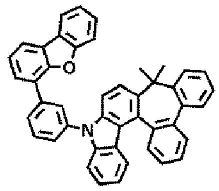
2-182

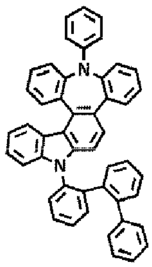
2-183

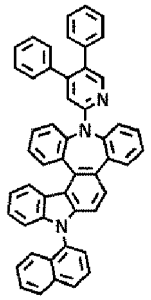
2-184

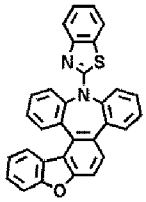
2-185

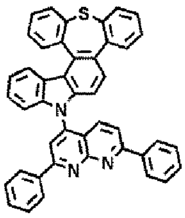
2-186

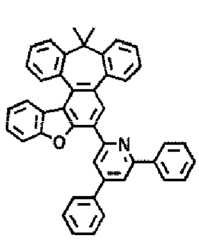
2-187

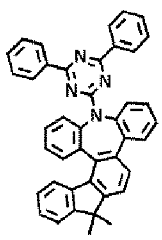
2-188

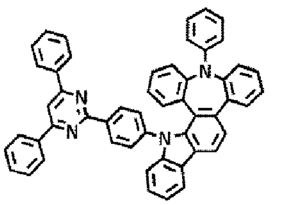
2-189

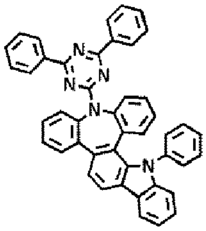
2-190

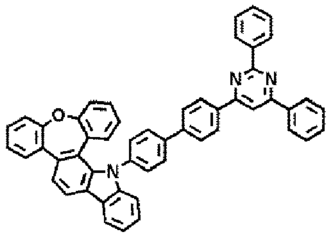
2-191

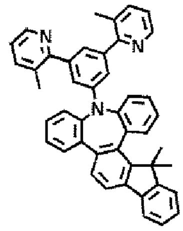
2-192

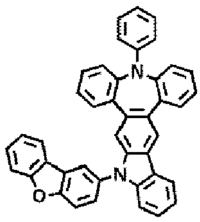
2-193

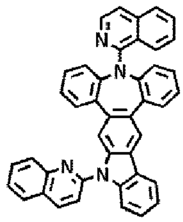
2-194

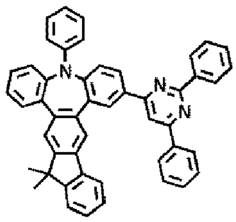
2-195

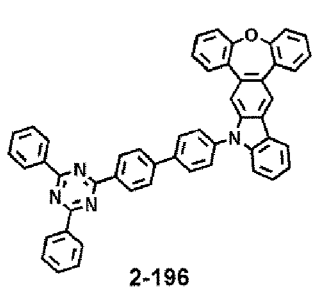
2-196

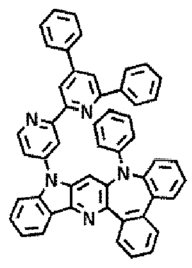
2-197

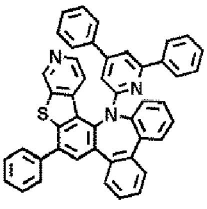
2-198

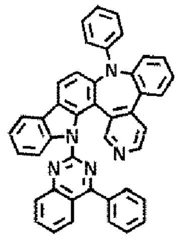
2-199

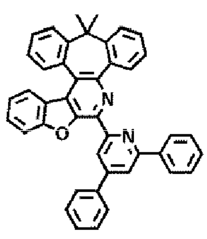
2-200

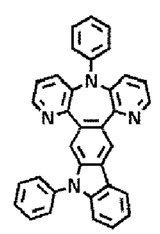
2-201

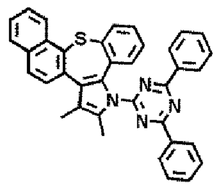
2-202

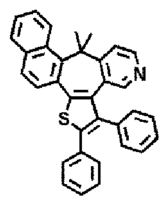
2-203

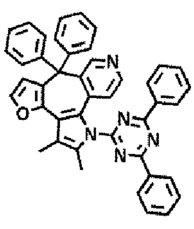
2-204

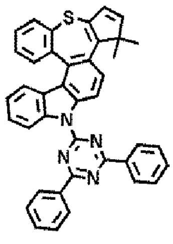
2-205

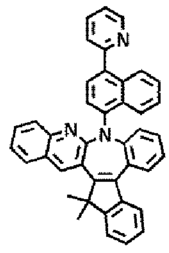
2-206

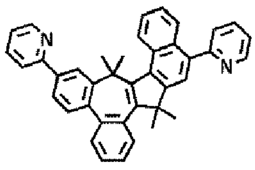
2-207

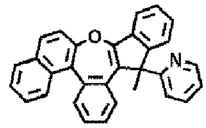
2-208

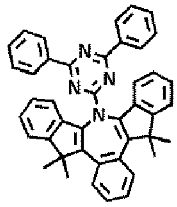
2-209

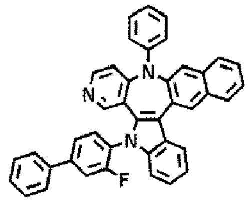
2-210

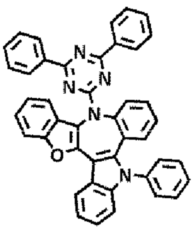
2-211

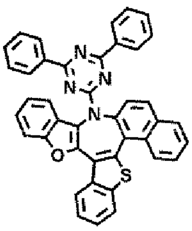
2-212

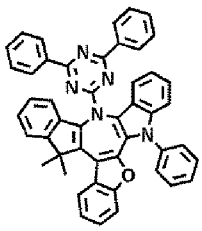
2-213

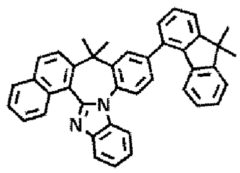
2-214

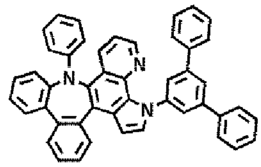
2-215

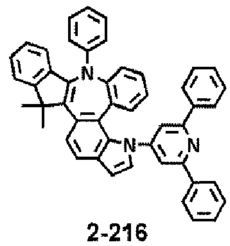
2-216

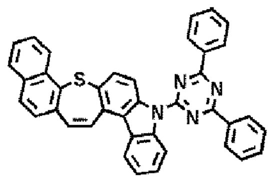
2-217

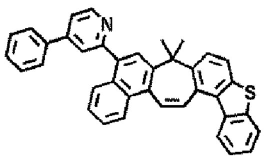
2-218

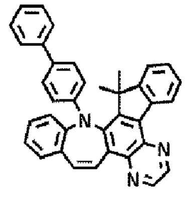
2-219

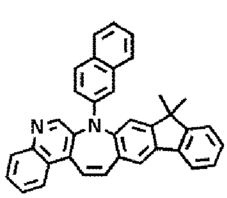
2-220

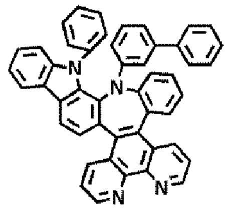
2-221

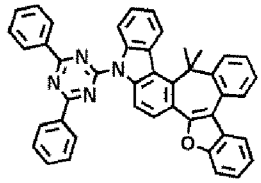
2-222

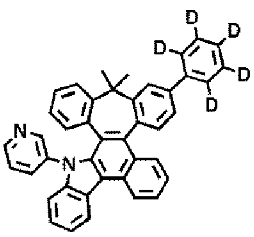
2-223

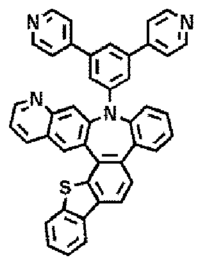
2-224

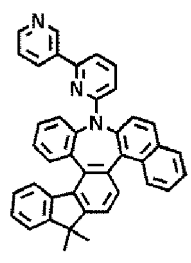
2-225

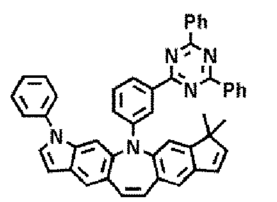
2-226

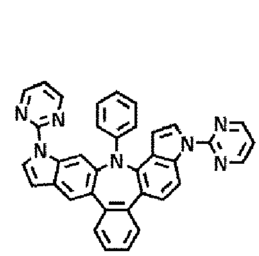
2-227

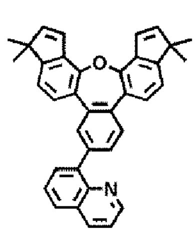
2-228

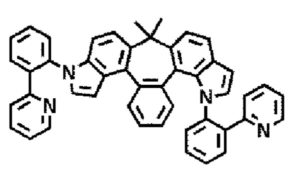
2-229

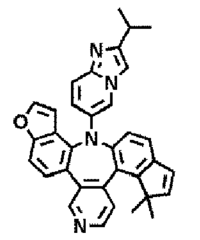
2-230

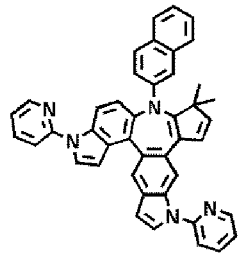
2-231

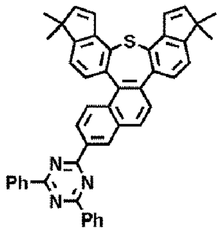
2-232

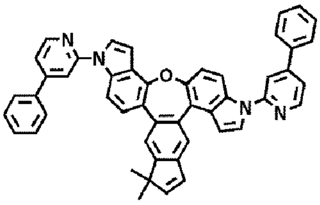
2-233

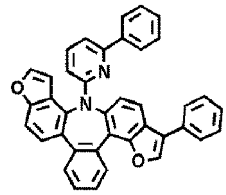
2-234

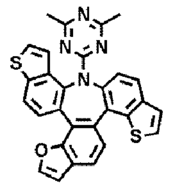
2-235

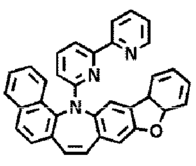
2-236

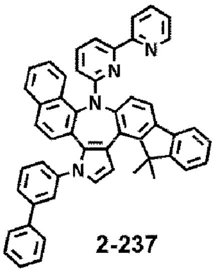
2-237

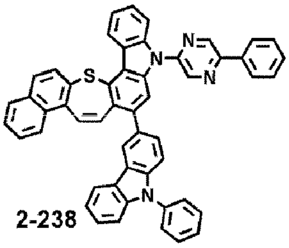
2-238

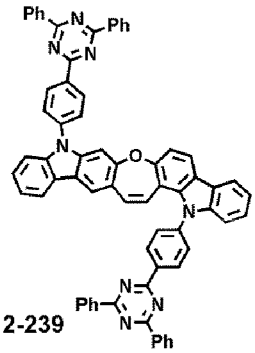
2-239

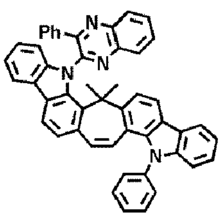
2-240

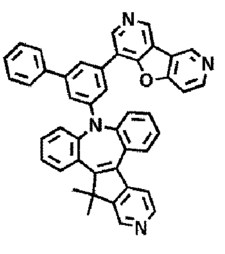
2-241

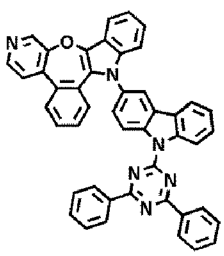
2-242

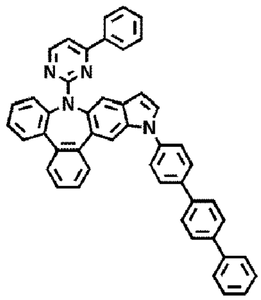
2-243

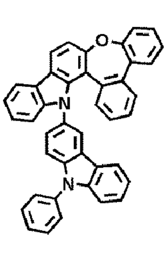
2-244

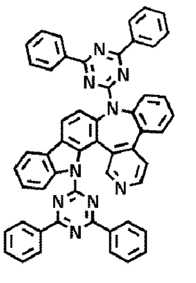
2-245

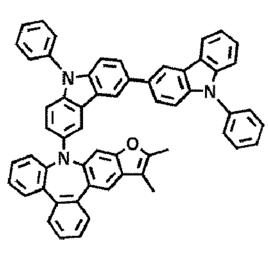
2-246

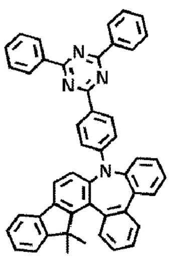
2-247

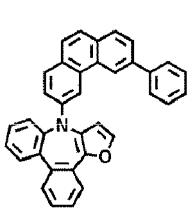 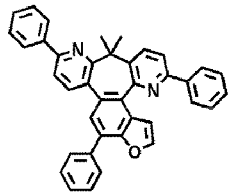 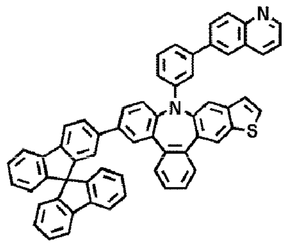 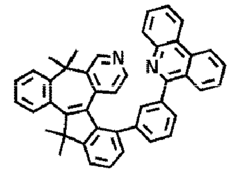

2-248 2-249 2-250 2-251

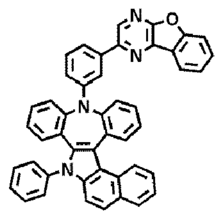 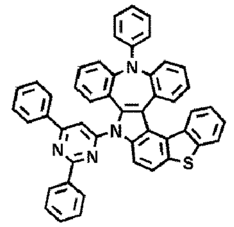 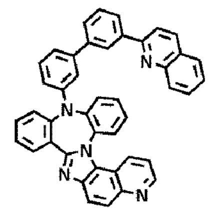 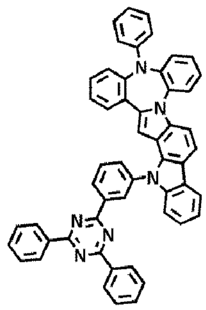

2-252 2-253 2-254 2-255

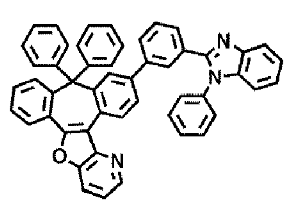 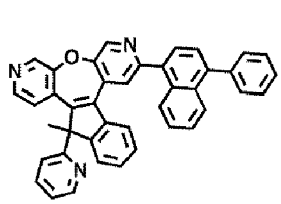 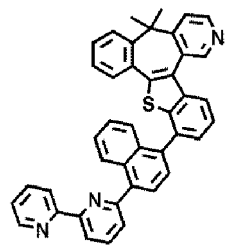 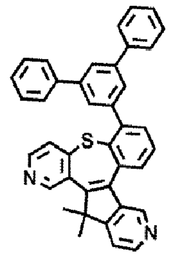

2-256 2-257 2-258 2-259

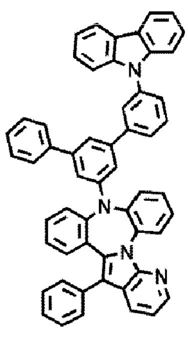 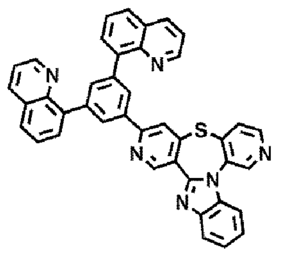 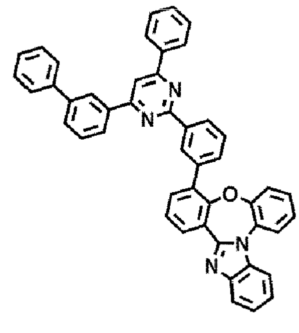

2-260 2-261 2-262

Any suitable combinations of ring $A_1$, ring $A_2$, $X_1$, $L_1$ to $L_3$, a1 to a3, $Ar_1$ to $Ar_3$, $R_1$, $R_2$, b1, b2, c1 to c3, d11, and d12 in Formula 1 may be applicable within the scope described herein.

Any suitable combinations of ring $A_{21}$, ring $A_{22}$, ring $A_{23}$, $X_{21}$, and $T_{11}$ to $T_{14}$ in Formulae 2A and 2B may be applicable within the scope described herein.

Any suitable combinations of*-$[(L_{22})_{a22}$-$(R_{22})_{b22}]$, $C(R_{23})(R_{24})$, $Si(R_{23})(R_{24})$, and N-$[(L_{21})_{a21}$-$(R_{21})_{b21}]$ maybe applicable within the scope of $L_{21}$, $L_{22}$, a2i, a22, $R_{21}$ to $R_{24}$, b21, and b22 described herein.

In various embodiments, in the organic light-emitting device, the first electrode may be an anode, the second electrode may be a cathode, the organic layer may comprise an emission layer and an electron transport region between the second electrode and the emission layer, the emission layer may comprise the first compound, and the electron transport region may comprise the second compound.

Since the emission layer of the organic light-emitting device comprises the first compound and at least one selected from the hole transport region and the electron transport region comprises the second compound, a balance of electrons and/or holes injected or transported into the emission layer may be easily adjusted, thus reducing or preventing a leakage current from occurring. Thus, the organic light-emitting device may have low driving voltage and high efficiency characteristics.

In various embodiments, triplet energy of the second compound may be about 2.2 eV or more. For example, the triplet energy of the second compound may be about 2.3 eV or more, or may be about 2.4 eV or more.

When the triplet energy of the second compound is within these ranges, it is expected that the emission efficiency of a fluorescent organic light-emitting device will be improved due to triplet-triplet fusion (TTF). In a phosphorescent organic light-emitting device, it is possible to reduce or prevent a reduction in efficiency of an organic light-emitting device by blocking transition of triplet excitons formed in an emission layer.

For example, the emission layer may comprise a first host and a second host, wherein the first host may comprise the first compound.

In various embodiments, the hole transport region may comprise an emission auxiliary layer, the emission auxiliary layer may directly contact the emission layer, and the second compound may be comprised in the emission auxiliary layer.

In various embodiments, the electron transport region may comprise a buffer layer, the buffer layer may directly contact the emission layer, and the second compound may be comprised in the buffer layer, but embodiments of the present disclosure are not limited thereto.

When both the hole transport region and the electron transport region in the organic light-emitting device comprise the second compound described above, the second compound comprised in the hole transport region and the second compound comprised in the electron transport region may be identical to or different from each other.

Description of **FIG. 1**

FIG. 1 is a schematic view of an organic light-emitting device 10 according to an embodiment. The organic light-emitting device 10 may comprise a first electrode 110, an organic layer 150, and a second electrode 190.

Hereinafter, the structure of the organic light-emitting device 10 according to an embodiment and a method of manufacturing the organic light-emitting device 10 according to an embodiment will be described in connection with FIG. 1.

**First electrode 110**

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing or sputtering a material for forming the first electrode 110 on the substrate. When the first electrode 110 is an anode, the material for forming the first electrode 110 may be selected from materials with a high work function to facilitate hole injection.

The first electrode 110 may be a reflective electrode, a semi-transmissive electrode, or a transmissive electrode. When the first electrode 110 is a transmissible electrode, a material for forming the first electrode 110 may be selected from indium tin oxide (ITO), indium zinc oxide (IZO), tin oxide ($SnO_2$) zinc oxide (ZnO), and combinations thereof, but embodiments of the present disclosure are not limited thereto. When the first electrode 110 is a semi-transmissive electrode or a reflective electrode, as a material for forming the first electrode 110, magnesium (Mg), silver (Ag), aluminum (Al), aluminum-lithium (Al-Li), calcium (Ca), magnesium-indium (Mg-In), magnesium-silver (Mg-Ag), or a combination thereof may be utilized. However, the material for forming the first electrode 110 is not limited thereto.

The first electrode 110 may have a single-layered structure, or a multi-layered structure comprising two or more layers. For example, the first electrode 110 may have a three-layered structure of ITO/Ag/ITO, but the structure of the first electrode 110 is not limited thereto.

**Organic layer 150**

The organic layer 150 is disposed on the first electrode 110. The organic layer 150 may comprise an emission layer.

The organic layer 150 may comprise a hole transport region between the first electrode 110 and the emission layer, and an electron transport region between the emission layer and the second electrode 190.

**Hole transport region in organic layer 150**

The hole transport region may have i) a single-layered structure including a single layer including a single material, ii) a single-layered structure including a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

For example, the hole transport region may have a single-layered structure including a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, wherein in each of these structures, constituting layers are sequentially stacked from the first electrode 110 in this stated order, but the structure of the hole transport region is not limited thereto.

The hole transport region may comprise the second compound as described above.

In various embodiments, the hole transport region may comprise an emission auxiliary layer. The emission auxiliary layer may directly contact the emission layer.

In various embodiments, the hole transport region may comprise a hole injection layer and a hole transport layer, may comprise a hole injection layer and an emission auxiliary layer, or may comprise a hole injection layer, a hole transport layer, and an emission auxiliary layer, wherein in each of these cases, constituting layers are sequentially stacked from the first electrode 110 in this stated order, but embodiments of the present disclosure are not limited thereto.

When the hole transport region comprises the emission auxiliary layer, the emission auxiliary layer may comprise the second compound as described above.

The hole transport region may comprise at least one selected from m-MTDATA, TDATA, 2-TNATA, NPB(NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (Pani /PSS), a compound represented by Formula 201, and a compound represented by Formula 202:

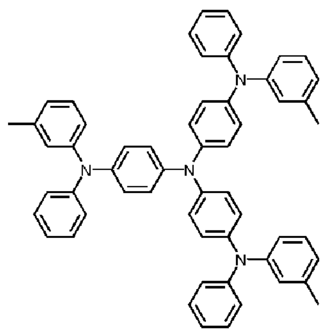

m-MTDATA

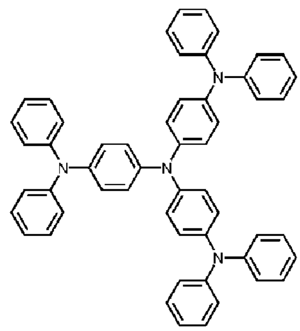

TDATA

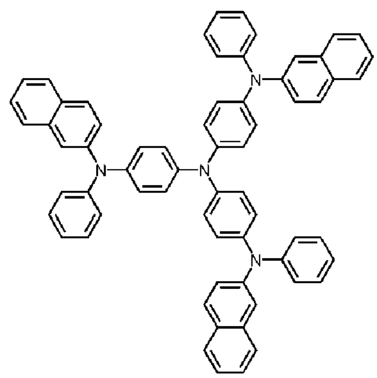

2-TNATA

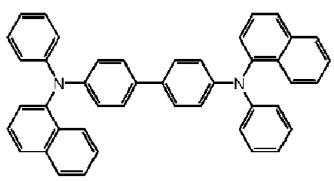

NPB

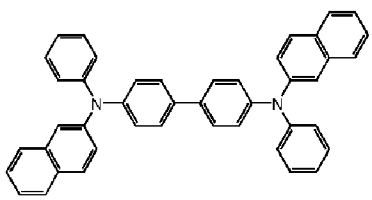

β-NPB

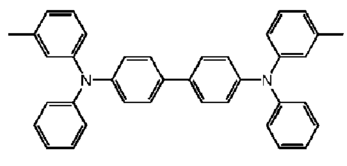

TPD

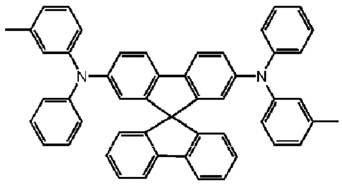

Spiro-TPD

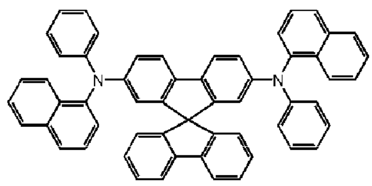

Spiro-NPB

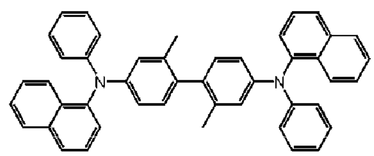

methylated NPB

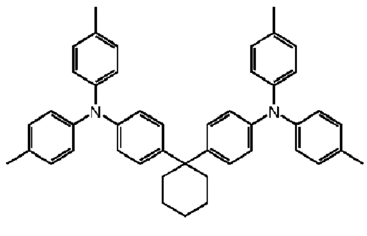

TAPC

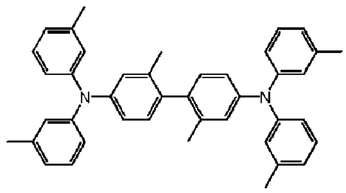

HMTPD

Formula 201

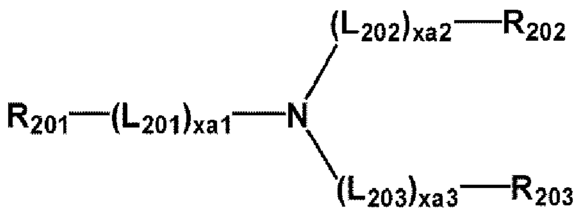

Formula 202

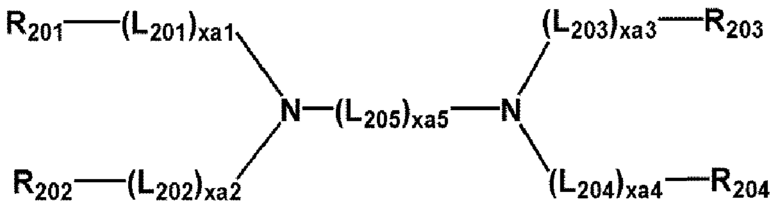

,

wherein, in Formulae 201 and 202,

$L_{201}$ to $L_{204}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed $C_8$-$C_{60}$ polycyclic group, and a substituted or unsubstituted divalent non-aromatic condensed 8- to 6o-membered heteropolycyclic group,

$L_{205}$ may be selected from *-O-*', *-S-*', *-N($Q_{201}$)-*', a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed $C_8$-$C_{60}$ polycyclic group, and a substituted or unsubstituted divalent non-aromatic condensed 8- to 6o-membered heteropolycyclic group,

xai to xa4 may each independently be an integer selected from 0 to 3,

xa5 may be an integer selected from 1 to 10, and

$R_{201}$ to $R_{204}$ and $Q_{201}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed $C_8$-$C_{60}$ polycyclic group, and a substituted or unsubstituted monovalent non-aromatic condensed 8- to 6o-membered heteropolycyclic group.

For example, in Formula 202, $R_{201}$ and $R_{202}$ may be optionally connected to each other via a single bond, a dimethyl-methylene group, or a diphenyl-methylene group, and $R_{203}$ and $R_{204}$ may be optionally connected to each other via a single bond, a dimethyl-methylene group, or a diphenyl-methylene group.

In various embodiments, in Formulae 201 and 202,

$L_{201}$ to $L_{205}$ may each independently be selected from the group consisting of:

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, $-Si(Q_{31})(Q_{32})(Q_{33})$, and $-N(Q_{31})(Q_{32})$,
wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In various embodiments, xai to xa4 may each independently be 0, 1, or 2.
In various embodiments, xa5 may be 1, 2, 3, or 4.
In various embodiments, $R_{201}$ to $R_{204}$ and $Q_{201}$ may each independently be selected from the group consisting of:

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a

picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, $-Si(Q_{31})(Q_{32})(Q_{33})$, and $-N(Q_{31})(Q_{32})$,

wherein $Q_{31}$ to $Q_{33}$ are the same as described above.

In various embodiments, at least one selected from $R_{201}$ to $R_{203}$ in Formula 201 may each independently be selected from the group consisting of:

a fluorenyl group, a spiro-bifluorenyl group, a carbazolyl group, a dibenzofuranyl group, and a dibenzothiophenyl group; and

a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,

but embodiments of the present disclosure are not limited thereto.

In various embodiments, in Formula 202, i) $R_{201}$ and $R_{202}$ may be connected to each other via a single bond, and/or ii) $R_{203}$ and $R_{204}$ may be connected to each other via a single bond.

In various embodiments, at least one selected from $R_{201}$ to $R_{204}$ in Formula 202 may be selected from the group consisting of:

a carbazolyl group; and

a carbazolyl group substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,

but embodiments of the present disclosure are not limited thereto.

The compound represented by Formula 201 may be represented by Formula 201A:

Formula 201A

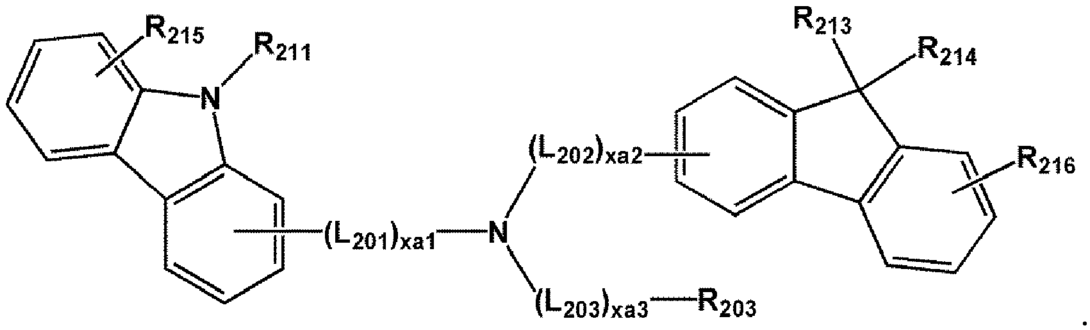

In various embodiments, the compound represented by Formula 201 may be represented by Formula 201A(1), but embodiments of the present disclosure are not limited thereto:

Formula 201A(1)

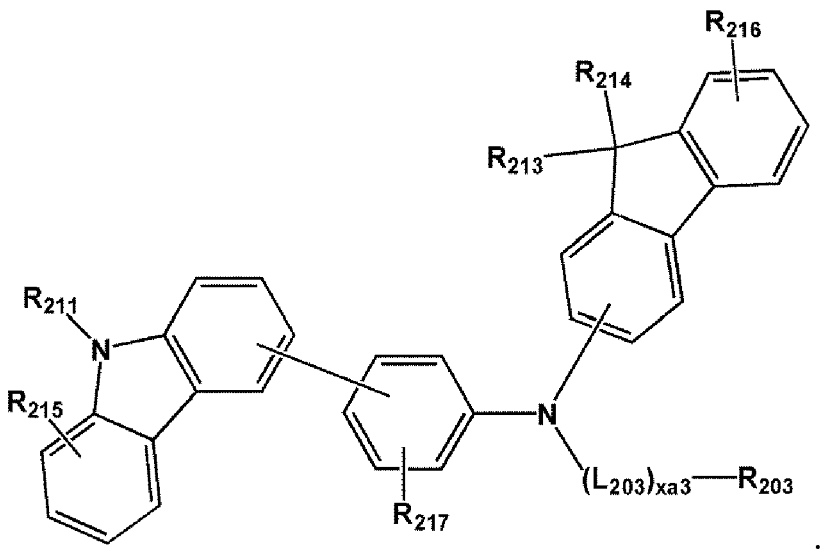

In various embodiments, the compound represented by Formula 201 may be represented by Formula 201A-1, but embodiments of the present disclosure are not limited thereto:

Formula 201A-1

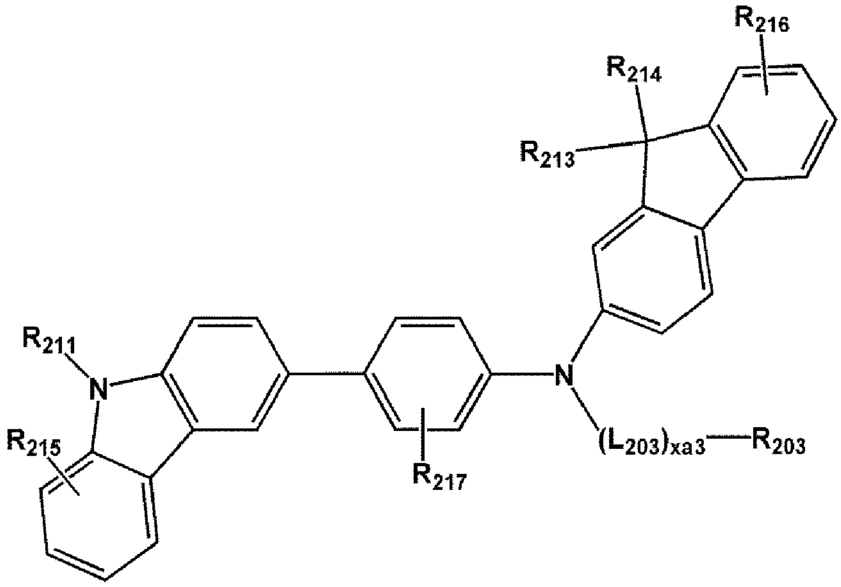

.

In various embodiments, the compound represented by Formula 202 may be represented by Formula 202A:

Formula 202A

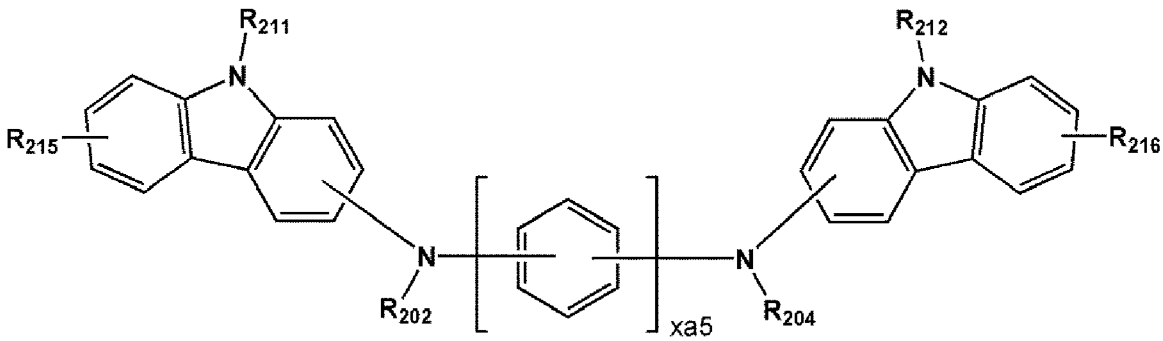

In various embodiments, the compound represented by Formula 202 may be represented by Formula 202A-1:

Formula 202A-1

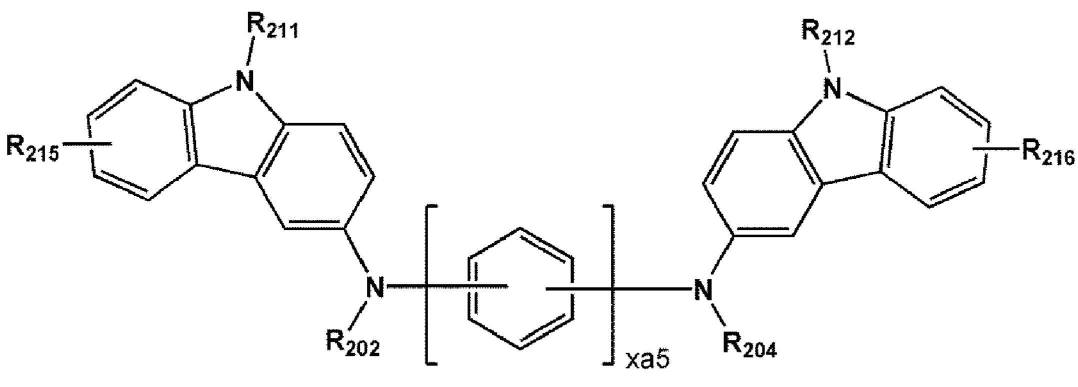

.

In Formulae 201A, 201A(1), 201A-1, 202A, and 202A-1,

$L_{201}$ to $L_{203}$, xa1 to xa3, xa5, and $R_{202}$ to $R_{204}$ are the same as described above,
$R_{211}$ and $R_{212}$ are the same as described above in connection with $R_{203}$, and
$R_{213}$ to $R_{217}$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to $HT_{39}$, but embodiments of the present disclosure are not limited thereto:

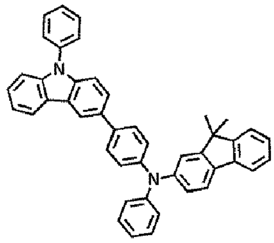

HT1

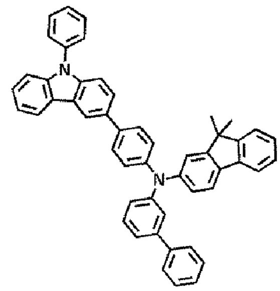

HT2

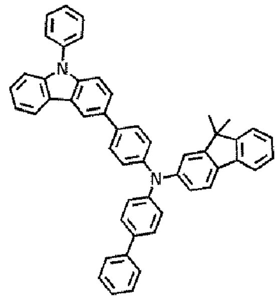

HT3

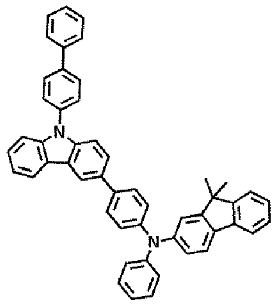

HT4

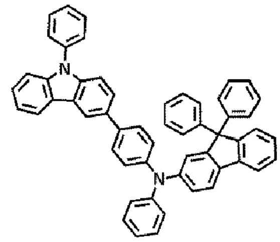

HT5

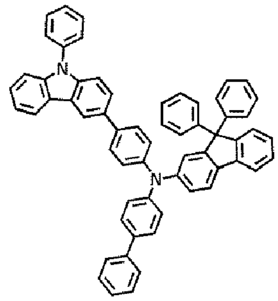

HT6

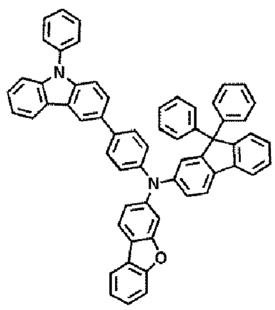

HT7

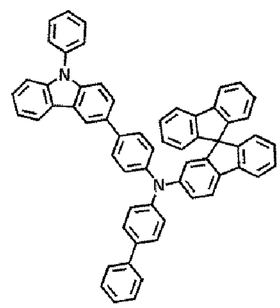

HT8

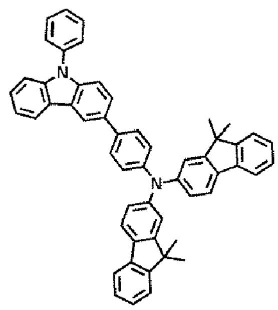

HT9

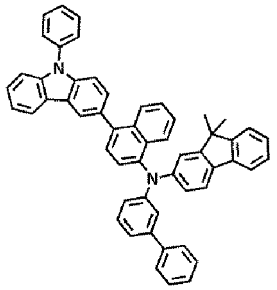
HT10

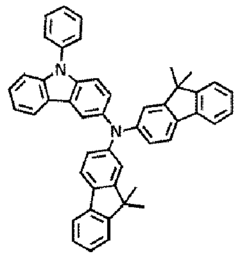
HT11

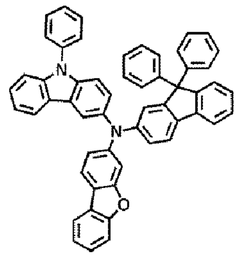
HT12

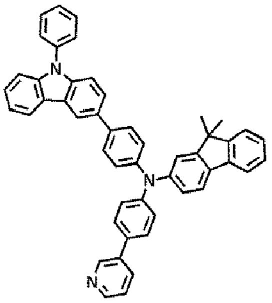
HT13

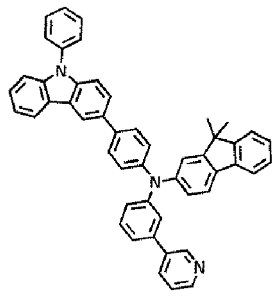
HT14

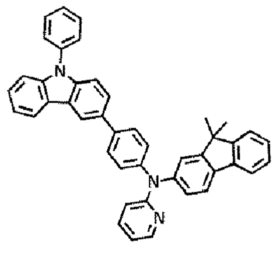
HT15

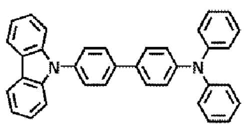
HT16

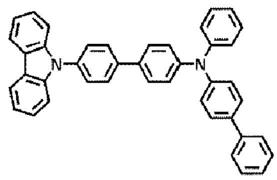
HT17

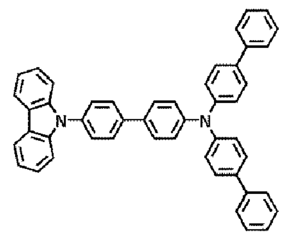
HT18

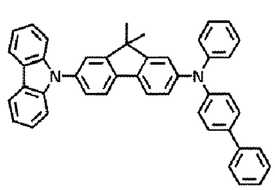
HT19

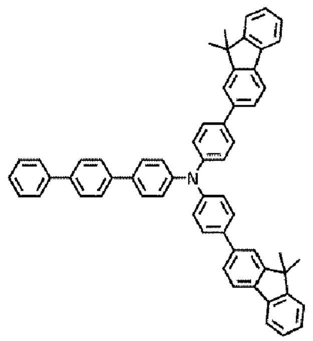
HT20

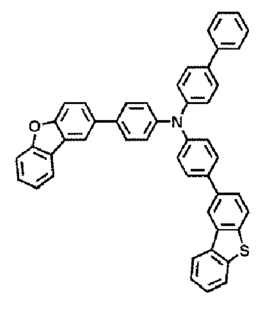
HT21

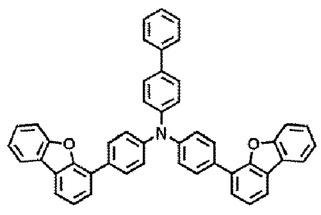
HT22

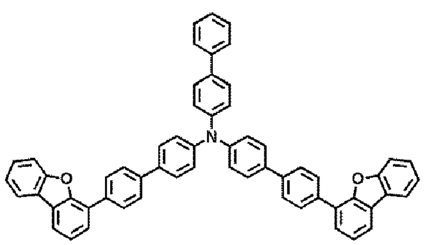
HT23

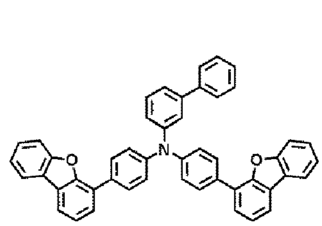
HT24

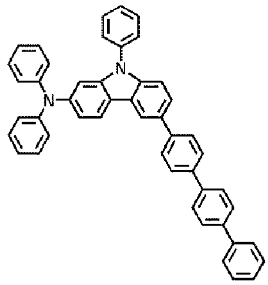

HT25

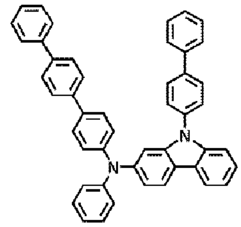

HT26

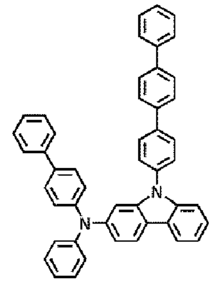

HT27

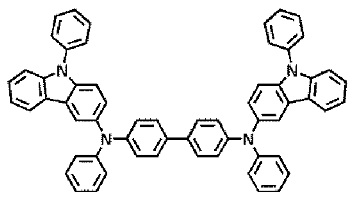

HT28

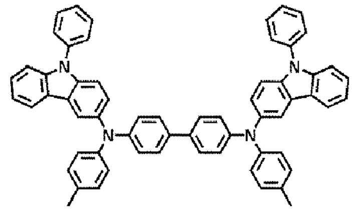

HT29

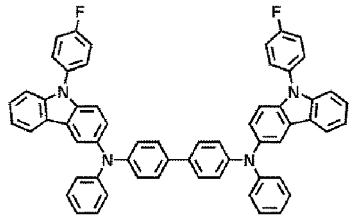

HT30

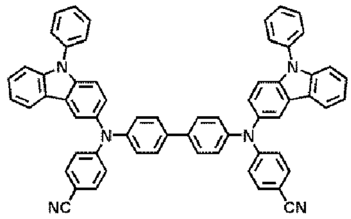

HT31

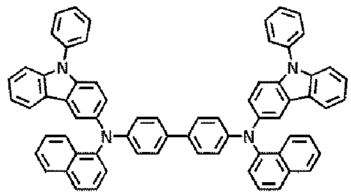

HT32

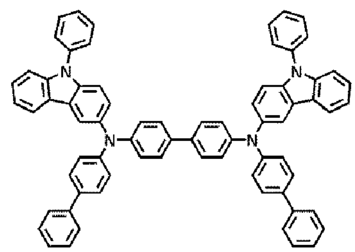

HT33

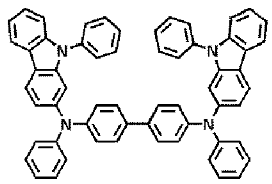

HT34

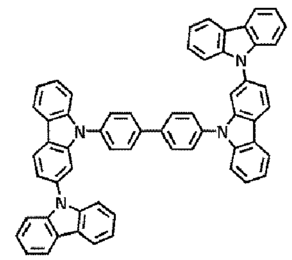

HT35

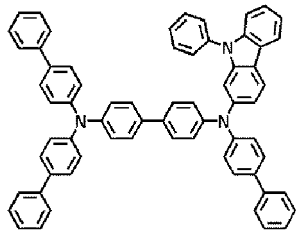

HT36

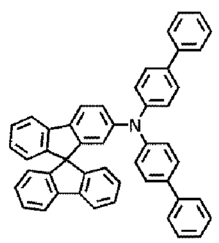

HT37

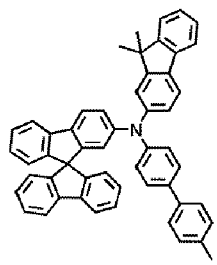

HT38

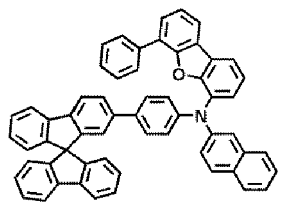

HT39

.

A thickness of the hole transport region may be in a range of about 100 Å to about 10,000 Å, for example, about

100 Å to about 1,000 Å. When the hole transport region comprises at least one selected from a hole injection layer and a hole transport layer, a thickness of the hole injection layer may be in a range of about 100 Å to about 9,000 Å, for example, about 100 Å to about 1,000 Å, and a thickness of the hole transport layer may be in a range of about 50Å to about 2,000Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport region. The emission auxiliary layer and the electron blocking layer may comprise the materials as described above.

**p-dopant**

The hole transport region may further comprise, in addition to these materials, a charge-generation material for the improvement of conductive properties. The charge-generation material may be homogeneously or non-homogeneously dispersed in the hole transport region.

The charge-generation material may be, for example, a p-dopant.

A doping concentration of the p-dopant may be in a range of about 0.1 wt% to about 20 wt%, for example, about 0.5 wt% to about 10 wt%.

In various embodiments, a lowest unoccupied molecular orbital (LUMO) of the p-dopant may be about -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:

a quinone derivative, such as tetracyanoquinodimethane (TCNQ) and/or 2,3,5,6-tetrafluoro-7,7,8,8-tetracyanoquinodimethane ($F_4$-TCNQ);
a metal oxide, such as a tungsten oxide and/or a molybdenum oxide;
1,4,5,8,9,11-hexaazatriphenylene-hexacarbonitrile (HAT-CN); and
a compound represented by Formula 221,
but embodiments of the present disclosure are not limited thereto:

HAT-CN

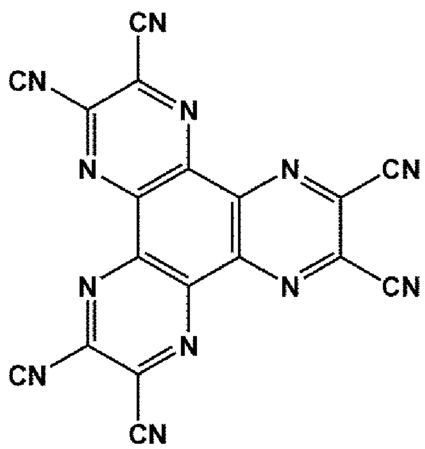

F4-TCNQ

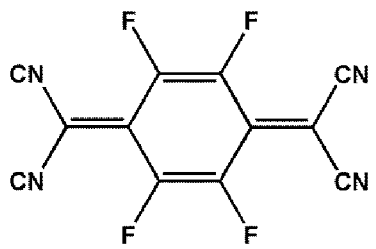

**Formula 221**

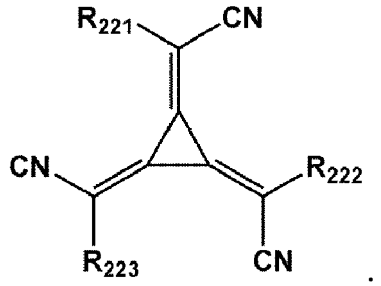

In Formula 221,
$R_{221}$ to $R_{223}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed $C_8$-$C_{60}$ polycyclic group, and a substituted or unsubstituted monovalent non-aromatic condensed 8- to 6o-membered heteropolycyclic group, wherein at least one selected from $R_{221}$ to $R_{223}$ may have at least one substituent selected from a cyano group, -F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I.

**Emission layer in organic layer 150**

When the organic light-emitting device 10 is a full color organic light-emitting device, the emission layer may be patterned into a red emission layer, a green emission layer, or a blue emission layer, according to a sub-pixel. In various embodiments, the emission layer may have a stacked structure of two or more layers selected from a red emission layer, a green emission layer, and a blue emission layer, in which the two or more layers contact each other or are separated from each other. In various embodiments, the emission layer may comprise two or more materials selected from a red-light emission material, a green-light emission material, and a blue-light emission material, in which the two or more materials are mixed with each other in a single layer to emit white light.

In various embodiments, the emission layer of the organic light-emitting device 10 may be a first-color-light emission layer,
the organic light-emitting device 10 may further comprise i) at least one second-color-light emission layer or ii) at least one second-color-light emission layer and at least one third-color-light emission layer, between the first electrode 110 and the second electrode 190,
a maximum emission wavelength of the first-color-light emission layer, a maximum emission wavelength of the second-color-light emission layer, and a maximum emission wavelength of the third-color-light emission layer may be identical to or different from one another, and
the organic light-emitting device 10 may emit mixed light comprising first-color-light and second-color-light, or mixed light comprising first-color-light, second-color-light, and third-color-light, but embodiments of the present disclosure are not limited thereto.

For example, the maximum emission wavelength of the first-color-light emission layer may be different from the maximum emission wavelength of the second-color-light emission layer, and the mixed light comprising first-color-light and second-color-light may be white light, but embodiments of the present disclosure are not limited thereto.

In various embodiments, the maximum emission wavelength of the first-color-light emission layer, the maximum emission wavelength of the second-color-light emission layer, and the maximum emission wavelength of the third-color-light emission layer may be different from one another, and the mixed light comprising first-color-light, second-color-light, and third-color-light may be white light. However, embodiments of the present disclosure are not limited thereto.

As used herein the maximum emission wavelength of an emission layer is the wavelength of light emitted by the emission layer with maximum intensity.

The emission layer may comprise a host and a dopant. The dopant may comprise at least one selected from a phosphorescent dopant and a fluorescent dopant.

An amount of the dopant in the emission layer may be, in general, in a range of about 0.01 to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

**Host in emission layer**

The emission layer may comprise the first compound as a host. The first compound is the same as described above.

The emission layer may comprise the first compound as a first host, and may further comprise a second host different from the first host.

For example, the second host may be selected from compounds other than the first compound.

In various embodiments, the second host may be selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), and 1,3,5-tri(carbazol-9-yl)benzene (TCP), but embodiments of the present disclosure are not limited thereto.

A weight ratio of the first host to the second host in the emission layer may be, for example, about 90:10 to about 10:90, about 80:20 to about 20:80, or about 50:50, but embodiments of the present disclosure are not limited thereto.

**Phosphorescent dopant included in emission layer in organic layer 150**

The phosphorescent dopant may comprise an organometallic complex represented by Formula 401:

**Formula 401** $M(L_{401})_{xc1}(L_{402})_{xc2}$

in which $L_{401}$ is selected from ligands represented by Formula 402,

**Formula 402**

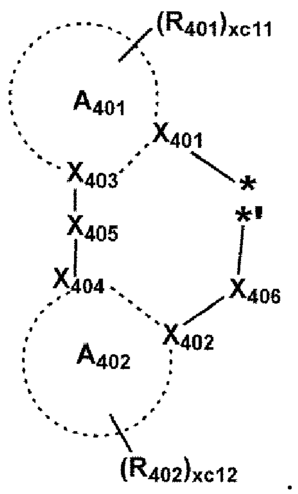

Wherein, in Formulae 401 and 402,

M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),xc1 may be 1, 2, or 3, wherein when xc1 is two or more, two or more $L_{401}$(s) may be identical to or different from each other,

$L_{402}$ may be an organic ligand, and xc2 may be an integer selected from 0 to 4, wherein when xc2 is two or more, two or more $L_{402}$(s) may be identical to or different from each other,

$X_{401}$ to $X_{404}$ may each independently be nitrogen or carbon,

$X_{401}$ and $X_{403}$ may be connected to each other via a single bond or a double bond, and $X_{402}$ and $X_{404}$ may be connected to each other via a single bond or a double bond,

$A_{401}$ and $A_{402}$ may each independently be a $C_5$-$C_{60}$ carbocyclic group or a $C_1$-$C_{60}$ heterocyclic group,

$X_{405}$ may be a single bond, -O-, -S-, -C(=O)-, -N($Q_{411}$)-, -C($Q_{411}$)($Q_{412}$)-,-C($Q_{411}$)=C($Q_{412}$)-, -C($Q_{411}$)=, or =C($Q_{411}$)=, wherein $Q_{411}$ and $Q_{412}$ may each independently be hydrogen, deuterium, a $C_1$-$C_{20}$ alkyl group, a $C_1$-$C_{20}$ alkoxy group, a phenyl group, a biphenyl group, a terphenyl group, or a naphthyl group,

$X_{406}$ may be a single bond, O, or S,

$R_{401}$ and $R_{402}$ may each independently be selected from hydrogen, deuterium, - F, -Cl, -Br, -I, $-CD_3$, $-CF_3$, a hydroxyl group, a cyano group, a nitro group, an amidino group, a hydrazino group, a hydrazono group, a substituted or unsubstituted $C_1$-$C_{20}$ alkyl group, a substituted or unsubstituted $C_1$-$C_{20}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed $C_8$-$C_{60}$ polycyclic group, a substituted or unsubstituted monovalent non-aromatic condensed 8- to 60-membered heteropolycyclic group $-Si(Q_{401})(Q_{402})(Q_{403})$,$-N(Q_{401})(Q_{402})$, $-B(Q_{401})(Q_{402})$, $-C(=O)(Q_{401})$, $-S(=O)_2(Q_{401})$, and $-P(=O)(Q_{401})(Q_{402})$, wherein $Q_{401}$ to $Q_{403}$ may each independently be selected from a $C_1$-$C_{10}$ alkyl group, a $C_1$-$C_{10}$ alkoxy group, a $C_6$-$C_{20}$ aryl group, and a $C_1$-$C_{20}$ heteroaryl group,

xc11 and xc12 may each independently be an integer selected from 0 to 10, and

* and *' in Formula 402 each indicate a binding site to M in Formula 401.

In various embodiments, $A_{401}$ and $A_{402}$ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzoimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In various embodiments, in Formula 402, i) $X_{401}$ may be nitrogen and $X_{402}$ may be carbon, or ii) both $X_{401}$ and $X_{402}$ may be nitrogen.

In various embodiments, $R_{401}$ and $R_{402}$ in Formula 402 may each independently be selected from the group consisting of:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;

a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;

a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and

$$-Si(Q_{401})(Q_{402})(Q_{403}),\ -N(Q_{401})(Q_{402}),\ -B(Q_{401})(Q_{402}),\ -C(=O)(Q_{401}),\ -S(=O)_2(Q_{401}),\ \text{and}\ -P(=O)(Q_{401})(Q_{402}),$$

wherein $Q_{401}$ to $Q_{403}$ may each independently be selected from a $C_1$-$C_{10}$ alkyl group, a $C_1$-$C_{10}$ alkoxy group, a phenyl group, a biphenyl group, and a naphthyl group, but embodiments of the present disclosure are not limited thereto.

In various embodiments, when xc1 in Formula 401 is two or more, two $A_{401}$(s) selected from two or more $L_{401}$(s)

may be optionally connected via a linking group $X_{407}$, or two $A_{402}$(s) may be optionally connected via a linking group $X_{408}$ (see Compounds PD1 to $PD_4$ and $PD_7$ below). $X_{407}$ and $X_{408}$ may each independently be a single bond, *-O- *', *-S-*', *-C(=O)-*', *-N($Q_{413}$)-*', *-C($Q_{413}$)($Q_{414}$)-*', or *-C($Q_{413}$)=C($Q_{414}$)-*' (wherein $Q_{413}$ and $Q_{414}$ may each independently be hydrogen, deuterium, a $C_1$-$C_{20}$ alkyl group, a $C_1$-$C_{20}$ alkoxy group, a phenyl group, a biphenyl group, a terphenyl group, or a naphthyl group), but embodiments of the present disclosure are not limited thereto.

$L_{402}$ in Formula 401 may be any monovalent, divalent, or trivalent organic ligand. For example, $L_{402}$ may be selected from a halogen, a diketone (for example, an acetylacetonate), a carboxylic acid (for example, a picolinate), -C(=O), an isonitrile, - CN, and phosphorus (for example, a phosphine or a phosphite), but embodiments of the present disclosure are not limited thereto.

In various embodiments, the phosphorescent dopant may be selected from, for example, Compounds PD1 to PD25, but embodiments of the present disclosure are not limited thereto:

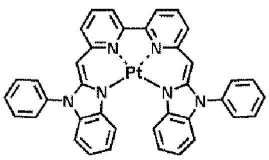
PD1

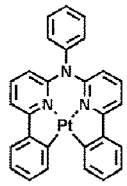
PD2

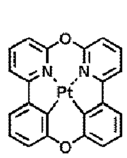
PD3

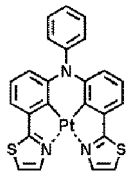
PD4

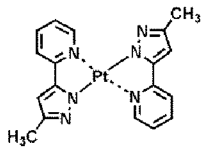
PD5

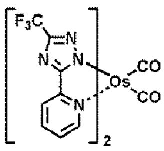
PD6

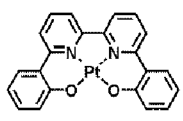
PD7

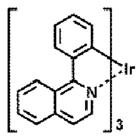
PD8

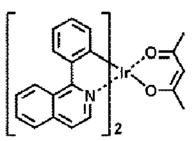
PD9

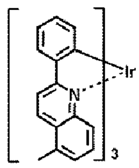
PD10

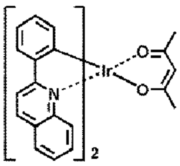
PD11

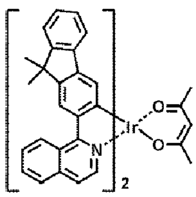
PD12

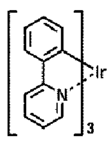
PD13

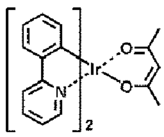
PD14

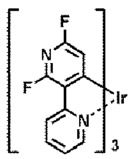
PD15

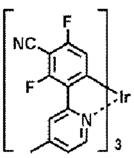
PD16

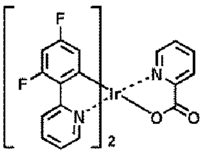
PD17

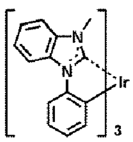
PD18

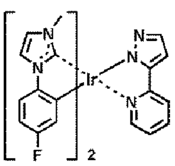
PD19

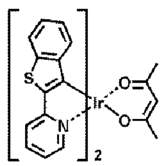
PD20

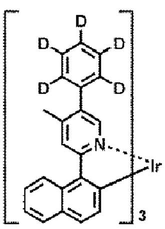
PD21

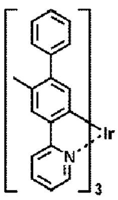
PD22

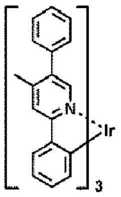
PD23

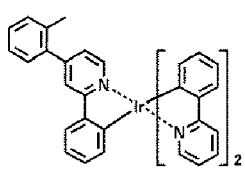
PD24

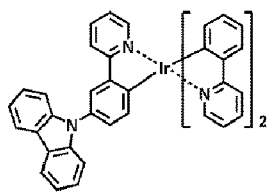
PD25

Fluorescent dopant in emission layer

The fluorescent dopant may comprise an arylamine compound or a styrylamine compound.

In various embodiments, the fluorescent dopant may comprise a compound represented by Formula 501 below:

## Formula 501

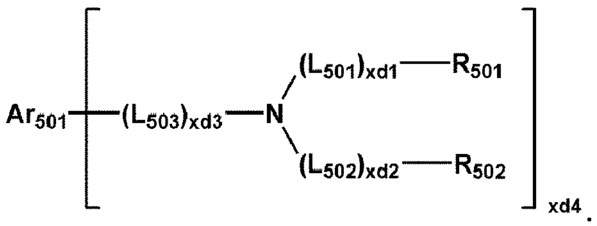

In Formula 501,
$Ar_{501}$ may be a substituted or unsubstituted $C_5$-$C_{60}$ carbocyclic group or a substituted or unsubstituted $C_1$-$C_{60}$ heterocyclic group,
$L_{501}$ to $L_{503}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed C8-C60 polycyclic group, and a substituted or unsubstituted divalent non-aromatic condensed 8- to 6o-membered heteropolycyclic group,
xd1 to $xd_3$ may each independently be an integer selected from 0 to 3,
$R_{501}$ and $R_{502}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed C8-C60 polycyclic group, and a substituted or unsubstituted monovalent non-aromatic condensed 8- to 6o-membered heteropolycyclic group, and
$xd_4$ may be an integer selected from 1 to 6.

In various embodiments, $Ar_{501}$ in Formula 501 may be selected from the group consisting of:

a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

In various embodiments, $L_{501}$ to $L_{503}$ in Formula 501 may each independently be selected from the group consisting of:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene

group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In various embodiments, $R_{501}$ and $R_{502}$ in Formula 501 may each independently be selected from the group consisting of:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - $Si(Q_{31})(Q_{32})(Q_{33})$,

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In various embodiments, $xd_4$ in Formula 501 may be two, but embodiments of the present disclosure are not limited thereto.

For example, the fluorescent dopant may be selected from Compounds FD1 to FD22:

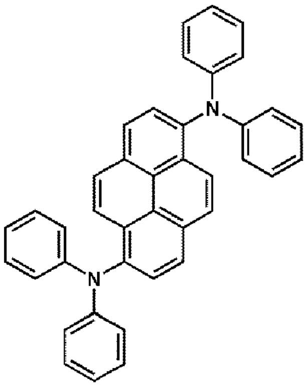

FD1

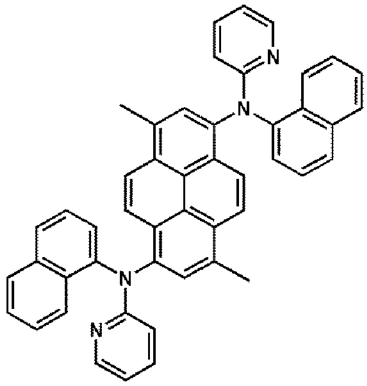

FD2

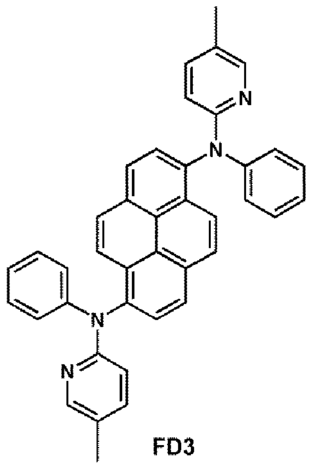

FD3

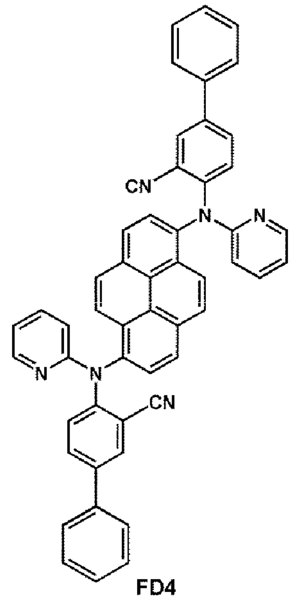

FD4

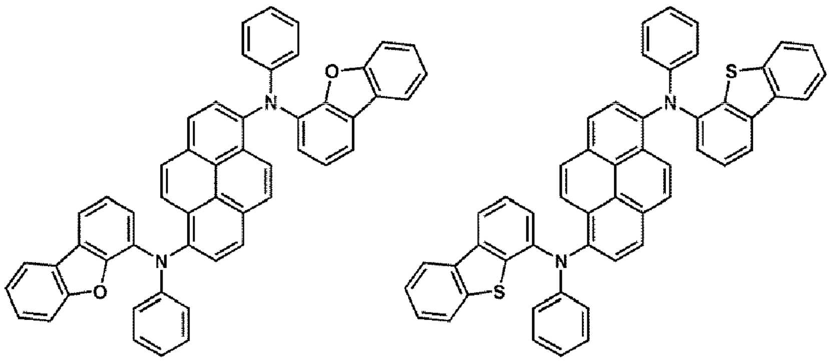

FD5

FD6

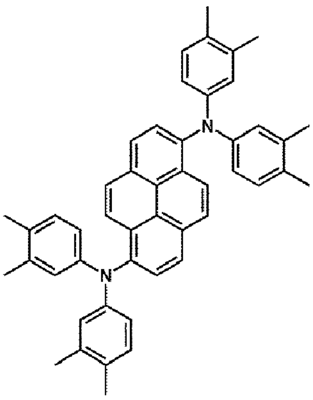

FD7

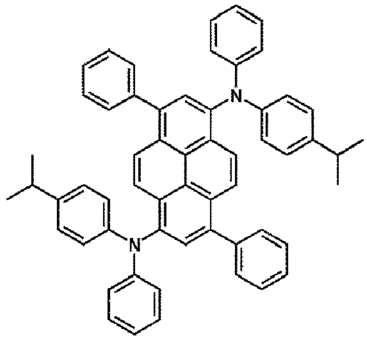

FD8

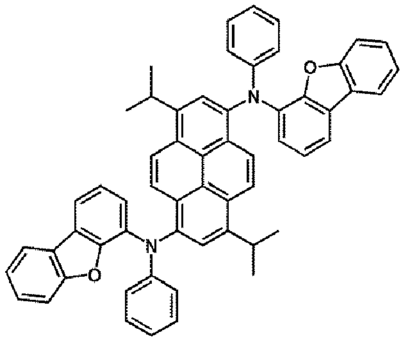

FD9

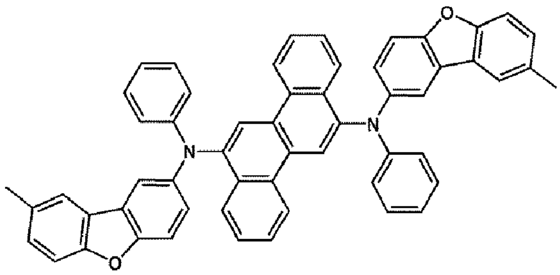

FD10

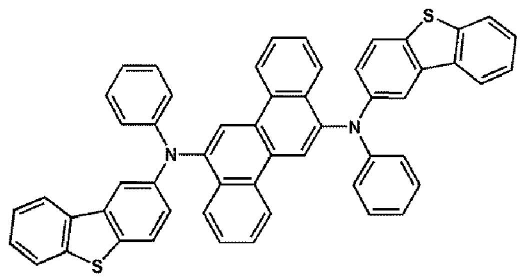

FD11

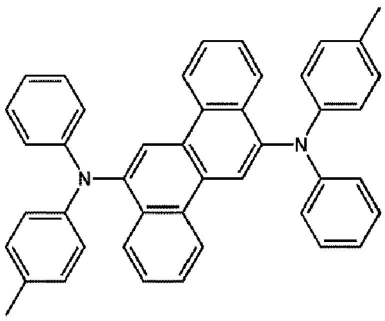

FD12

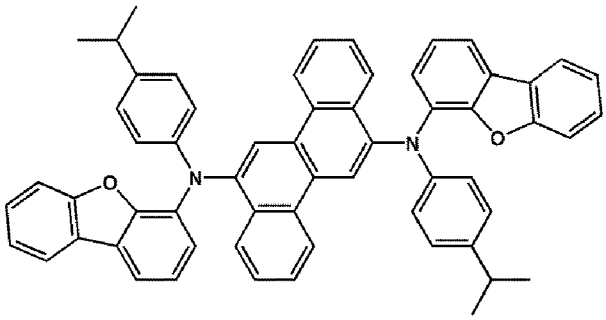

FD13

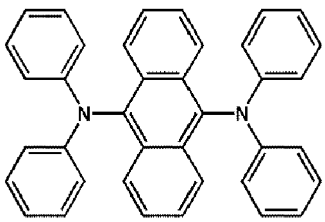

FD14

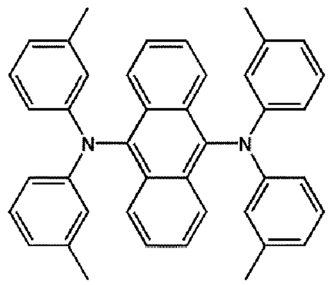

FD15

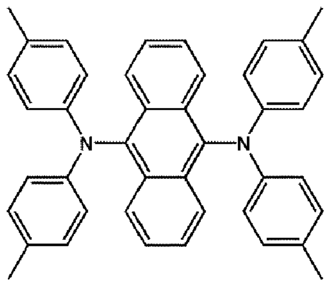

FD16

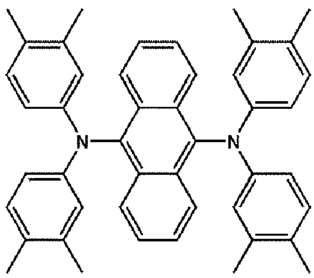

FD17

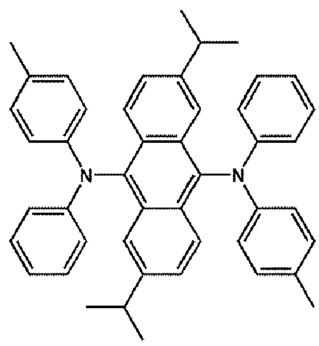

FD18

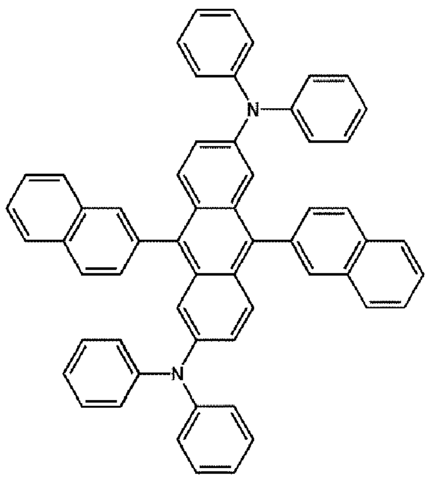

FD19

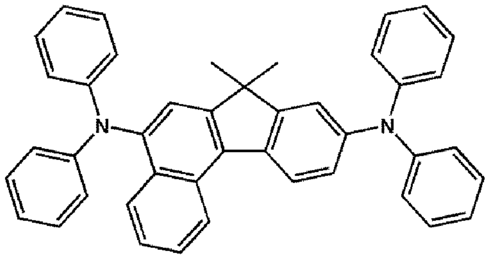

FD20

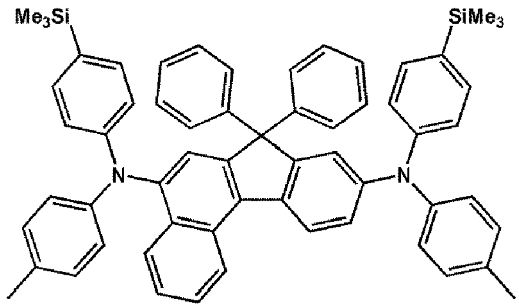

FD21

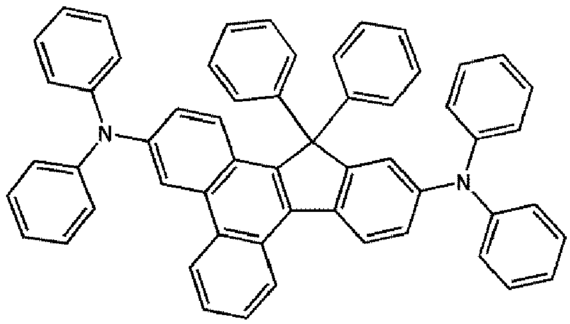

FD22

.

In various embodiments, the fluorescent dopant may be selected from compounds illustrated below, but embodiments of the present disclosure are not limited thereto:

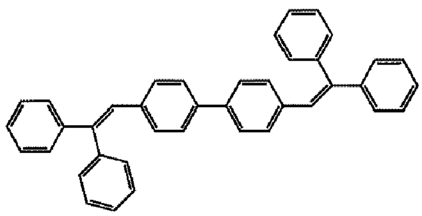

DPVBi

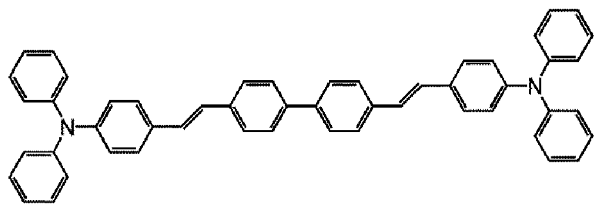

DPAVBi

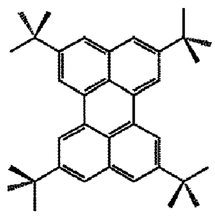

TBPe

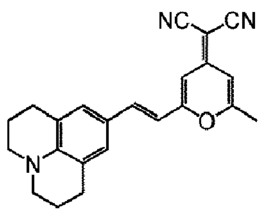

DCM

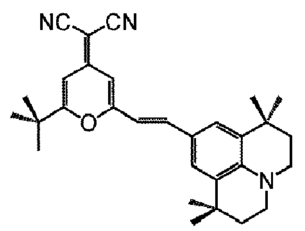

DCJTB

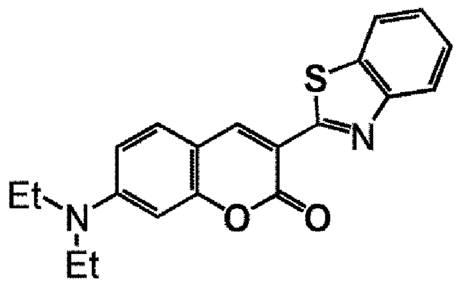

Coumarin 6

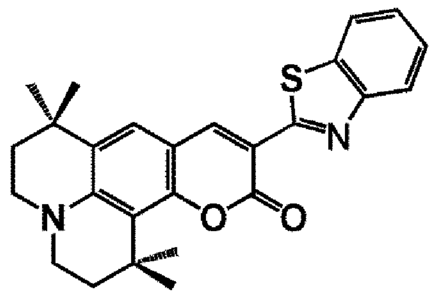

C545T.

**Electron transport region in organic layer 150**

The electron transport region may have i) a single-layered structure including a single layer including a single material, ii) a single-layered structure including a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer (ETL), and an electron injection layer, but embodiments of the present disclosure are not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein in each of these structures, constituting layers are sequentially stacked in this stated order from an emission layer. However, the structure of the electron transport layer is not limited thereto.

The electron transport region may comprise the second compound as described above.

In various embodiments, the electron transport region may comprise a buffer layer, the buffer layer may directly contact the emission layer, and the buffer layer may comprise the second compound as described above.

In various embodiments, the electron transport region may comprise a buffer layer, an electron transport layer, and an electron injection layer, which are sequentially stacked from the emission layer in this stated order, and the buffer layer may comprise the second compound as described above.

The electron transport region (for example, a hole blocking layer, an electron control layer, or an electron transport layer in the electron transport region) may comprise a metal-free compound containing at least once $\pi$ electron-depleted nitrogen-containing ring.

The "$\pi$ electron-depleted nitrogen-containing ring" refers to a $C_1$-$C_{60}$ heterocyclic group having at least one *-N=*' moiety as a ring-forming moiety.

For example, the "$\pi$ electron-depleted nitrogen-containing ring" may be i) a 5-membered to 7-membered hetero monocyclic group having at least one *-N=*' moiety, ii) a heteropoly cyclic group in which two or more 5-membered to 7-membered hetero monocyclic groups each having at least one *-N=*' moiety are condensed with each other, or iii) a heteropoly cyclic group in which at least one selected from 5-membered to 7-membered hetero monocyclic groups, each having at least one *-N=*' moiety, is condensed with at least one $C_5$-$C_{60}$ carbocyclic group.

Examples of the $\pi$ electron-depleted nitrogen-containing ring comprise an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an isobenzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, but embodiments of the present disclosure are not limited thereto.

For example, the electron transport region may comprise a compound represented by Formula 601:

**Formula 601** $[Ar_{601}]_{xe11}$-$[(L_{601})_{xe1}$-$R_{601}]_{xe21}$.

In Formula 601,

$Ar_{601}$ may be a substituted or unsubstituted $C_5$-$C_{60}$ carbocyclic group or a substituted or unsubstituted $C_1$-$C_{60}$ heterocyclic group,

xe11 may be 1, 2, or 3,

$L_{601}$ may be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed C8-C60 polycyclic group, and a substituted or unsubstituted divalent non-aromatic condensed 8- to 6o-membered heteropolycyclic group,

xei may be an integer selected from 0 to 5,

$R_{601}$ may be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed C8-C60 polycyclic group, a substituted or unsubstituted monovalent non-aromatic condensed 8- to 6o-membered heteropolycyclic group, -Si($Q_{601}$)($Q_{602}$)($Q_{603}$), -C(=O)($Q_{601}$), -S(=O)$_2$($Q_{601}$), and-P(=O)($Q_{601}$)($Q_{602}$),

$Q_{601}$ to $Q_{603}$ may each independently be selected from a $C_1$-$C_{10}$ alkyl group, a $C_1$-$C_{10}$ alkoxy group, a phenyl group, a biphenyl group, a terphenyl group, and a naphthyl group, and

xe2i may be an integer selected from 1 to 5.

In various embodiments, at least one selected from $Ar_{601}$(s) in number of xe11 and $R_{601}$(s) in number of xe2i may comprise the $\pi$ electron-depleted nitrogen-containing ring as described above.

In various embodiments, ring $Ar_{601}$ in Formula 601 may be selected from the group consisting of:

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzoimidazole group, an iso-benzothiazole group, a benzoxazole group, an isobenzoxazole group, a triazole group, a tetrazole group, an oxadiazole group, a triazine group, thiadiazol group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, - Si($Q_{31}$)($Q_{32}$)($Q_{33}$), -S(=O)$_2$($Q_{31}$), and -P(=O)($Q_{31}$)($Q_{32}$),

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

When xe11 in Formula 601 is two or more, two or more $Ar_{601}$(s) may be connected to each other via a single bond.

In various embodiments, $Ar_{601}$ in Formula 601 may be an anthracene group.

In various embodiments, the compound represented by Formula 601 may be represented by Formula 601-1:

**Formula 601-1**

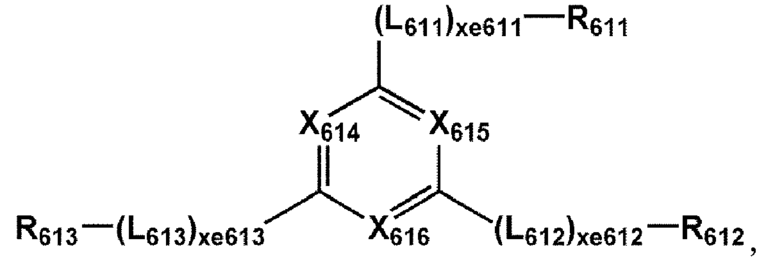

wherein, in Formula 601-1,

$X_{614}$ may be N or $C(R_{614})$, $X_{615}$ may be N or $C(R_{615})$, $X_{616}$ may be N or $C(R_{616})$, and at least one selected from $X_{614}$ to $X_{616}$ may be N,
$L_{611}$ to $L_{613}$ are each independently the same as described above in connection with $L_{601}$,
xe611 to xe613 are each independently the same as described above in connection with xei,
$R_{611}$ to $R_{613}$ are each independently the same as described above in connection with $R_{601}$, and
$R_{614}$ to $R_{616}$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

In various embodiments, $L_{601}$ and $L_{611}$ to $L_{613}$ in Formulae 601 and 601-1 may each independently be selected from the group consisting of:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl

group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments of the present disclosure are not limited thereto.

In various embodiments, xei and xe611 to xe613 in Formulae 601 and 601-1 may each independently be 0, 1, or 2.

In various embodiments, $R_{601}$ and $R_{611}$ to $R_{613}$ in Formulae 601 and 601-1 may each independently be selected from the group consisting of:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

$$-S(=O)_2(Q_{601}) \text{ and } -P(=O)(Q_{601})(Q_{602}),$$

wherein $Q_{601}$ and $Q_{602}$ are the same as described above.

The electron transport region may comprise at least one compound selected from Compounds ET1 to ET36, but embodiments of the present disclosure are not limited thereto:

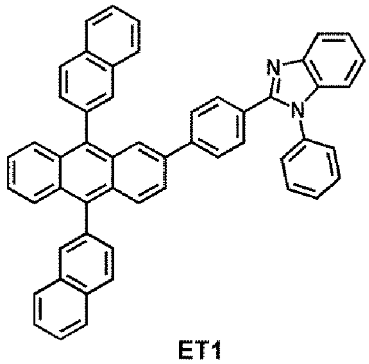

ET1

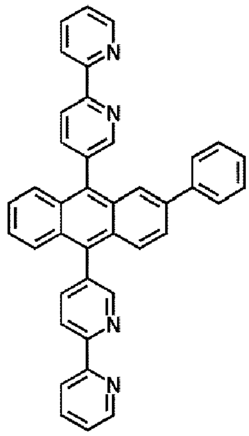

ET2

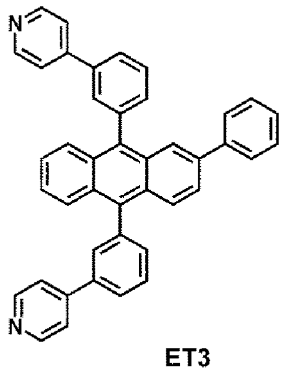

ET3

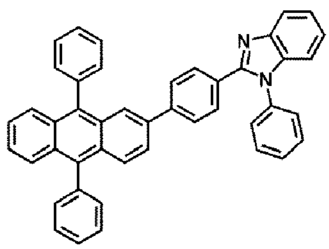

ET4

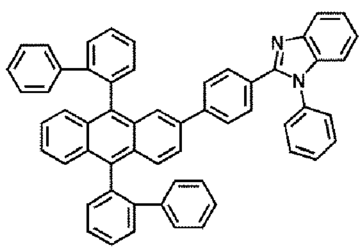

ET5

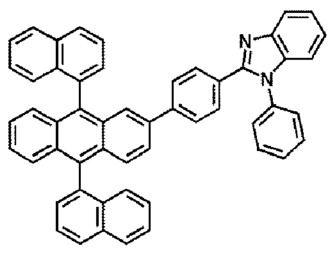

ET6

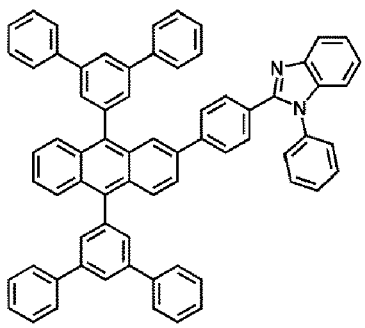

ET7

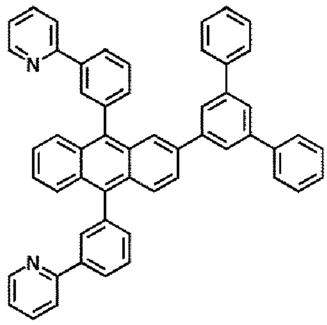

ET8

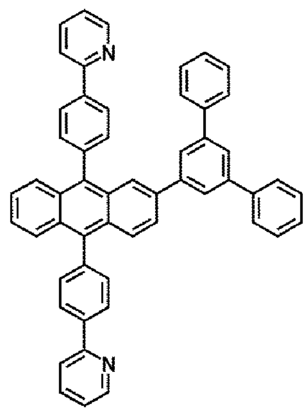

ET9

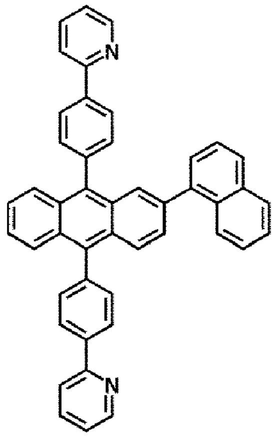

ET10

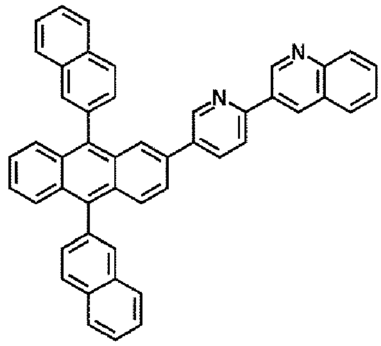

ET11

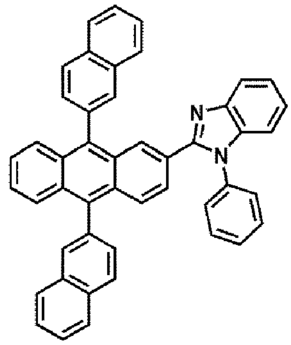

ET12

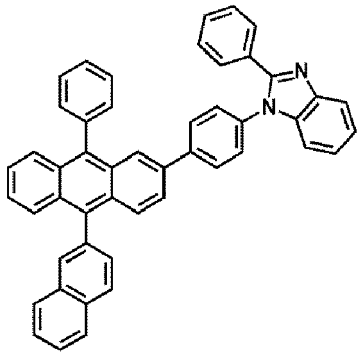

ET13

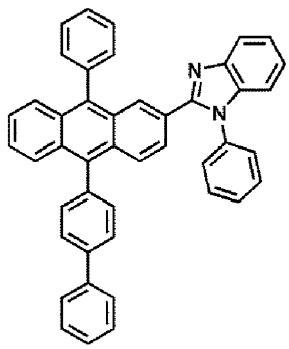

ET14

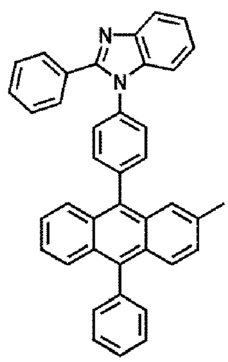

ET15

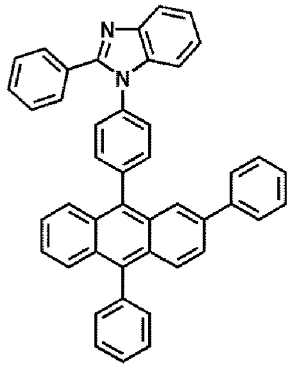

ET16

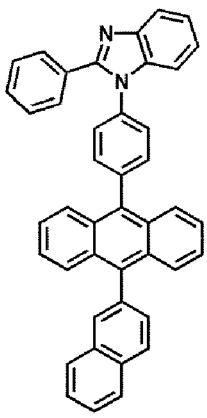

ET17

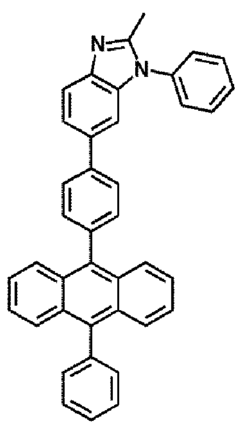

ET18

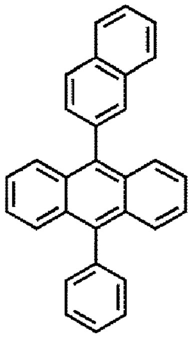

**ET19**

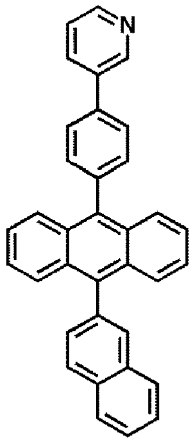

**ET20**

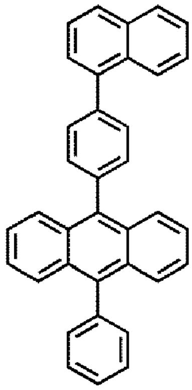

**ET21**

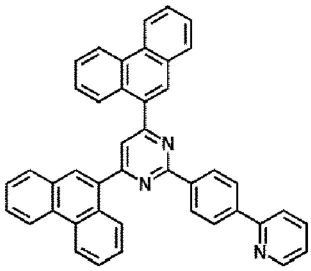

**ET22**

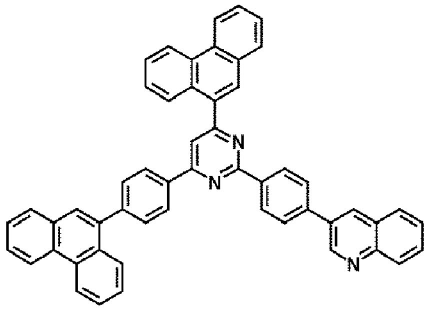

**ET23**

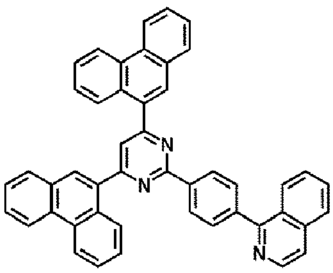

**ET24**

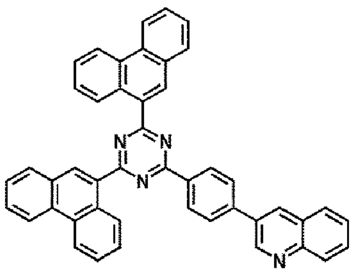

**ET25**

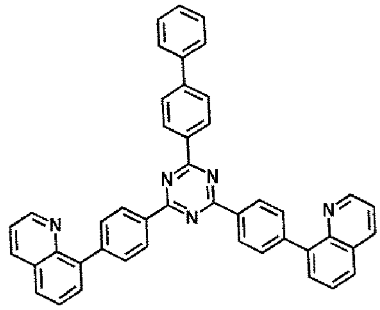

**ET26**

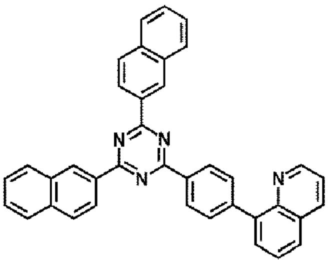

**ET27**

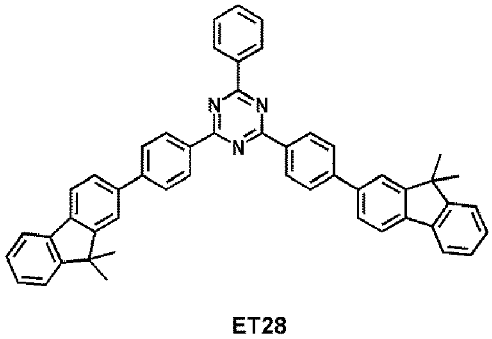

**ET28**

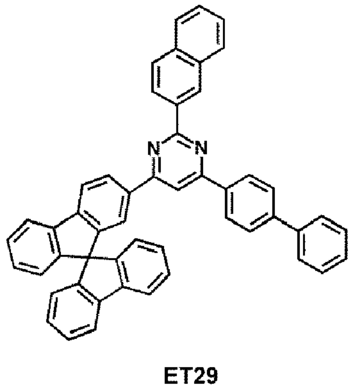

**ET29**

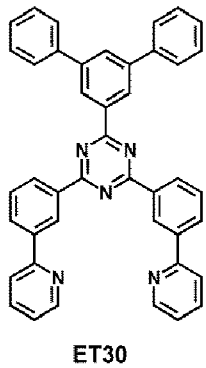

**ET30**

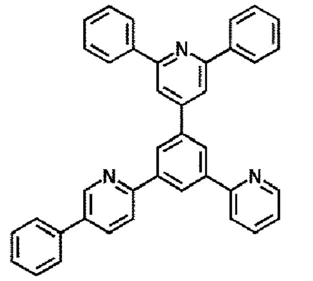

ET31

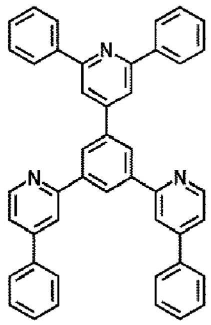

ET32

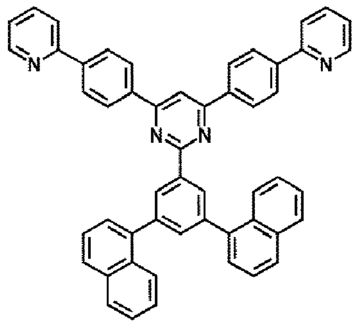

ET33

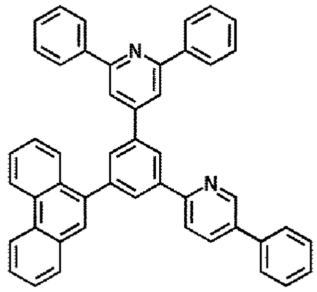

ET34

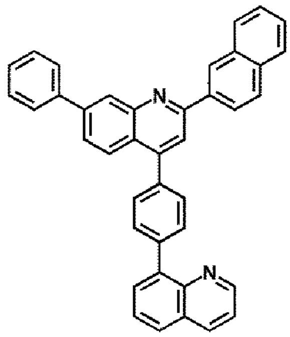

ET35

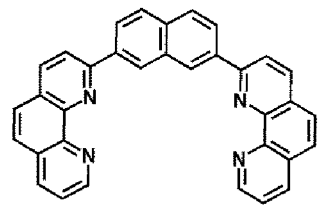

ET36

.

In various embodiments, the electron transport region may comprise at least one compound selected from 2,9-dimethyl-4,7-diphenyl-1,10-phenanthroline (BCP), 4,7-diphenyl-1,10-phenanthroline (Bphen), $Alq_3$, Balq, 3-(biphenyl-4-yl)-$_5$-(4-*tert*-butylphenyl)-4-phenyl-4*H*-1,2,4-triazole (TAZ), and NTAZ:

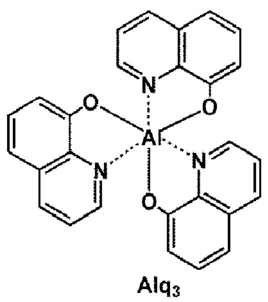

$Alq_3$

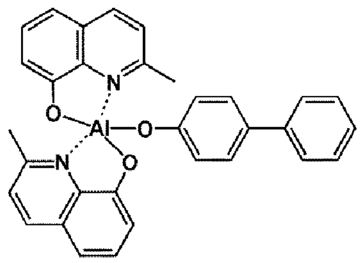

BAlq

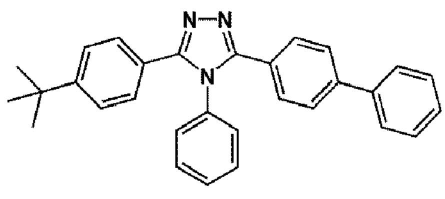

TAZ

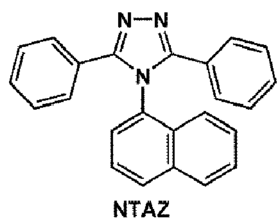

NTAZ

The thickness of the buffer layer, the hole blocking layer, and/or the electron control layer may each independently be in a range of about 20 Å to about 1,000 Å, for example, about 30 Å to about 300 Å. When the thickness of the buffer layer, the hole blocking layer, and/or the electron control layer are within the ranges described above, the electron blocking layer may have excellent electron blocking characteristics or electron control characteristics without a substantial increase in driving voltage.

A thickness of the electron transport layer may be in a range of about 100 Å to about 1,000 Å, for example,

about 150 Å to about 500 Å. When the thickness of the electron transport layer is within the ranges described above, the electron transport layer may have satisfactory electron transport characteristics without a substantial increase in driving voltage.

The electron transport region (for example, the electron transport layer in the electron transport region) may further comprise, in addition to the materials described above, a metal-containing material.

The metal-containing material may comprise at least one selected from an alkaline metal complex and an alkaline earth-metal complex. The alkaline metal complex may comprise a metal ion selected from an Li ion, a Na ion, a K ion, a Rb ion, and a Cs ion, and the alkaline earth-metal complex may comprise a metal ion selected from a Be ion, a Mg ion, a Ca ion, a Sr ion, and a Ba ion. A ligand coordinated with the metal ion of the alkaline metal complex or the alkaline earth-metal complex may each independently be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazol, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may comprise a Li complex. The Li complex may comprise, for example, Compound ET-D1 (lithium quinolate, LiQ) or ET-D2:

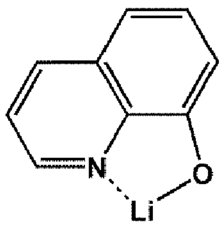

ET-D1

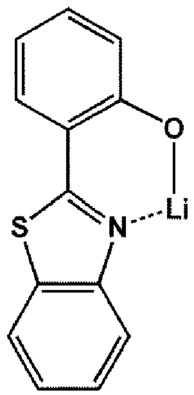

ET-D2 .

The electron transport region may comprise an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof.

In various embodiments, the electron injection layer may comprise Li, Na, K, Rb, Cs, Mg, Ca, Er, Tm, Yb, or a combination thereof. However, a material comprised in the electron injection layer is not limited thereto.

The alkaline metal may be selected from Li, Na, K, Rb, and Cs. In various embodiments, the alkaline metal may be Li, Na, or Cs. In various embodiments, the alkaline metal may be Li or Cs, but embodiments of the present disclosure are not limited thereto.

The alkaline earth metal may be selected from Mg, Ca, Sr, and Ba.

The rare-earth metal may be selected from Sc, Y, Ce, Yb, Gd, and Tb.

The alkaline metal compound, the alkaline earth-metal compound, and the rare-earth metal compound may be selected from oxides and halides (for example, fluorides, chlorides, bromides, or iodines) of the alkaline metal, the alkaline earth-metal, and the rare-earth metal.

The alkaline metal compound may be selected from alkaline metal oxides, such as $Li_{2O}$, $Cs_{2O}$, or $K_{2O}$, and alkaline metal halides, such as LiF, NaF, CsF, KF, LiI, NaI, CsI, RbI, or KI. In various embodiments, the alkaline metal compound may be selected from LiF, $Li_{2O}$, NaF, LiI, NaI, CsI, and KI, but embodiments of the present disclosure are not limited thereto.

The alkaline earth-metal compound may be selected from alkaline earth-metal compounds, such as BaO, SrO, CaO, $Ba_xSr_{1-x}O$ (0<x<1), or $Ba_xCa_{1-x}O$ (0<x<1). In various embodiments, the alkaline earth-metal compound may be selected from BaO, SrO, and CaO, but embodiments of the present disclosure are not limited thereto.

The rare-earth metal compound may be selected from $YbF_3$, $ScF_3$, $ScO_3$, $Y_2O_3$, $Ce_2O_3$, $GdF_3$, and $TbF_3$. In various embodiments, the rare-earth metal compound may be selected from $YbF_3$, $ScF_3$, $TbF_3$, $YbI_3$, $ScI_3$, and $TbI_3$, but embodiments of the present disclosure are not limited thereto.

The alkaline metal complex, the alkaline earth-metal complex, and the rare-earth metal complex may comprise an ion of alkaline metal, alkaline earth-metal, and rare-earth metal as described above, and a ligand coordinated with a metal ion of the alkaline metal complex, the alkaline earth-metal complex, and the rare-earth metal complex may each independently be selected from a hydroxy quinoline, a hydroxy isoquinoline, a hydroxy benzoquinoline, a hydroxy acridine, a hydroxy phenanthridine, a hydroxy phenylan oxazole, a hydroxy phenylthiazole, a hydroxy diphenylan oxadiazole, a hydroxy diphenylthiadiazol, a hydroxy phenylpyridine, a hydroxy phenylbenzimidazole, a hydroxy phenylbenzothiazole, a bipyridine, and a phenanthroline and cyclopentadiene, but embodiments of the present disclosure are not limited thereto.

The electron injection layer may comprise (e.g., consist of) an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof, as described above. In various embodiments, the electron injection layer may further comprise an organic material. When the electron injection layer further comprises an organic material, an alkaline metal, an alkaline earth metal, a rare-earth-metal, an alkaline metal compound, an alkaline earth-metal compound, a rare-earth metal compound, an alkaline metal complex, an alkaline earth-metal complex, a rare-earth metal complex, or a combination thereof may be homogeneously or non-homogeneously dispersed in a matrix comprising the organic material.

A thickness of the electron injection layer may be in a range of about 1 Å to about 100 Å, for example, about 3 Å to about 90 Å. When the thickness of the electron injection layer is within the ranges described above, the electron injection layer may have satisfactory electron injection characteristics without a substantial increase in driving voltage.

At least one layer selected from the electron transport layer and the electron injection layer may comprise an alkaline metal, an alkaline earth metal, a rare-earth-metal, an alkaline metal compound, an alkaline earth-metal compound, a rare-earth metal compound, an alkaline metal complex, an alkaline earth-metal complex, a rare-earth metal complex, or a combination thereof.

**Second electrode 190**

The second electrode 190 may be disposed on the organic layer 150 having such a structure. The second electrode 190 may be a cathode that is an electron injection electrode, and in this regard, a material for forming the second electrode 190 may be a material having a low work function, and such a material may be metal, alloy, an electrically conductive compound, or a combination thereof.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure comprising two or more layers.

**Description of FIGS. 2 to 5**

An organic light-emitting device 20 of FIG. 2 may comprise a first capping layer 210, a first electrode 110, an organic layer 150, and a second electrode 190, which are sequentially stacked in this stated order, an organic light-emitting device 30 of FIG. 3 may comprise a first electrode 110, an organic layer 150, a second electrode 190, and a second capping layer 220, which are sequentially stacked in this stated order, and an organic light-emitting device 40 of FIG. 4 may comprise a first capping layer 210, a first electrode 110, an organic layer 150, a second electrode 190, and a second capping layer 220, which are sequentially stacked in this stated order.

Regarding FIGS. 2 to 4, the first electrode 110, the organic layer 150, and the second electrode 190 may be understood by referring to the description respectively presented in connection with FIG. 1.

In the organic layer 150 of each of the organic light-emitting devices 20 and 40, light generated in the emission layer may pass through the first electrode 110, which is a semi-transmissive electrode or a transmissive electrode, and the first capping layer 210 toward the outside, and in the organic layer 150 of each of the organic light-emitting devices 30 and 40, light generated in the emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be a capping layer comprising an organic material, an inorganic capping layer comprising an inorganic material, or a composite capping

layer comprising an organic material and an inorganic material.

At least one selected from the first capping layer 210 and the second capping layer 220 may each independently include at least one material selected from carbocyclic compounds, heterocyclic compounds, amine-based compounds, porphine derivatives, phthalocyanine derivatives, naphthalocyanine derivatives, alkaline metal complexes, and alkaline earth-based complexes. The carbocyclic compound, the heterocyclic compound, and the amine-based compound may be optionally substituted with a substituent containing at least one element selected from O, N, S, Se, Si, F, Cl, Br, and I. In various embodiments, at least one selected from the first capping layer 210 and the second capping layer 220 may each independently comprise an amine-based compound.

In various embodiments, at least one selected from the first capping layer 210 and the second capping layer 220 may each independently comprise the compound represented by Formula 201 or the compound represented by Formula 202.

In various embodiments, at least one selected from the first capping layer 210 and the second capping layer 220 may each independently comprise a compound selected from Compounds HT28 to HT33 as described above and Compounds CP1 to CP5, but embodiments of the present disclosure are not limited thereto:

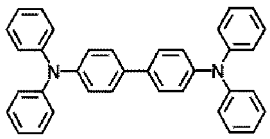

CP1

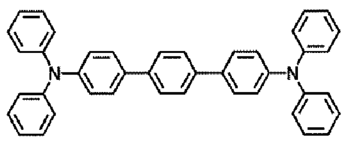

CP2

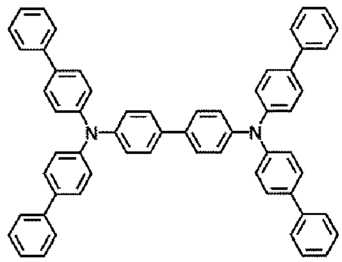

CP3

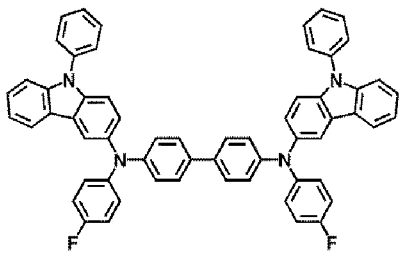

CP4

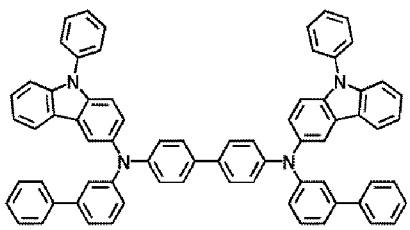

CP5

FIG. 5 is a schematic view of an organic light-emitting device 11 according to various embodiments. The organic light-emitting device 11 may comprise a first electrode 110, a hole transport layer 151, an emission auxiliary layer 153, an emission layer 155, a buffer layer 156, an electron transport layer 157, an electron injection layer 159, and a second electrode 190, which are sequentially stacked.

Respective layers constituting the organic light-emitting device 11 of FIG. 5 may be understood by referring to corresponding descriptions above.

Hereinbefore, the organic light-emitting device according to various embodiments has been described in connection with FIGS. 1 to 5. However, embodiments of the present disclosure are not limited thereto.

Layers constituting the hole transport region, the emission layer, and layers constituting the electron transport region may be formed in a certain region by utilizing one or more suitable methods selected from vacuum deposition, spin coating, casting, a Langmuir-Blodgett (LB) method, ink-jet printing, laser-printing, and laser-induced thermal imaging.

When the respective layers of the hole transport region, the emission layer, and the respective layers of the electron transport region are formed by vacuum deposition, the deposition may be performed at a deposition temperature of about 100◦C to about 500 °C, at a vacuum degree of about $10^{-8}$ torr to about $10^{-3}$ torr, and at a deposition rate of about 0.01 Å/sec to about 100 Å/sec by taking into account a material for forming a layer to be deposited, and a structure of the layer to be formed.

When layers constituting the hole transport region, the emission layer, and layers constituting the electron transport region are formed by spin coating, the spin coating may be performed at a coating speed of about 2,000 rpm to about 5,000 rpm and at a heat treatment temperature of about 80 °C to 200 °C by taking into account a material to be comprised in a to-be-formed layer, and a structure of the to-be-formed layer.

**General definition of substituents**

The term "$C_1$-$C_{60}$ alkyl group," as used herein, refers to a linear or branched aliphatic saturated hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Non-limiting examples thereof may include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group," as used herein, refers to a divalent group having substantially the same structure as the $C_1$-$C_{60}$ alkyl group.

The term "$C_2$-$C_{60}$ alkenyl group," as used herein, refers to a hydrocarbon group having at least one carbon-carbon double bond at one or more positions along the hydrocarbon chain of the $C_2$-$C_{60}$ alkyl group (e.g., in the middle or at the terminus of the $C_2$-$C_{60}$ alkyl group), and non-limiting examples thereof may include an ethenyl group, a propenyl group, and a butenyl group. The term "$C_2$-$C_{60}$ alkenylene group," as used herein, refers to a divalent group having substantially the same structure as the $C_2$-$C_{60}$ alkenyl group.

The term "$C_2$-$C_{60}$ alkynyl group," as used herein, refers to a hydrocarbon group having at least one carbon-carbon triple bond at one or more positions along the hydrocarbon chain of the $C_2$-$C_{60}$ alkyl group (e.g., in the middle or at the terminus of the $C_2$-$C_{60}$ alkyl group), and non-limiting examples thereof may include an ethynyl group, and a propynyl group. The term "$C_2$-$C_{60}$ alkynylene group," as used herein, refers to a divalent group having substantially the same structure as the $C_2$-$C_{60}$ alkynyl group.

The term "$C_1$-$C_{60}$ alkoxy group," as used herein, refers to a monovalent group represented by $-OA_{101}$ (wherein $A_{101}$ is the $C_1$-$C_{60}$ alkyl group), and non-limiting examples thereof may include a methoxy group, an ethoxy group, and an isopropyloxy group.

The term "$C_3$-$C_{10}$ cycloalkyl group," as used herein, refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "$C_3$-$C_{10}$ cycloalkylene group," as used herein, refers to a divalent group having substantially the same structure as the $C_3$-$C_{10}$ cycloalkyl group.

The term "$C_1$-$C_{10}$ heterocycloalkyl group," as used herein, refers to a monovalent saturated monocyclic group having at least one heteroatom (e.g. 1, 2, 3, 4 or 5 hereoatoms) selected from N, O, Si, P, and S as a ring-forming atom in addition to 1 to 10 carbon atoms, e.g. 1, 2, 3, 4 or 5 ring carbon atoms. Non-limiting examples thereof may include a 1,2,3,4-oxatriazolidinyl group, a tetrahydrofuranyl group, and a tetrahydrothiophenyl group. The term "$C_1$-$C_{10}$ heterocycloalkylene group," as used herein, refers to a divalent group having substantially the same structure as the $C_1$-$C_{10}$ heterocycloalkyl group.

The term "$C_3$-$C_{10}$ cycloalkenyl group," as used herein, refers to a monovalent saturated monocyclic group that has 3 to 10 carbon atoms and at least one double bond in the ring thereof and does not have aromaticity, and non-limiting examples thereof may include a cyclopentenyl group, a cyclohexenyl group, and a cycloheptenyl group. The term "$C_3$-$C_{10}$ cycloalkenylene group," as used herein, refers to a divalent group having substantially the same structure as the $C_3$-$C_{10}$ cycloalkenyl group.

The term "$C_1$-$C_{10}$ heterocycloalkenyl group," as used herein, refers to a monovalent monocyclic group that has at least one heteroatom (e.g. 1, 2, 3, 4 or 5 hereoatoms) selected from N, O, Si, P, and S as a ring-forming atom in addition to 1 to 10 carbon atoms, e.g. 1, 2, 3, 4 or 5 ring carbon atoms, and at least one double bond in its ring. Non-limiting examples of the $C_1$-$C_{10}$ heterocycloalkenyl group may include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group," as used herein, refers to a divalent group having substantially the same structure as the $C_1$-$C_{10}$ heterocycloalkenyl group.

The term "$C_6$-$C_{60}$ aryl group," as used herein, refers to a monovalent group having a carbocyclic aromatic system having 6 to 60 carbon atoms e.g. 6 to 20 ring carbon atoms, 6 to 14 ring cabon atoms or 6 to 10 ring carbon atoms, and the term "$C_6$-$C_{60}$ arylene group," as used herein, refers to a divalent group having a carbocyclic aromatic system having 6 to 60 carbon atoms e.g. 6 to 20 ring carbon atoms, 6 to 14 ring cabon atoms or 6 to 10 ring carbon atoms. Non-limiting examples of the $C_6$-$C_{60}$ aryl group may include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each comprise two or more rings, the rings may be fused to each other.

The term "$C_1$-$C_{60}$ heteroaryl group," as used herein, refers to a monovalent group having a heterocyclic aromatic system that has at least one heteroatom selected from N, O, Si, P, and S as a ring-forming atom in addition to 1 to 60 carbon atoms. The term "$C_1$-$C_{60}$ heteroarylene group," as used herein, refers to a divalent group having a heterocyclic aromatic system that has at least one heteroatom (e.g. 1, 2, 3, 4 or 5 hereoatoms) selected from N, O, Si, P, and S as a ring-forming atom in addition to 1 to 60 carbon atoms e.g. 1 to 19 ring carbon atoms, 1 to 13 ring cabon atoms or 1 to 9 ring carbon atoms. Non-limiting examples of the $C_1$-$C_{60}$ heteroaryl group may include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each comprise two or more rings, the rings may be respectively fused to each other.

The term "$C_6$-$C_{60}$ aryloxy group," as used herein, refers to a group represented by -$OA_{102}$ (wherein $A_{102}$ is the $C_6$-$C_{60}$ aryl group), and the term "$C_6$-$C_{60}$ arylthio group," as used herein, refers to a group represented by -$SA_{103}$ (wherein $A_{103}$ is the $C_6$-$C_{60}$ aryl group).

The term "monovalent non-aromatic condensed $C_8$-$C_{60}$ polycyclic group," as used herein, refers to a monovalent group having 8 to 60 ring carbon atoms (for example, having 8 to 20, 8 to 14 or 8 to 10 ring carbon atoms) that has two or more rings condensed with each other, only carbon atoms as a ring forming atom, and non-aromaticity in the entire molecular structure. Non-limiting examples of the monovalent non-aromatic condensed C8-C60 polycyclic group may include a fluorenyl group and a spiro-bifluorene group. The term "divalent non-aromatic condensed C8-$C_{60}$ polycyclic group," as used herein, refers to a divalent group having substantially the same structure as the monovalent non-aromatic condensed C8-C60 polycyclic group.

The term "monovalent non-aromatic condensed 8- to 60-membered heteropolycyclic group," as used herein, refers to a monovalent group (for example, having 1 to 59, 2 to 59, 2 to 19, 2 to 13 or 2 to 9 carbon atoms) that has two or more rings condensed to each other, has at least one heteroatom (e.g. 1, 2, 3, 4 or 5 hereoatoms) selected from N, O, Si, P, and S, in addition to carbon atoms, as a ring forming atom, and has non-aromaticity in the entire molecular structure. An example of the monovalent non-aromatic condensed 8- to 60-membered heteropolycyclic group is a carbazolyl group. The term "divalent non-aromatic condensed 8- to 60-membered heteropolycyclic group," as used herein, refers to a divalent group having substantially the same structure as the monovalent non-aromatic condensed 8- to 60-membered heteropolycyclic group.

The term "$C_5$-$C_{60}$ carbocyclic group," as used herein, refers to a monocyclic or polycyclic group having 5 to 60 carbon atoms in which the ring-forming atoms include only carbon atoms, e.g. 5 to 20 ring carbon atoms, 5 to 14 ring cabon atoms or 5 to 10 ring carbon atoms. The term "$C_5$-$C_{60}$ carbocyclic group," as used herein, refers to an aromatic carbocyclic group or a non-aromatic carbocyclic group. The term "$C_5$-$C_{60}$ carbocyclic group," as used herein, refers to a ring, such as a benzene group, a monovalent group, such as a phenyl group, or a divalent group, such as a phenylene group. In various embodiments, depending on the number of substituents connected to the $C_5$-$C_{60}$ carbocyclic group, the $C_5$-$C_{60}$ carbocyclic group may be a trivalent group or a quadrivalent group.

The term "$C_1$-$C_{60}$ heterocyclic group," as used herein, refers to a group having substantially the same structure as the $C_5$-$C_{60}$ carbocyclic group, except that as a ring-forming atom, at least one heteroatom (e.g. 1, 2, 3, 4 or 5 hereoatoms) selected from N, O, Si, P, S and Se is used in addition to carbon atom (the number of carbon atoms may be in a range of 1 to 60, e.g. 1 to 20 ring carbon atoms, 1 to 14 ring cabon atoms or 1 to 10 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:

deuterium (-D), -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br,-I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60 polycyclic group, a monovalent non-aromatic condensed 8- to 60-membered heteropolycyclic group, -$Si(Q_{11})(Q_{12})(Q_{13})$, -$N(Q_{11})(Q_{12})$,-$B(Q_{11})(Q_{12})$, -$C(=O)(Q_{11})$, -$S(=O)_2(Q_{11})$, and -$P(=O)(Q_{11})(Q_{12})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60 polycyclic group, and a monovalent non-aromatic condensed 8- to 60-membered heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed C8-C60 polycyclic group, a monovalent non-aromatic condensed 8- to 6o-membered heteropolycyclic group,

-Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), and -P(=O)($Q_{21}$)($Q_{22}$); and -Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and-P(=O)($Q_{31}$)($Q_{32}$), wherein $Q_{11}$ to $Q_{13}$, $Q_{21}$ to $Q_{23}$, and $Q_{31}$ to $Q_{33}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with a $C_1$-$C_{60}$ alkyl group, a $C_6$-$C_{60}$ aryl group substituted with a $C_6$-$C_{60}$ aryl group, a terphenyl group, a $C_1$-$C_{60}$ heteroaryl group, a $C_1$-$C_{60}$ heteroaryl group substituted with a $C_1$-$C_{60}$ alkyl group, a $C_1$-$C_{60}$ heteroaryl group substituted with a $C_6$-$C_{60}$ aryl group, a monovalent non-aromatic condensed C8-C60 polycyclic group, and a monovalent non-aromatic condensed 8- to 6o-membered heteropolycyclic group.

The term "Ph", as used herein, may refer to a phenyl group; the term "Me", as used herein, may refer to a methyl group; the term "Et", as used herein, may refer to an ethyl group; the terms "ter-Bu" or "But", as used herein, may refer to a tert-butyl group; the term "OMe," as used herein, may refer to a methoxy group, and the term "D", as used herein, may refer to deuterium.

The term "biphenyl group" as used herein refers to "a phenyl group substituted with a phenyl group." The "biphenyl group" belongs to "a substituted phenyl group" having "a $C_6$-$C_{60}$ aryl group" as a substituent.

The term "terphenyl group" as used herein refers to "a phenyl group substituted with a biphenyl group." The "terphenyl group" belongs to "a substituted phenyl group" having "a $C_6$-$C_{60}$ aryl group substituted with a $C_6$-$C_{60}$ aryl group."

Symbols and *' as used herein, unless defined otherwise, each refer to a binding site to a neighboring atom in a corresponding formula.

Hereinafter, a compound according to one or more embodiments and an organic light-emitting device according to one or more embodiments will be described in more detail with reference to the Synthesis Examples and Examples. The phrase "B was utilized instead of A" utilized in describing Synthesis Examples refers to that an identical number of molar equivalent of B was utilized in place of molar equivalent of A.

Example

**Example 1-1: Manufacture of red organic light-emitting device**

An anode was prepared by cutting an ITO glass substrate (manufactured by Corning) on which ITO was formed to a thickness of 15 Ω/cm$^2$ (1,200 Å) to a size of 50 mm x 50 mm x 0.5 mm, ultrasonically cleaning the ITO glass substrate utilizing isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum-deposited on the ITO glass substrate (anode) to have a thickness of 700 Å to form a hole transport layer. Then, TCTA was vacuum deposited on the hole transport layer to have a thickness of 100 Å to form an emission auxiliary layer.

Compound 1-1 (as a host) and PD11 (as a dopant) were co-deposited on the emission auxiliary layer at a weight ratio of 98:2 to form an emission layer having a thickness of 300 Å.

Compound 2-9 was deposited on the emission layer to form a buffer layer having a thickness of 100 Å, and then, $Alq_3$ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an *organic light-emitting device.*

**Examples 1-2 to 1-10 and Comparative Examples 1-1 to 1-3**

Organic light-emitting devices were manufactured in substantially the same manner as in Example 1-1, except that compounds shown in Table 5 were each utilized in forming an emission layer and a buffer layer.

**Evaluation Example 1**

The driving voltage and efficiency of the organic light-emitting devices of Examples 1-1 to 1-10 and Comparative Examples 1-1 to 1-3 were evaluated at 5 mA/cm$^2$ by utilizing a Keithley SMU 236 meter. Results thereof are shown in Table 5.

Table 5

| | Emission layer (host) | Buffer layer | Driving voltage (V) | Efficiency (cd/A) |
|---|---|---|---|---|
| Example 1-1 | Compoundi-i | Compound 2-9 | 5·3 | 23·9 |
| Example 1-2 | Compound 1-6 | Compound 2-48 | 5·4 | 24·5 |
| Example 1-3 | Compound 1-124 | Compound 2-147a | 5.2 | 23.7 |
| Example 1-4 | Compound 1-97 | Compound 2-143a | 5·3 | 24.1 |
| Example 1-5 | Compound 1-41 | Compound 2-48 | 5·5 | 23.8 |
| Example 1-6 | Compound 1-19 | Compound 2-93 | 5·5 | 24·5 |
| Example 1-7 | Compound 1-57 | Compound 2-153 | 5·3 | 25·3 |
| Example 1-8 | Compound 1-64 | Compound 2-165 | 5·3 | 25·1 |
| Example 1-9 | Compound 1-126 | Compound 2-189 | 5.4 | 24.0 |
| Example 1-10 | Compound 1-137 | Compound 2-211 | 5.2 | 24.7 |
| Comparative Example 1-1 | CBP | Compound 2-9 | 5.9 | 22.3 |
| Comparative Example 1-2 | Compound 1-1 | BAlq | 5.8 | 22.7 |
| Comparative Example 1-3 | CBP | BAlq | 6·2 | 21.6 |

Referring to Table 5, it was confirmed that the organic light-emitting devices of Examples 1-1 to 1-10 had a low driving voltage and high efficiency, compared to those of the organic light-emitting devices of Comparative Examples 1-1 to 1-3.

**Example 2-1: Manufacture of green (phosphorescent) organic light-emitting device**

An anode was prepared by cutting an ITO glass substrate (manufactured by Corning) on which ITO was formed to a thickness of 15 $\Omega/cm^2$ (1,200 Å) to a size of 50 mm x 50 mm x 0.5 mm, ultrasonically cleaning the ITO glass substrate utilizing isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, TCTA was vacuum deposited on the hole transport layer to a thickness of 100 Å to form an emission auxiliary layer.

Compound 1-1 (as a host) and PD13 (as a dopant) were co-deposited on the emission auxiliary layer at a weight ratio of 90:10 to form an emission layer having a thickness of 300 Å.

Compound 2-9 was deposited on the emission layer to form a buffer layer having a thickness of 100 Å, and then, $Alq_3$ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

**Examples 2-2 to 2-5 and Comparative Examples 2-1 to 2-3**

Organic light-emitting devices were manufactured in substantially the same manner as in Example 2-1, except that compounds shown in Table 6 were each utilized in forming an emission layer and a buffer layer.

**Example 2-6**

An organic light-emitting device was manufactured in substantially the same manner as in Example 2-1, except that Compound 1-1 (as a first host), CBP (as a second host), and PD13 (as a dopant) were co-deposited at a weight ratio of 50:50:10 in forming an emission layer.

**Examples 2-7 to 2-10**

Organic light-emitting devices were manufactured in substantially the same manner as in Example 2-6, except

that compounds shown in Table 7 were each utilized in forming an emission layer and a buffer layer.

**Example 2-m: Manufacture of green (fluorescent) organic light-emitting device**

An anode was prepared by cutting an ITO glass substrate (manufactured by Corning) on which ITO was formed to a thickness of 15 Ω/$cm^2$ (1,200 Å) to a size of 50 mm x 50 mm x 0.5 mm, ultrasonically cleaning the ITO glass substrate utilizing isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, NPB was vacuum deposited on the hole transport layer to a thickness of 100 Å to form an emission auxiliary layer.

Compound 1-166 (as a host) and FD19 (as a dopant) were co-deposited on the emission auxiliary layer at a weight ratio of 95:5 to form an emission layer having a thickness of 300 Å.

Compound 2-9 was deposited on the emission layer to form a buffer layer having a thickness of 100 Å, and then, $Alq_3$ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

**Examples 2-12 to 2-15 and Comparative Examples 2-4 to 2-6**

Organic light-emitting devices were manufactured in substantially the same manner as in Example 2-11, except that compounds shown in Table 6 are each utilized in forming an emission layer and a buffer layer.

**Evaluation Example 2**

The driving voltage and efficiency of the organic light-emitting devices of Examples 2-1 to 2-15 and Comparative Examples 2-1 to 2-6 were evaluated at 5 mA/$cm^2$ (phosphorescence) and 10 mA/$cm^2$ (fluorescence) by utilizing a Keithley SMU 236 meter. Results thereof are shown in Tables 6 and 7.

Table 6

| | Emission layer (host) | Emission layer (dopant) | Buffer layer | Weight ratio host: (dopant) | Driving voltage (V) | Efficiency (cd/A) |
|---|---|---|---|---|---|---|
| Example 2-1 | Compound 1-1 | PD13 | Compound 2-9 | 90:10 | 5.5 | 41.5 |
| Example 2-2 | Compound 1-20 | PD13 | Compound 2-48 | 90:10 | 5.2 | 43.6 |
| Example 2-3 | Compound 1-46 | PD13 | Compound 2-136a | 90:10 | 5.4 | 42.8 |
| Example 2-4 | Compound 1-59 | PD13 | Compound 2-103 | 90:10 | 5.4 | 43.1 |
| Example 2-5 | Compound 1-104 | PD13 | Compound 2-162 | 90:10 | 5.3 | 42.6 |
| Comparative Example 2-1 | CBP | PD13 | Compound 2-9 | 90:10 | 5.9 | 38.7 |
| Comparative Example 2-2 | Compound 1-1 | PD13 | BAlq | 90:10 | 5.9 | 38.3 |
| Comparative Example 2-3 | CBP | PD13 | BAlq | 90:10 | 6.1 | 36.1 |
| Example 2-11 | Compound 1-1 | FD19 | Compound 2-9 | 95:5 | 4.5 | 19.1 |

(continued)

| | Emission layer (host) | Emission layer (dopant) | Buffer layer | Weight ratio host: (dopant) | Driving voltage (V) | Efficiency (cd/A) |
|---|---|---|---|---|---|---|
| Example 2-12 | Compound 1-20 | FD19 | Compound 2-48 | 95:5 | 4.7 | 19.9 |
| Example 2-13 | Compound 1-46 | FD19 | Compound 2-136a | 95:5 | 4.4 | 20.1 |
| Example 2-14 | Compound 1-59 | FD19 | Compound 2-103 | 95:5 | 4.3 | 19.8 |
| Example 2-15 | Compound 1-104 | FD19 | Compound 2-162 | 95:5 | 4.5 | 20.3 |
| Comparative Example 2-4 | AND | FD19 | Compound 2-9 | 95:5 | 4.8 | 18.3 |
| Comparative Example 2-5 | Compound 1-166 | FD19 | $Alq_3$ | 95:5 | 4.6 | 17.8 |
| Comparative Example 2-6 | AND | FD19 | $Alq_3$ | 95:5 | 5.0 | 16.2 |

**Table 7**

| | Emission layer (first host: second host) | Emission layer (dopant) | Buffer layer | Weight ratio (ist host: 2nd host: dopant) | Driving voltage (V) | Efficiency (cd/A) |
|---|---|---|---|---|---|---|
| Example 2-6 | Compound 1-1: CPB | PD13 | Compound 2-9 | 50:50:10 | 5.5 | 41.1 |
| Example 2-7 | Compound 1-1: Compound 1-39 | PD13 | Compound 2-48 | 50:50:10 | 5.3 | 42.3 |
| Example 2-8 | Compound 1-20: Compound 1-41 | PD13 | Compound 2-136a | 50:50:10 | 5.2 | 42.7 |
| Example 2-9 | Compound 1-113: Compound 1-60 | PD13 | Compound 2-103 | 50:50:10 | 5.4 | 42.0 |
| Example 2-10 | Compound 1-46: Compound 1-16 | PD13 | Compound 2-162 | 50:50:10 | 5.3 | 43.2 |

Referring to Tables 6 and 7, it was confirmed that the organic light-emitting devices of Examples 2-1 to 2-10 had a low driving voltage and high efficiency, compared to those of the organic light-emitting devices of Comparative Examples 2-1 to 2-3, and the organic light-emitting devices of Examples 2-11 to 2-15 had a low driving voltage and high efficiency, compared to those of the organic light-emitting devices of Comparative Examples 2-4 to 2-6.

**Example 3-1: Manufacture of blue organic light-emitting device**

An anode was prepared by cutting an ITO glass substrate (manufactured by Corning) on which ITO was formed to a thickness of 15 $\Omega/cm^2$ (1,200 Å) to a size of 50 mm x 50 mm x 0.5 mm, ultrasonically cleaning the ITO glass substrate utilizing isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, NPB was vacuum deposited on the hole transport layer to a thickness of 100 Å to form an emission auxiliary layer.

Compound 1-166 (as a host) and FD1 (as a dopant) were co-deposited on the emission auxiliary layer at a

weight ratio of 95:5 to form an emission layer having a thickness of 300 Å.

Compound 2-9 was deposited on the emission layer to form a buffer layer having a thickness of 100 Å, and then, $Alq_3$ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

**Examples 3-2 to 3-5 and Comparative Examples 3-1 to 3-3**

Organic light-emitting devices were manufactured in substantially the same manner as in Example 3-1, except that compounds shown in Table 8 were each utilized in forming an emission layer and a buffer layer.

**Examples 3-6 to 3-10**

Organic light-emitting devices were manufactured in substantially the same manner as in Example 3-1, except that 1 wt% of $F_4$-TCNQ was doped in forming a hole transport layer and that compounds shown in Table 8 were each utilized in forming an emission layer and a buffer layer.

**Table 8**

| | Emission layer (host) | Buffer layer | Driving voltage (V) | Efficiency (cd/A) |
|---|---|---|---|---|
| Example 3-1 | Compound 1-166 | Compound 2-9 | 4·5 | 5·1 |
| Example 3-2 | Compound 1-164 | Compound 2-48 | 4·5 | 5·3 |
| Example 3-3 | Compound 1-178 | Compound 2-136a | 4.6 | 5.0 |
| Example 3-4 | Compound 1-164 | Compound 2-103 | 4.4 | 4.9 |
| Example 3-5 | Compound 1-178 | Compound 2-162 | 4.4 | 5.2 |
| Example 3-6 | Compound 1-165 | Compound 2-131 | 4.2 | 5.2 |
| Example 3-7 | Compound 1-171 | Compound 2-121a | 4.1 | 5.0 |
| Example 3-8 | Compound 1-171 | Compound 2-180 | 4.2 | 5.0 |
| Example 3-9 | Compound 1-176 | Compound 2-13a | 4.2 | 5.2 |
| Example 3-10 | Compound 1-176 | Compound 2-242 | 4.3 | 5.1 |
| Comparative Example 3-1 | AND | Compound 2-9 | 4.7 | 4.6 |
| Comparative Example 3-2 | Compound 1-166 | $Alq_3$ | 4.6 | 4.8 |
| Comparative Example 3-3 | ADN | $Alq_3$ | 4.9 | 4.4 |

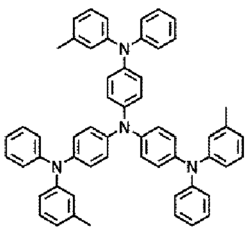
m-MTDATA

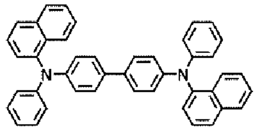
NPB

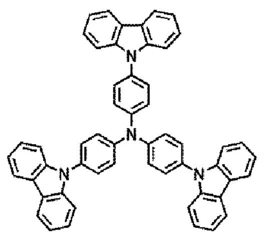
TCTA

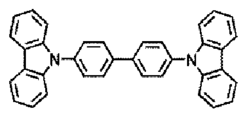
CBP

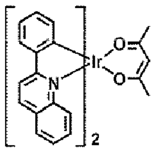
PD11

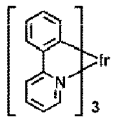
PD13

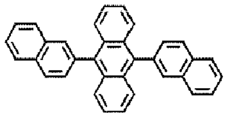
ADN

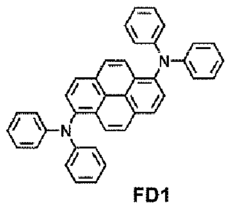
FD1

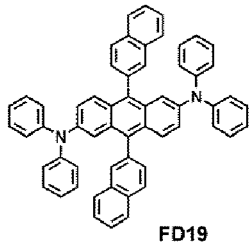
FD19

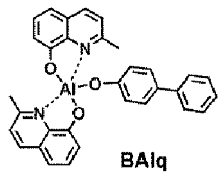
BAlq

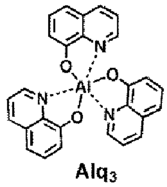
$Alq_3$

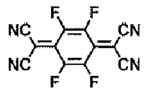
F4-TCNQ

Referring to Table 8, it was confirmed that the organic light-emitting devices of Examples 3-1 to 3-10 had a low driving voltage and high efficiency, compared to those of the organic light-emitting devices of Comparative Examples 3-1 to 3-3.

According to one or more embodiments, an organic light-emitting device may have a low driving voltage and high efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

**1.** An organic light-emitting device comprising:

a first electrode;
a second electrode facing the first electrode;
an emission layer between the first electrode and the second electrode;
a hole transport region between the first electrode and the emission layer; and
an electron transport region between the emission layer and the second electrode,
wherein the emission layer comprises a first compound,
at least one selected from the hole transport region and the electron transport region comprises a second compound, and
the first compound is a compound of Formula 1 other than 4,4'-bis(N-carbazolyl)-1,1'-biphenyl (CBP), and the second compound is represented by Formula 2A or 2B:

**Formula 1**

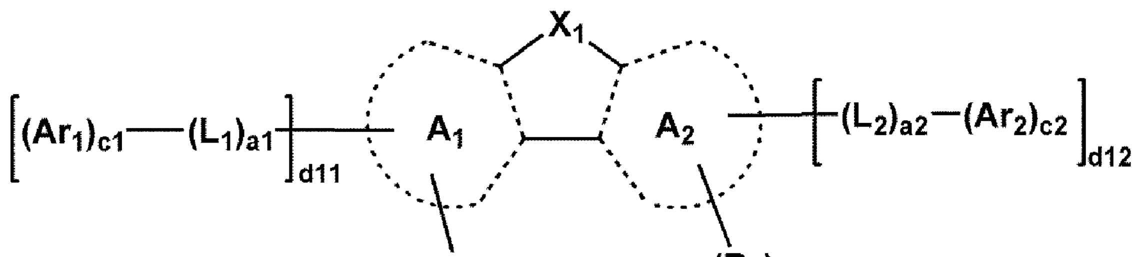

**Formula 2A**

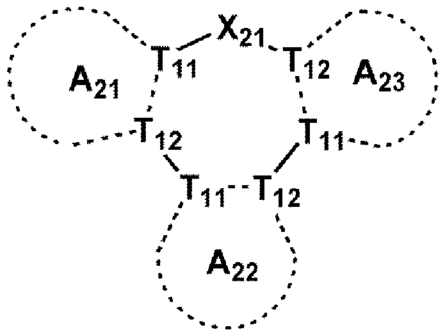

**Formula 2B**

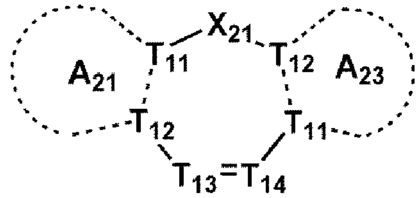

,

wherein, in Formulae 1, 2A, and 2B,

rings A1 and A2 are each independently selected from a C5-C60 carbocyclic group and a C1-C60 heterocyclic group,
rings A1 and A2 are each condensed with the 5-membered ring comprising X1 in Formula 1,
rings A21, A22, and A23 are each independently a $C_5$-$C_{60}$ carbocyclic group or a $C_1$-$C_{60}$ heterocyclic group, each substituted with at least one *-[(L22)a22-(R22)b22], wherein indicates a binding side to ring A21, A22, or A23,
each T11 is independently carbon or nitrogen,
each T12 is independently carbon or nitrogen, T13 is N or C(R27),
T14 is N or C(R28),
each bond between T11 and T12 represented by a dashed line in Formulae 2A and 2B is a single bond or a double bond,
wherein the six atoms represented by the three T11(s) and three T12(s) in Formula 2A are not all nitrogen, and the six atoms represented by the two T11(s), two T12(s), T13, and T14 in Formula 2B are not all nitrogen,
rings A21, A22, and A23 are each fused with the central 7-membered ring in Formulae 2A and 2B, such that they each share a T11 and a T12 with the central 7-membered ring,
X1 is selected from N[(L3)a3-(Ar3)c3], Si(R3)(R4), O, S, and Se,
X21 is selected from O, S, Se, C(R23)(R24), Si(R23)(R24), and N[(L21)a21-(R21)b21],
L1 to L3, L21, and L22 are each independently selected from a substituted or unsubstituted C3-C10 cycloalkylene group, a substituted or unsubstituted C1-C10 heterocycloalkylene group, a substituted or unsubstituted C3-C10 cycloalkenylene group, a substituted or unsubstituted C1-C10heterocycloalkenylene group, a substituted or unsubstituted C6-C60 arylene group, a substituted or unsubstituted C1-C60 heteroarylene group, a substituted or unsubstituted divalent non-aromatic condensed C8-C60 polycyclic group, and a substituted or unsubstituted divalent non-aromatic condensed 8- to 60-membered heteropolycyclic group,
a1 to a3, a21, and a22 are each independently an integer selected from o to 5,
Ar1 to Ar3 are each independently selected from a substituted or unsubstituted $C_1$-$C_{60}$ alkyl group, a substituted or unsubstituted C3-C10 cycloalkyl group, a substituted or unsubstituted C1-C10heterocycloalkyl group, a substituted or unsubstituted C3-C10 cycloalkenyl group, a substituted or unsubstituted C1-C10 heterocycloalkenyl group, a substituted or unsubstituted C6-C60 aryl group, a substituted or unsubstituted C6-C60 aryloxy group, a substituted or unsubstituted C6-C60 arylthio group, a substituted or unsubstituted $C_1$-$C_{60}$ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q1)(Q2)(Q3), -N(Q1)(Q2), -B(Q1)(Q2), - C(=O)(Q1), -S(=O)2(Q1), and -P(=O)(Q1)(Q2),
c1 to c3 are each independently an integer selected from 1 to 3,
R1 to R4, R21 to R24, R27, and R28 are each independently selected from hydrogen, deuterium (-D), -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted C2-C60 alkenyl group, a substituted or unsubstituted C2-C60 alkynyl group, a substituted or unsubstituted $C_1$-$C_{60}$ alkoxy group, a substituted or unsubstituted C3-C10 cycloalkyl group, a substituted or unsubstituted C1-C10heterocycloalkyl group, a substituted or unsubstituted C3-C10 cycloalkenyl group, a substituted or unsubstituted C1-C10 heterocycloalkenyl group, a substituted or unsubstituted C6-C60 aryl group, a substituted or unsubstituted C6-C60 aryloxy group, a substituted or unsubstituted C6-C60 arylthio group, a substituted or unsubstituted $C_1$-$C_{60}$ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q4)(Q5)(Q6), -N(Q4)(Q5), -B(Q4)(Q5),-C(=O)(Q4), -S(=O)2(Q4), and -P(=O)(Q4)(Q5),

b1 and b2 are each independently an integer selected from 1 to 6,

b21 and b22 are each independently an integer selected from 1 to 3,

d11 and d12 are each independently an integer selected from 0 to 4, and

the substituted C3-C10 cycloalkylene group, the substituted C1-C10 heterocycloalkylene group, the substituted C3-C10 cycloalkenylene group, the substituted C1-C10heterocycloalkenylene group, the substituted C6-C60 arylene group, the substituted $C_1$-$C_{60}$ heteroarylene group, the substituted divalent non-aromatic condensed C8-C60 polycyclic group, the substituted divalent non-aromatic condensed 8- to 60-membered heteropolycyclic group, the substituted $C_1$-$C_{60}$ alkyl group, the substituted C2-C60 alkenyl group, the substituted C2-C60 alkynyl group, the substituted $C_1$-$C_{60}$ alkoxy group, the substituted C3-C10 cycloalkyl group, the substituted C1-C10heterocycloalkyl group, the substituted C3-C10 cycloalkenyl group, the substituted C1-C10heterocycloalkenyl group, the substituted C6-C60 aryl group, the substituted C6-C60 aryloxy group, the substituted C6-C60 arylthio group, the substituted C1-C60 heteroaryl group, the substituted monovalent non-aromatic condensed C8-C60 polycyclic group, and the substituted monovalent non-aromatic condensed 8- to 60-membered heteropolycyclic group is each independently substituted with one or more substituents selected from the group consisting of:

deuterium, -F, -Cl, -Br, -I, a hydroxyl group, a cyano group, a nitro group, an amidino group, a hydrazino group, a hydrazono group, a C1-C60 alkyl group, a C2-C60 alkenyl group, a C2-C60 alkynyl group, and a C1-C60 alkoxy group;

a C1-C60 alkyl group, a C2-C60 alkenyl group, a C2-C60 alkynyl group, and a C1-C60 alkoxy group, each substituted with at least one selected from deuterium, -F,-Cl, -Br, -I, a hydroxyl group, a cyano group, a nitro group, an amidino group, a hydrazino group, a hydrazono group, a C3-C10 cycloalkyl group, a C1-C10 heterocycloalkyl group, a C3-C10 cycloalkenyl group, a C1-C10heterocycloalkenyl group, a C6-C60 aryl group, a C6-C60 aryloxy group, a C6-C60 arylthio group, a C1-C60 heteroaryl group, a monovalent non-aromatic condensed C8-C60 polycyclic group, a monovalent non-aromatic condensed 8- to 60-membered heteropolycyclic group,-Si(Q11)(Q12)(Q13), -N(Q11)(Q12), -B(Q11)(Q12), -C(=O)(Q11), -S(=O)2(Q11), and-P(=O)(Q11)(Q12);

a C3-C10 cycloalkyl group, a C1-C10heterocycloalkyl group, a C3-C10 cycloalkenyl group, a C1-C10heterocycloalkenyl group, a C6-C60 aryl group, a C6-C60 aryloxy group, a C6-C60 arylthio group, a $C_1$-$C_{60}$ heteroaryl group, a monovalent non-aromatic condensed C8-C60 polycyclic group, a monovalent non-aromatic condensed 8- to 60-membered heteropolycyclic group, a biphenyl group, and a terphenyl group;

a C3-C10 cycloalkyl group, a C1-C10heterocycloalkyl group, a C3-C10 cycloalkenyl group, a C1-C10heterocycloalkenyl group, a C6-C60 aryl group, a C6-C60 aryloxy group, a C6-C60 arylthio group, a $C_1$-$C_{60}$ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ alkyl group, a C2-C60 alkenyl group, a C2-C60 alkynyl group, a $C_1$-$C_{60}$ alkoxy group, a C3-C10 cycloalkyl group, a C1-C10heterocycloalkyl group, a C3-C10cycloalkenyl group, a C1-C10 heterocycloalkenyl group, a C6-C60 aryl group, a C6-C60 aryloxy group, a C6-C60 arylthio group, a $C_1$-$C_{60}$ heteroaryl group, a monovalent non-aromatic condensed C8-C60 polycyclic group, a monovalent non-aromatic condensed 8- to 60-membered heteropolycyclic group, -Si(Q21)(Q22)(Q23), -N(Q21)(Q22), -B(Q21)(Q22),-C(=O)(Q21), -S(=O)2(Q21), and -P(=O)(Q21)(Q22); and

-Si(Q31)(Q32)(Q33), -N(Q31)(Q32), -B(Q31)(Q32), -C(=O)(Q31), -S(=O)2(Q31), and -P(=O)(Q31)(Q32),

wherein Q1 to Q6, Q11 to Q13, Q21 to Q23, and Q31 to Q33 are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a C2-C60 alkenyl group, a C2-C60 alkynyl group, a $C_1$-$C_{60}$ alkoxy group, a C3-C10cycloalkyl group, a C1-C10heterocycloalkyl group, a C3-C10 cycloalkenyl group, a C1-C10heterocycloalkenyl group, a C6-C60 aryl group, a C6-C60 aryl group substituted with a $C_1$-$C_{60}$ alkyl group, a C6-C60 aryl group substituted with a C6-C60 aryl group, a terphenyl group, a $C_1$-$C_{60}$ heteroaryl group, a $C_1$-$C_{60}$ heteroaryl group substituted with a $C_1$-$C_{60}$ alkyl group, a $C_1$-$C_{60}$ heteroaryl group substituted with a C6-C60 aryl group, a monovalent non-aromatic condensed C8-C60 polycyclic group, and a monovalent non-aromatic condensed 8- to 60-membered heteropolycyclic group.

2. The organic light-emitting device of claim 1, wherein rings A1 and A2 in Formula 1 are each independently selected from a benzene group, a naphthalene group, an anthracene group, a phenanthrene group, an indene group, a fluorene group, a pyridine group, a pyrimidine group, a pyrazine group, a pyrrole group, a pyrazole group, an imidazole group, a quinoline group, a quinoxaline group, an isoquinoline group, a cinnoline group, a phthalazine group, a quinazoline group, a phenanthroline group, a phenanthridine group, a furan group, a thiophene group, an indole group, a benzofuran group, a benzothiophene group, a benzoxazole group, a benzothiazole group, a benzoimidazole group, a benzocarbazole group, a benzofluorene group, a benzonaphthofuran group, a benzonaphthothiophene group, a carbazole group, a dibenzofuran group, a dibenzothiophene group, a pyridoindole group, an indenopyridine group, a benzofuropyrimidine group, a benzofuropyridine group, an indenofluorene group, an indenoindole group, a benzoindole group, a naphthofuran group, a dipyridofuran group, a dipyridothiophene group, a pyrimidobenzofuran group, a pyridobenzofuran group, a pyrimidobenzothiophene group, a pyridobenzothiophene group, a group represented by Formula

" 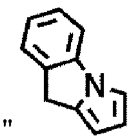 ",

a group represented by Formula

" 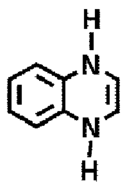 ",

a group represented by Formula

" 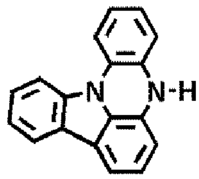 ",

and a group represented by Formula

" 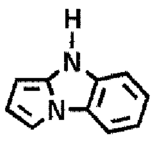 ".

3. The organic light-emitting device of claim 1 or 2, wherein rings A21, A22, and A23 in Formulae 2A and 2B are each independently selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran

group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and a naphthoindole group, each substituted with at least one *-[(L22)a22-(R22)b22].

**4.** The organic light-emitting device of claim 1 or 2, wherein
rings A21, A22, and A23 in Formulae 2A and 2B are each independently selected from groups represented by Formulae 2-1 to 2-36, each substituted with at least one *-[(L22)a22-(R22)b22)]:

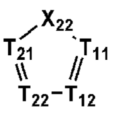

Formula 2-1

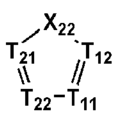

Formula 2-2

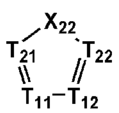

Formula 2-3

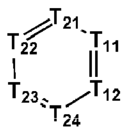

Formula 2-4

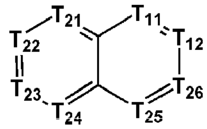

Formula 2-5

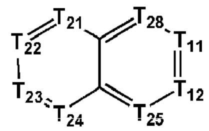

Formula 2-6

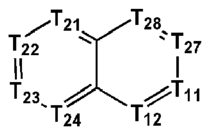

Formula 2-7

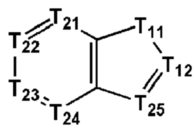

Formula 2-8

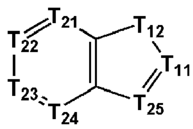

Formula 2-9

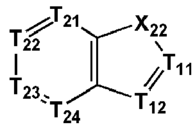

Formula 2-10

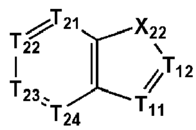

Formula 2-11

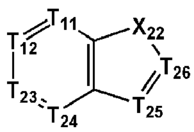

Formula 2-12

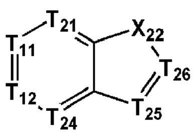

Formula 2-13

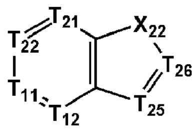

Formula 2-14

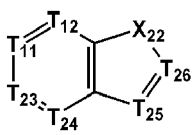

Formula 2-15

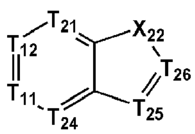

Formula 2-16

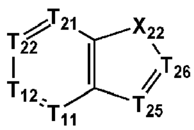

Formula 2-17

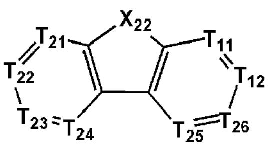

Formula 2-18

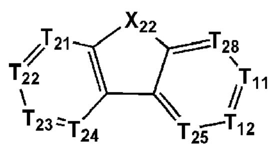

Formula 2-19

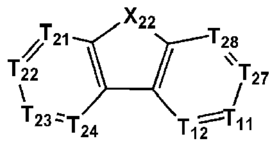

Formula 2-20

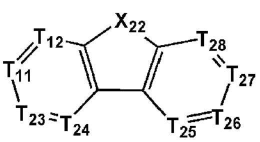

Formula 2-21

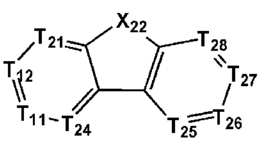

Formula 2-22

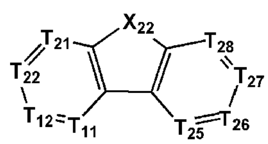

Formula 2-23

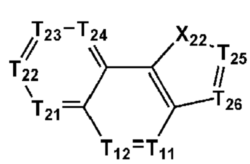

Formula 2-24

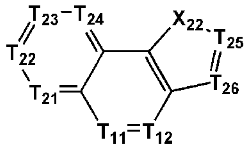

Formula 2-25

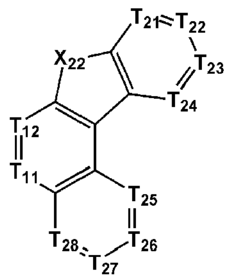

Formula 2-26

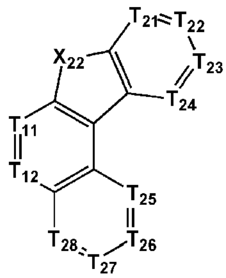

Formula 2-27

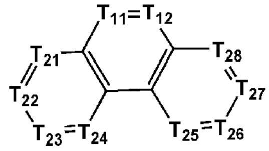

Formula 2-28

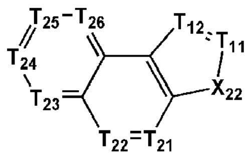

Formula 2-29

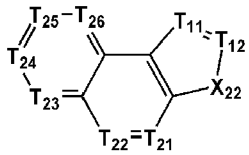

Formula 2-30

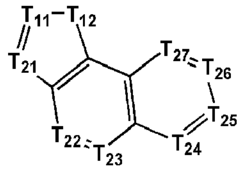

Formula 2-31

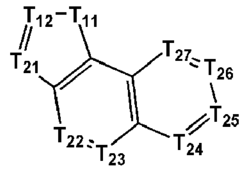

Formula 2-32

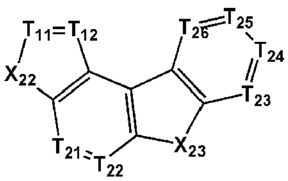

Formula 2-33

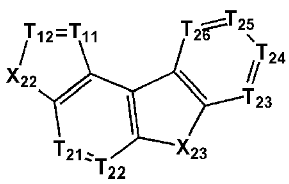

Formula 2-34

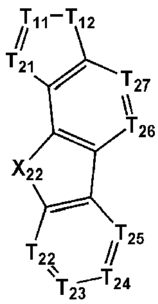

Formula 2-35

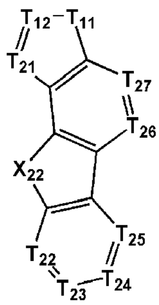

Formula 2-36

,

wherein, in Formulae 2-1 to 2-36,

T11 and T12 are the same as respectively described in connection with Formulae 2A and 2B,
X22 and X23 are each independently selected from O, S, Se, a moiety comprising C, a moiety comprising N, and a moiety comprising Si; and
T21 to T28 are each independently selected from N and a moiety comprising C.

5. The organic light-emitting device of any one of the preceding claims, wherein X1 in Formula 1 is selected from N[(L3)a3-(Ar3)c3], O, and S.

6. The organic light-emitting device of any one of the preceding claims, wherein

(a) X21 in Formulae 2A and 2B is N[(L21)a21-(R21)b21]; or
(b) X21 in Formulae 2A and 2B is O, S, Se, C($R_{23}$)($R_{24}$), or Si(R23)(R24), andat least one selected from rings A21, A22, and A23 in Formula 2A and at least one selected from rings A21 and A23 in Formula 2B are each independently selected from groups represented by Formulae 2-1 to 2-3, 2-10 to 2-27, and 2-33 to 2-36, wherein X22 or X23 in Formulae 2-1 to 2-3, 2-10 to 2-27, and 2-33 to 2-36 is N-[(L22)a22-(R22)b22].

7. The organic light-emitting device of any one of the preceding claims, wherein in Formulae 1, 2A, and 2B,
L1 to L3, L21, and L22 are each independently selected from the group consisting of:

a phenylene group, a pentalenylene group, an indenylene group, a naphthylene group, an azulenylene group,

an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and

a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C1-C20 alkyl group, a C1-C20 alkoxy group, a C3-C10cycloalkyl group, a C1-C10heterocycloalkyl group, a C3-C10 cycloalkenyl group, a C1-C10heterocycloalkenyl group, a C6-C60 aryl group, a $C_1$-$C_{60}$ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q31)(Q32)(Q33), -N(Q31)(Q32), -B(Q31)(Q32), -C(=O)(Q31), -S(=O)2(Q31), and -P(=O)(Q31)(Q32),

wherein Q31 to Q33 are each independently selected from the group consisting of:

a C1-C10alkyl group, a C1-C10alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and

a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C1-C10alkyl group, a C1-C10alkoxy group, and a phenyl group.

**8.** The organic light-emitting device of any one of the preceding claims, wherein,
in Formulae 1, 2A, and 2B,
Ar1 to Ar3 are each independently selected from the group consisting of:

a group represented by any of Formulae 1-1 and 1-2, a C1-C20 alkyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si(Q1)(Q2)(Q3), -N(Q1)(Q2), - B(Q1)(Q2), -C(=O)(Q1), -S(=O)2(Q1), and -P(=O)(Q1)(Q2); and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl, and an imidazopyrimidinyl group, each substituted with at least one selected from deuterium,-F, -Cl, -Br, -I, a hydroxyl group, a cyano group, a nitro group, an amidino group, a hydrazino group, a hydrazono group, a C1-C10alkyl group, a C1-C10alkoxy group, a C3-C10cycloalkyl group, a C1-C10heterocycloalkyl group, a C3-C10cycloalkenyl group, a C1-C10heterocycloalkenyl group, a C6-C60 aryl group, a C1-C60 heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q31)(Q32)(Q33), -N(Q31)(Q32), -B(Q31)(Q32), -C(=O)(Q31),-S(=O)2(Q31), and -P(=O)(Q31)(Q32), and
R1 to R4, R21 to R24, R27, and R28 are each independently selected from the group consisting of:

hydrogen, deuterium, -F, -Cl, -Br, -I, a hydroxyl group, a cyano group, a nitro group, an amidino group, a hydrazino group, a hydrazono group, a C1-C20 alkyl group, and a C1-C20 alkoxy group;
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, an imidazopyrimidinyl group, -Si(Q4)(Q5)(Q6), -N(Q4)(Q5), -B(Q4)(Q5), -C(=O)(Q4),-S(=O)2(Q4), and -P(=O)(Q4)(Q5); and
a phenyl group, a biphenyl group, a terphenyl group, a pentalenyl group, an indenyl group, a naphthyl group,

an azulenyl group, an indacenyl group, an acenaphthyl group, a fluorenyl group, a spiro-bifluorenyl group, a benzofluorenyl group, a dibenzofluorenyl group, a spiro-benzofluorene-fluorenyl group, an indenofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a dibenzosilolyl group, a thiadiazolyl group, an imidazopyridinyl group, and an imidazopyrimidinyl group, each substituted with at least one selected from deuterium, - F, -Cl, -Br, -I, a hydroxyl group, a cyano group, a nitro group, an amidino group, a hydrazino group, a hydrazono group, a C1-C10alkyl group, a C1-C10alkoxy group, a C3-C10cycloalkyl group, a C1-C10heterocycloalkyl group, a C3-C10cycloalkenyl group, a C1-C10heterocycloalkenyl group, a C6-C60 aryl group, a C1-C60 heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q31)(Q32)(Q33), -N(Q31)(Q32), -B(Q31)(Q32), -C(=O)(Q31),-S(=O)2(Q31), and -P(=O)(Q31)(Q32),

wherein Q1 to Q6 and Q31 to Q33 are each independently selected from the group consisting of:

a C1-C10alkyl group, a C1-C10alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C1-C10alkyl group, a C1-C10alkoxy group, and a phenyl group:

**Formula 1-1**

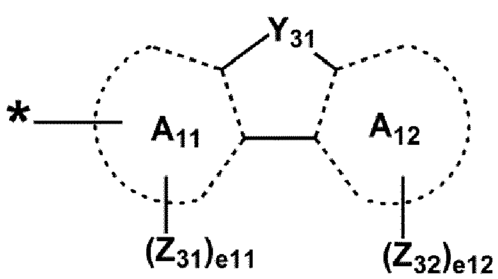

**Formula 1-2**

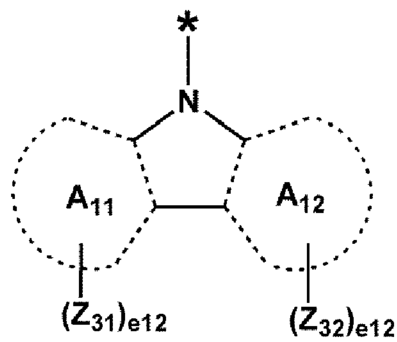

,

wherein, in Formulae 1-1 and 1-2,

A11 and A12 are each independently selected from a cyclohexene group, a benzene group, a naphthalene group, a phenanthrene group, an anthracene group, a triphenylene group, a pyrene group, a carbazole group, a fluorene group, a spiro-bifluorene group, a pyridine group, a pyrazine group, a pyrimidine group, a pyridazine group, a quinoline group, an isoquinoline group, a quinoxaline group, a quinazoline group, a triazine group, an indene group, a benzofuran group, a benzothiophene group, a dibenzofuran group, and a dibenzothiophene group,
Y31 is selected from N[(L11)a11-(Z33)e13], C(Z34)(Z35), Si(Z34)(Z35), O, S, and Se,
L11 is the same as defined for L1 in claim 1 or clam 7,
a11 is the same as defined for a1 in claim 1,
Z31 to Z35 are each independently selected from the group consisting of:

hydrogen, deuterium, -F, -Cl, -Br, -I, a hydroxyl group, a cyano group, a nitro group, an amidino group, a hydrazino group, a hydrazono group, a C1-C20 alkyl group, and a C1-C20 alkoxy group; a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a quinolinyl group, an isoquinolinyl group, a benzoquinolinyl group, a quinoxalinyl group, a quinazolinyl group, a benzoimidazolyl group, an isobenzothiazolyl group, a benzoxazolyl group, an isobenzoxazolyl group, an oxadiazolyl group, and a triazinyl group; and

-Si(Q31)(Q32)(Q33), -N(Q31)(Q32), -B(Q31)(Q32), -C(=O)(Q31), -S(=O)2(Q31), and -P(=O)(Q31)(Q32),

e11 and e12 are each independently an integer selected from 1 to 10,

e13 is an integer selected from 1 to 3, and

* indicates a binding site to a neighboring atom.

**9.** The organic light-emitting device of any one of the preceding claims, wherein the first compound is represented by one selected from Formulae 1A to 1F:

Formula 1A

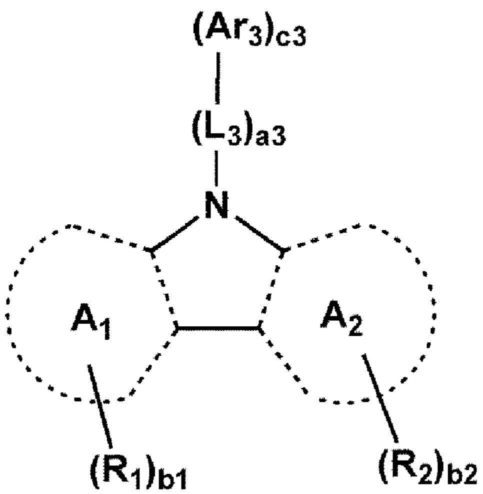

Formula 1B

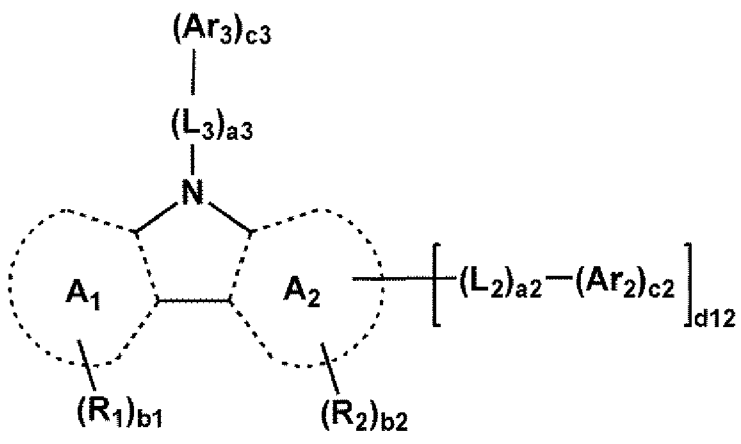

Formula 1C

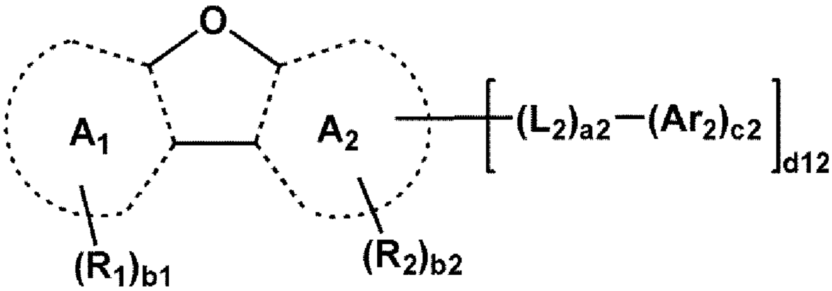

Formula 1D

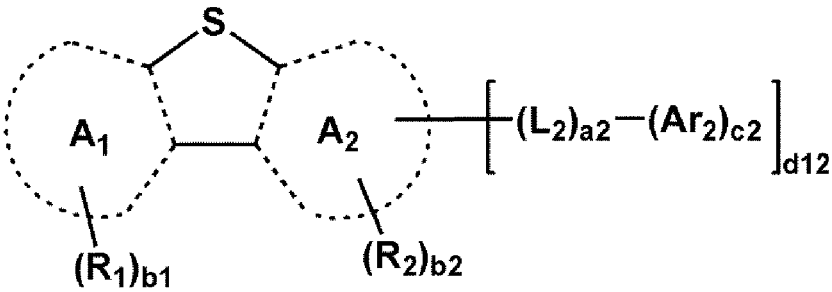

Formula 1E

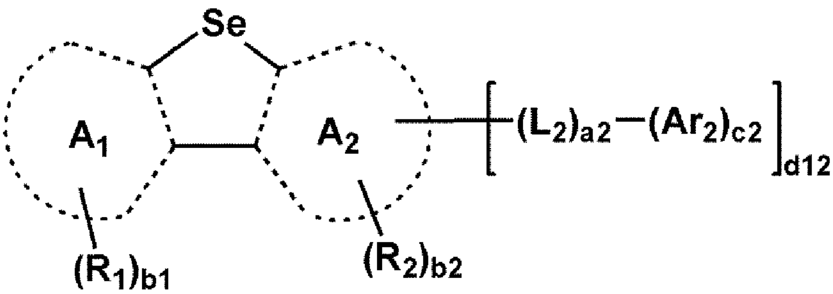

Formula 1F

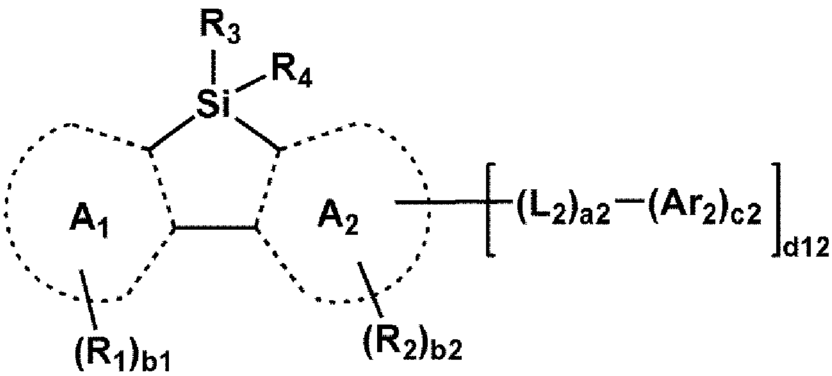

wherein, in Formulae 1A to 1F,

ring A1, ring A2, L2, L3, a2, a3, Ar2, Ar3, c2, c3, R1 to R4, b1, b2, and d12 are the same as defined in any one of the claims 1, 2, 7 and 8;
preferably wherein, in Formulae 1A to 1F,
ring A1 is selected from a benzene group, a naphthalene group, a pyridine group, and a pyrimidine group,
ring A2 is selected from a benzene group, a naphthalene group, a phenanthrene group, an anthracene group, a phenanthroline group, an indenopyridine group, a benzofuropyrimidine group, a benzofuropyridine group, an indenofluorene group, an indenoindole group, a benzoindole group, a naphthofuran group, a benzonaphthofuran group, a pyridobenzothiophene group, a benzonaphthothiophene group, a benzocarbazole group, a quinoline group, a quinoxaline group, a pyridine group, a pyrimidine group, an indole group, a carbazole group, a fluorene group, a benzofluorene group, a benzofuran group, a benzoxazole group, an indene group, a dibenzofuran group, a dibenzothiophene group, a pyridoindole group, a group represented by Formula

" 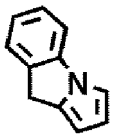 ",

a group represented by Formula

" 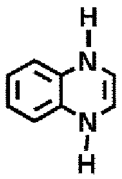 "

a group represented by Formula

" 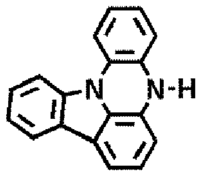 ",

and a group represented by Formula

" 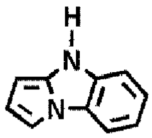 ",

and
R1 and R2 are each independently selected from hydrogen, deuterium, -F, -Cl, - Br, -I, a hydroxyl group, a cyano group, a nitro group, an amidino group, a hydrazino group, a hydrazono group, a C1-C20 alkyl group, a C1-C20 alkoxy group, a C6-C30 aryl group, a C1-C30 heteroaryl group, -Si(Q4)(Q5)(Q6), -N(Q4)(Q5), -B(Q4)(Q5), - C(=O)(Q4), -S(=O)2(Q4), and -P(=O)(Q4)(Q5).

**10.** The organic light-emitting device of any one of the preceding claims, wherein:

(a) triplet energy of the second compound is about 2.2 eV or more; and/or
(b) the emission layer comprises a first host and a second host, wherein the first host comprises the first compound; and/or
(c) the electron transport region comprises a buffer layer, and the buffer layer directly contacts the emission layer and comprises the second compound.

**11.** The organic light-emitting device of any one of the preceding claims, wherein
the emission layer comprises a host and a dopant,
the host comprises the first compound, and the dopant comprises an organometallic complex represented by Formula 401:

**Formula 401** M(L401)xc1(L402)xc2

in which L401 is selected from ligands represented by Formula 402,

Formula 402

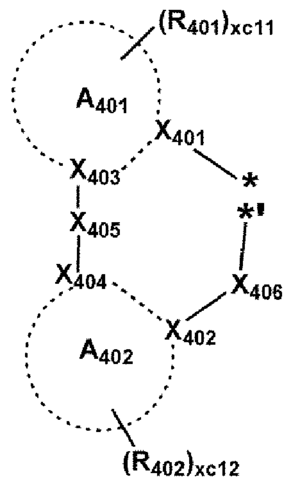

,

wherein, in Formula 401,

M is selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 is 1, 2, or 3, wherein when xc1 is two or more, two or more L401(s) are identical to or different from each other,
L402 is an organic ligand,
xc2 is an integer selected from o to 4, wherein when xc2 is two or more, two or more L402(s) are identical to or different from each other,
and wherein in Formula 402,
X401 to X404 are each independently nitrogen or carbon,
X401 and X403 are connected to each other via a single bond or a double bond, and X402 and X404 are connected to each other via a single bond or a double bond,
A401 and A402 are each independently a $C_5$-$C_{60}$ carbocyclic group or a C1-C60 heterocyclic group,
X405 is a single bond, -O-, -S-, -C(=O)-, -N(Q411)-, -C(Q411)(Q412)-,-C(Q411)=C(Q412)-, -C(Q411)=, or =C(Q411)=, wherein Q411 and Q412 are each independently hydrogen, deuterium, a C1-C20 alkyl group, a C1-C20 alkoxy group, a phenyl group, a biphenyl group, a terphenyl group, or a naphthyl group,
X406 is a single bond, O, or S,
R401 and R402 are each independently selected from hydrogen, deuterium, -F, -Cl, -Br, -I, -CD3, -CF3, a hydroxyl group, a cyano group, a nitro group, an amidino group, a hydrazino group, a hydrazono group, a substituted or unsubstituted C1-C20 alkyl group, a substituted or unsubstituted C1-C20 alkoxy group, a substituted or unsubstituted C3-C10cycloalkyl group, a substituted or unsubstituted C1-C10 heterocycloalkyl group, a substituted or unsubstituted C3-C10cycloalkenyl group, a substituted or unsubstituted C1-C10heterocycloalkenyl group, a substituted or unsubstituted C6-C60 aryl group, a substituted or unsubstituted C6-C60 aryloxy group, a substituted or unsubstituted C6-C60 arylthio group, a substituted or unsubstituted $C_1$-$C_{60}$ heteroaryl group, a substituted or unsubstituted monovalent non-aromatic condensed C8-C60 polycyclic group, a substituted or unsubstituted monovalent non-aromatic condensed 8- to 60-membered heteropolycyclic group,-Si(Q401)(Q402)(Q403), -N(Q401)(Q402), -B(Q401)(Q402), -C(=O)(Q401),-S(=O)$_2$(Q401), and -P(=O)(Q401)(Q402), wherein Q401 to Q403 are each independently selected from a C1-C10alkyl group, a C1-C10alkoxy group, a C6-C20 aryl group, and a C1-C20 heteroaryl group,
xc11 and xc12 are each independently an integer selected from o to 10, and
* and *' in Formula 402 each indicate a binding site to M in Formula 401.

**12.** The organic light-emitting device of any one of the preceding claims, wherein
the emission layer comprises a host and a dopant,
the host comprises the first compound, and the dopant comprieses a compound represented by Formula 501:

**Formula 501**

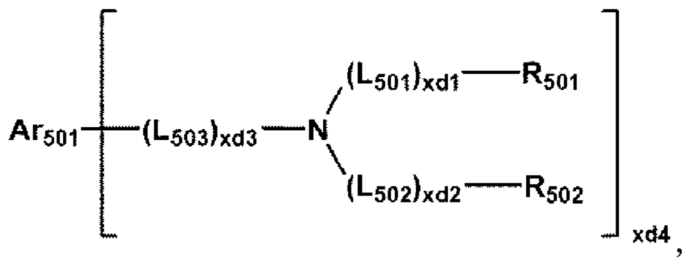

wherein, in Formula 501,

Ar501 is a substituted or unsubstituted $C_5$-$C_{60}$ carbocyclic group or a substituted or unsubstituted C1-C60 heterocyclic group,
L501 to L503 are each independently selected from a substituted or unsubstituted C6-C60 arylene group, a substituted or unsubstituted C1-C60 heteroarylene group, a substituted or unsubstituted divalent non-aromatic condensed C8-C60 polycyclic group, and a substituted or unsubstituted divalent non-aromatic condensed 8- to 60-membered heteropolycyclic group,
xd1 to xd3 are each independently an integer selected from o to 3,
R501 and R502 are each independently selected from a substituted or unsubstituted C3-C10cycloalkyl group, a substituted or unsubstituted C1-C10 heterocycloalkyl group, a substituted or unsubstituted C3-C10cycloalkenyl group, a substituted or unsubstituted C1-C10heterocycloalkenyl group, a substituted or unsubstituted C6-C60 aryl group, a substituted or unsubstituted C1-C60 heteroaryl group, a substituted or unsubstituted monovalent non-aromatic condensed C8-C60 polycyclic group, and a substituted or unsubstituted monovalent non-aromatic condensed 8- to 60-membered heteropolycyclic group, and
xd4 is an integer selected from 1 to 4.

**13.** The organic light-emitting device of any one of the preceding claims,
wherein
the electron transport region comprises a buffer layer, an electron transport layer, and an electron injection layer, and at least one layer selected from the electron transport layer and the electron injection layer comprises an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof.

**14.** The organic light-emitting device of any one of the preceding claims,
wherein
the hole transport region comprises a p-dopant, and
a lowest unoccupied molecular orbital (LUMO) of the p-dopant is about -3.5 eV or less; preferably wherein
the p-dopant comprises a cyano group-containing compound.

**15.** The organic light-emitting device of any one of the preceding claims, wherein
the emission layer is a first-color-light emission layer,
the organic light-emitting device further comprises i) at least one second-color-light emission layer or ii) at least one second-color-light emission layer and at least one third-color-light emission layer, between the first electrode and the second electrode,
a maximum emission wavelength of the first-color-light emission layer, a maximum emission wavelength of the second-color-light emission layer, and a maximum emission wavelength of the third-color-light emission layer are identical to or different from one another, and
the organic light-emitting device is configured to emit mixed light comprising first-color-light and second-color-light, or mixed light comprising first-color-light, second-color-light, and third-color-light.

FIG. 1

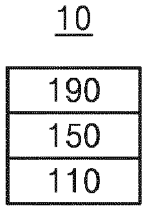


FIG. 2

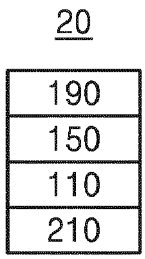


FIG. 3

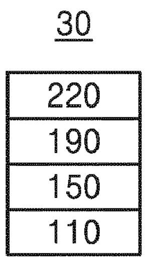

FIG. 4

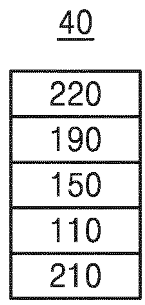


FIG. 5

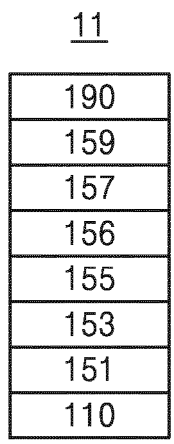

Europäisches Patentamt
European Patent Office
Office européen des brevets

# EUROPEAN SEARCH REPORT

Application Number
EP 16 19 1351

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 2015 0021861 A (CHOI DON SOO [KR]; CHO YOUN HWAN [KR]) 3 March 2015 (2015-03-03)<br>* claims 1, 6 *<br>----- | 1-15 | INV.<br>H01L51/50 |
| Y | US 2015/194610 A1 (HWANG KYU-YOUNG [KR] ET AL) 9 July 2015 (2015-07-09)<br>* claims 14-17 *<br>* page 51, paragraph 273; page 52, formula 201; page 53, compound HT1 *<br>----- | 1-15 | |
| Y | KR 2015 0070897 A (DOOSAN CORP [KR]) 25 June 2015 (2015-06-25)<br>* page 24; compounds A-5 *<br>* page 24; compound B5 *<br>* paragraphs [0025], [0899] - [0903] *<br>----- | 1-15 | |
| X | EP 2 599 851 A2 (ROHM & HAAS ELECT MATERIALS [KR]) 5 June 2013 (2013-06-05) | 1-15 | |
| Y | * page 16; compounds 66, 68 *<br>* page 36; example 8 *<br>* claim 1, formulae 3 and 4 *<br>* page 35, line 9 *<br>----- | 1-15 | TECHNICAL FIELDS SEARCHED (IPC)<br>H01L<br>C07D |

The present search report has been drawn up for all claims

1

| Place of search | Date of completion of the search | Examiner |
|---|---|---|
| Munich | 26 October 2016 | Gutke, Hans-Jürgen |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT ON EUROPEAN PATENT APPLICATION NO. EP 16 19 1351

This annex lists the patent family members relating to the patent documents cited in the above-mentioned European search report. The members are as contained in the European Patent Office EDP file on The European Patent Office is in no way liable for these particulars which are merely given for the purpose of information.

26-10-2016

| Patent document cited in search report | Publication date | Patent family member(s) | Publication date |
|---|---|---|---|
| KR 20150021861 A | 03-03-2015 | NONE | |
| US 2015194610 A1 | 09-07-2015 | KR 20150081736 A | 15-07-2015 |
| | | US 2015194610 A1 | 09-07-2015 |
| KR 20150070897 A | 25-06-2015 | CN 105829314 A | 03-08-2016 |
| | | KR 20150070897 A | 25-06-2015 |
| | | WO 2015093812 A1 | 25-06-2015 |
| EP 2599851 A2 | 05-06-2013 | CN 103140564 A | 05-06-2013 |
| | | EP 2599851 A2 | 05-06-2013 |
| | | EP 2806008 A1 | 26-11-2014 |
| | | EP 2857395 A1 | 08-04-2015 |
| | | EP 2905281 A1 | 12-08-2015 |
| | | JP 2013539206 A | 17-10-2013 |
| | | KR 20120012431 A | 09-02-2012 |
| | | KR 20140051871 A | 02-05-2014 |
| | | KR 20140051872 A | 02-05-2014 |
| | | KR 20140058454 A | 14-05-2014 |
| | | TW 201300501 A | 01-01-2013 |
| | | US 2014054564 A1 | 27-02-2014 |
| | | WO 2012015274 A2 | 02-02-2012 |

EPO FORM P0459

For more details about this annex : see Official Journal of the European Patent Office, No. 12/82